# EUROPEAN PATENT SPECIFICATION

(11) **EP 2 062 958 B1**
(45) Date of publication and mention of the grant of the patent: **28.07.2010**
(21) Application number: 08169469.7
(22) Date of filing: 20.11.2008
(51) Int. Cl.: C09K 11/06, H05B 33/14, C07D 215/58, C07F 15/00, H01L 51/50, H01L 51/00

(54) **Novel organic electroluminescent compounds and organic electroluminescent device using the same**
Neue organische Elektrolumineszenzverbindungen und organische Elektrolumineszenzvorrichtung damit
Nouveaux composés électroluminescents organiques et dispositif électroluminescent organique les utilisant

(30) Priority: 20.11.2007 KR 20070118634
(43) Date of publication of application: 27.05.2009
(73) Proprietor: Gracel Display Inc., Seoul 133-833 (KR)
(72) Inventor: Eum, Sung Jin, Seoul (KR); Kim, Jin Ho, Seoul (KR); Cho, Young Jun, 136-060, Seoul (KR); Kwon, Hyuck Joo, 130-100, Seoul (KR); Kim, Bong Ok, 135-090, Seoul (KR); Kim, Sung Min, 157-886, Seoul (KR); Yoo, Seung Soo, 135-884, Seoul (KR)
(74) Representative: Kent, Venetia Katherine

(56) References cited:
- EP-A- 1 371 708
- WO-A-03/040256
- WO-A-2006/095943
- US-A1- 2001 019 782
- US-A1- 2003 040 627
- US-A1- 2005 164 030

## Description

### FIELD OF THE INVENTION

The present invention relates to novel organic electroluminescent compounds exhibiting high luminous efficiency, and organic electroluminescent devices comprising the same.

### BACKGROUND OF THE INVENTION

The most important factor to determine luminous efficiency in an OLED (organic light-emitting diode) is the type of electroluminescent material. Though fluorescent materials has been widely used as an electroluminescent material up to the present, development of phosphorescent materials is one of the best methods to improve the luminous efficiency theoretically up to four(4) times, in view of electroluminescent mechanism.

Up to now, iridium (III) complexes are widely known as phosphorescent material, including (acac)Ir(btp)₂, Ir(ppy)₃ and Firpic, as the red, green and blue one, respectively. In particular, a lot of phosphorescent materials have been recently investigated in Japan, Europe and America.

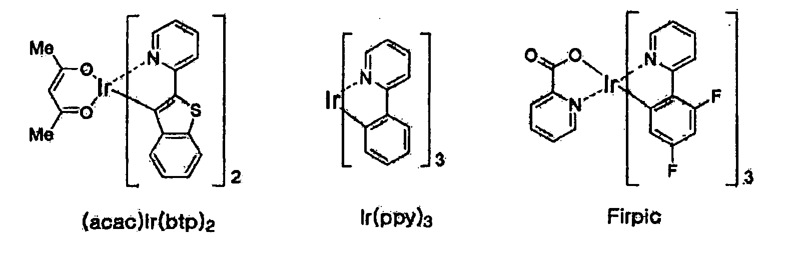

Among conventional red phosphorescent materials, several materials have been reported to have good EL (electroluminescence) properties. For instance, US 2001/0019782, US2003/0040627 and WO 03/04026 each disclose electroluminescent compounds for use in OLEDs. However, very rare materials among them have reached the level of commercialization. As the most preferable material, an iridium complex of 1-phenyl isoquinoline may be mentioned, which is known to have excellent EL property and to exhibit color purity of dark red with high luminous efficiency. [See A. Tsuboyama et al., J. Am. chem. Soc. 2003, 125(42), 12971-12979.]

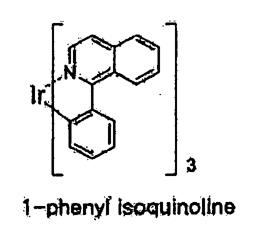

Moreover, the red materials, having no significant problem of lifetime, have tendency of easy commercialization if they have good color purity or luminous efficiency. Thus, the above-mentioned iridium complex is a material having noticeable viability of commercialization due to its excellent color purity and luminous efficiency.

However, the iridium complex is still construed as a material which is merely applicable to small displays, while higher levels of EL properties than those of known materials are practically required for an OLED panel of medium to large size.

### SUMMARY OF THE INVENTION

With intensive efforts to overcome the problems of conventional techniques as described above, the present inventors have researched for developing novel organic electroluminescent compounds to realize an organic EL device having excellent luminous efficiency and surprisingly improved lifetime. Eventually, the inventors found that luminous efficiency and life property are improved when an iridium complex, which was synthesized by employing 2-cyclopentenylquinoline as the backbone of the primary ligand compound, is applied as a dopant of an electroluminescent device, and completed the present invention. Thus, the object of the invention is to provide novel organic electroluminescent compounds having the backbone to give more excellent properties as compared to those of conventional red phosphorescent materials. Another object of the invention is to provide novel organic electroluminescent compounds which are applicable to OLED panels of medium to large size.

Still another object of the invention is to provide organic electroluminescent devices comprising the novel organic electroluminescent compounds.

Thus, the present invention relates to novel organic electroluminescent compounds and organic electroluminescent devices comprising the same. Specifically, the organic electroluminescent compounds according to the invention are **characterized in that** they are represented by Chemical Formula (1) : 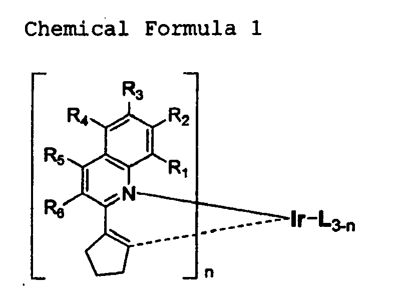 wherein, L is an organic ligand;

R₁ through R₆ independently represent hydrogen, (C1-C60)alkyl, (C1-C60)alkoxy, (C3-C60)cycloalkyl, a 5- or 6-membered heterocycloalkyl containing oxygen, nitrogen or sulfur, (C6-C60)aryl, (C5-C60)heteroaryl, halogen, mono or di(C1-C6)alkylamino, mono or di(C6-C60)arylamino, tri(C1-C60)alkylsilyl, di(C1-C60)alkyl(C6-C60)arylsilyl or tri(C6-C60)arylsilyl, or each of R₁ through R₆ may be linked to another adjacent group from R₁ through R₆ via (C3-C12)alkylene or (C3-C12)alkenylene with or without a fused ring to form an alicyclic ring, or a monocyclic or polycyclic aromatic ring;
the alkyl, alkoxy, cycloalkyl, aryl, heteroaryl of R₁ through R₆, or the alicyclic ring, or the monocyclic or polycyclic aromatic ring formed therefrom by linkage via (C3-C12) alkylene or (C3-C12)alkenylene may be further substituted by one or more substituent(s) selected from (C1-C60)alkyl with or without halogen substituent(s), halogen, cyano, tri(C1-C60)alkylsilyl, di(C1-C60)alkyl(C6-C60)arylsilyl, tri(C6-C60)arylsilyl, (C1-C60)alkoxy, (C3-C60)cycloalkyl, mono or di(C1-C60)alkylamino, mono or di(C6-C60)arylamino, (C1-C60)alkylcarbonyl, (C6-C60)arylcarbonyl and (C6-C60)aryl; and
n is an integer from 1 to 3.

### BRIEF DESCRIPTION OF THE DRAWINGS

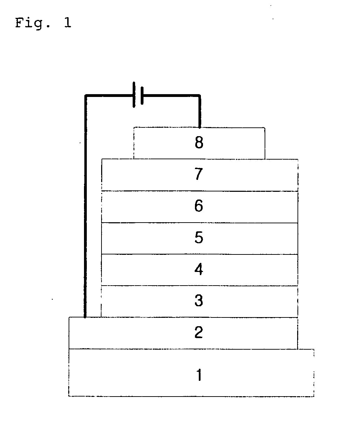

Fig. 1 is a cross-sectional view of an OLED.

### DETAILED DESCRIPTION OF THE INVENTION

Referring now to the Drawings, Fig. 1 illustrates a cross-sectional view of an OLED comprising a Glass 1, a Transparent electrode 2, a Hole injection layer 3, a Hole transport layer 4, an Electroluminescent layer 5, an Electron transport layer 6, an Electron injection layer 7 and an A1 cathode 8.

The term "alkyl" described herein and any substituents comprising "alkyl" moiety include both linear and branched species.

The term "aryl" described herein means an organic radical derived from aromatic hydrocarbon via elimination of one hydrogen atom. Each ring comprises a monocyclic or fused ring system containing from 4 to 7, preferably from 5 to 6 cyclic atoms. Specific examples include phenyl, naphthyl, biphenyl, anthryl, indenyl, fluorenyl, phenanthryl, triphenylenyl, pyrenyl, perylenyl, chrysenyl, naphthacenyl and fluoranthenyl, but they are not restricted thereto.

The term "heteroaryl" described herein means an aryl group containing from 1 to 4 heteroatom(s) selected from N, O and S as the aromatic cyclic backbone atom(s), and carbon atom(s) for remaining aromatic cyclic backbone atoms. The heteroaryl may be a 5- or 6-membered monocyclic heteroaryl or a polycyclic heteroaryl which is fused with one or more benzene ring(s), and may be partially saturated. The heteroaryl group may comprise a bivalent aryl group, of which the heteroatoms may be oxidized or quaternized to form N-oxide and quaternary salt. Specific examples include monocyclic heteroaryl groups such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl; polycyclic heteroaryl groups such as benzofuranyl, benzothiophenyl, isobenzofuranyl, benzimidazolyl, benzothiazolyl, benzisothiazolyl, benzisoxazolyl, benzoxazolyl, isoindolyl, indolyl, indazolyl, benzothiadiazolyl, quinolyl, isoquinolyl, cinnolinyl, quinazolinyl, quinoxalinyl, carbazolyl, phenanthridinyl and benzodioxolyl; and corresponding N-oxides (for example, pyridyl N-oxide, quinolyl N-oxide) and quaternary salts thereof; but they are not restricted thereto.

The naphthyl of Chemical Formula (1) may be 1-naphthyl or 2-naphthyl; the anthryl may be 1-anthryl, 2-anthryl or 9-anthryl; and the fluorenyl may be 1-fluorenyl, 2-fluorenyl, 3-fluorenyl, 4-fluorenyl or 9-fluorenyl.

The substituents comprising "(C1-C60)alkyl" moiety described herein may contain 1 to 60 carbon atoms, 1 to 20 carbon atoms, or 1 to 10 carbon atoms. The substituents comprising "(C6-C60)aryl" moiety may contain 6 to 60 carbon atoms, 6 to 20 carbon atoms, or 6 to 12 carbon atoms. The substituents comprising "(C3-C60)heteroaryl" moiety may contain 3 to 60 carbon atoms, 4 to 20 carbon atoms, or 4 to 12 carbon atoms. The substituents comprising "(C3-C60)cycloalkyl" moiety may contain 3 to 60 carbon atoms, 3 to 20 carbon atoms, or 3 to 7 carbon atoms. The substituents comprising "(C2-C60)alkenyl or alkynyl" moiety may contain 2 to 60 carbon atoms, 2 to 20 carbon atoms, or 2 to 10 carbon atoms.

The compound within the square bracket ([]) serves as a primary ligand of iridium, and L serves as a subsidiary ligand. The organic electroluminescent compounds according to the present invention also include the complex with the ratio of primary ligand: subsidiary ligand = 2:1 (n=2) and the complex with the ratio of primary ligand: subsidiary ligand = 1:2 (n=1), as well as the tris-chelated complexes without subsidiary ligand (L) (n=3).

In the compounds represented by Chemical Formula (1) according to the invention, R₁ through R₆ independently represent hydrogen, methyl, ethyl, n-propyl, i-propyl, n-butyl, i-butyl, t-butyl, n-pentyl, i-pentyl, n-hexyl, n-heptyl, n-octyl, ethylhexyl, trifluoromethyl, methoxy, ethoxy, butoxy, cyclopropyl, cyclobutyl, cyclopentyl, cyclohexyl, cycloheptyl, morpholine, fluoro, phenyl, naphthyl, anthryl, fluorenyl, spirobifluorenyl, furyl, pyrrolyl, imidazolyl, pyrazolyl, thiazolyl, pyridyl, quinolyl, thiophenyl, dimethylamino, methylethylamino, diphenylamino, trimethylsilyl, triethylsilyl, tripropylsilyl, tri(t-butyl)silyl, t-butyldimethylsilyl or triphenylsilyl; and the phenyl, naphthyl, anthryl, fluorenyl, furyl, pyrrolyl, imidazolyl, pyrazolyl, thiazolyl, pyridyl, quinolyl and thiophenyl of R₁ through R₆ may be further substituted by one or more substituent(s) selected from methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, trifluoromethyl, fluoro, cyano, trimethylsilyl, tripropylsilyl, tri(t-butyl)silyl, t-butyldimethylsilyl, triphenylsilyl, methoxy, ethoxy, butoxy, cyclopropyl, cyclobutyl, cyclopentyl, cyclohexyl, cycloheptyl, dimethylamino, diphenylamino, methylcarbonyl, ethylcarbonyl, t-butylcarbonyl, phenylcarbonyl, phenyl, naphthyl, anthryl and fluorenyl.

The organic electroluminescent compounds according to the present invention can be specifically exemplified by the following compounds, but they are not restricted thereto: 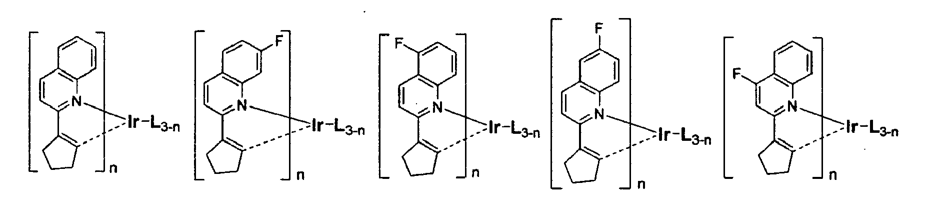 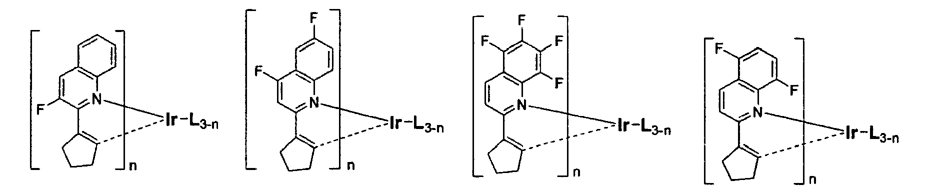 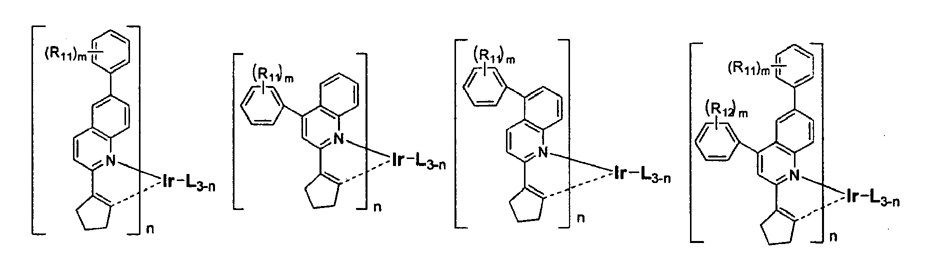 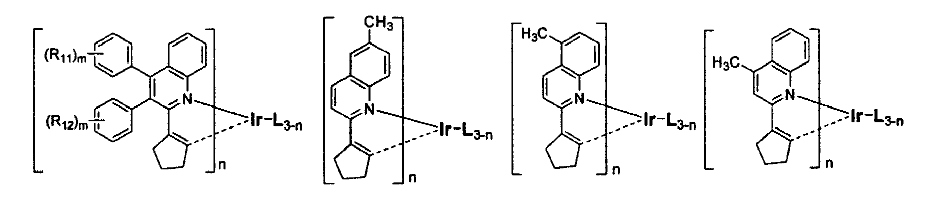 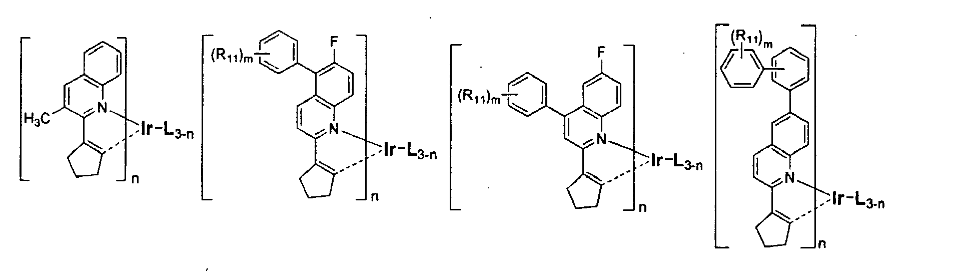 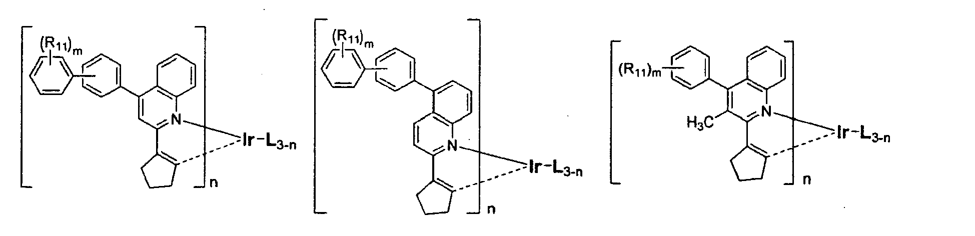 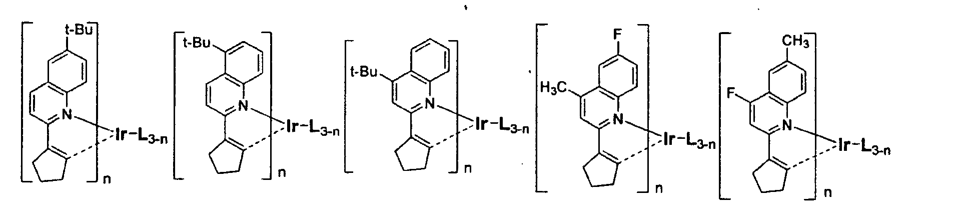 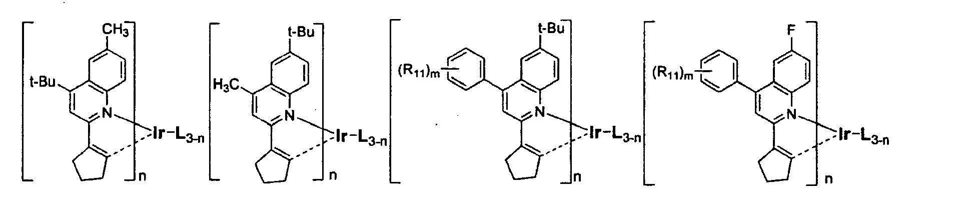 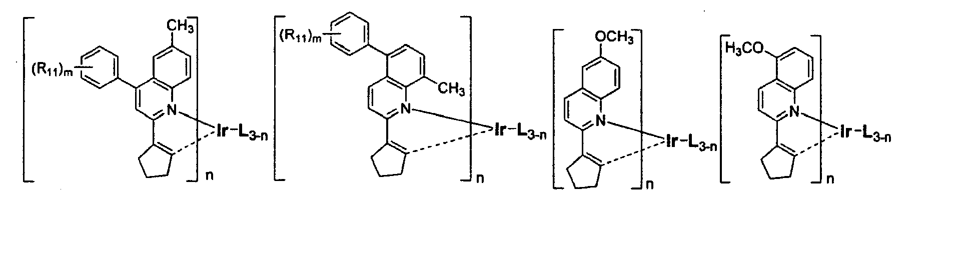 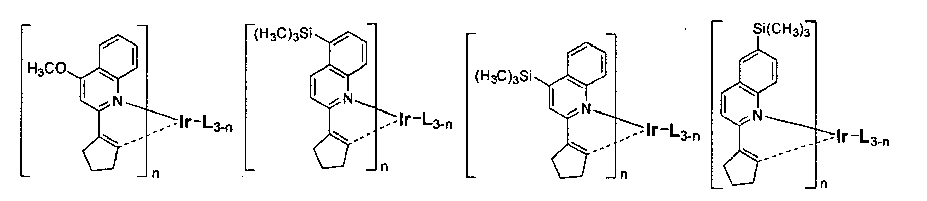 wherein, L represents an organic ligand;
R₁₁ and R₁₂ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, trifluoromethyl, fluoro, cyano, trimethylsilyl, tripropylsilyl, tri(t-butyl)silyl, t-butyldimethylsilyl, triphenylsilyl, methoxy, ethoxy, butoxy, cyclopropyl, cyclobutyl, cyclopentyl, cyclohexyl, cycloheptyl, dimethylamino, diphenylamino, methylcarbonyl, ethylcarbonyl, t-butylcarbonyl, phenylcarbonyl, phenyl, naphthyl, anthryl or fluorenyl;
n is an integer from 1 to 3; and
m is an integer from 1 to 5.

The subsidiary ligands (L) of the organic electroluminescent compounds according to the present invention include the following structures: 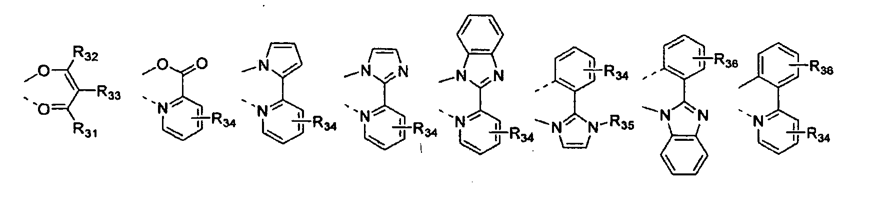 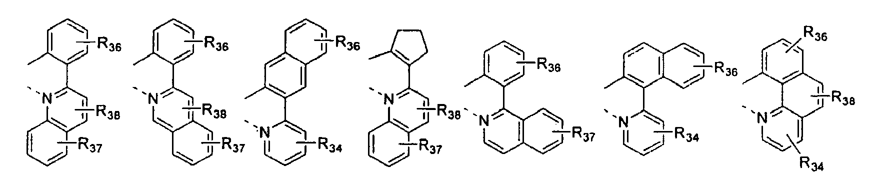 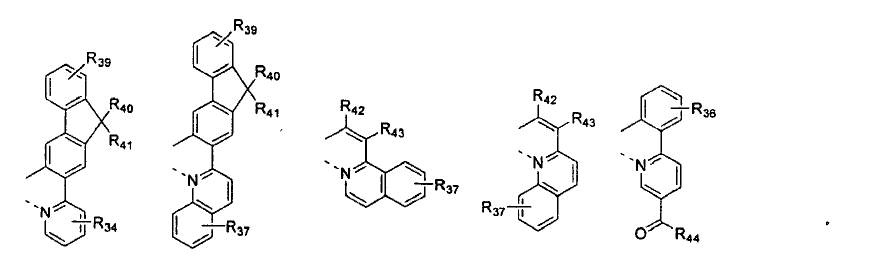 wherein, R₃₁ and R₃₂ independently represent hydrogen, (C1-C60)alkyl with or without halogen substituent(s), phenyl with or without (C1-C60)alkyl substituent(s), or halogen;
R₃₃ through R₃₉ independently represent hydrogen, (C1-C60)alkyl, phenyl with or without (C1-C60)alkyl substituent(s), tri(Cl-C60)alkylsilyl or halogen;
R₄₀ through R₄₃ independently represent hydrogen, (C1-C60)alkyl, phenyl with or without (C1-C60)alkyl substituent(s); and
R₄₄ represents (C1-C60)alkyl, phenyl with or without (C1-C60)alkyl substituent(s), or halogen.

The subsidiary ligands (L) of the organic electroluminescent compounds according to the present invention can be exemplified by the following structures, but they are not restricted thereto:

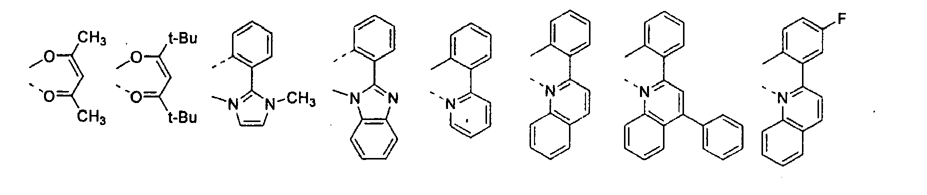

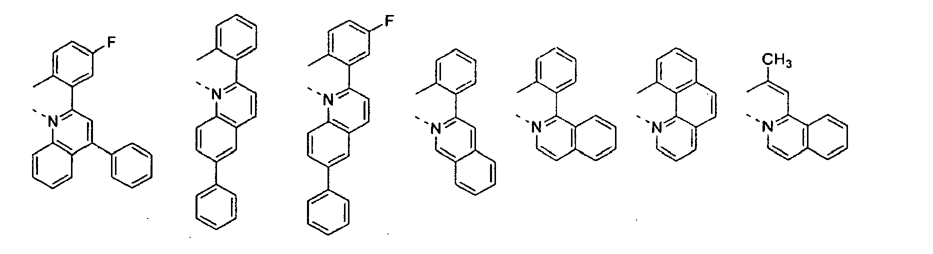

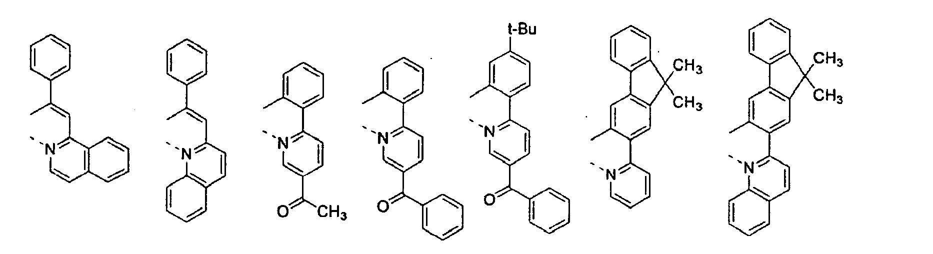

The processes for preparing the organic electroluminescent compounds according to the present invention are described by referring to Reaction Schemes (1) to (3) shown below: 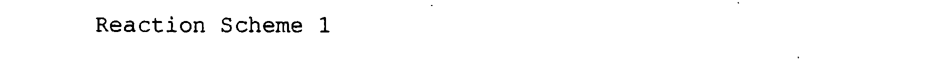 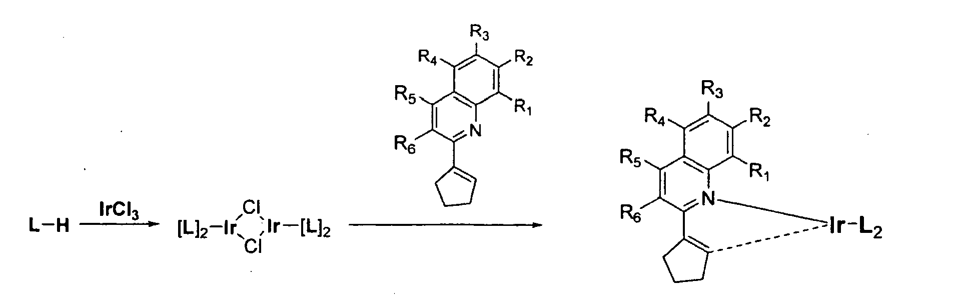 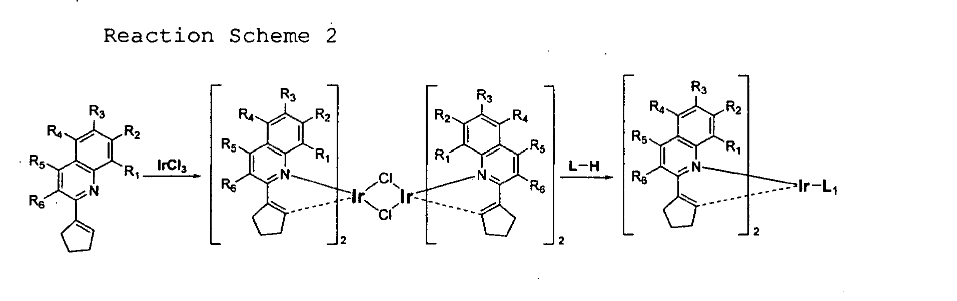 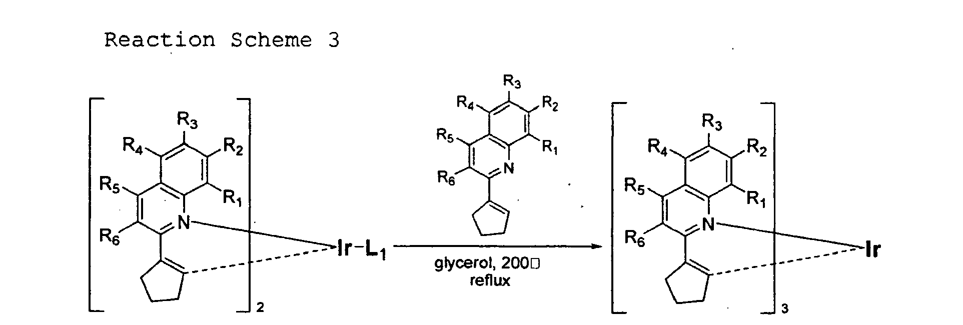 wherein, R₁, R₂, R₃, R₄, R₅, R₆ and L are defined as in Chemical Formula (1).

Reaction Scheme (1) provides a compound of Chemical Formula (1) with n=1, in which iridium trichloride (IrCl₃) and subsidiary ligand compound (L-H) are mixed in a solvent at a molar ratio of 1:2∼3, and the mixture is heated under reflux before isolating diiridium dimer. In the reaction stage, preferable solvent is alcohol or a mixed solvent of alcohol/water, such as 2-ethoxyethanol, and 2-ethoxyethanol/water mixtures. The isolated diiridium dimer is then heated with a primary ligand compound in organic solvent to provide an organic phosphorescent iridium compound having the ratio of primary ligand: subsidiary ligand of 1:2 as the final product. The reaction is carried out with AgCF₃SO₃, Na₂CO₃ or NaOH being admixed with organic solvent such as 2-ethoxyethanol and 2-methoxyethylether.

Reaction Scheme (2) provides a compound of Chemical Formula (1) with n=2, in which iridium trichloride (IrCl₃) and a primary ligand compound are mixed in a solvent at a molar ratio of 1:2∼3, and the mixture is heated under reflux before isolating diiridium dimer. In the reaction stage, preferable solvent is alcohol or a mixed solvent of alcohol/water, such as 2-ethoxyethanol, and 2-ethoxyethanol/water mixtures. The isolated diiridium dimer is then heated with the subsidiary ligand compound (L-H) in organic solvent to provide an organic phosphorescent iridium compound having the ratio of primary ligand: subsidiary ligand of 2:1 as the final product. The molar ratio of the primary ligand compound and the subsidiary ligand (L) in the final product is determined by appropriate molar ratio of the reactant depending on the composition. The reaction may be carried out with AgCF₃SO₃, Na₂CO₃ or NaOH being admixed with organic solvent such as 2-ethoxyethanol, 2-methoxyethylether and 1,2-dichloroethane.

Reaction Scheme (3) provides a compound of Chemical Formula (1) with n=3, in which iridium complex prepared according to Reaction Scheme (2) and the primary ligand compound are mixed in glycerol at a molar ratio of 1:2∼3, and the mixture is heated under reflux to obtain organic phosphorescent iridium complex coordinated with three primary ligands.

The compounds employed as a primary ligand in the present invention can be prepared according to Reaction Scheme (4), on the basis of conventional processes, but it is not restrictive: 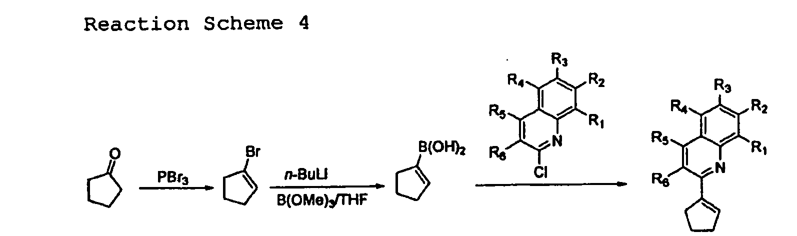 wherein, R₁ through R₆ are defined as in Chemical Formula (1).

The present invention also provides an organic electroluminescent device which is comprised of a first electrode; a second electrode; and at least one organic layer(s) interposed between the first electrode and the second electrode; wherein the organic layer comprises one or more compound(s) represented by Chemical Formula (1).

The organic electroluminescent device according to the present invention is **characterized in that** the organic layer comprises an electroluminescent region, which comprises one or more organic electroluminescent compound(s) represented by Chemical Formula (1) as electroluminescent dopant in an amount of 0.01 to 10% by weight, and one or more host(s). The host applied to the organic electroluminescent device according to the invention is not particularly restricted, but may be exemplified by 1,3,5-tricarbazolylbenzene, polyvinylcarbazole, m-biscarbazolylphenyl, 4,4'4"-tri(N-carbazolyl)triphenylamine, 1,3,5-tri(2-carbazolylphenyl)benzene, 1,3,5-tris(2-carbazolyl-5-methoxyphenyl)benzene, bis(4-carbazolylphenyl)silane or the compounds represented by one of Chemical Formulas (2) to (5):

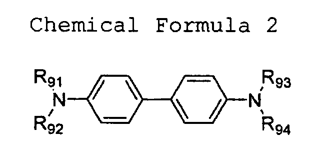

In Chemical Formula (2), R₉₁ through R₉₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₉₁ through R₉₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, or arylamino of R₉₁ through R₉₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5-or 6-membered heterocycloalkyl containing one or more heteroatom(s) selected from N, O and S, (C3-C60)cycloalkyl, tri(C1-C60)alkylsilyl, di(C-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

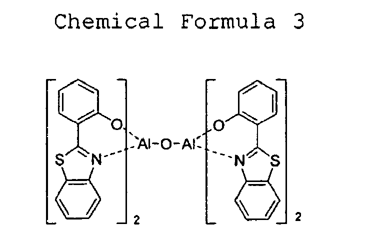

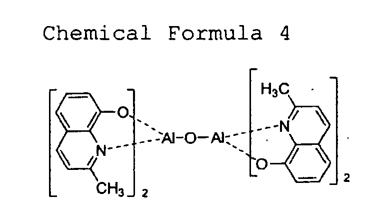

Chemical Formula 5 L¹L²M¹(Q)_{y}

In Chemical Formula (5), the ligands, L¹ and L² are independently selected from the following structures: 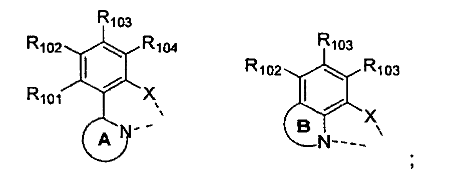 M¹ is a bivalent or trivalent metal;
y is 0 when M¹ is a bivalent metal, while y is 1 when M¹ is a trivalent metal;
Q represents (C6-C60)aryloxy or tri(C6-C60)arylsilyl, and the aryloxy and triarylsilyl of Q may be further substituted by (C1-C60)alkyl or (C6-C60)aryl;
X represents O, S or Se;
ring A represents oxazole, thiazole, imidazole, oxadiazole, thiadiazole, benzoxazole, benzothiazole, benzimidazole, pyridine or quinoline;
ring B represents pyridine or quinoline, and ring B may be further substituted by (C1-C60)alkyl, or phenyl or naphthyl with or without (C1-C60)alkyl substituent(s);
R₁₀₁ through R₁₀₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring; and the pyridine or quinoline may form a chemical bond with R₁₀₁ to form a fused ring;
the alkyl, alkenyl, alkynyl, cycloalkyl, heterocycloalkyl, aryl, heteroaryl, arylsilyl, alkylsilyl, alkylamino, or arylamino of ring A and R₁₀₁ through R₁₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5-or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

The ligands, L¹ and L² are independently selected from the following structures: 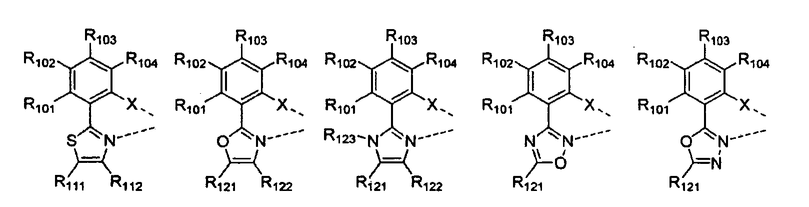 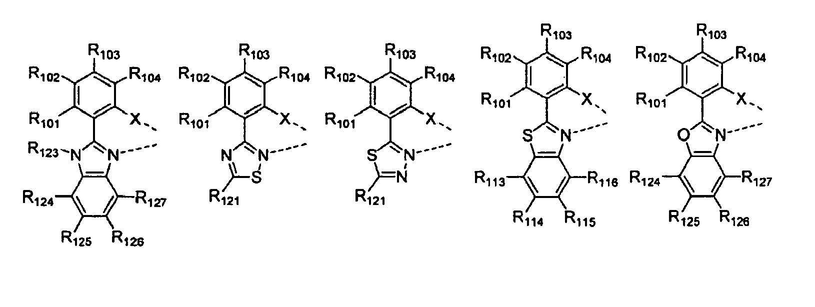 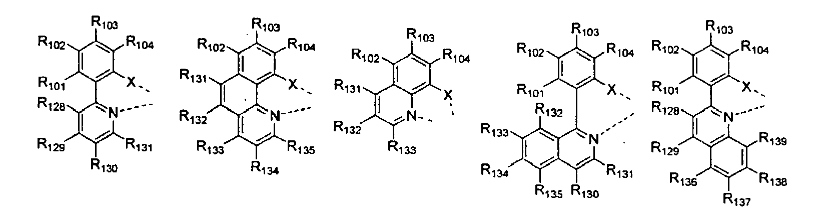 wherein, X represents O, S or Se;
R₁₀₁ through R₁₀₄ independently represent hydrogen, halogen, (C1-C60)alkyl, (C6-C60)aryl, (C4-C60)heteroaryl, a 5- or 6-membered heterocycloalkyl containing one or more heteroatoin(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring;
R₁₁₁ through R₁₁₆ and R₁₂₁ through R₁₃₉ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₁₁ through R₁₁₆ and R₁₂₁ through R₁₃₉ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino or arylamino of R₁₀₁ through R₁₀₄, R₁₁₁ through R₁₁₆, and R₁₂₁ through R₁₃₉, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

In Chemical Formula (5), M¹ is a bivalent metal selected from Be, Zn, Mg, Cu and Ni, or a trivalent metal selected from A1, Ga, In and B, and Q is selected from the following structures.

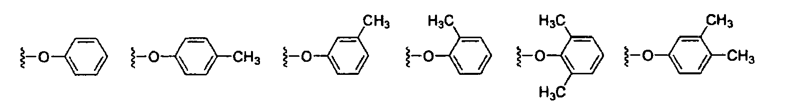

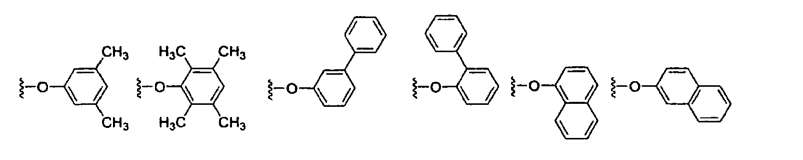

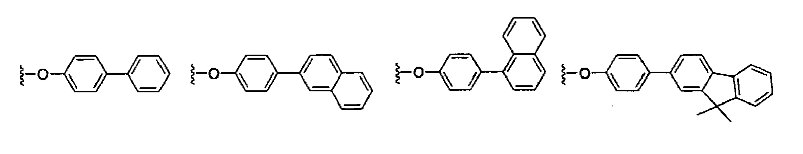

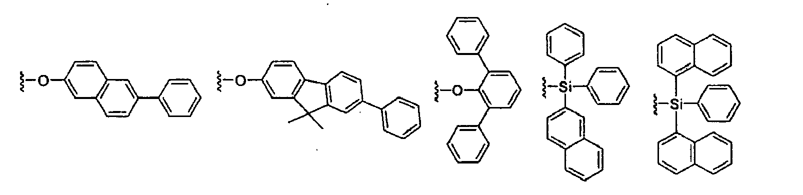

The compounds of Chemical Formula (2) may be specifically exemplified by the compounds represented by the following structures, but they are not restricted thereto.

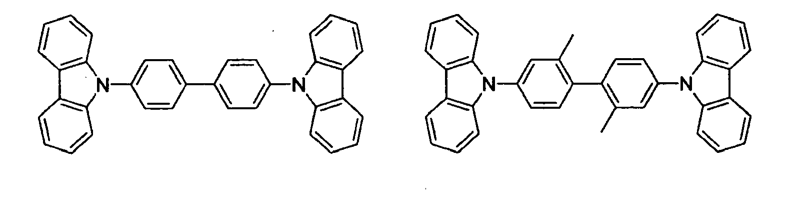

The compounds represented by one of Chemical Formulas (3) to (5) may be specifically exemplified by the compounds with one of the following structures, but they are not restricted thereto.

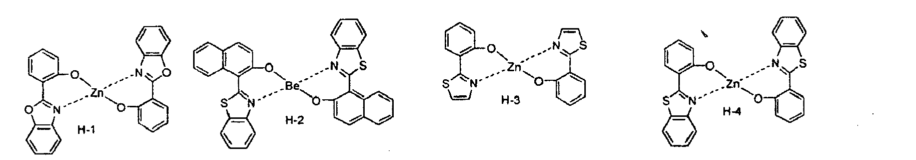

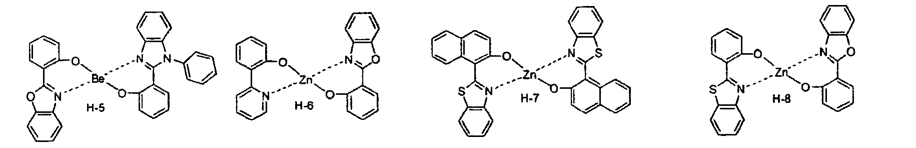

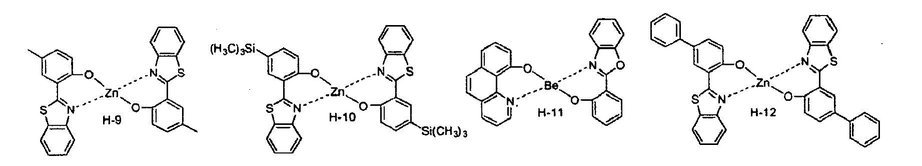

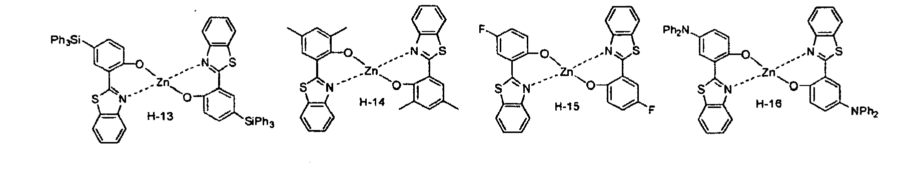

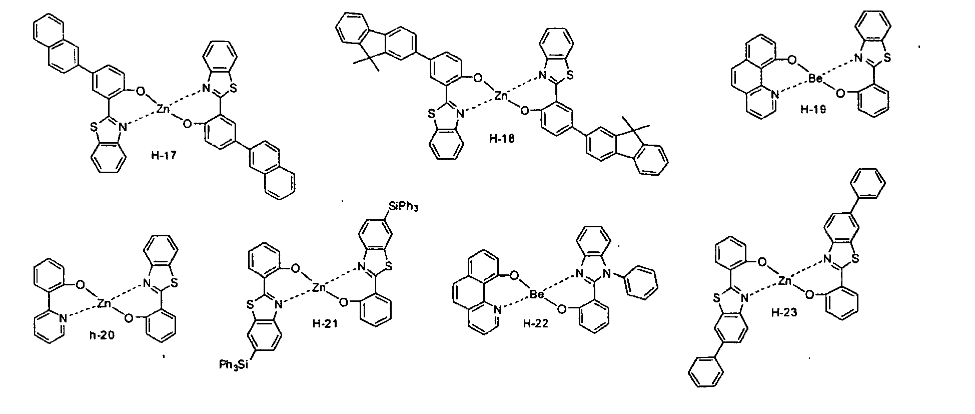

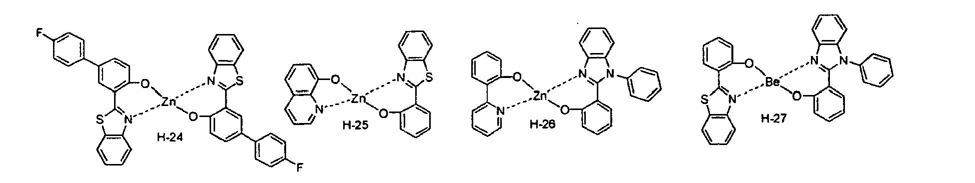

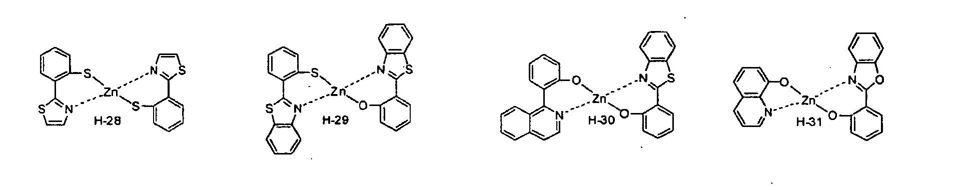

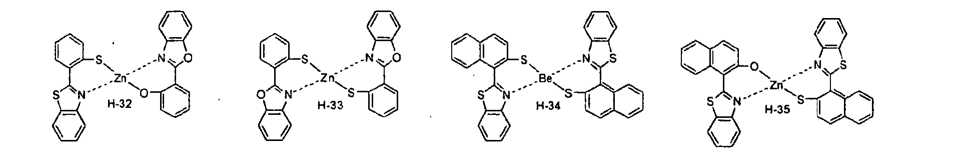

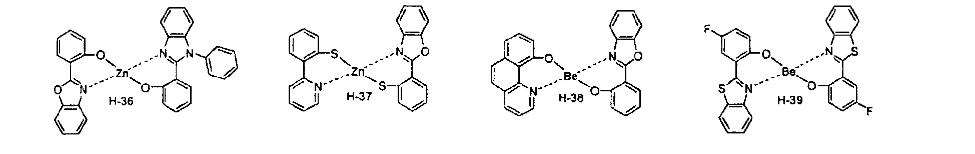

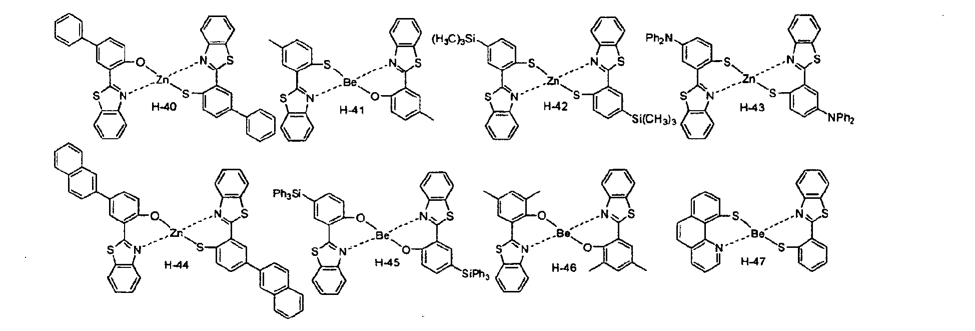

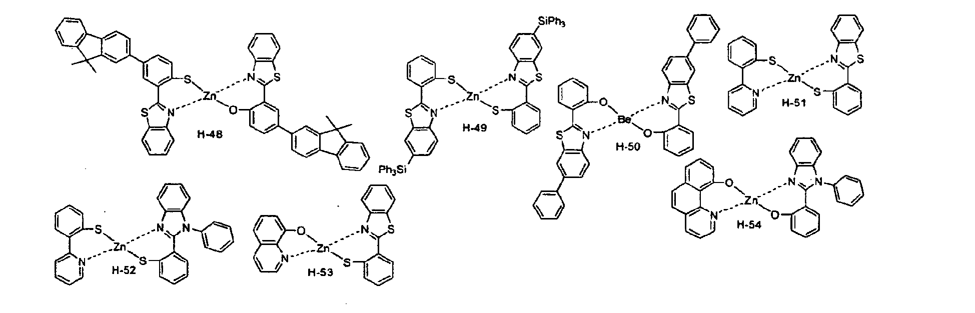

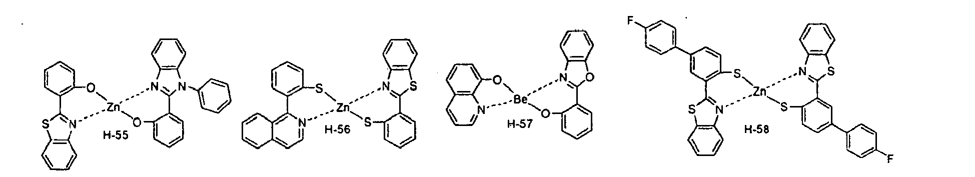

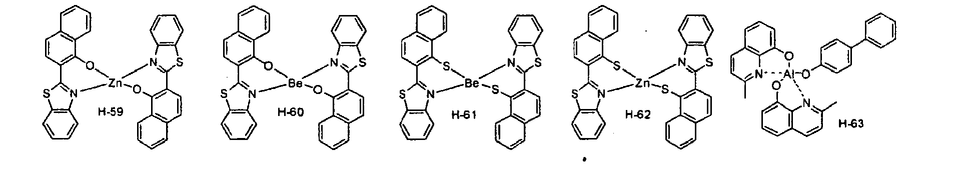

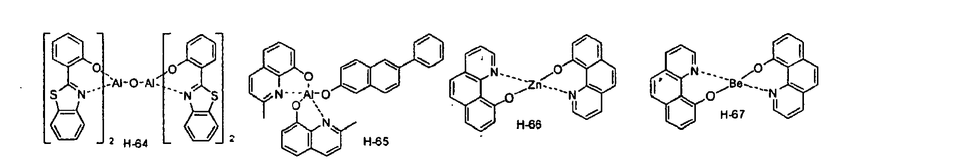

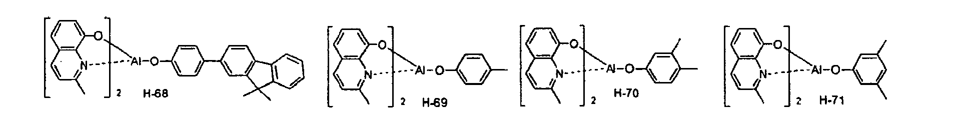

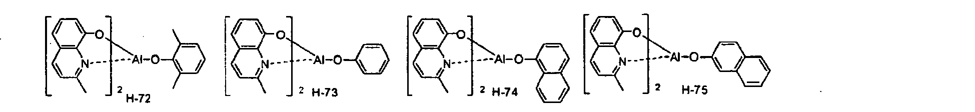

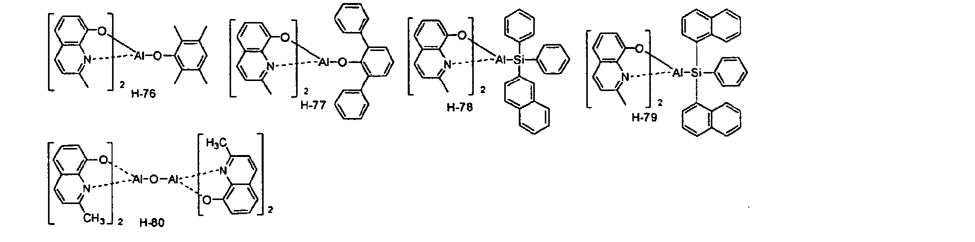

The electroluminescent layer means the layer where electroluminescence occurs, and it may be a single layer or a multi-layer consisting of two or more layers laminated. When a mixture of host-dopant is used according to the construction of the present invention, noticeable improvement in device life as well as in luminous efficiency could be confirmed.

The organic electroluminescent device according to the invention may further comprise one or more compound(s) selected from arylamine compounds and styrylarylamine compounds, as well as the organic electroluminescent compound represented by Chemical Formula (1). Examples of arylamine or styrylarylamine compounds include the compounds represented by Chemical Formula (6), but they are not restricted thereto: 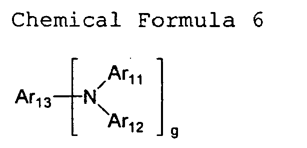 wherein, Ar₁₁ and Ar₁₂ independently represent (C1-C60)alkyl, (C6-C60)aryl, (C4-C60)heteroaryl, (C6-C60)arylamino, (C1-C60)alkylamino, a 5- or 6-membered heterocycloalkyl containing one or more heteroatom(s) selected from N, O and S, or (C3-C60)cycloalkyl, or Ar₁₁ and Ar₁₂ may be linked via (C3-C60)alkylene or (C3-C60)alkenylene with or without a fused ring to form an alicyclic ring, or a monocyclic or polycyclic aromatic ring;
when g is 1, Ar₁₃ represents (C6-C60)aryl, (C4-C60)heteroaryl, or an aryl represented by one of the following structural formulas: 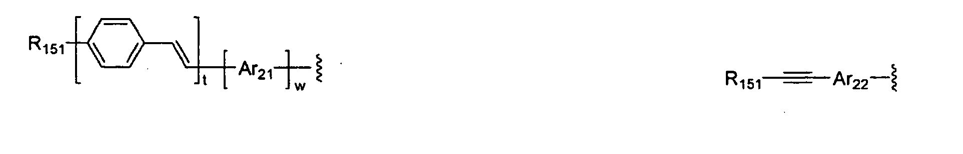 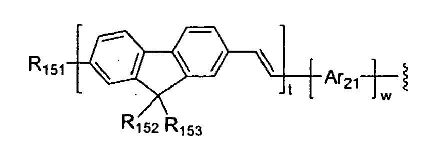 when g is 2, Ar₁₃ represents (C6-C60)arylene, (C4-C60)heteroarylene, or an arylene represented by one of the following structural formulas: 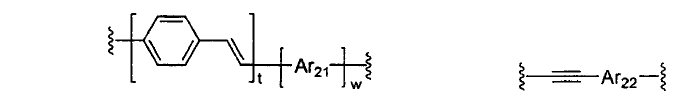 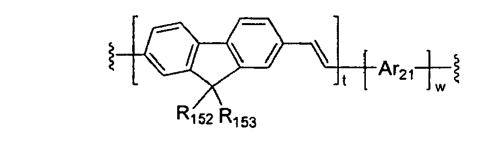 wherein Ar₂₁ and Ar₂₂ independently represent (C6-C60)arylene or (C4-C60)heteroarylene;
R₁₅₁, R₁₅₂ and R₁₅₃ independently represent hydrogen, (C1-C60)alkyl or (C6-C60)aryl;
t is an integer from 1 to 4, w is an integer of 0 or 1; and
the alkyl, aryl, heteroaryl, arylamino, alkylamino, cycloalkyl or heterocycloalkyl of Ar₁₁ and Ar₁₂, or the aryl, heteroaryl, arylene or heteroarylene of Ar₁₃, or the arylene or heteroarylene of Ar₂₁ and Ar₂₂, or the alkyl or aryl of R₁₅₁ through R₁₅₃ may be further substituted by one or more substituent(s) selected from a group consisting of halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

The arylamine compounds and styrylarylamine compounds may be more specifically exemplified by the following compounds, but are not restricted thereto.

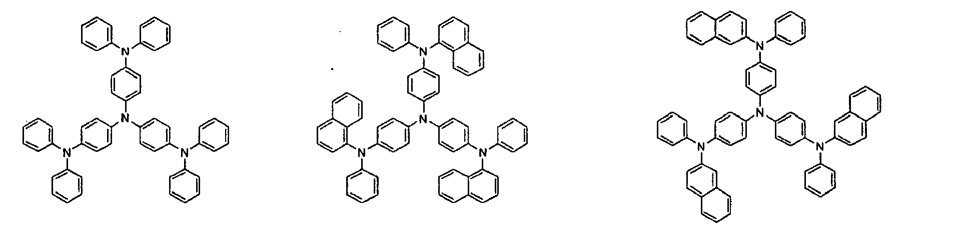

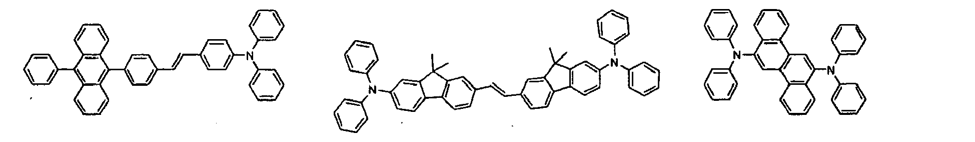

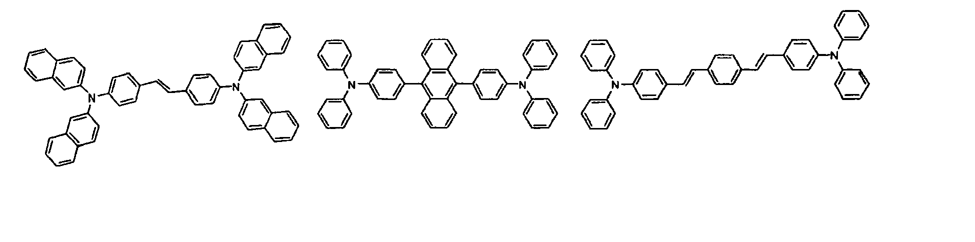

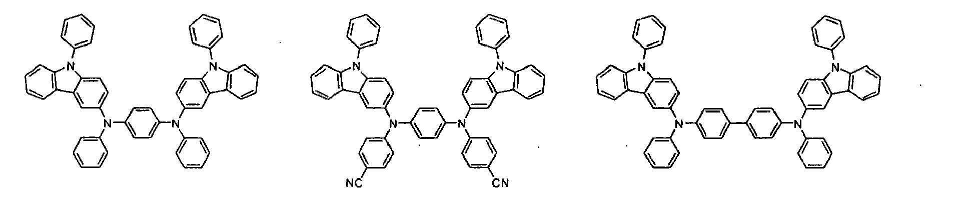

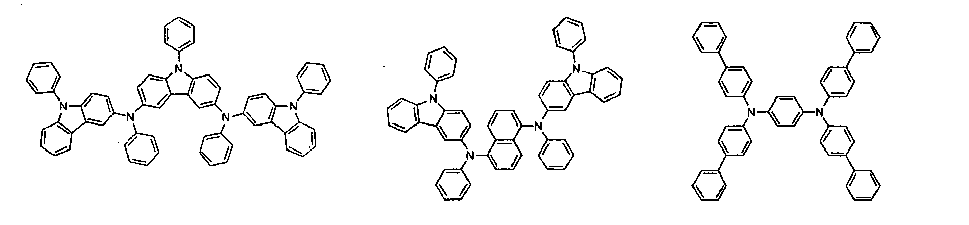

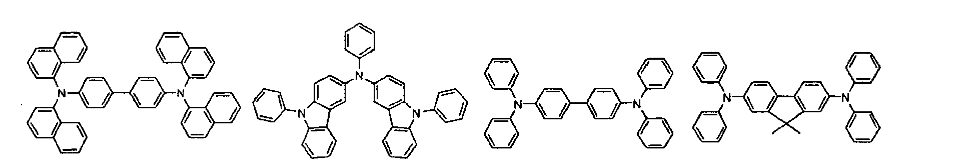

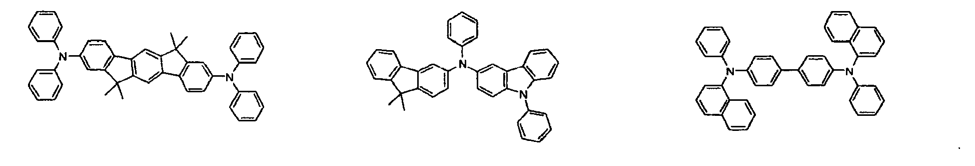

In an organic electroluminescent device according to the present invention, the organic layer may further comprise one or more metal(s) selected from a group consisting of organic metals of Group 1, Group 2, 4^{th} period and 5^{th} period transition metals, lanthanide metals and d-transition elements, as well as the organic electroluminescent compound represented by Chemical Formula (1). The organic layer may comprise a charge generating layer in addition to the electroluminescent layer.

The present invention can realize an electroluminescent device having a pixel structure of independent light-emitting mode, which comprises an organic electroluminescent device containing the compound of Chemical Formula (1) as a sub-pixel and one or more sub-pixel (s) comprising one or more compound(s) selected from a group consisting of arylamine compounds and styrylarylamine compounds, patterned in parallel at the same time.

Further, the organic electroluminescent device is an organic display which comprises one or more compound(s) selected from compounds having electroluminescent peak of wavelength of blue or green, at the same time. The compounds having electroluminescent peak of wavelength of blue or green may be exemplified by the compounds represented by one of Chemical Formulas (7) to (11), but they are not restricted thereto.

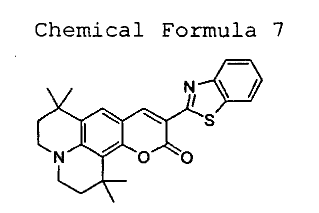

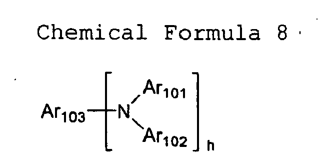

In Chemical Formula (8), Ar₁₀₁ and Ar₁₀₂ independently represent (C1-C60)alkyl, (C6-C60)aryl, (C4-C60)heteroaryl, (C6-C60)arylamino, (C1-C60)alkylamino, a 5- or 6-membered heterocycloalkyl containing one or more heteroatom(s) selected from N, O and S, or (C3-C60)cycloalkyl, or Ar₁₀₁ and Ar₁₀₂ may be linked via (C3-C60)alkylene or (C3-C60)alkenylene with or without a fused ring to form an alicyclic ring, or a monocyclic or polycyclic aromatic ring;
when h is 1, Ar₁₀₃ represents (C6-C60)aryl, (C4-C60)heteroaryl, or an aryl represented by one of the following structural formulas: 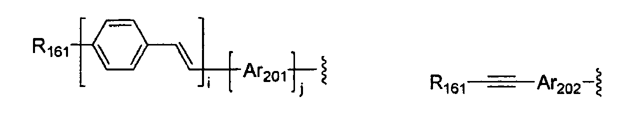 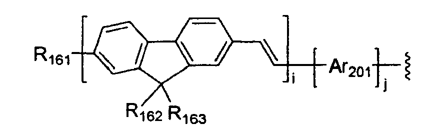 when h is 2, Ar₁₃ represents (C6-C60)arylene, (C4-C60)heteroarylene, or an arylene represented by one of the following structural formulas: 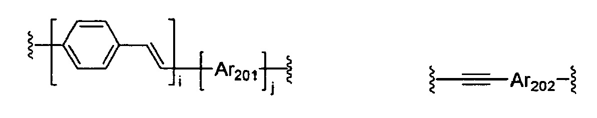 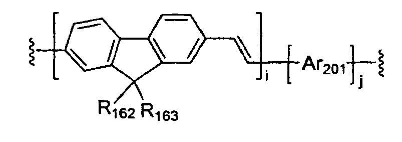 wherein Ar₂₀₁ and Ar₂₀₂ independently represent (C6-C60)arylene or (C4-C60)heteroarylene;
R₁₆₁, R₁₆₂ and R₁₆₃ independently represent hydrogen, (C1-C60)alkyl or (C6-C60)aryl;
i is an integer from 1 to 4, j is an integer of 0 or 1; and
the alkyl, aryl, heteroaryl, arylamino, alkylamino, cycloalkyl or heterocycloalkyl of Ar₁₀₁ and Ar₁₀₂, or the aryl, heteroaryl, arylene or heteroarylene of Ar₁₀₃, or the arylene or heteroarylene of Ar₂₀₁ and Ar₂₀₂, or the alkyl or aryl of R₁₆₁ through R₁₆₃ may be further substituted by one or more substituent(s) selected from a group consisting of halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(Cl-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

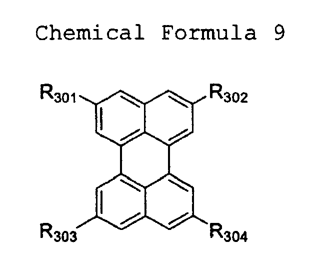

In Chemical Formula (9), R₃₀₁ through R₃₀₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₃₀₁ through R₃₀₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino or arylamino of R₃₀₁ through R₃₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

Chemical Formula 10 (Ar₃₀₁)ₚ-L₁₁-(Ar₃₀₂)_{q}

Chemical Formula 11 (Ar₃₀₃)ᵣ-L₁₂-(Ar₃₀₄)ₛ

In Chemical Formulas (10) and (11),
L₁₁ represents (C6-C60)arylene or (C4-C60)heteroarylene;
L₁₂ represents anthracenylene;
Ar₃₀₁ through Ar₃₀₄ are independently selected from hydrogen, (C1-C60)alkyl, (C1-C60)alkoxy, halogen, (C4-C60)heteroaryl, (C5-C60)cycloalkyl and (C6-C60)aryl, and the cycloalkyl, aryl or heteroaryl of Ar₃₀₁ through Ar₃₀₄ may be further substituted by one or more substituent(s) selected from a group consisting of (C6-C60)aryl or (C4-C60)heteroaryl with or without at least one substituent(s) selected from a group consisting of (C1-C60)alkyl, halo(C1-C60)alkyl, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
p, q, r and s independently represent an integer from 0 to 4.

The compounds represented by Chemical Formula (10) or (11) may be exemplified by the derivatives represented by one of Chemical Formulas (12) through (15).

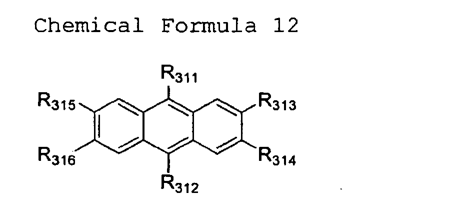

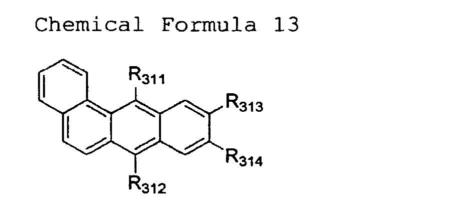

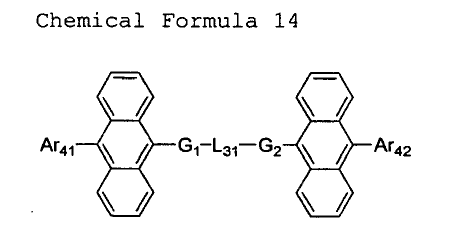

In Chemical Formulas (12) to (14), R₃₁₁ and R₃₁₂ independently represent (C6-C60)aryl, (C4-C60)heteroaryl or a 5- or 6-membered heterocycloalkyl containing one or more heteroatom(s) selected from N, O and S, or (C3-C60)cycloalkyl, and the aryl or heteroaryl of R₃₁₁ and R₃₁₂ may be further substituted by one or more substituent(s) selected from a group consisting of (C1-C60)alkyl, halo(C1-C60)alkyl, (C1 C60)alkoxy, (C3-C60)cycloalkyl, (C6-C60)aryl, (C4-C60)heteroaryl, halogen, cyano, tri(Cl-C60)alkylsilyl, di(C1-C60)alkyl(C6-C60)arylsilyl and tri(C6-C60)arylsilyl;
R₃₁₃ through R₃₁₆ independently represent hydrogen, (C1-C60)alkyl, (Cl-C60)alkoxy, halogen, (C4-C60)heteroaryl, (C5-C60)cycloalkyl or (C6-C60)aryl, and the heteroaryl, cycloalkyl or aryl of R₃₁₃ through R₃₁₆ may be further substituted by one or more substituent(s) selected from a group consisting of (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
G₁ and G₂ independently represent a chemical bond or (C6-C60)arylene with or without one or more substituent(s) selected from (C1-C60)alkyl, (C1-C60)alkoxy, (C6-C60)aryl, (C4-C60)heteroaryl and halogen;
Ar₄₁ and Ar₄₂ independently represents (C4-C60)heteroaryl or aryl selected from the following structures: 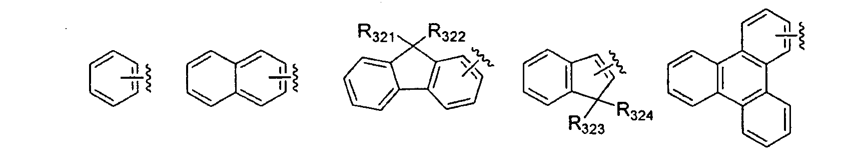 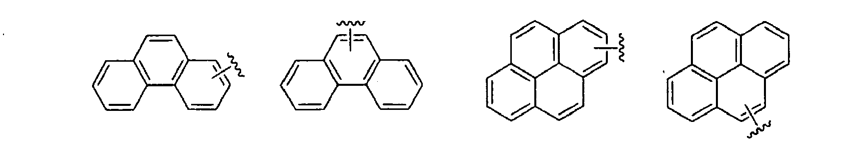 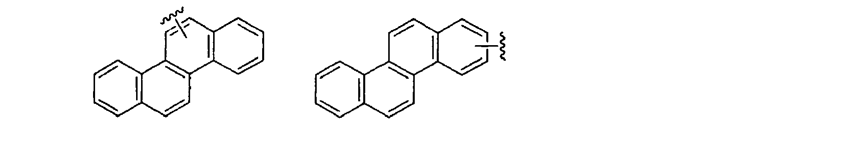 the aryl or heteroaryl of Ar₄₁ and Ar₄₂ may be substituted by one or more substituent(s) selected from (C1-C60)alkyl, (C1-C60)alkoxy, (C6-C60)aryl and (C4-C60)heteroaryl;

L₃₁ represents (C6-C60)arylene, (C4-C60)heteroarylene or a compound represented by the following structure: 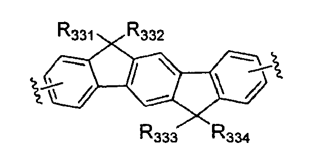 the arylene or heteroarylene of L₃₁ may be substituted by one or more substituent(s) selected from (C1-C60)alkyl, (C1-C60)alkoxy, (C6-C60)aryl, (C4-C60)heteroaryl and halogen;
R₃₂₁, R₃₂₂, R₃₂₃ and R₃₂₉ independently represent hydrogen, (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring;
R₃₃₁, R₃₃₂, R₃₃₃ and R₃₃₄ independently represent hydrogen, (C1-C60)alkyl, (C1-C60)alkoxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring, or a monocyclic or polycyclic aromatic ring.

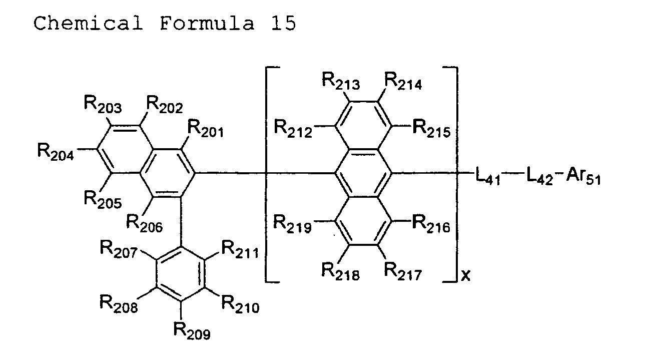

In Chemical Formula 15,
L₄₁ and L₄₂ independently represent a chemical bond, (C6-C60)arylene or (C3-C60)heteroarylene, and the arylene or heteroarylene of L₄₁ and L₄₂ may be further substituted by one or more substituent(s) selected from (C1-C60)alkykl, halogen, cyano, (C1-C60)alkoxy, (C3-C60)cycloalkyl, (C6-C60)aryl, (C3-C60)heteroaryl, tri(C1-C30)alkylsilyl, di(C1-C30)alkyl(C6-C30)arylsilyl and tri(C6-C30)arylsilyl;
R₂₀₁ through R₂₁₉ independently represent hydrogen, halogen, (C1-C60)alk (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₂₀₁ through R₂₁₉ may be linked to an adjacent substituent via (C3-C60)alkylene or (C3-C60)alkenylene with or without a fused ring to form an alicyclic ring, or a monocyclic or polycyclic aromatic ring;
Ar₅₁ represents (C6-C60)aryl, (C4-C60)heteroaryl, a 5- or 6-membered heterocycloalkyl containing one or more heteroatom(s) selected from N, O and S, (C3-C60)cycloalkyl, adamantyl, (C7-C60)bicycloalkyl, or a substituent selected from the following structures: 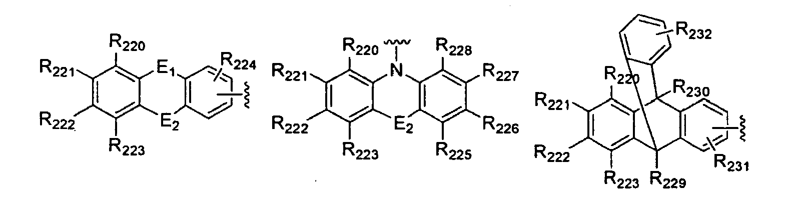 wherein, R₂₂₀ through R₂₃₂ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl;
E₁ and E₂ independently represent a chemical bond, - (CR₂₃₃R₂₃₄)_{z-}, -N(R₂₃₅)-, -S-, -O-, -Si(R₂₃₆)(R₂₃₇)-, -P(R₂₃₈)-, - C(=O)-, -B(R₂₃₉)-, -In(R₂₄₀)-, -Se-, -Ge(R₂₄₁)(R₂₄₂)-, - Sn(R₂₄₃) (R₂₄₄)-, -Ga(R₂₄₅)- or -C(R₂₄₆)=C(R₂₄₇)-;
R₂₃₃ through R₂₄₇ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60) alkenyl, (C2-C60)alkynyl, (C1-C60)alkoxy, cyano, (C1-C60)alkylamino, (C6-C60)arylamino, (C6-C60)ar(Cl-C60)alkyl, (C6-C60)aryloxy, (C6-C60)arylthio, (C1-C60)alkoxycarbonyl, carboxyl, nitro or hydroxyl, or each of R₂₃₃ through R₂₄₇ may be linked to an adjacent substituent via (C3-C60)alkylene or (C3-C60)alkenylene with or without a fused ring to form an alicyclic ring, or a monocyclic or polycyclic aromatic ring;
the aryl, heteroaryl, heterocycloalkyl, adamantyl or bicycloalkyl of Ar₅₁, or the alkyl, alkenyl, alkynyl, cycloalkyl, heterocycloalkyl, aryl, heteroaryl, arylsilyl, alkylsilyl, alkylamino or arylamino of R₂₀₁ through R₂₃₂ may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
x is an integer from 1 to 4; and
z is an integer from 0 to 4.

The organic compounds and organometallic compounds with green or blue electroluminescence can be more specifically exemplified by the following compounds, but they are not restricted thereto.

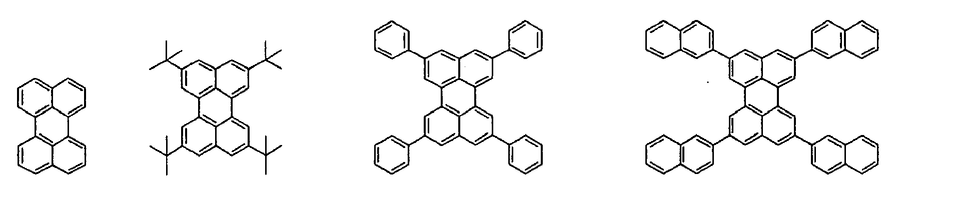

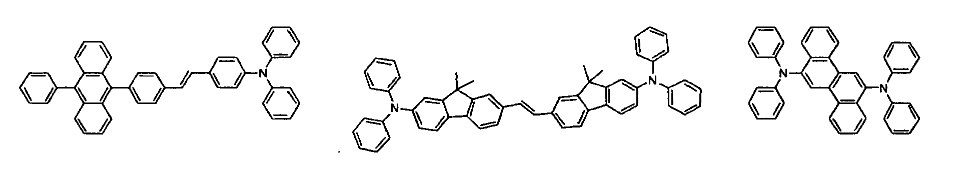

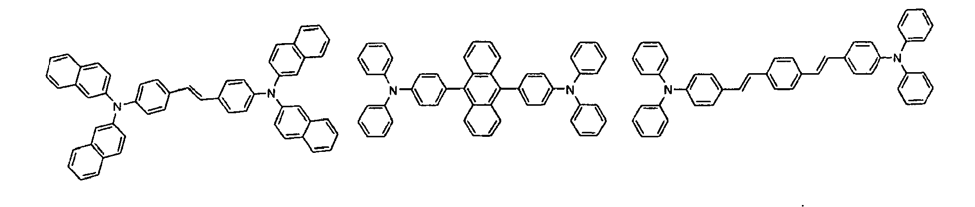

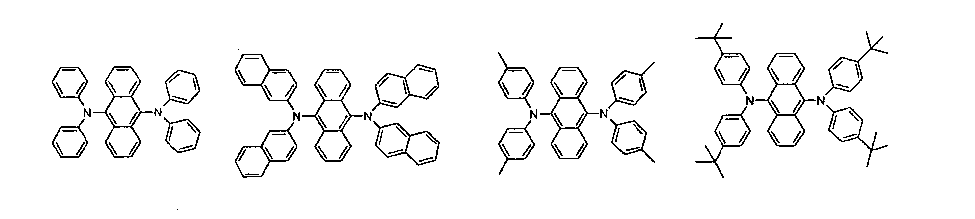

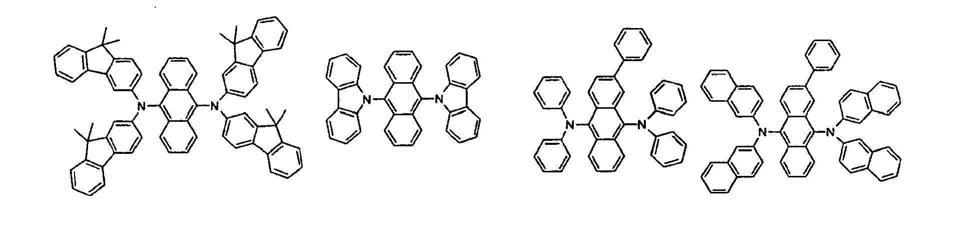

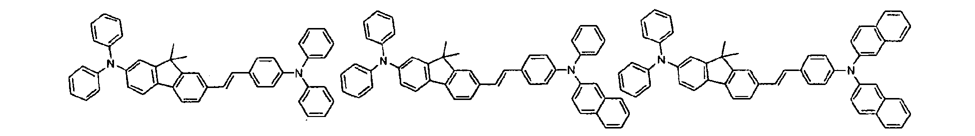

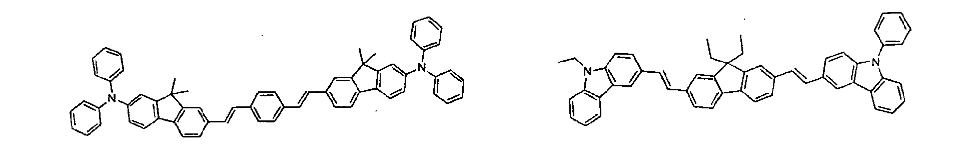

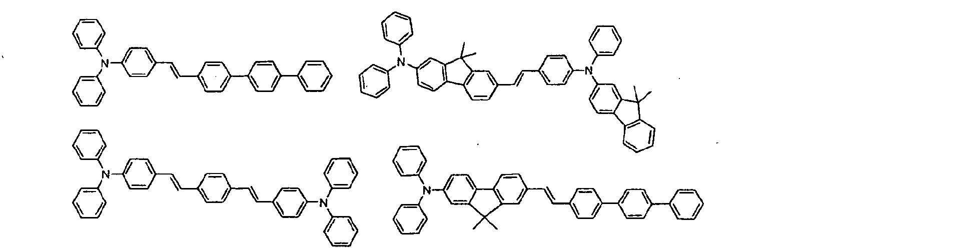

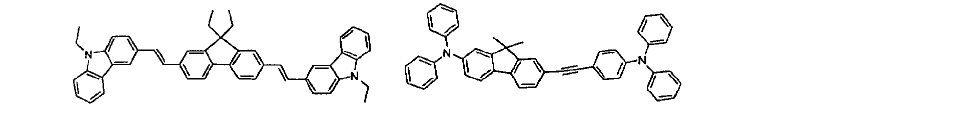

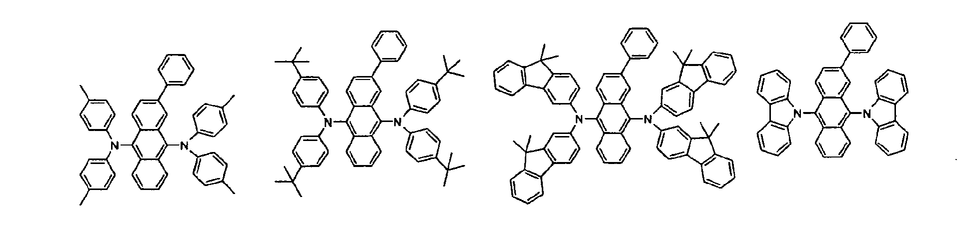

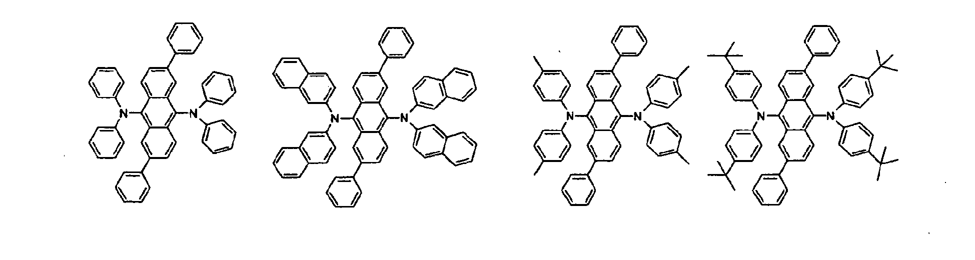

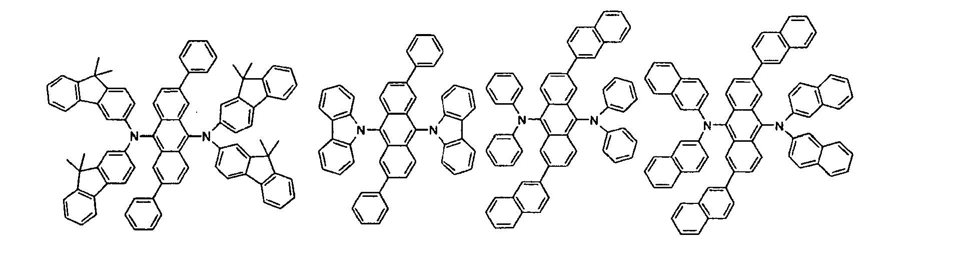

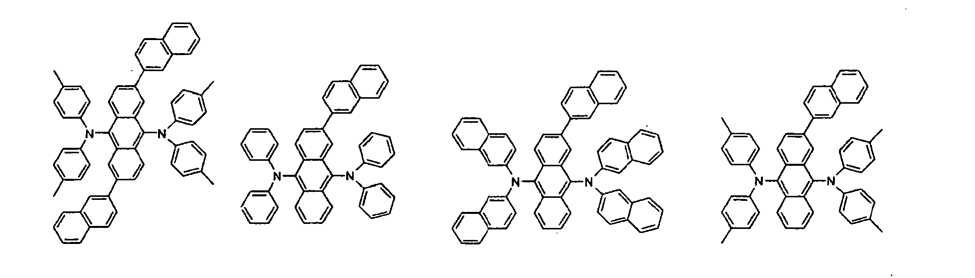

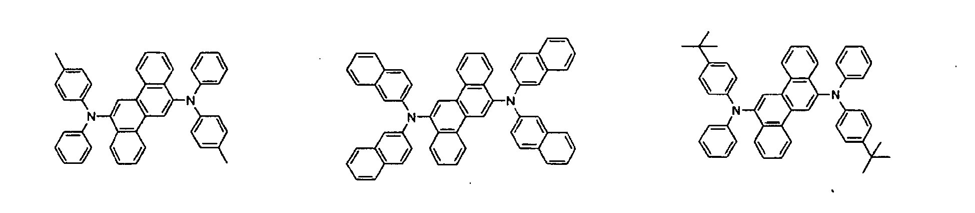

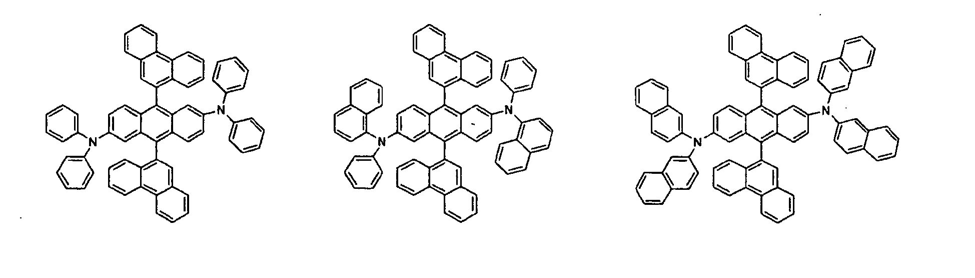

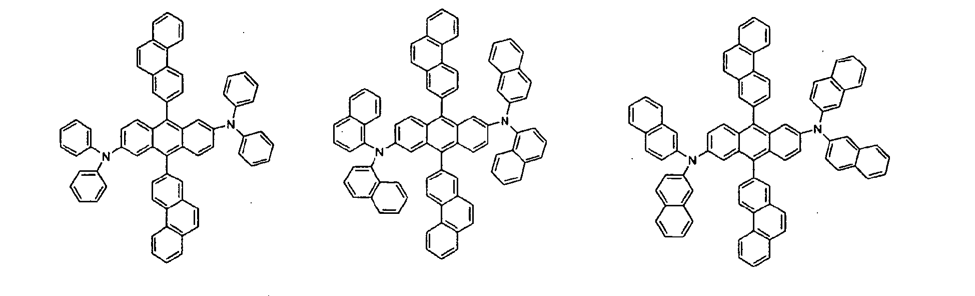

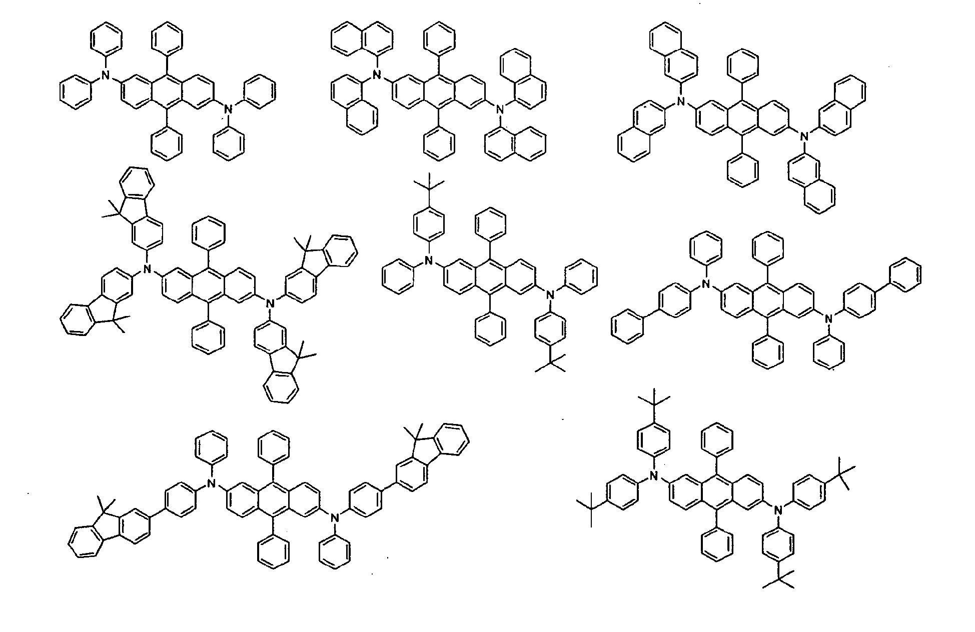

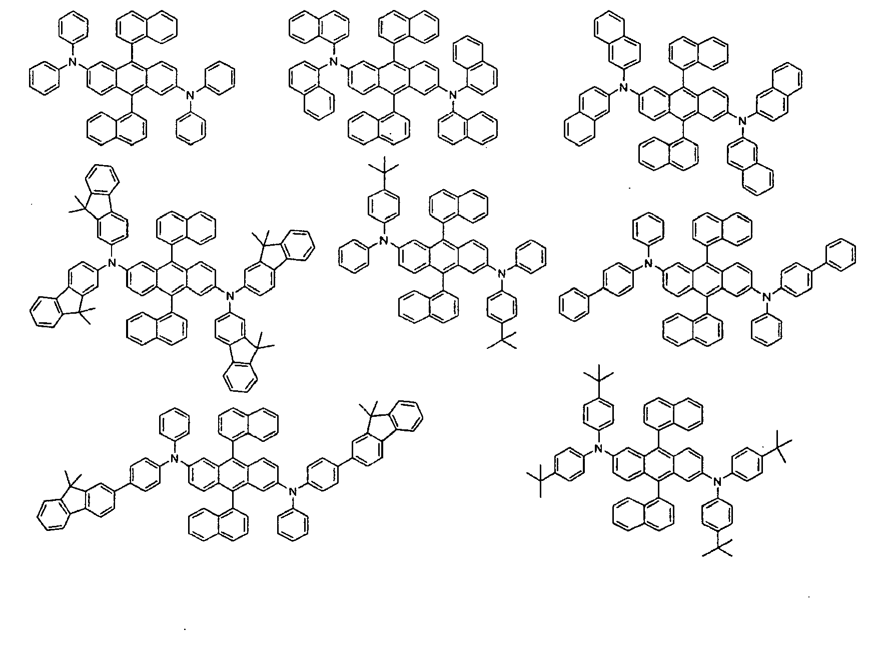

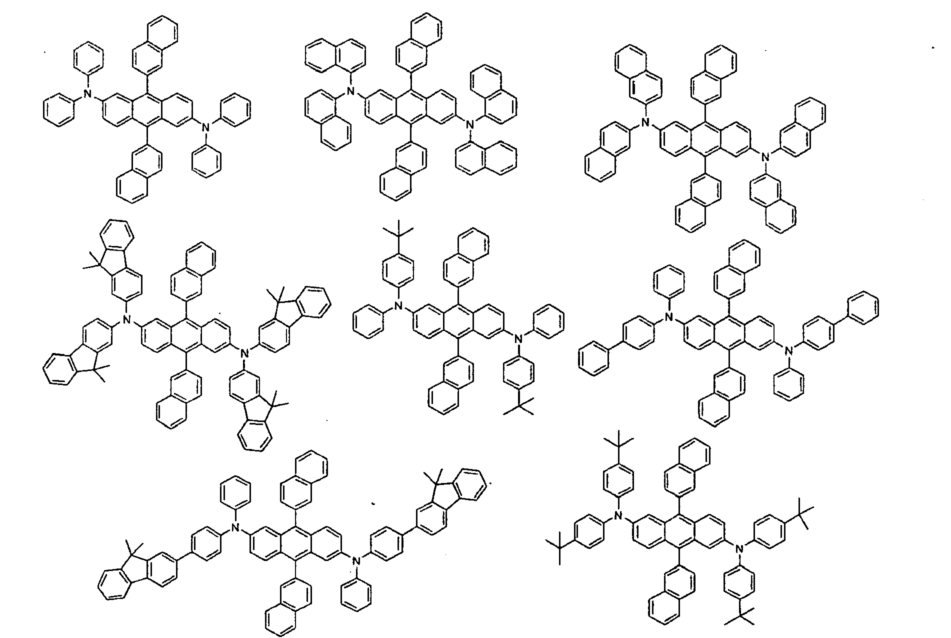

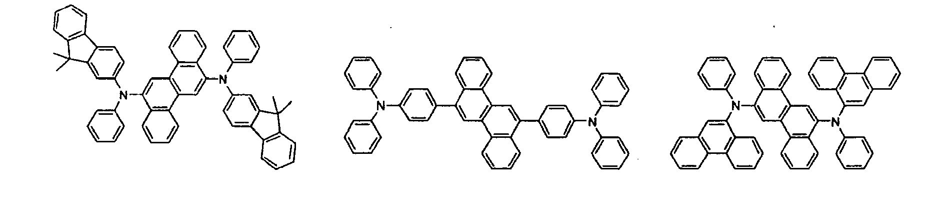

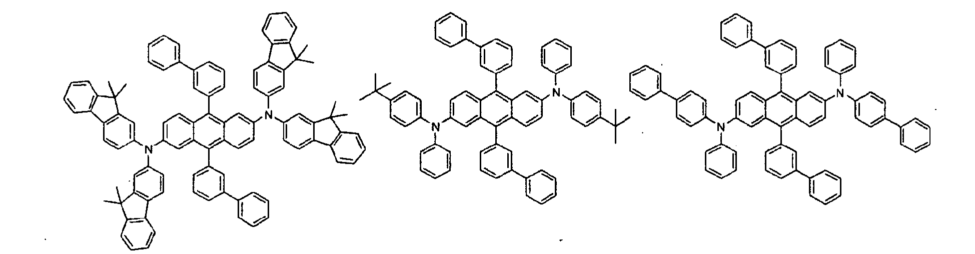

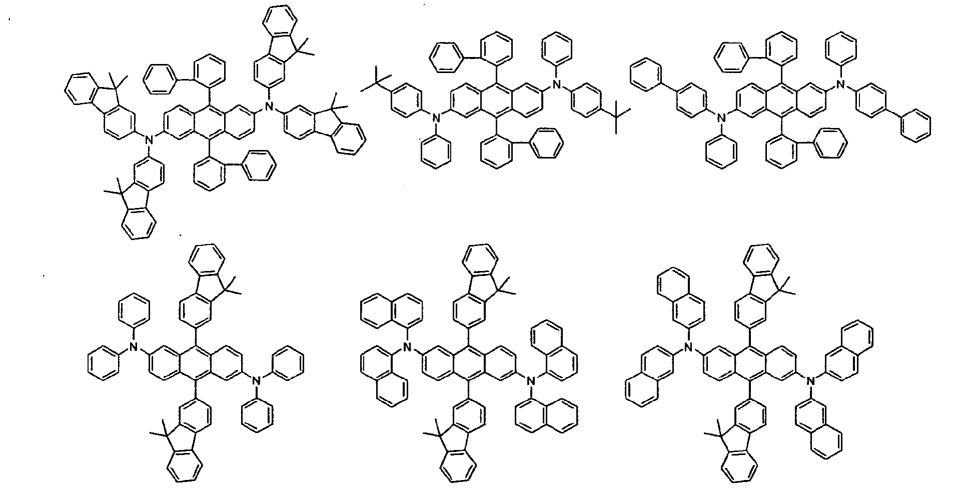

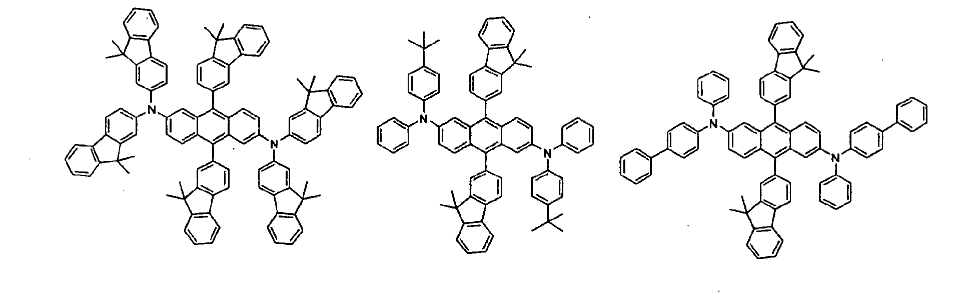

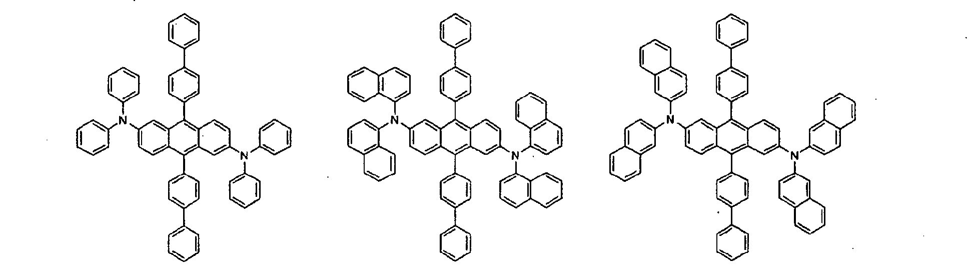

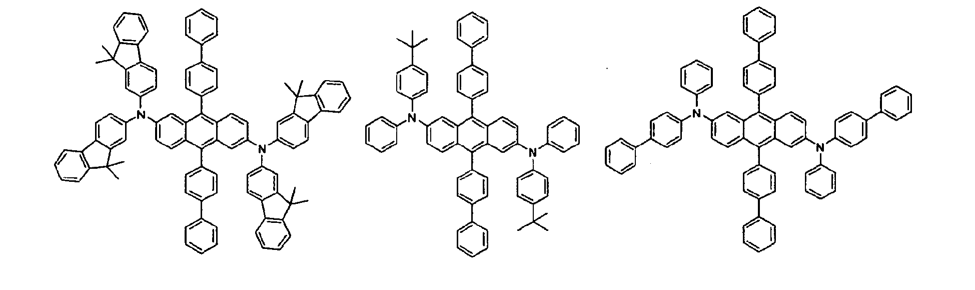

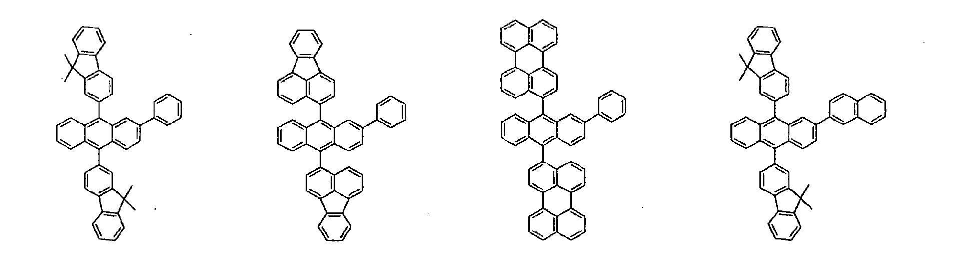

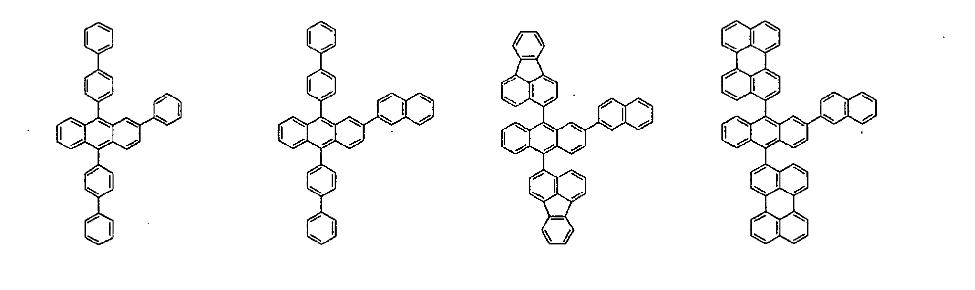

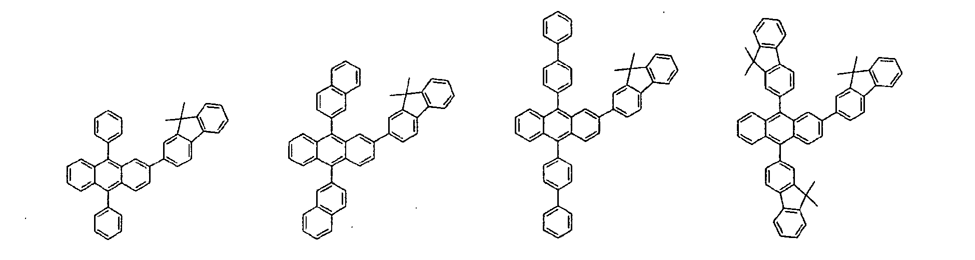

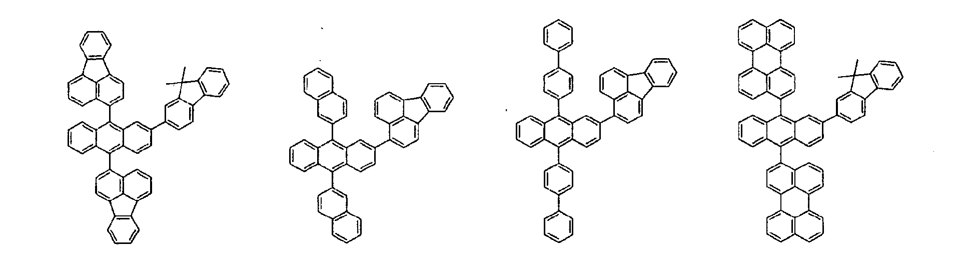

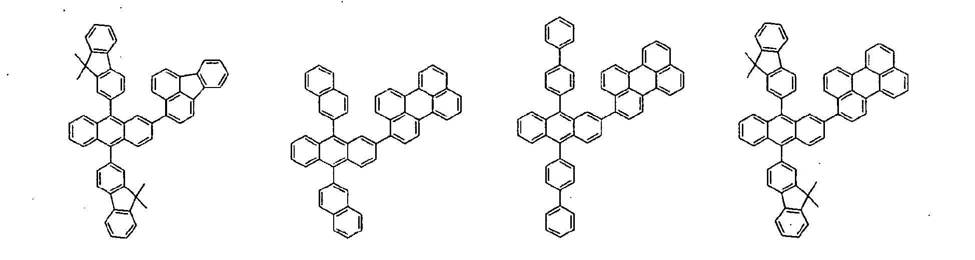

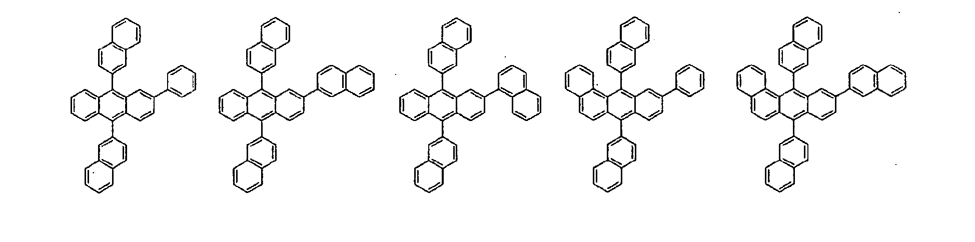

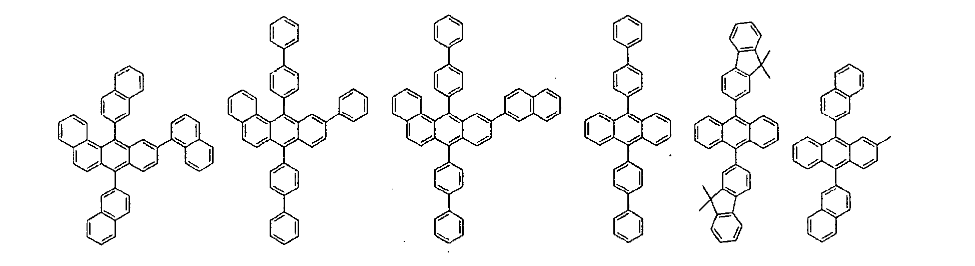

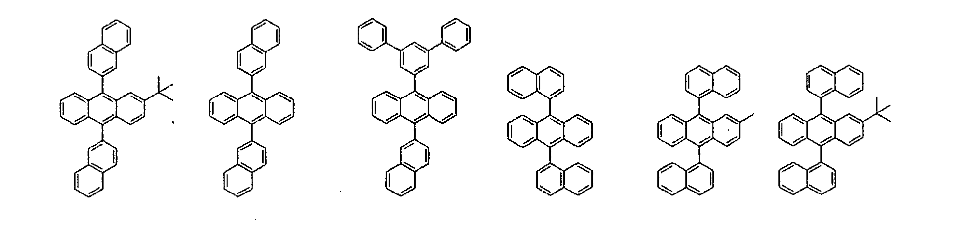

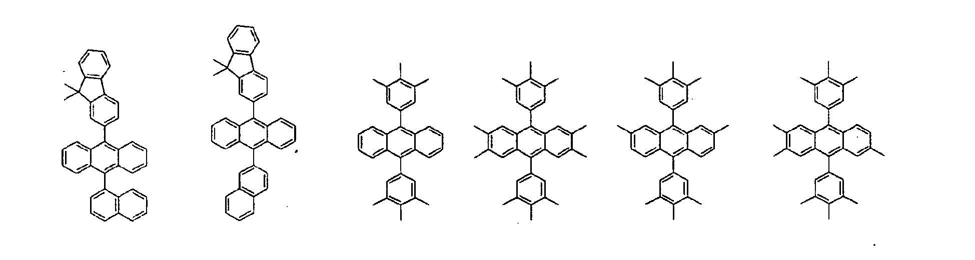

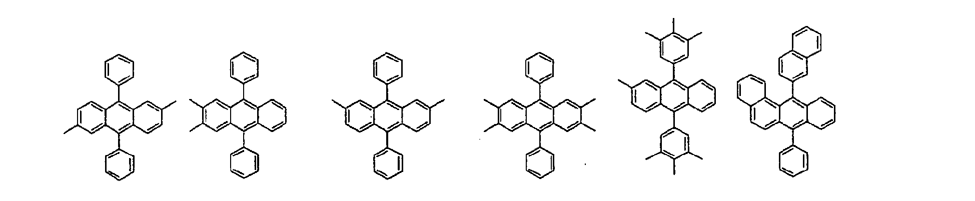

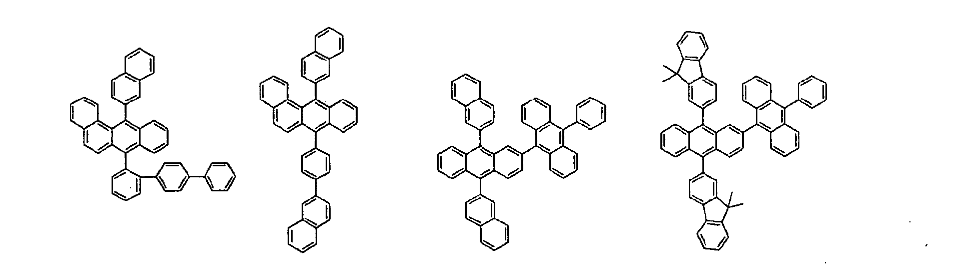

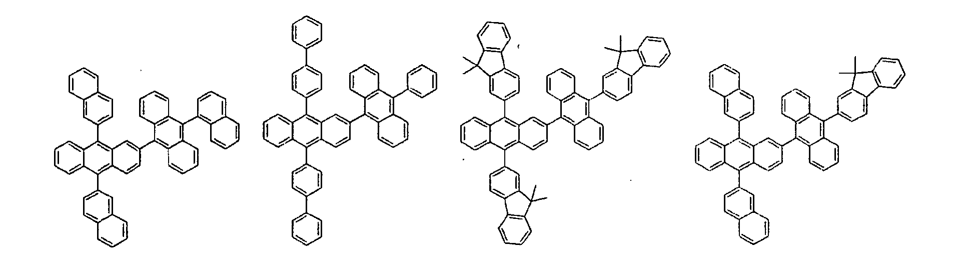

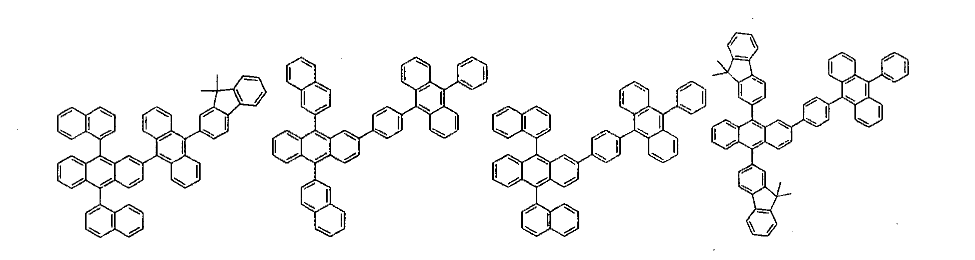

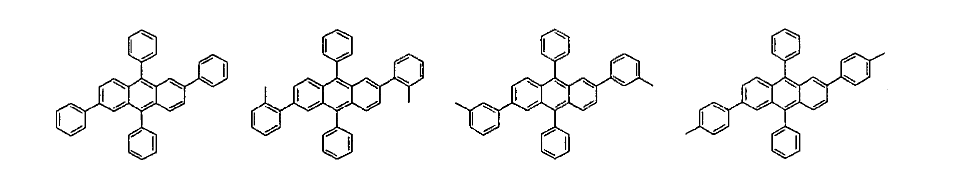

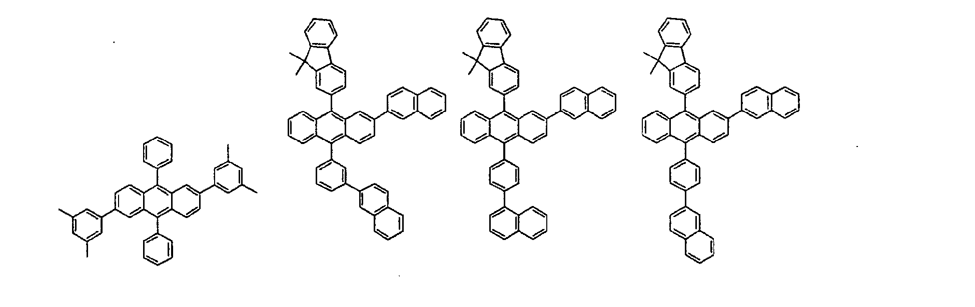

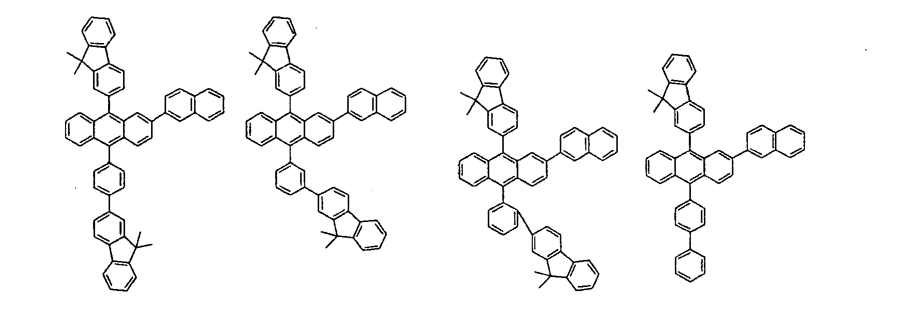

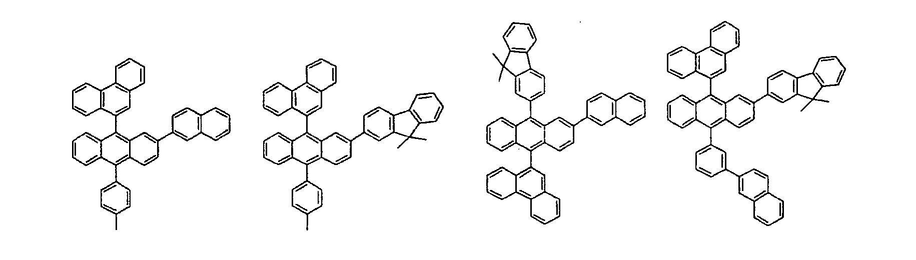

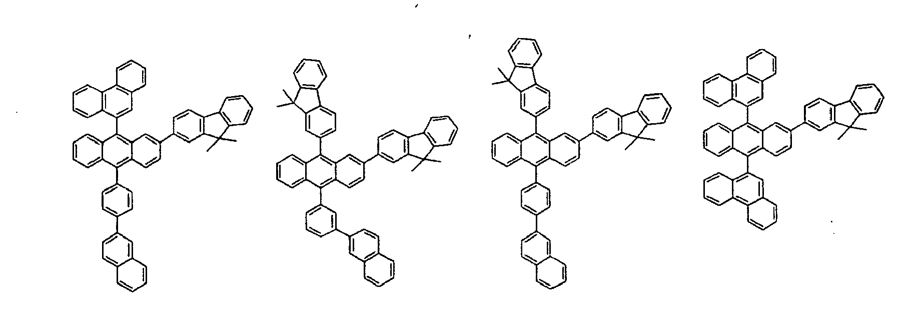

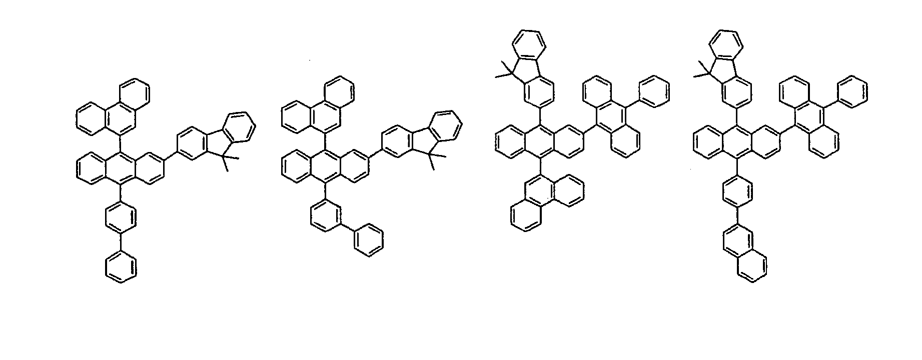

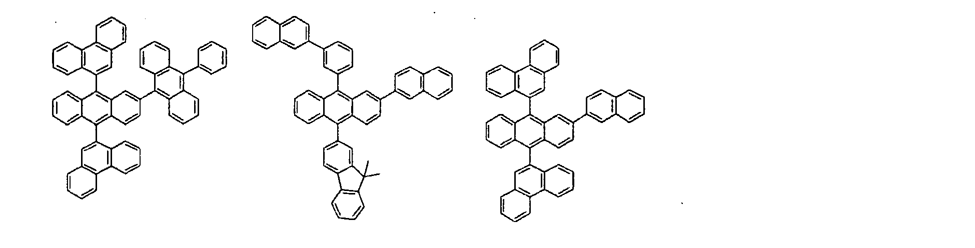

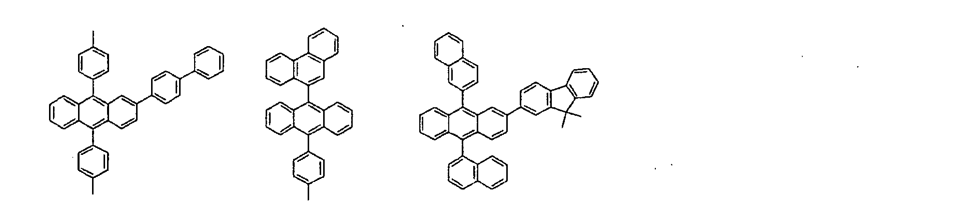

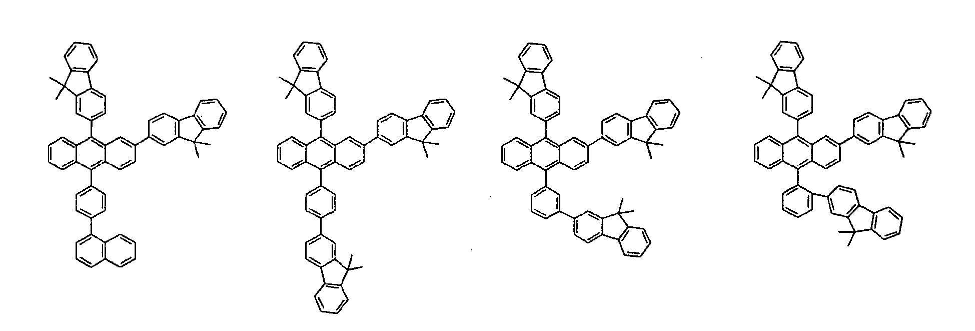

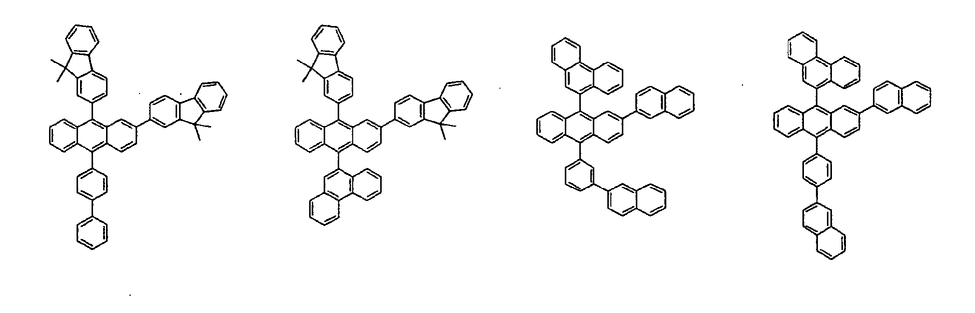

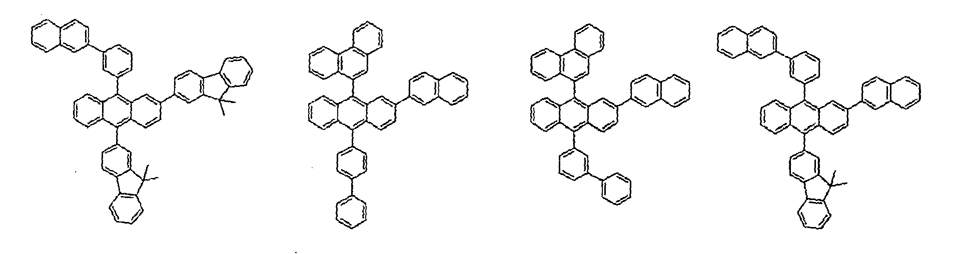

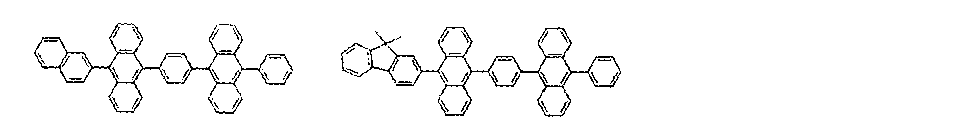

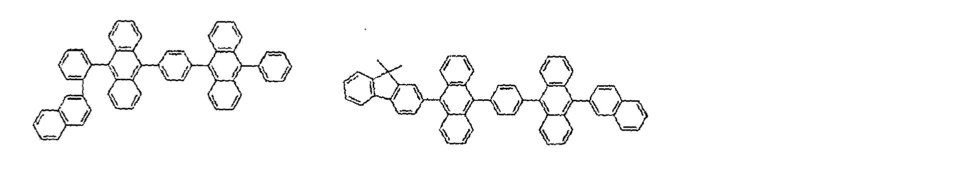

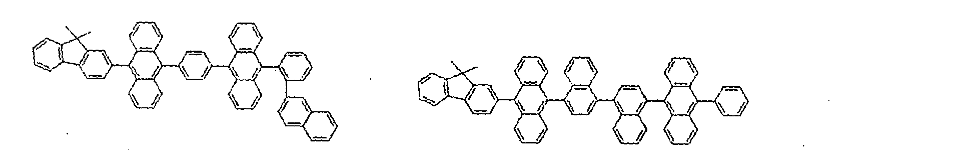

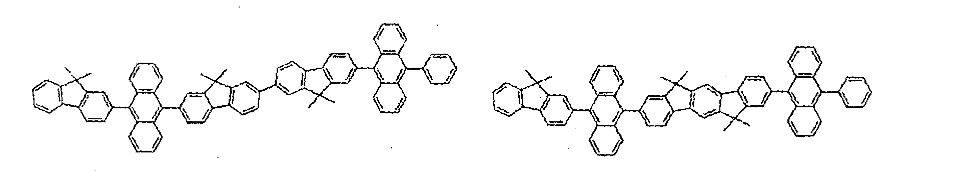

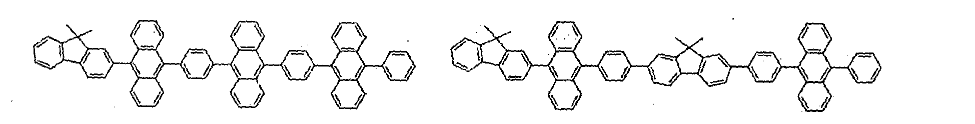

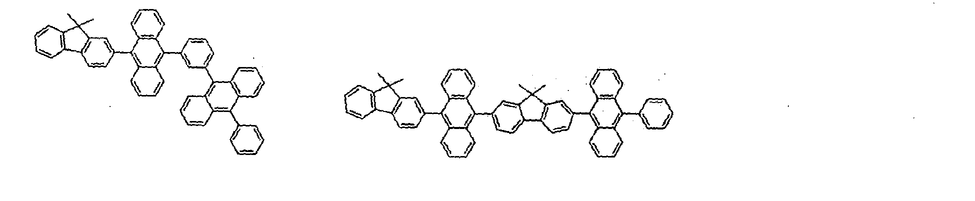

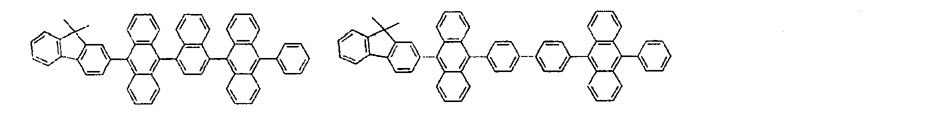

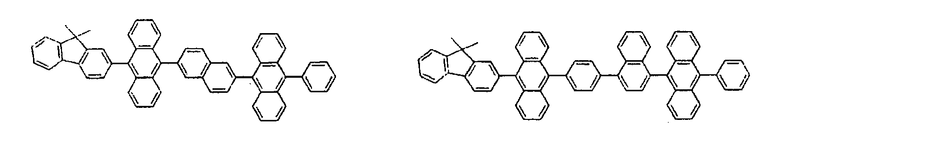

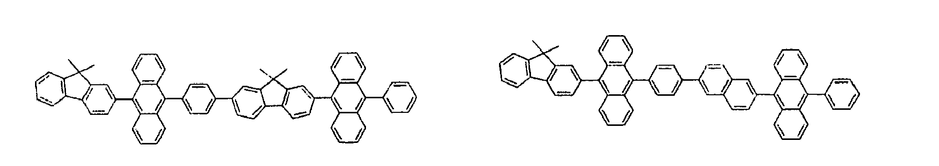

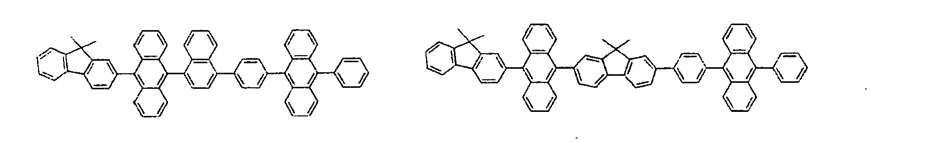

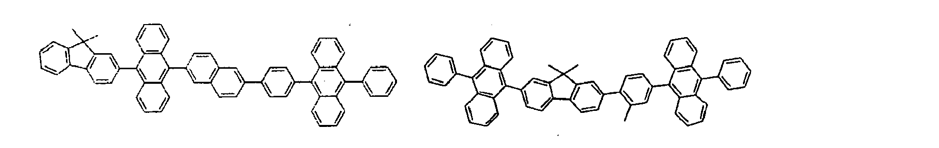

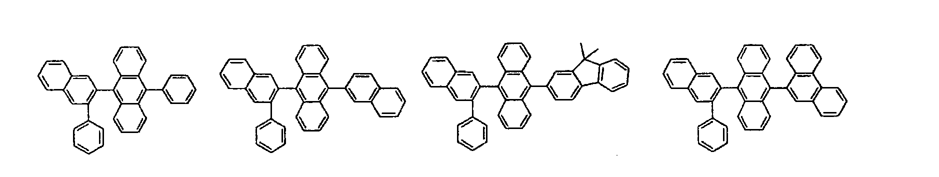

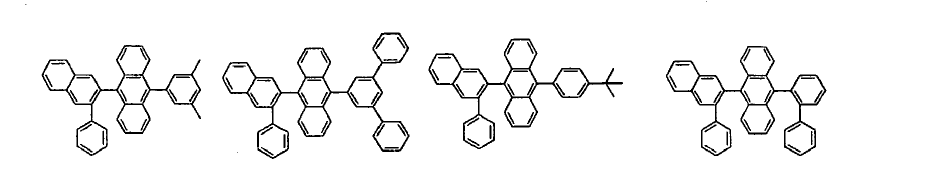

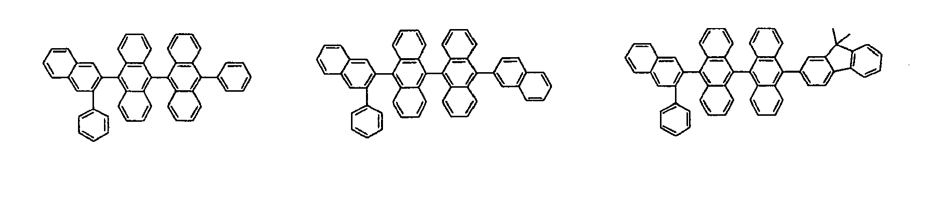

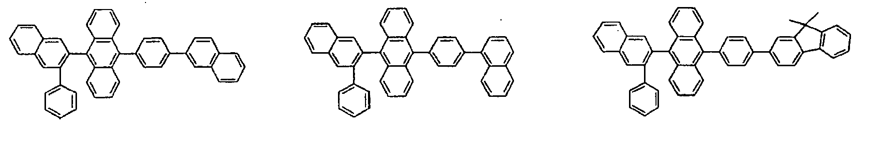

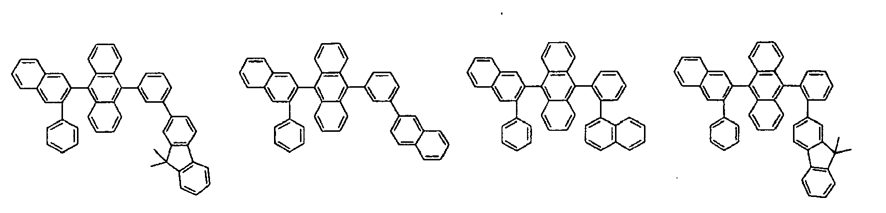

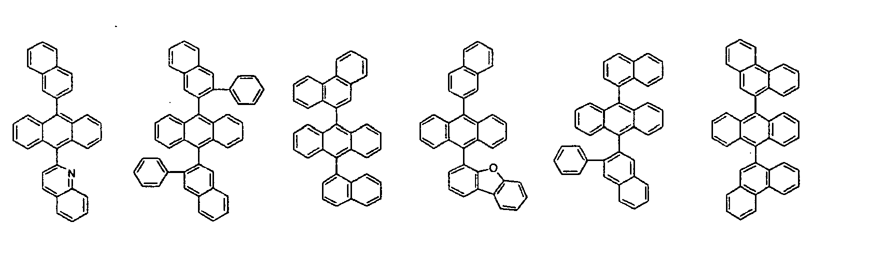

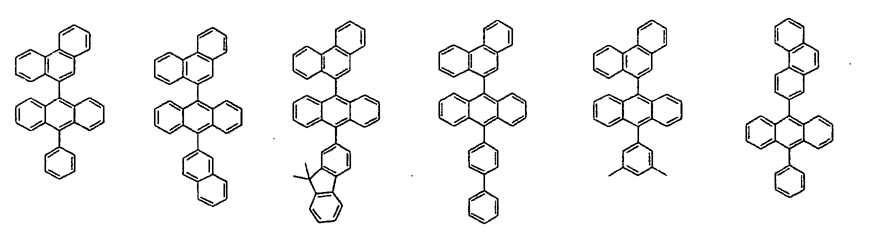

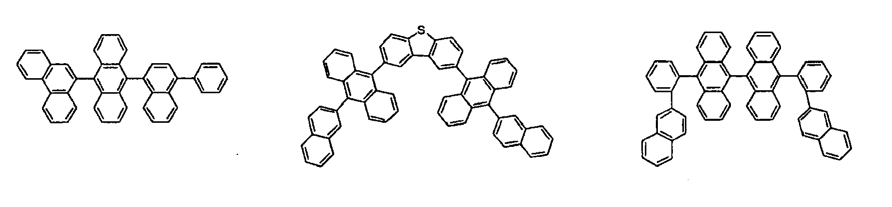

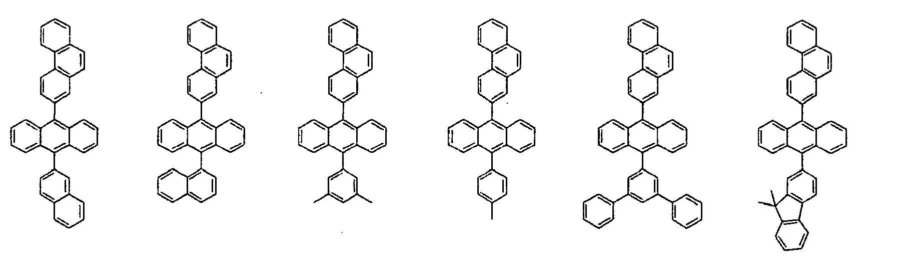

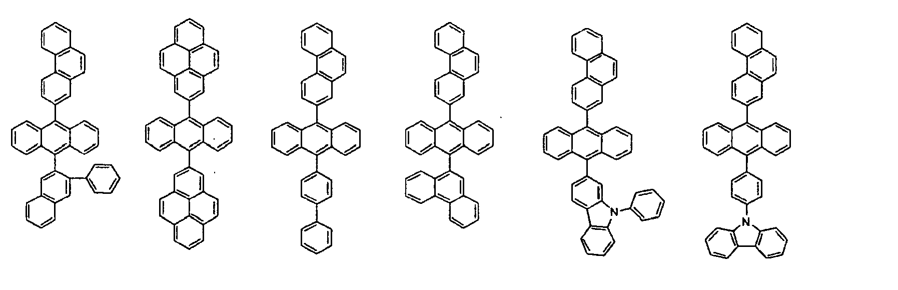

In an organic electroluminescent device according to the present invention, it is preferable to displace one or more layer(s) (here-in-below, referred to as the "surface layer") selected from chalcogenide layers, metal halide layers and metal oxide layers, on the inner surface of at least one side of the pair of electrodes. Specifically, it is preferable to arrange a chalcogenide layer of silicon and aluminum metal (including oxides) on the anode surface of the EL medium layer, and a metal halide layer or a metal oxide layer on the cathode surface of the EL medium layer. As the result, stability in operation can be obtained.

Examples of chalcogenides preferably include SiOₓ (1≤X≤2), AlOₓ (1≤X≤1.5), SiON, SiAlON, or the like. Examples of metal halides preferably include LiF, MgF₂, CaF₂, fluorides of lanthanides or the like. Examples of metal oxides preferably include Cs₂O, Li₂O, MgO, SrO, BaO, CaO, or the like.

In an organic electroluminescent device according to the present invention, it is also preferable to arrange, on at least one surface of the pair of electrodes thus manufactured, a mixed region of electron transport compound and a reductive dopant, or a mixed region of a hole transport compound with an oxidative dopant. Accordingly, the electron transport compound is reduced to an anion, so that injection and transportation of electrons from the mixed region to an EL medium are facilitated. In addition, since the hole transport compound is oxidized to form a cation, injection and transportation of holes from the mixed region to an EL medium are facilitated. Preferable oxidative dopants include various Lewis acids and acceptor compounds. Preferable reductive dopants include alkali metals, alkali metal compounds, alkaline earth metals, rare-earth metals, and mixtures thereof.

The organic electroluminescent compounds according to the invention, having a backbone of more excellent EL properties and thermal stability than conventional phosphorescent materials, provide higher quantum efficiency and lower operation voltage as compared to conventional materials. Thus, if an organic electroluminescent compound according to the present invention is applied to an OLED panel, further enhanced results are anticipated in development of OLED's having medium to large size. If the compound is applied to an organic solar cell as a material of high efficiency, more excellent properties are anticipated as compared to conventional materials.

### Best Mode

The present invention is further described with respect to the compounds according to the invention, the processes for preparing the same, and electroluminescent properties of devices manufactured therefrom by referring to the representative compounds of the invention, which are provided for illustration of the embodiments only but are not intended to limit the scope of the invention by any means.

### Preparation Examples

### [Preparation Example 1] Preparation of Compound (1)

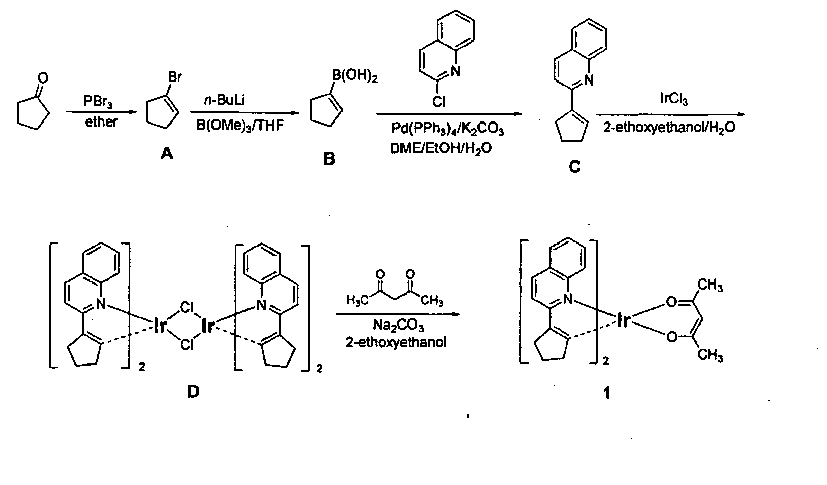

### Preparation of Compound (A)

Cyclopentanone (20.0 g, 238 mmol) was dissolved in ethyl ether (1L), and phosphorus pentabromide (100.0 g, 238 mmol) was slowly added thereto at 0°C. After stirring at room temperature for 24 hours, the reaction was quenched by using aqueous sodium hydrocarbonate solution. The reaction mixture was extracted with ethyl acetate, and dried under reduced pressure. Purification via column chromatography gave Compound (A) (17.8 g, 51).

### Preparation of Compound (B)

Compound (A) (15.0 g, 102 mmol) was dissolved in THF (1 L), and the solution was chilled to -78°C. Butyl lithium (61 mL, 2.5 M in hexane) was slowly added to the solution. After stirring at -78°C for about 1 hour, trimethylborate (13.7 mL, 122 mmol) was added thereto at the same temperature. The temperature was slowly raised to room temperature, and the reaction mixture was stirred for 24 hours. Upon quenching the reaction by using aqueous 1N hydrochloric acid solution, the reaction mixture was extracted with ethyl acetate and dried under reduced pressure. Recrystallization from hexane/ethyl acetate gave Compound (B) (9.3 g, 68%).

### Preparation of Compound (C)

In ethyleneglycoldimethyl ether (670 mL), ethanol (130 mL) and distilled water (130 mL) dissolved were 2-chloroquinoline (11.0 g, 67.0 mmol), Compound (B) (9.0 g, 80.4 mmol) and tetrakispalladium (0) triphenylphosphine (Pd(PPh₃)₄) (3.9 g, 3.4 mmol). Aqueous 2M sodium carbonate solution (18.5 g, 134 mmol) was added to the solution, and the mixture was stirred under reflux at 120°C for 24 hours. Then the reaction mixture was cooled to 25°C, and distilled water (1000 mL) was added thereto to quench the reaction. The resultant mixture was extracted with ethyl acetate (800 mL), and the extract was dried under reduced pressure. Purification via silica gel column chromatography gave Compound (9.9 g, 76%).

### Preparation of Compound (D)

A reaction vessel was charged with Compound (C) (7.0 g, 35.9 mmol), iridium chloride (IrCl₃) (4.9 g, 16.3 mmol), 2-ethoxyethanol (150 mL) and distilled water (50 mL), and the mixture was heated under reflux in the presence of argon gas atmosphere for 24 hours. The reaction mixture was then cooled to ambient temperature, and the precipitate produced was filtered and thoroughly dried, to give Compound (D) (8.8 g, 20%).

### Preparation of Compound (1)

Compound (D) (8.0 g, 6.5 mmol), 2,4-pentanedione (1.3 mL, 13.0 mmol) and sodium carbonate (3.4 g, 32.5 mmol) were dissolved in 2-ethoxyethanol (360 mL), and the solution was heated for 4 hours. When the reaction was completed, the reaction mixture was cooled to room temperature, and the solid precipitate produced was filtered. Purification via silica gel column chromatography and recrystallization from hexane/dichloromethane gave Compound (1) (1.2 g, 28%) as red crystal.

According to the same procedure as Preparation Example 1, organic phosphorescent compounds (Compound 1 through Compound 1320) in Table 1 were prepared, of which the ¹H NMR and MS/FAB data are listed in Table 2.

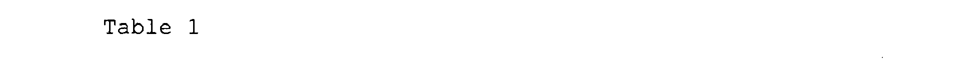

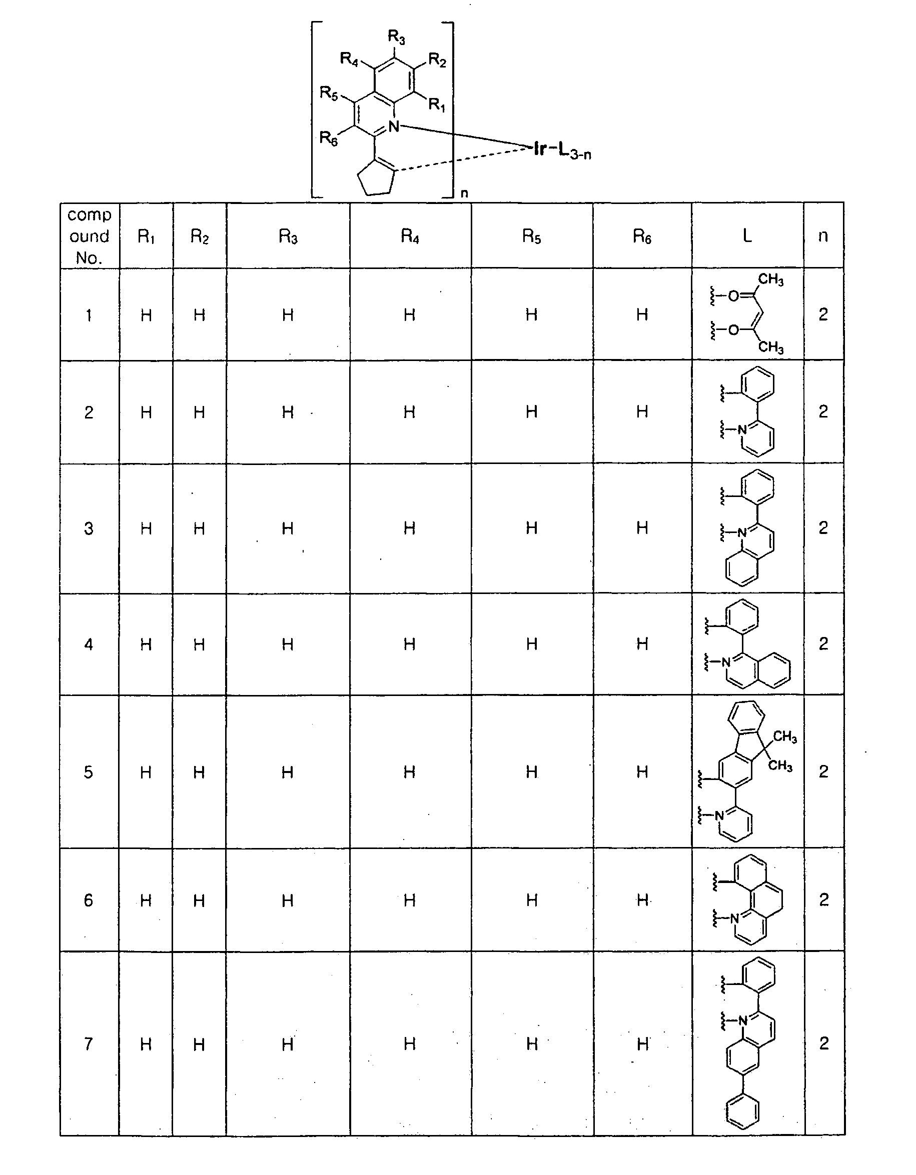

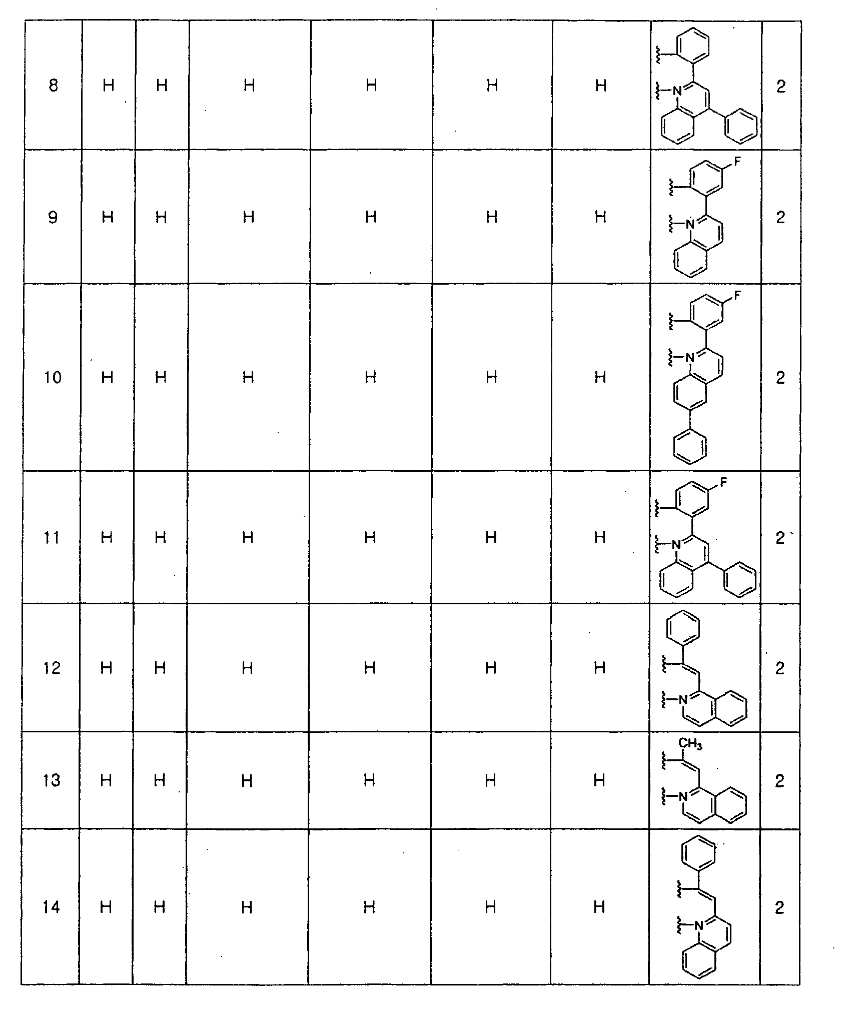

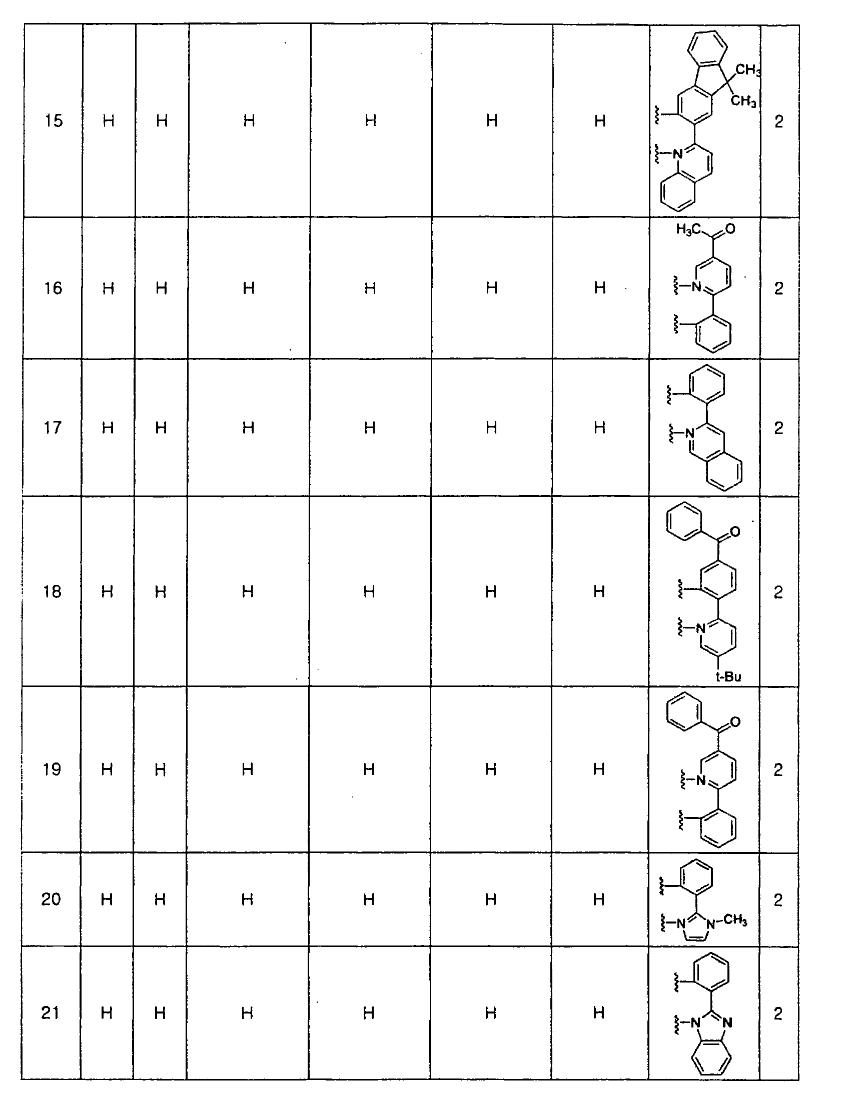

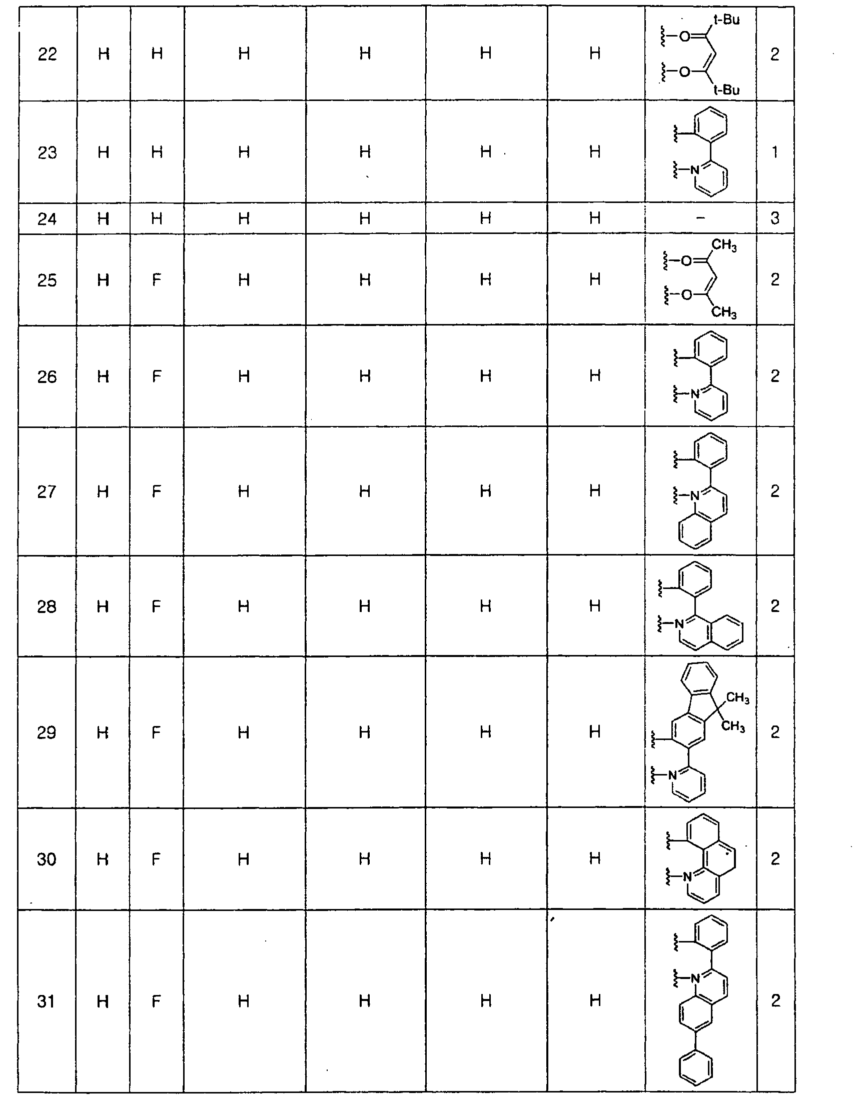

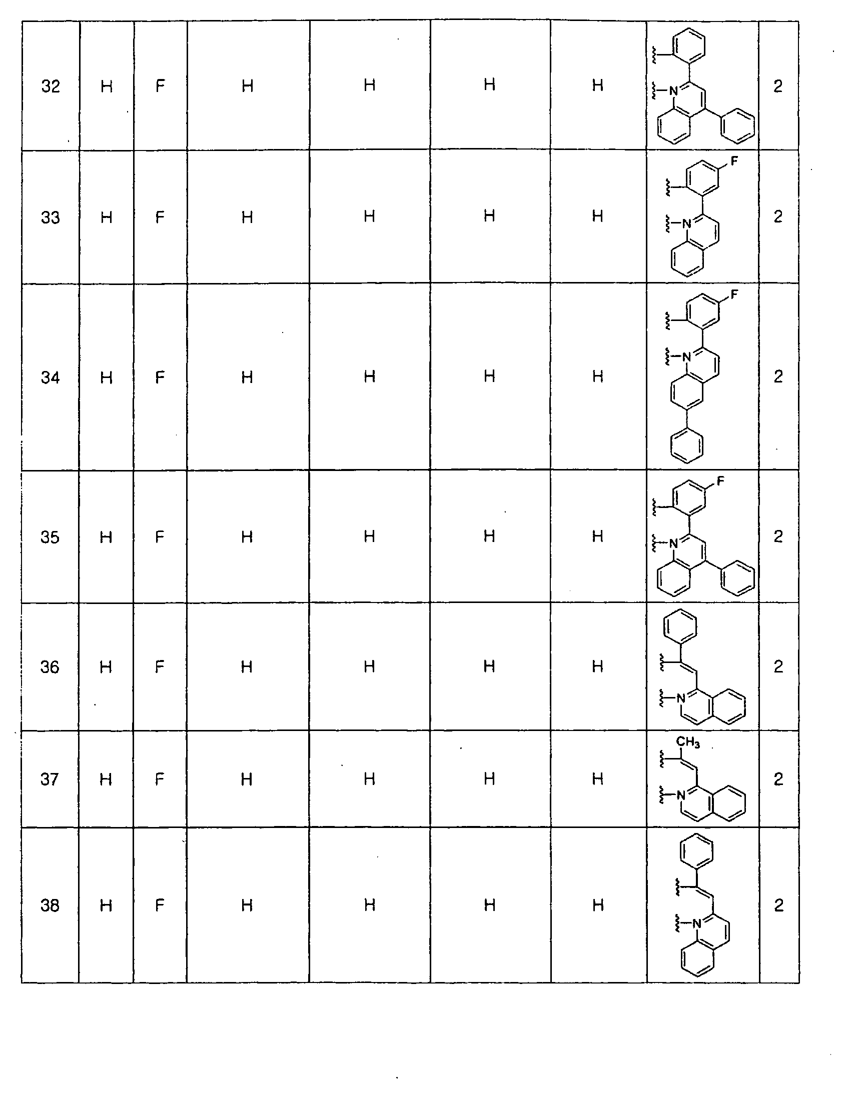

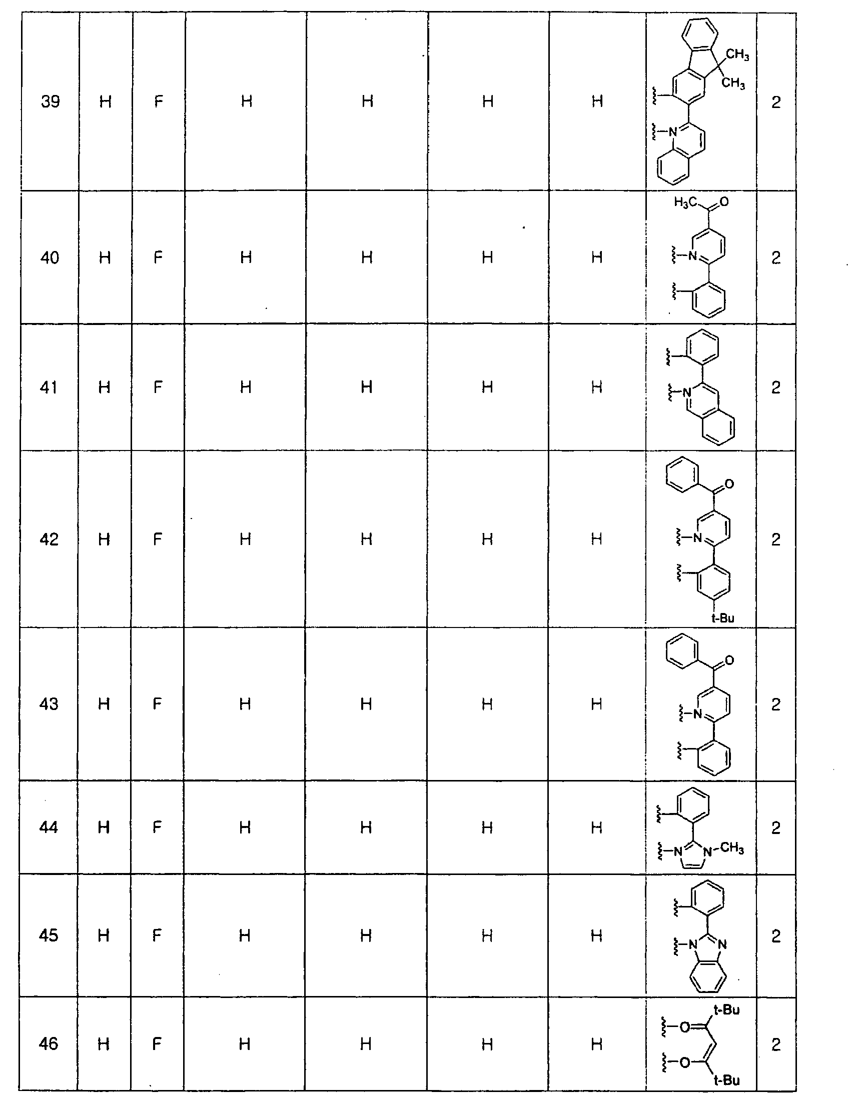

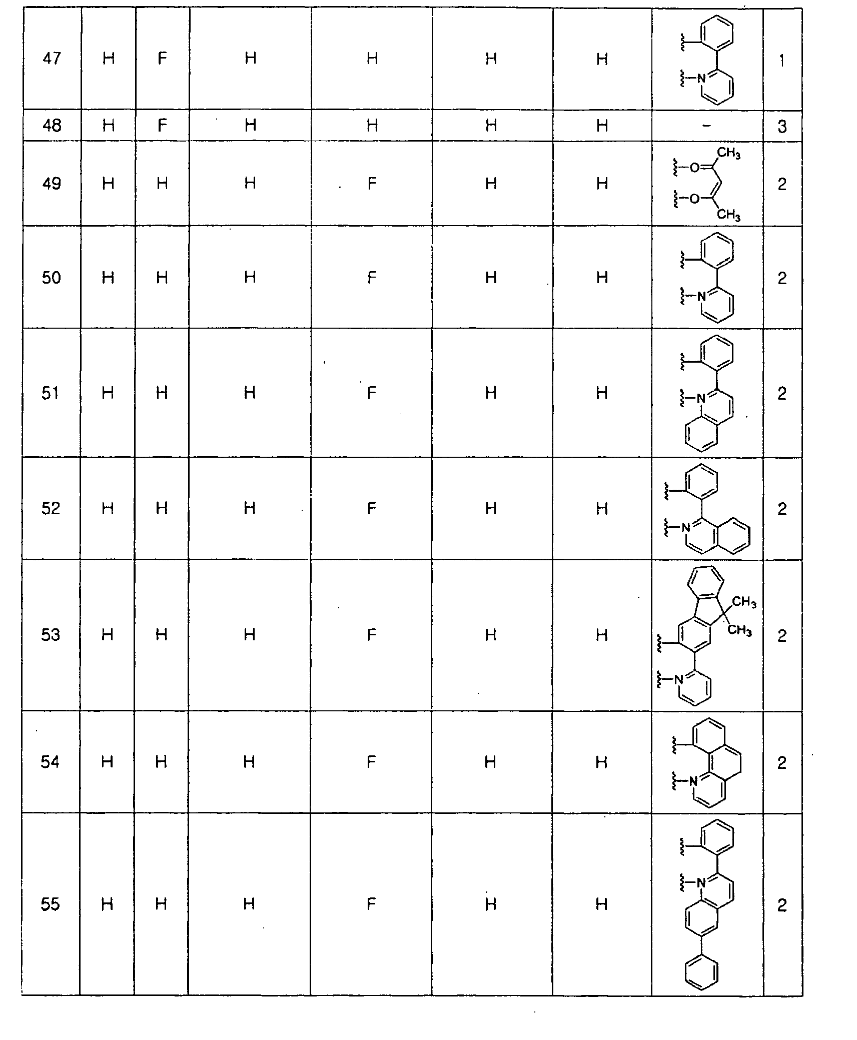

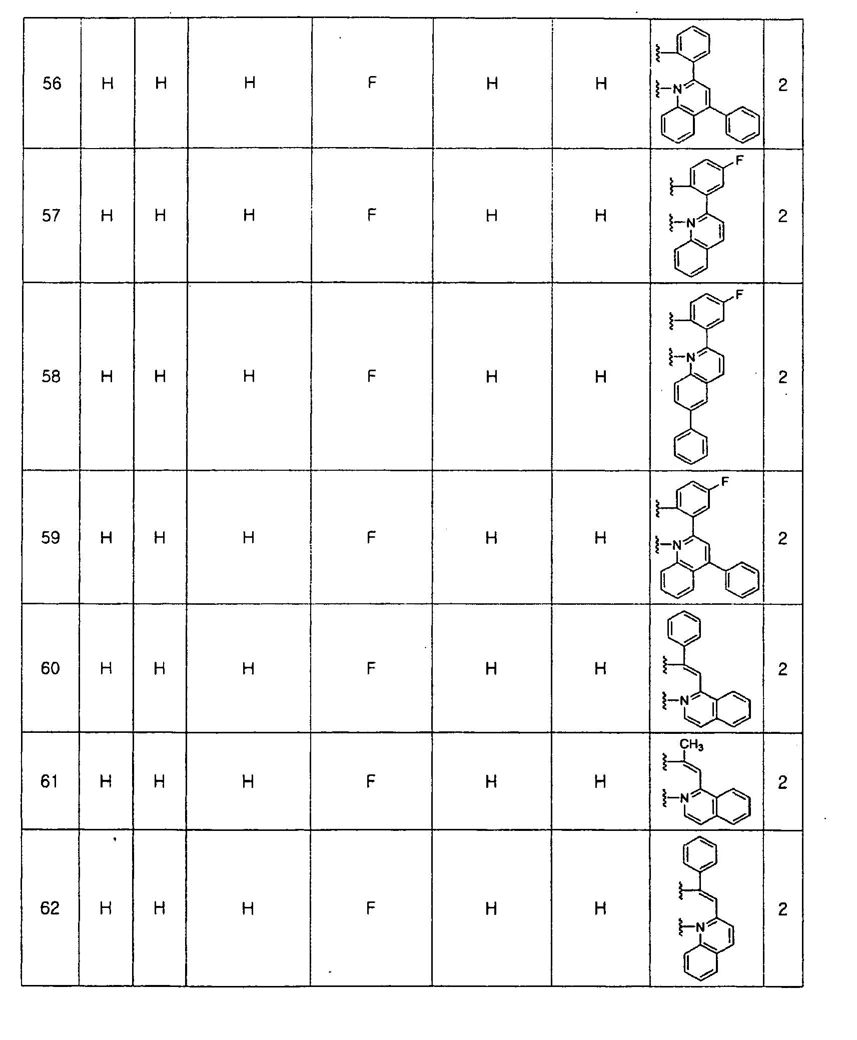

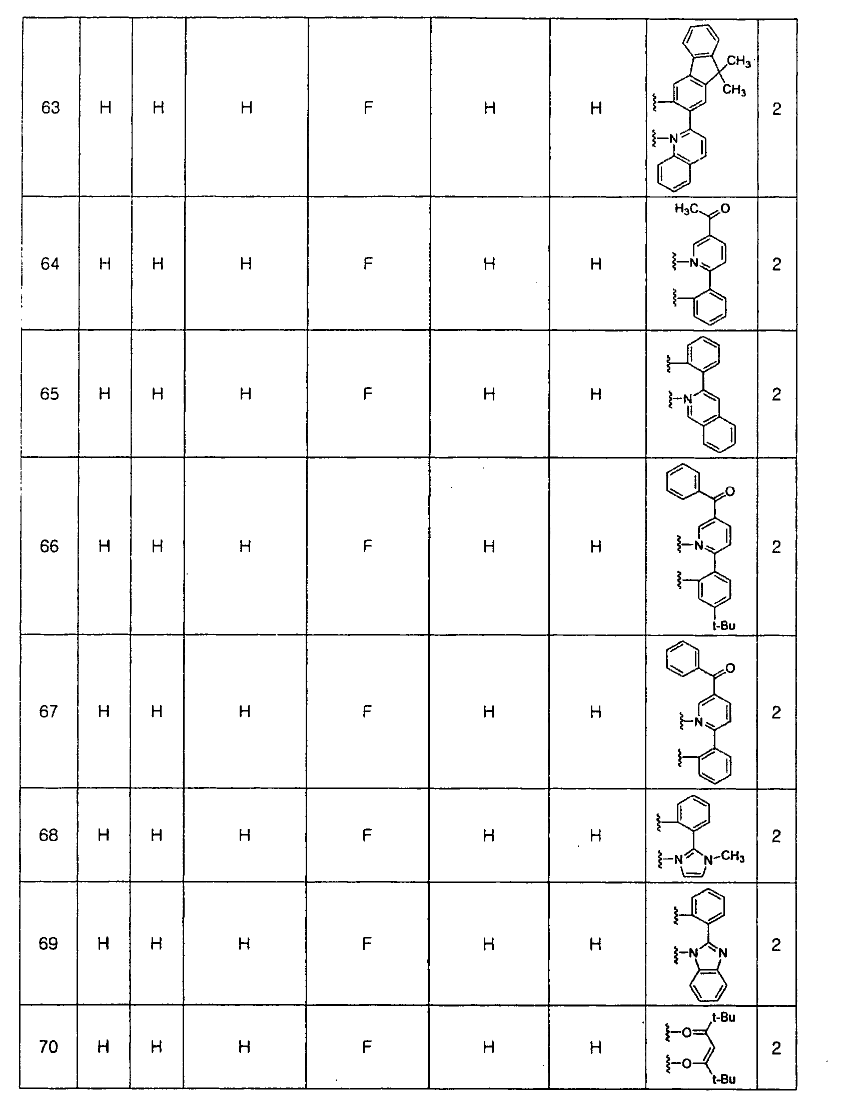

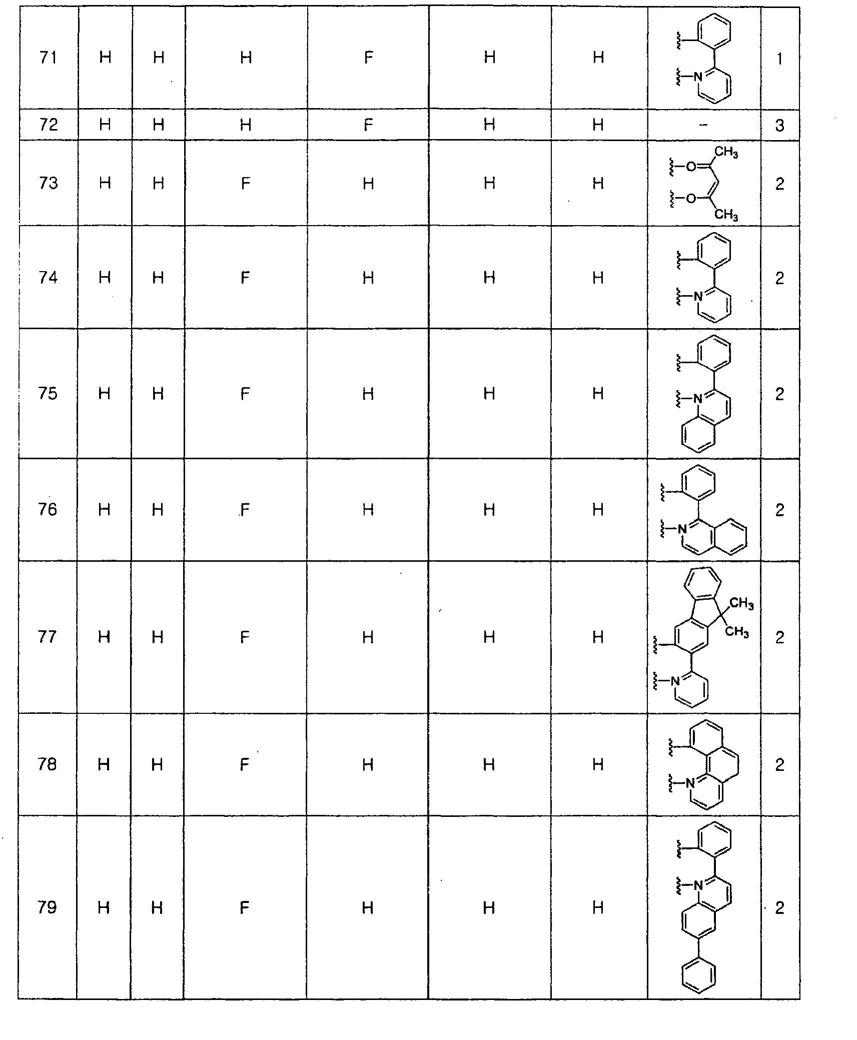

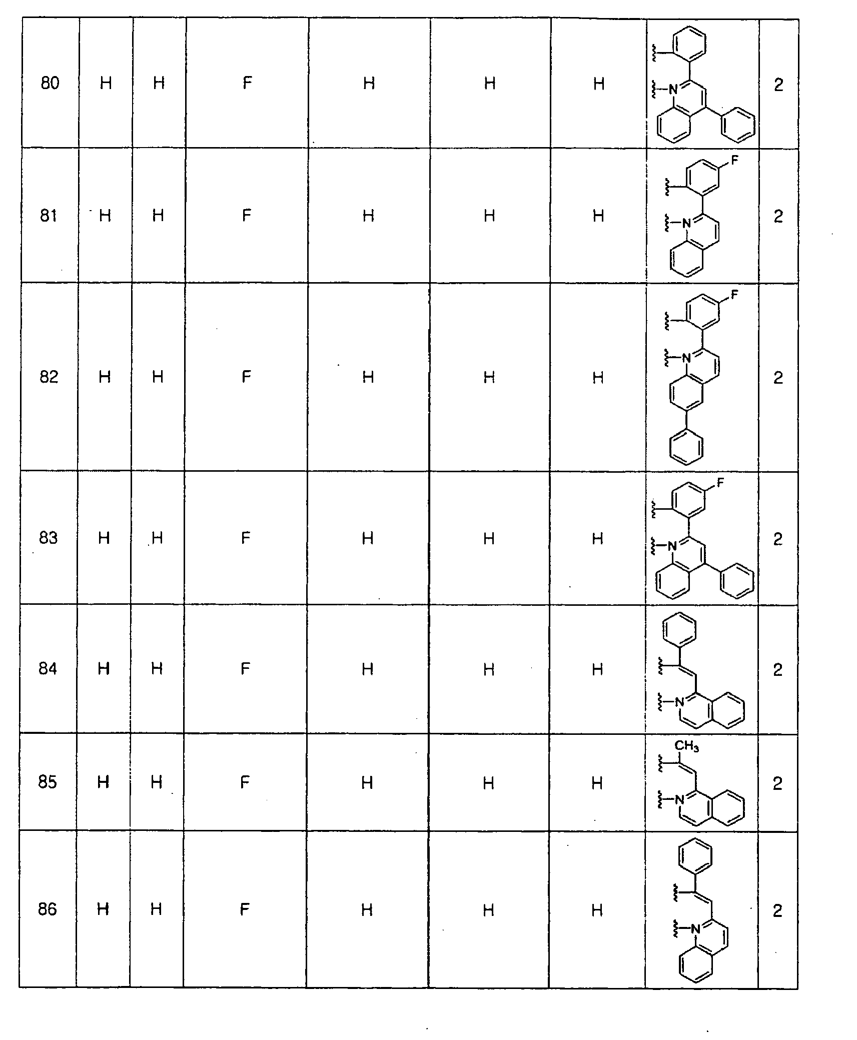

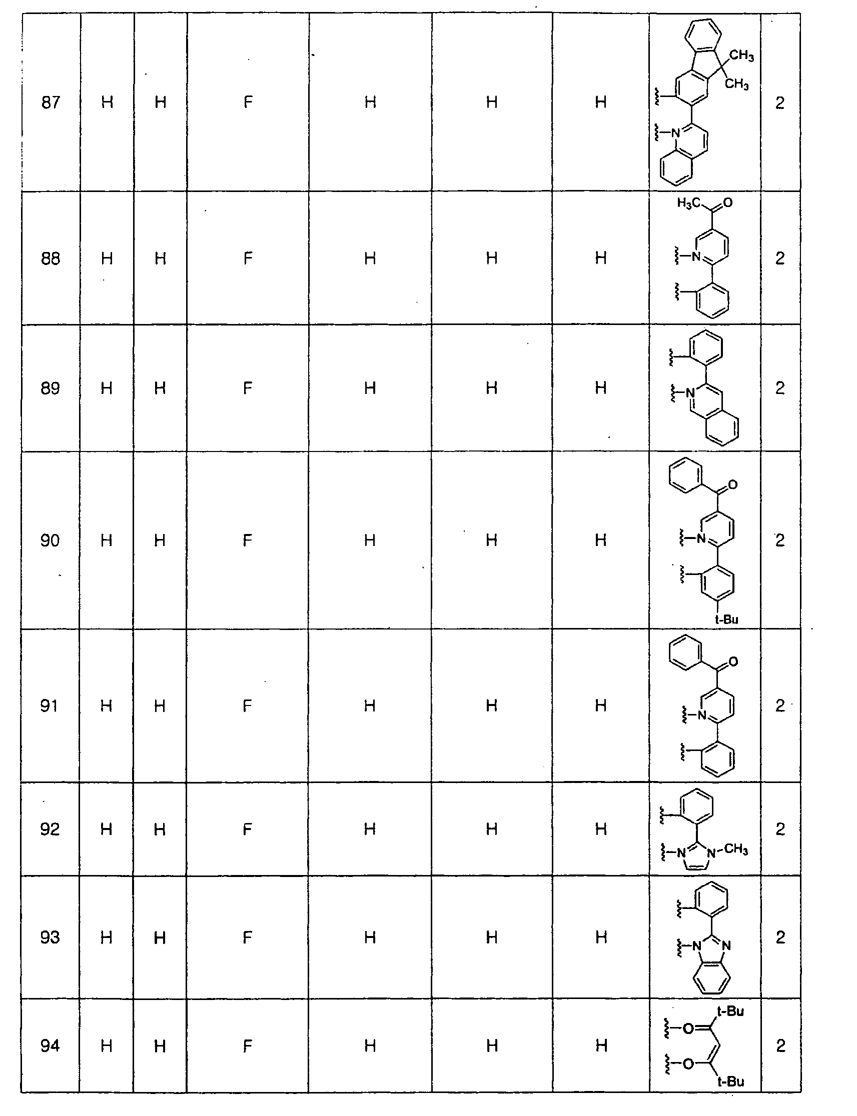

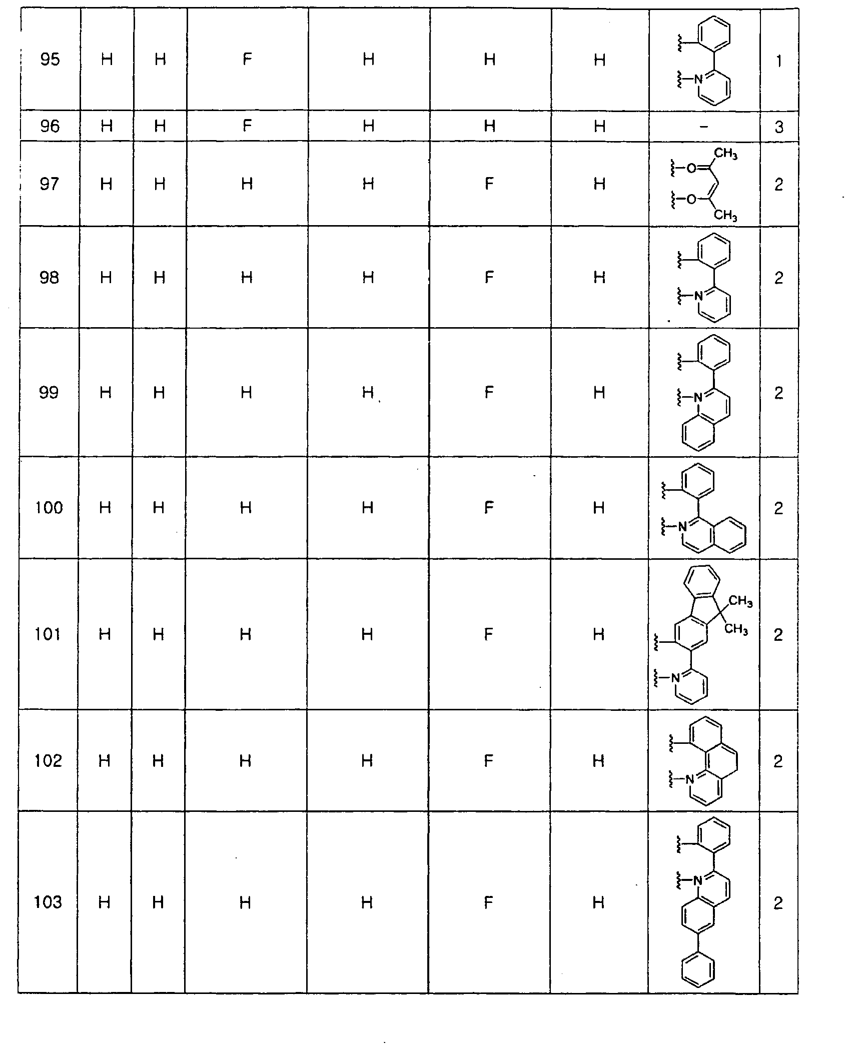

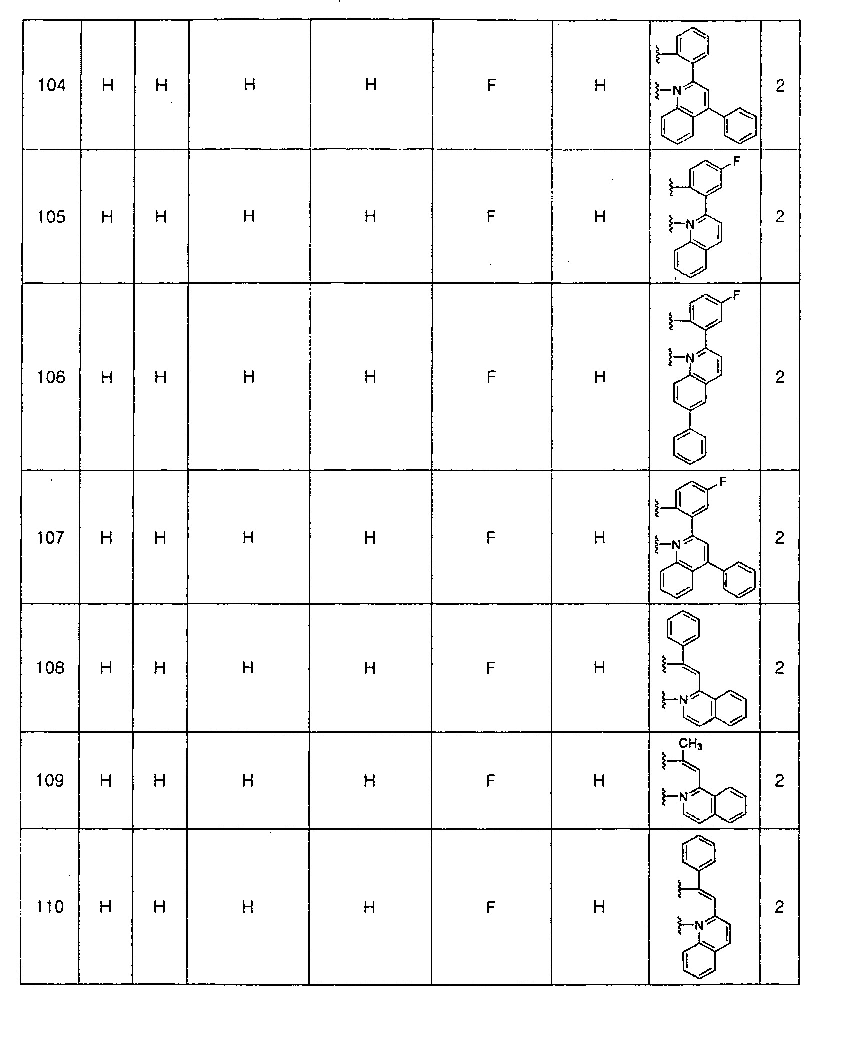

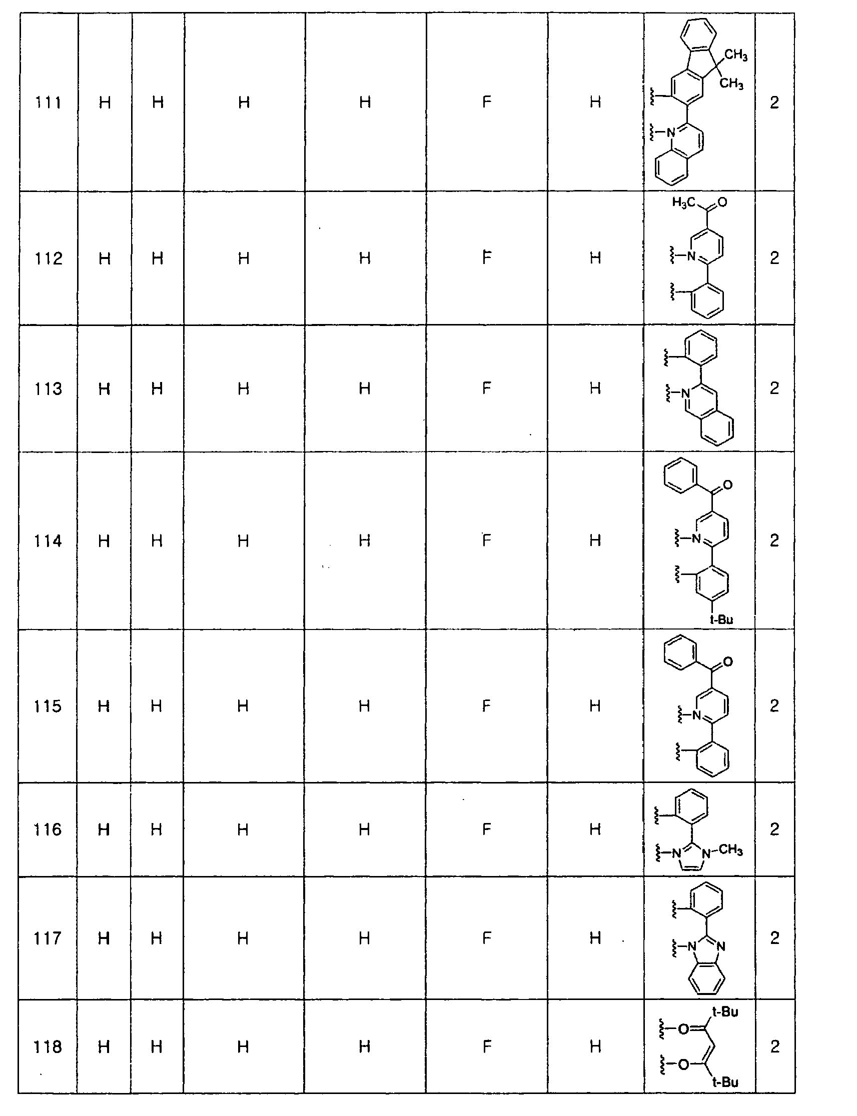

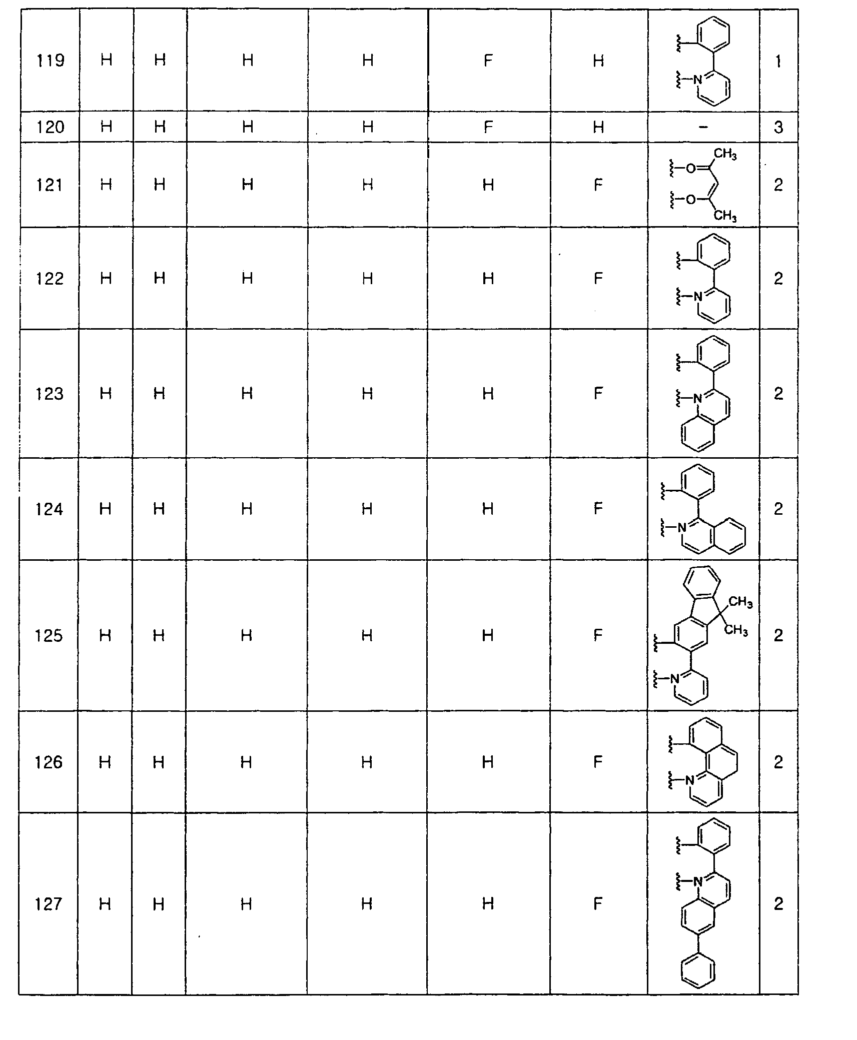

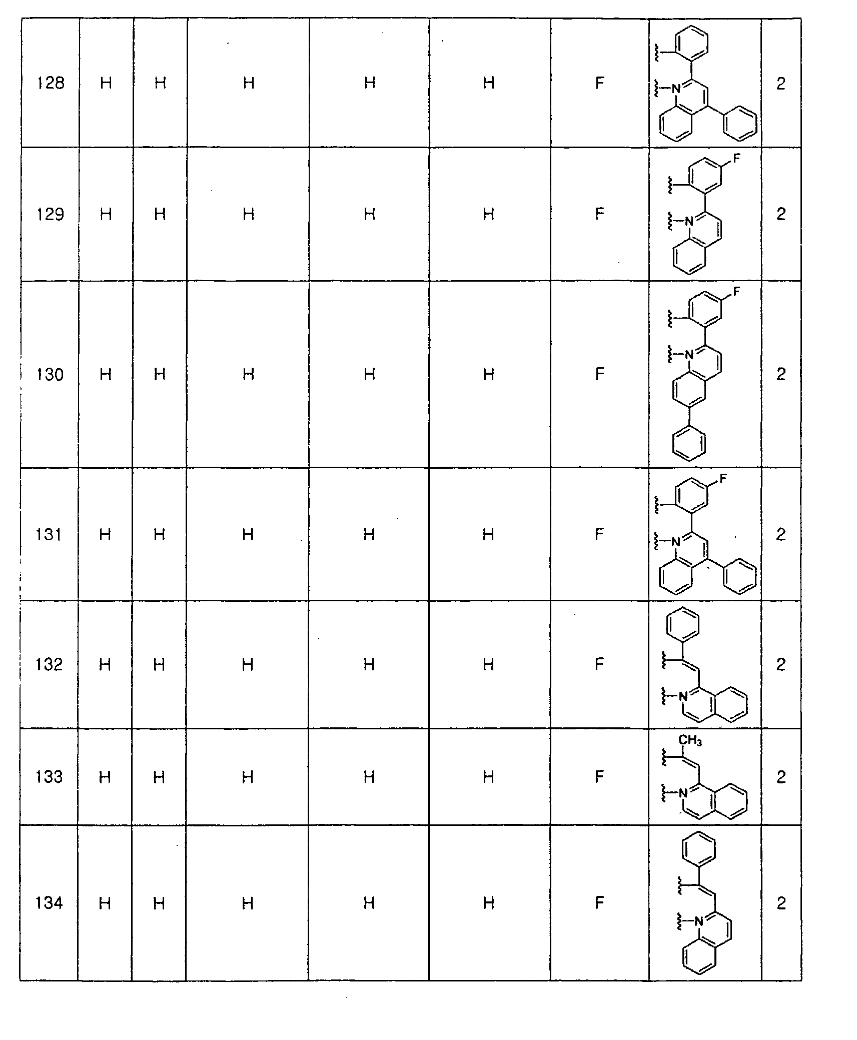

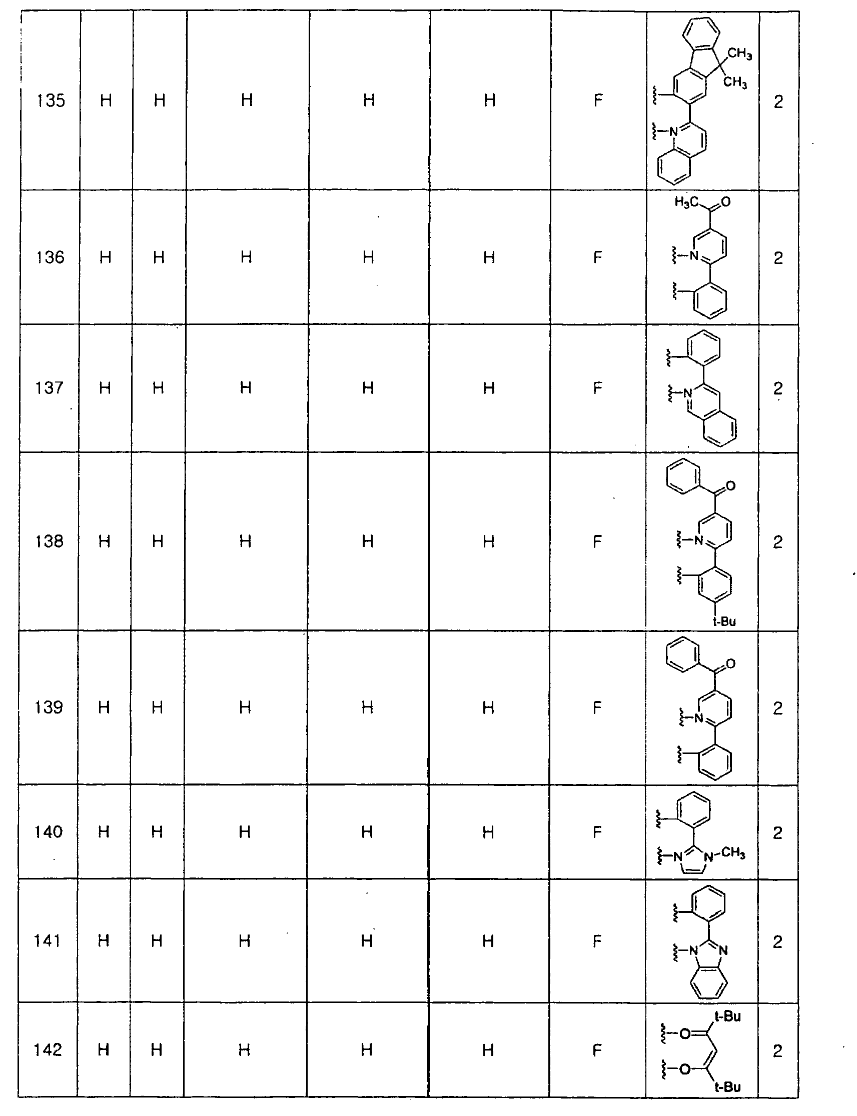

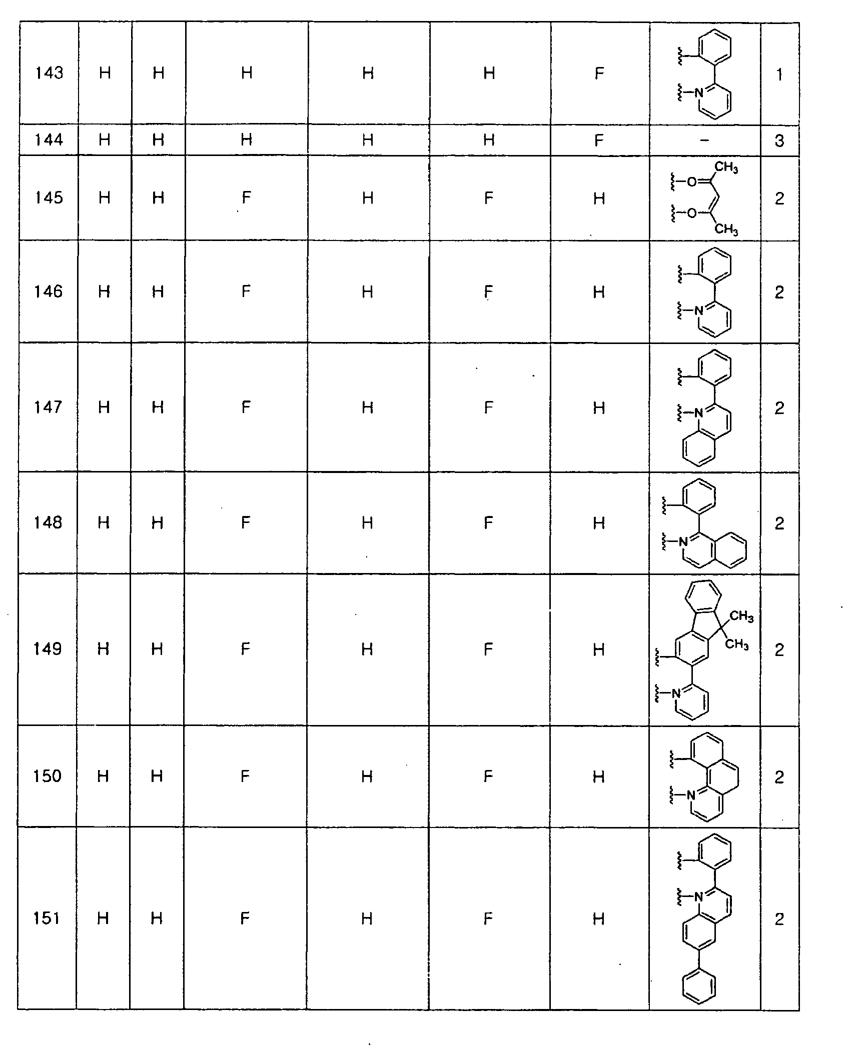

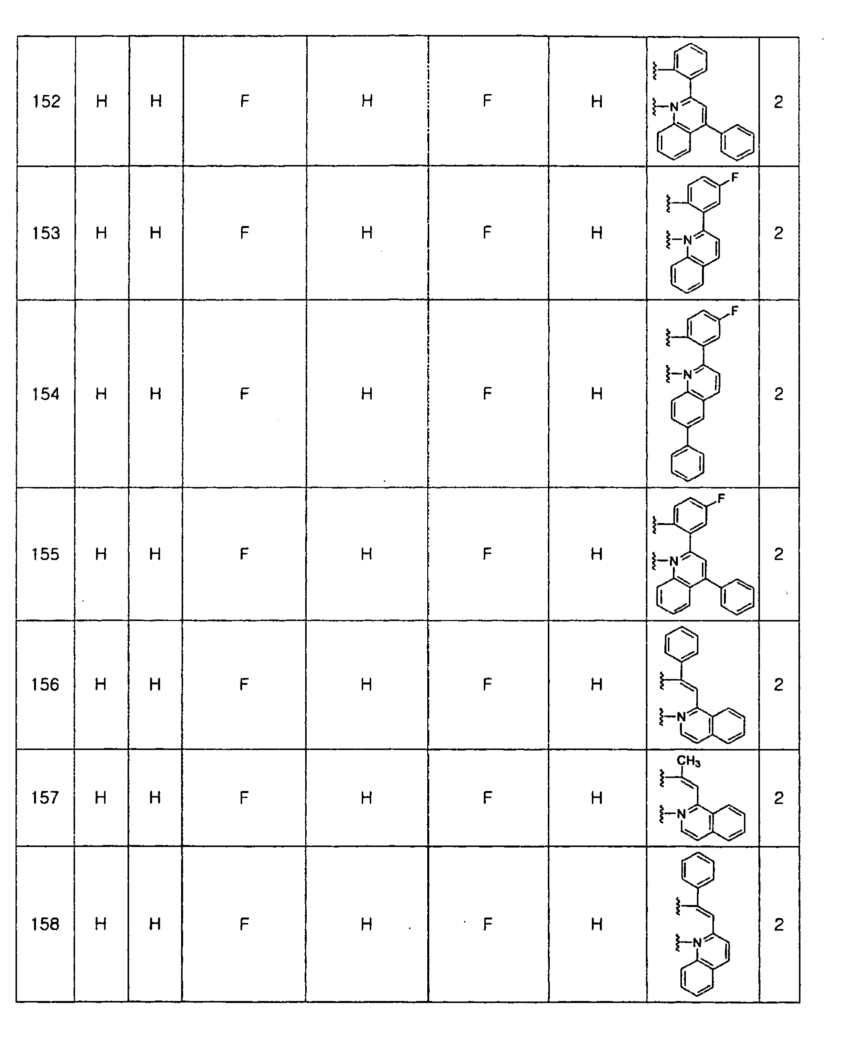

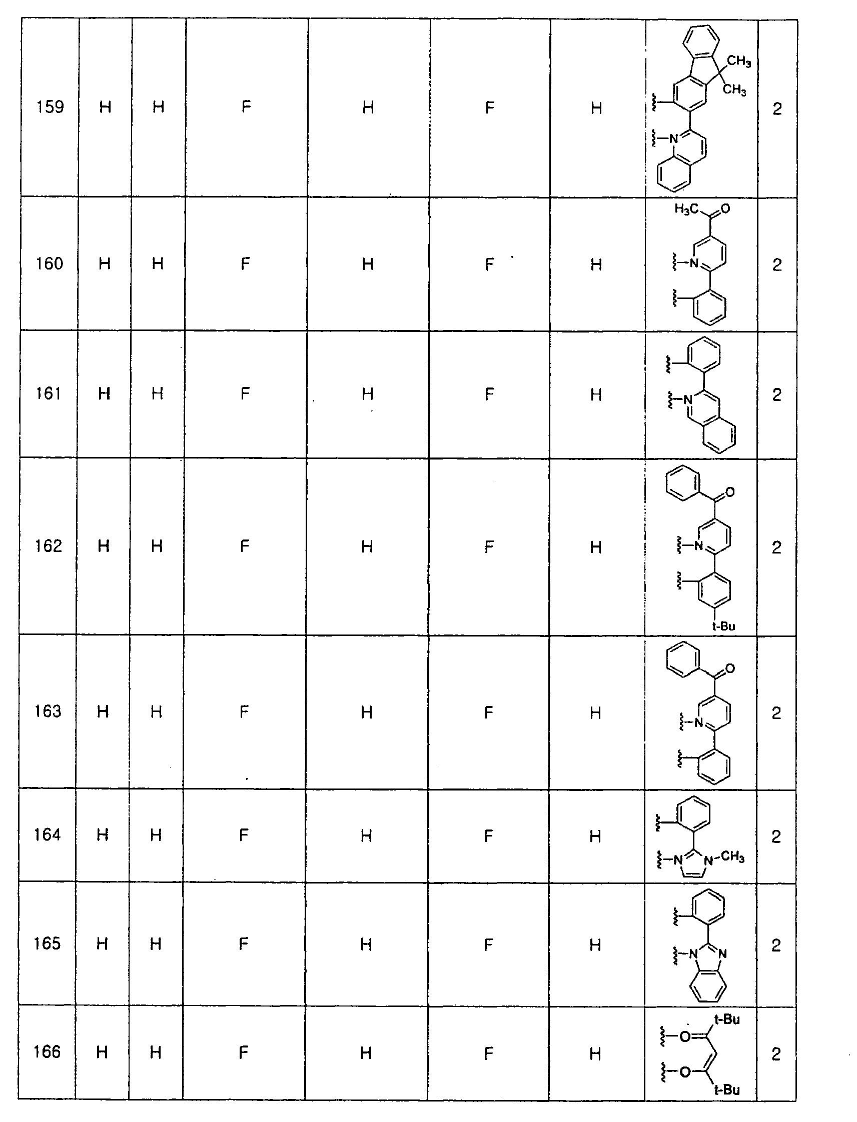

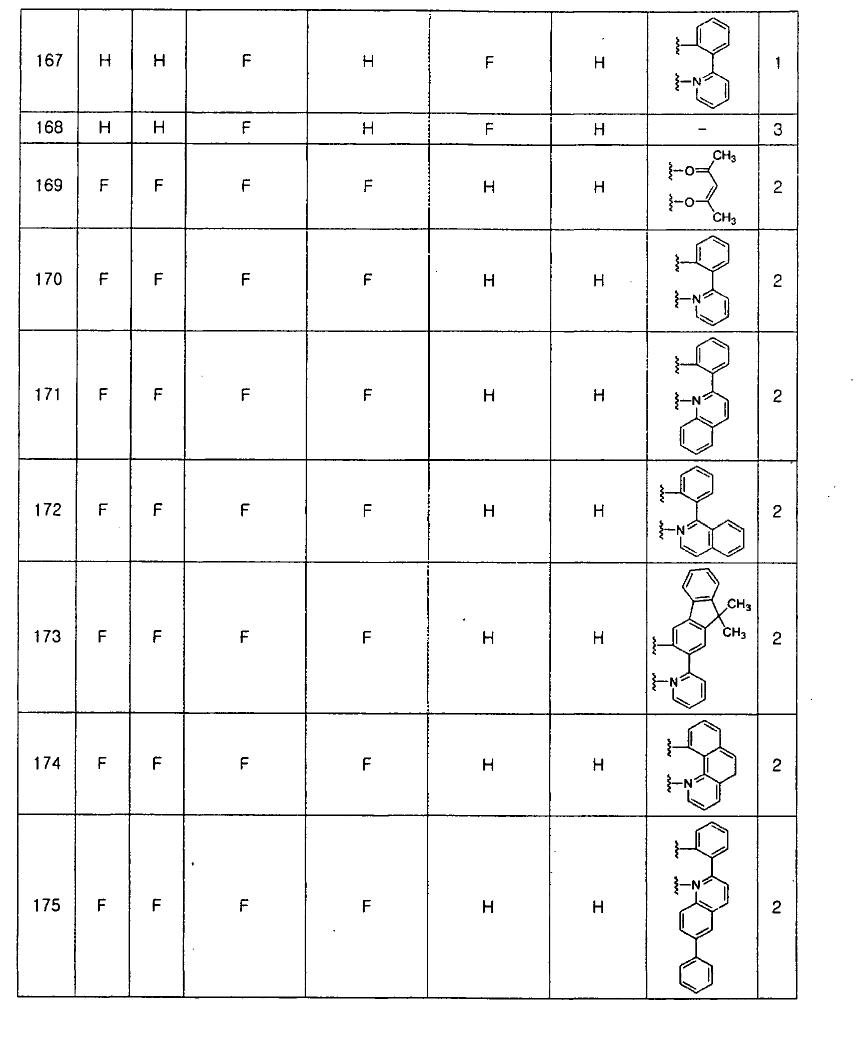

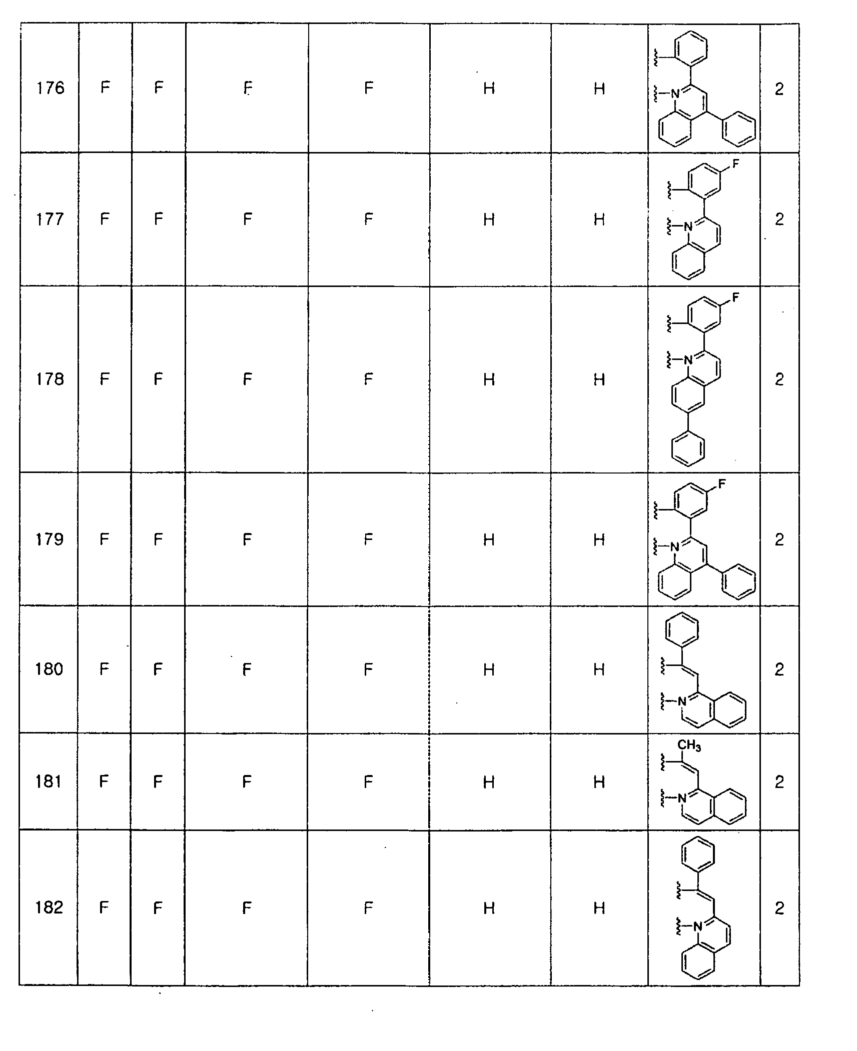

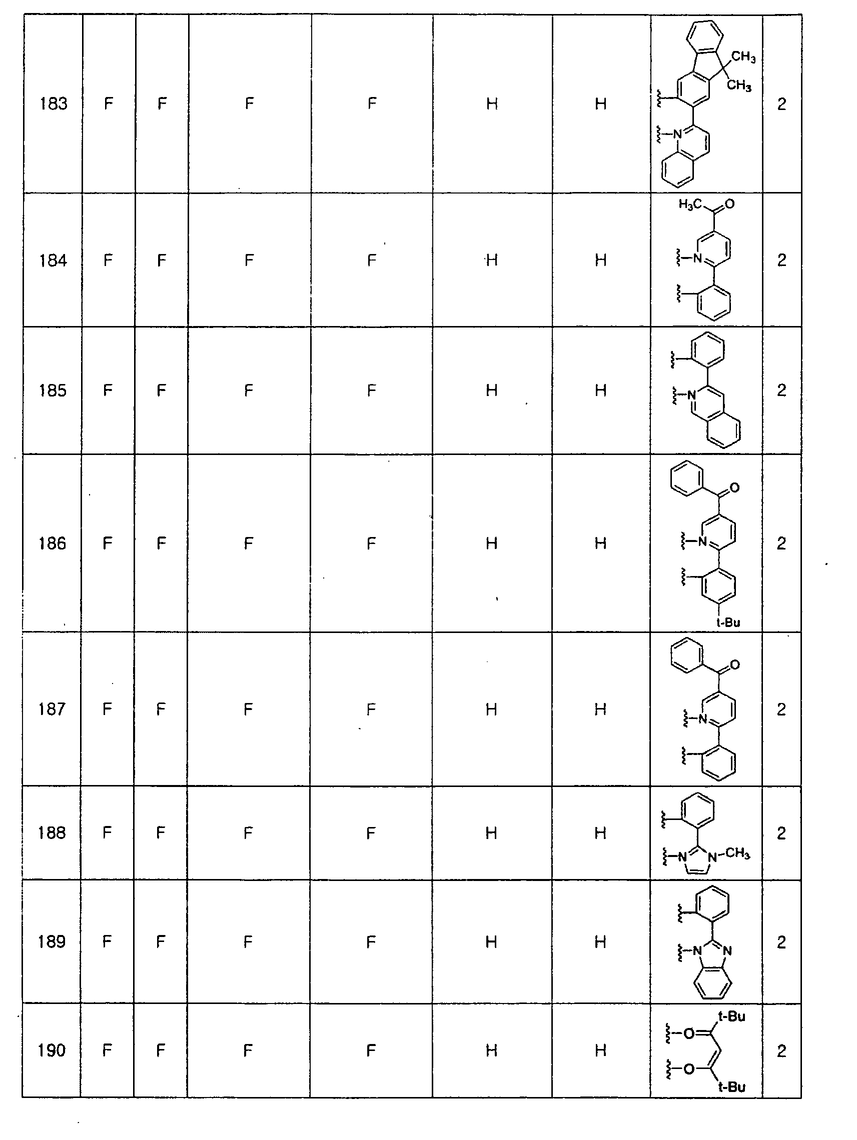

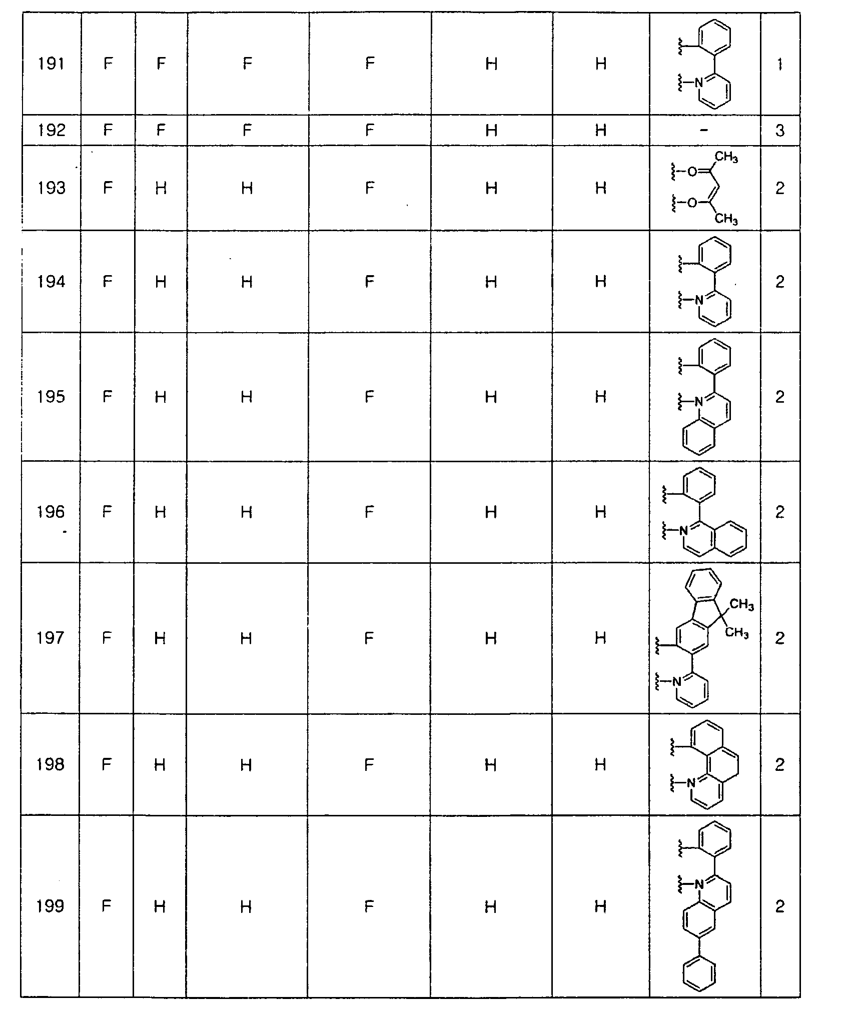

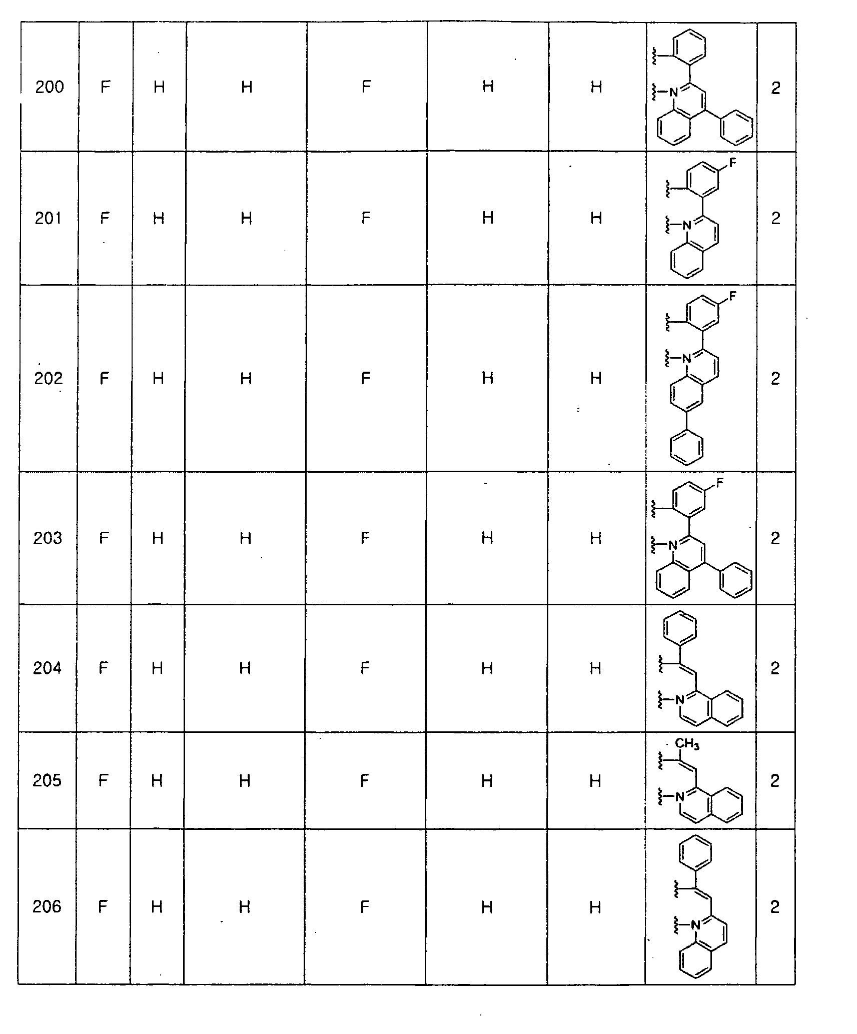

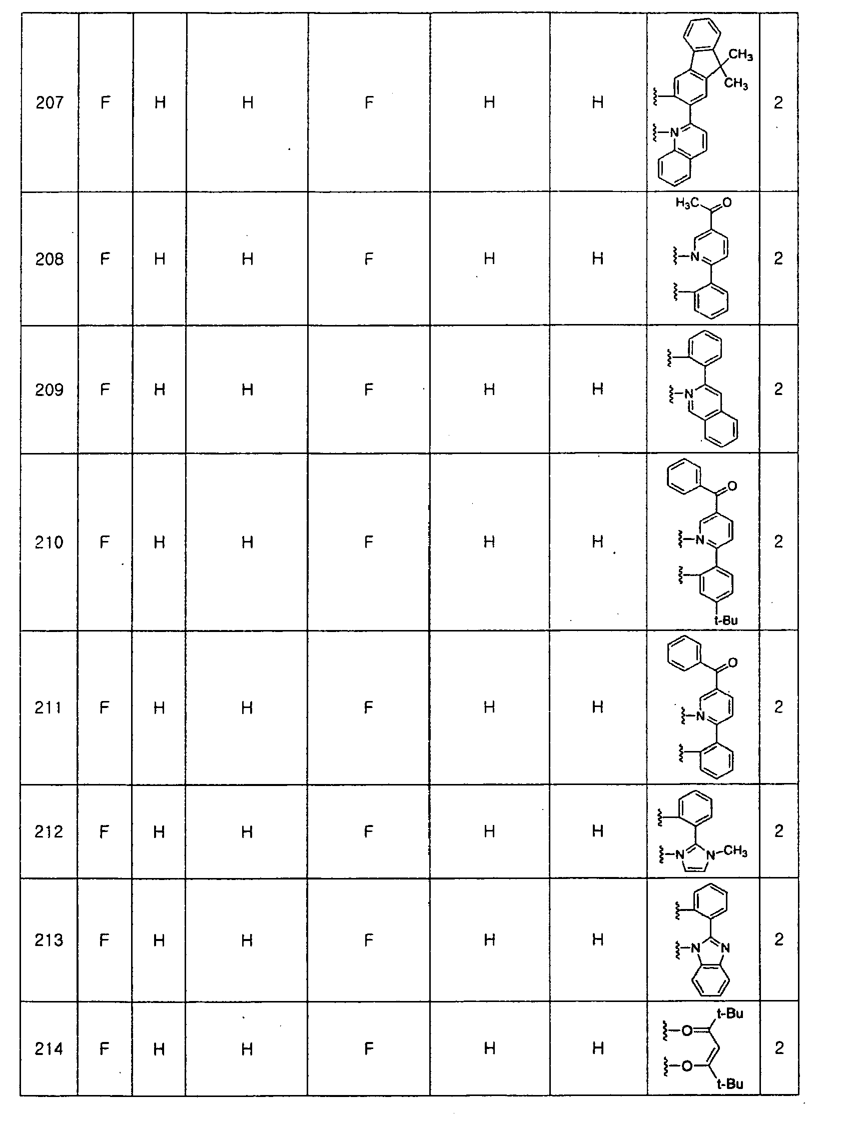

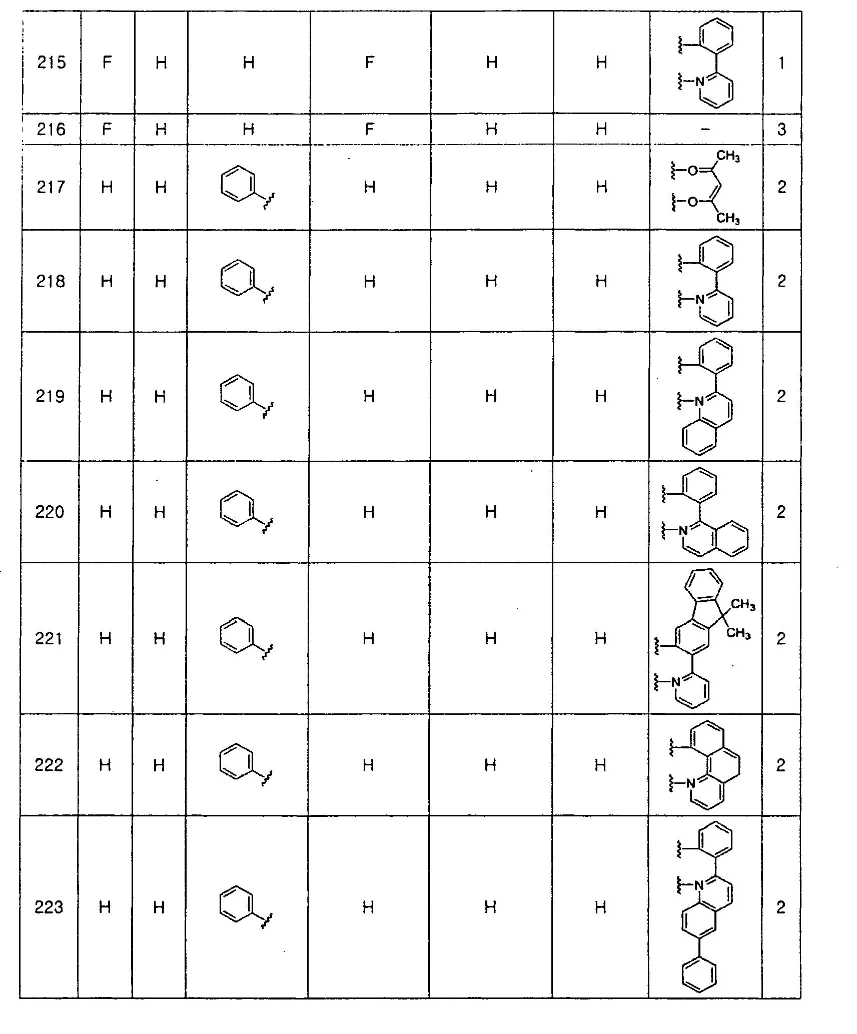

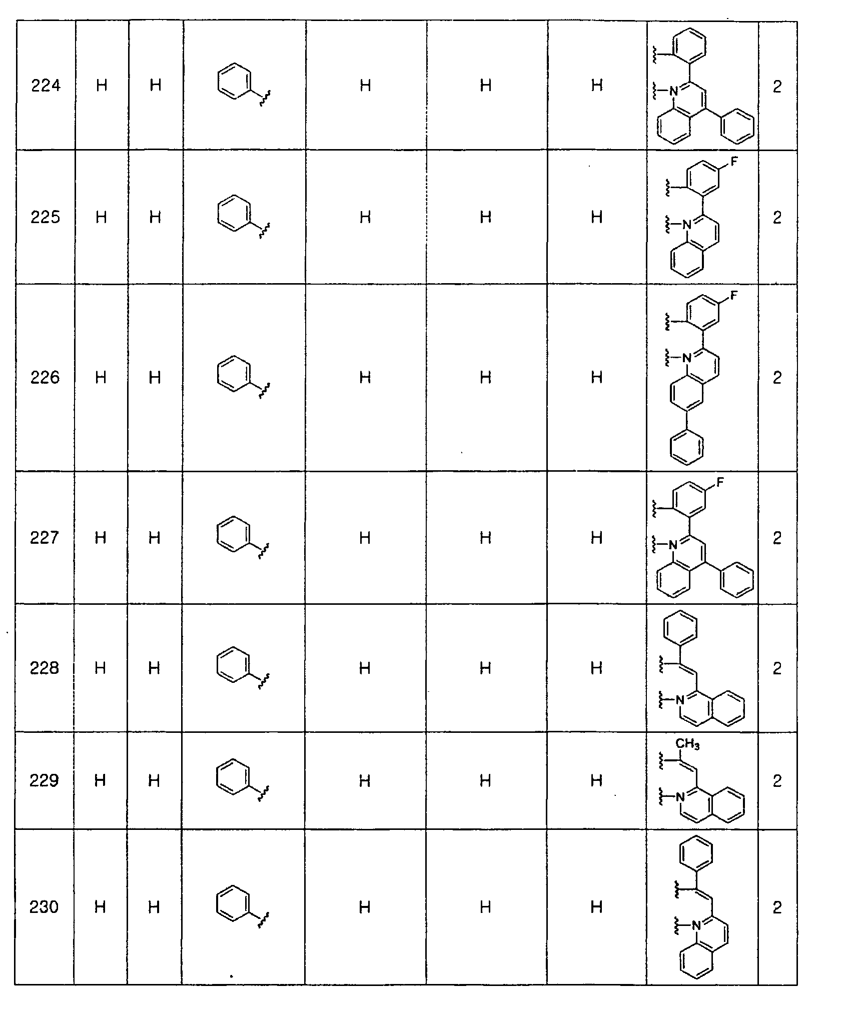

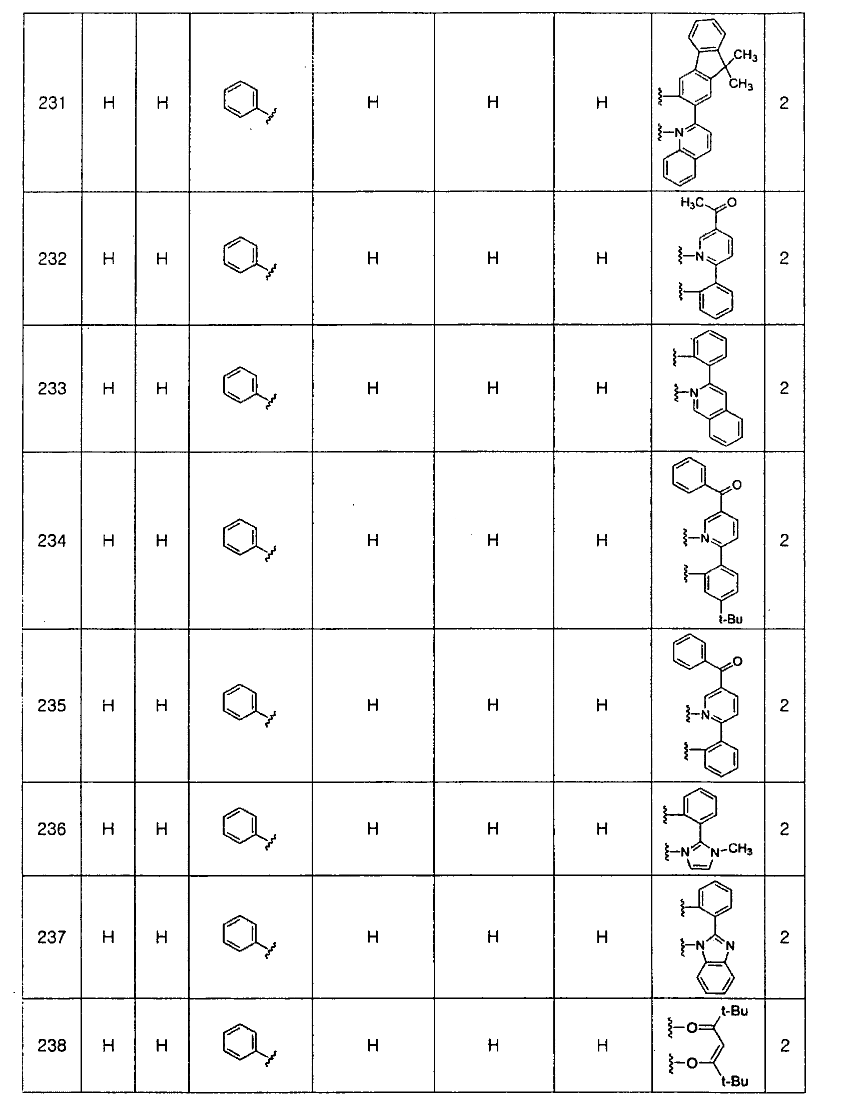

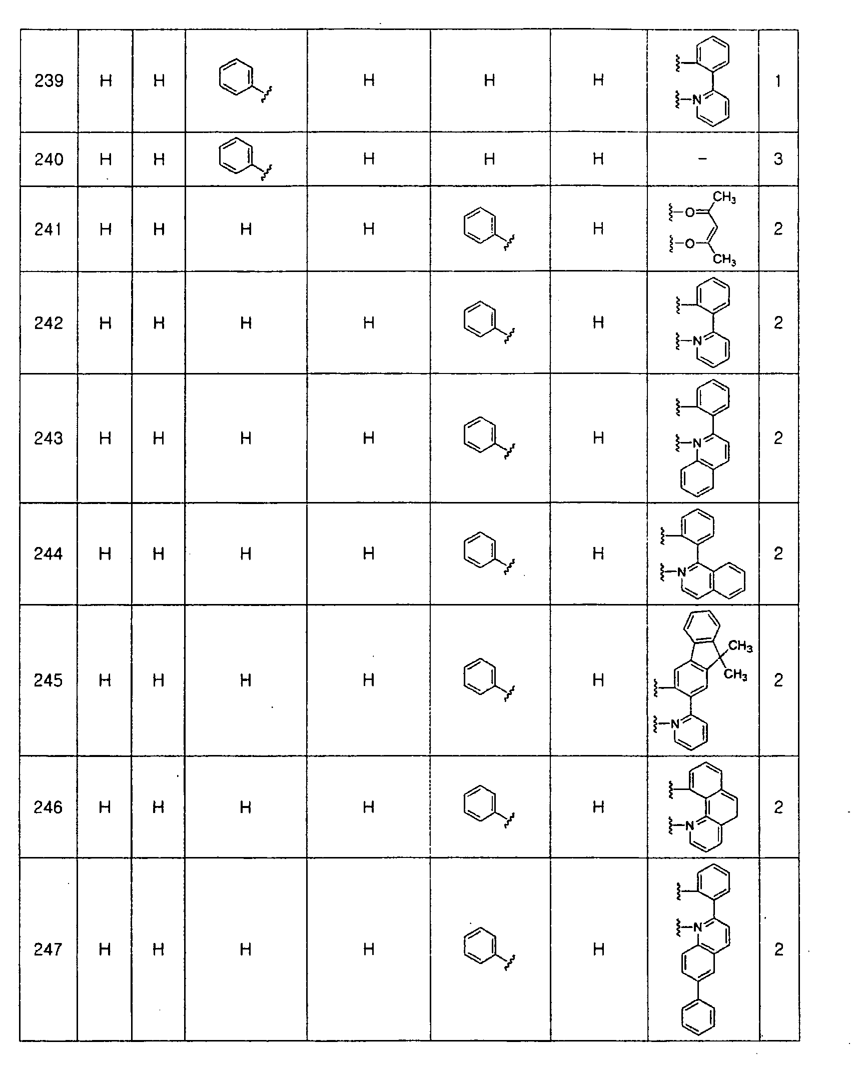

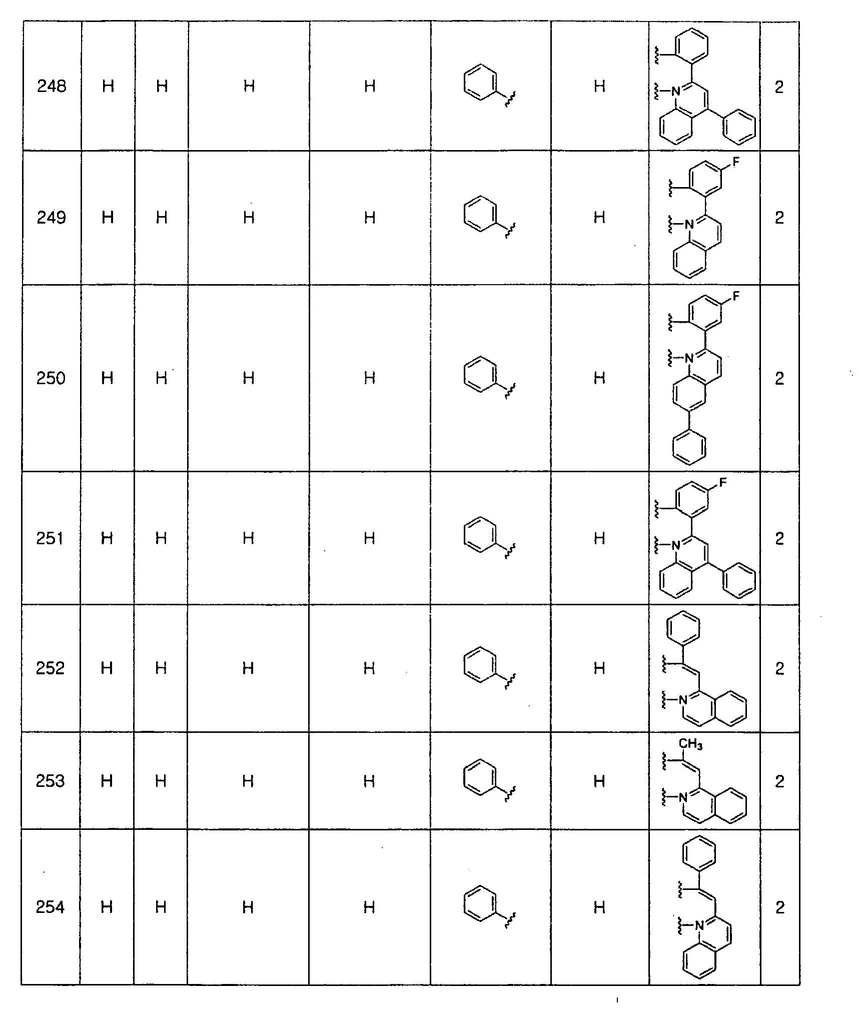

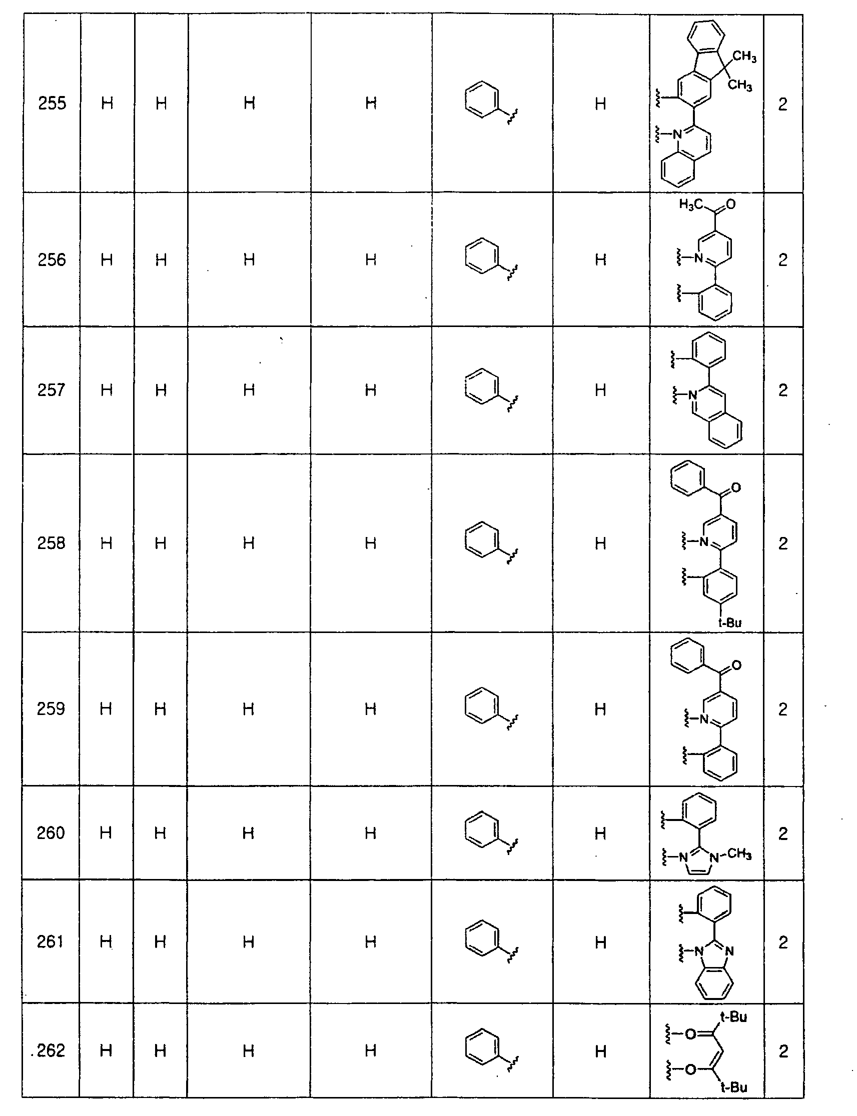

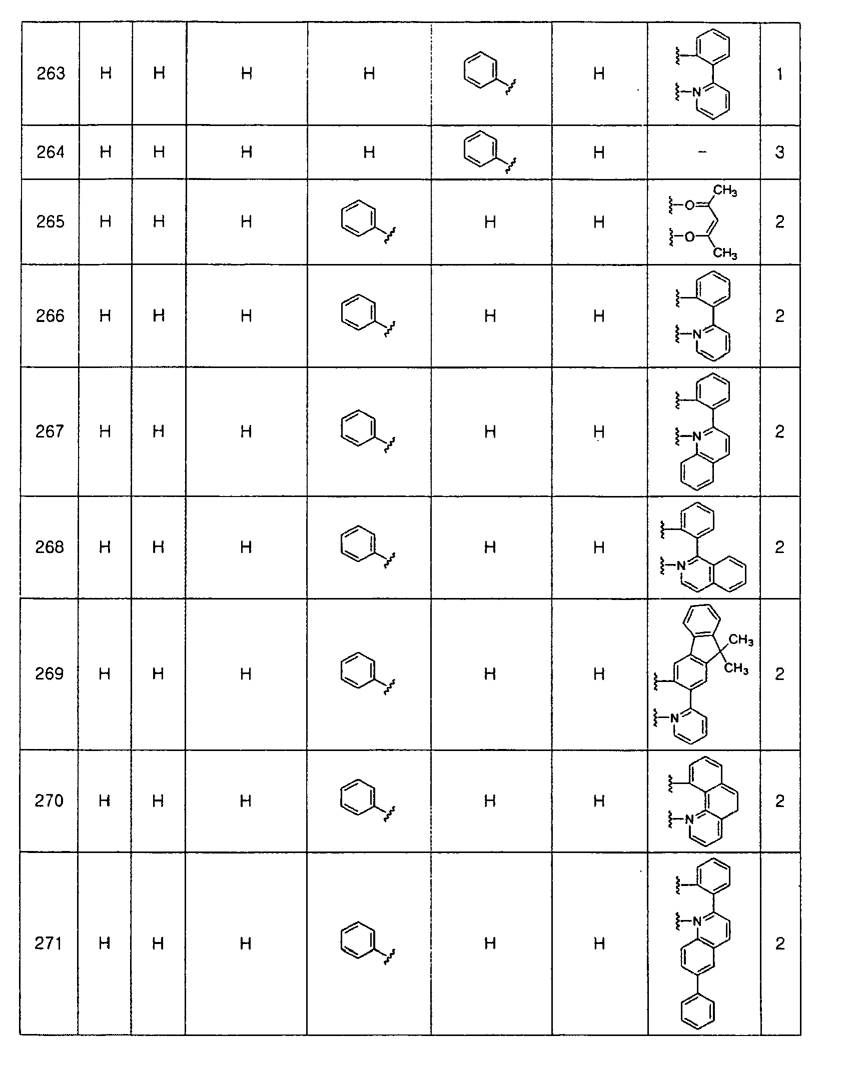

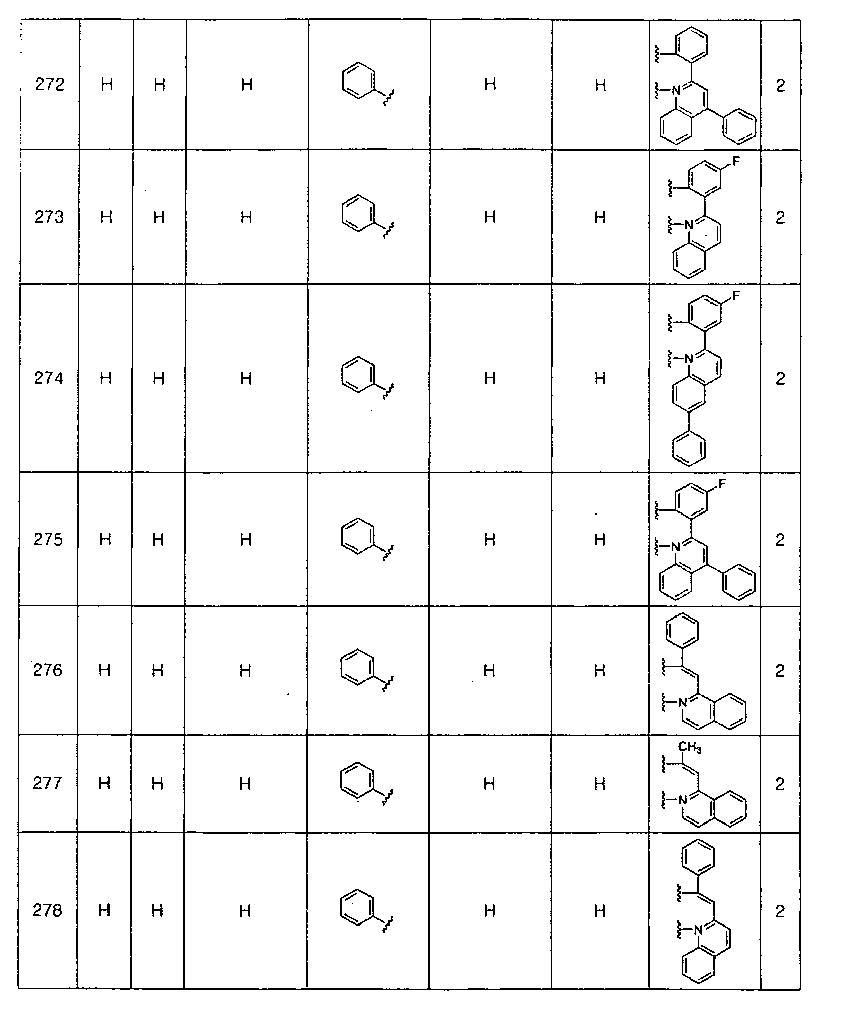

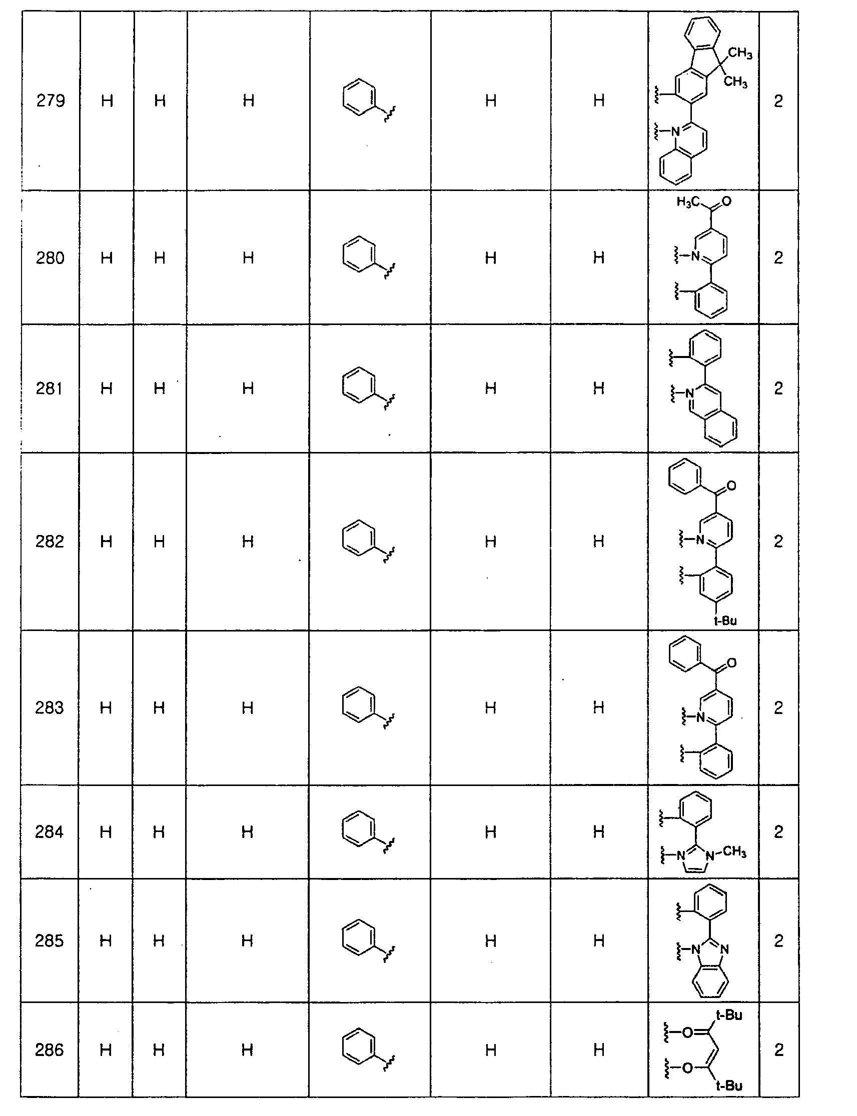

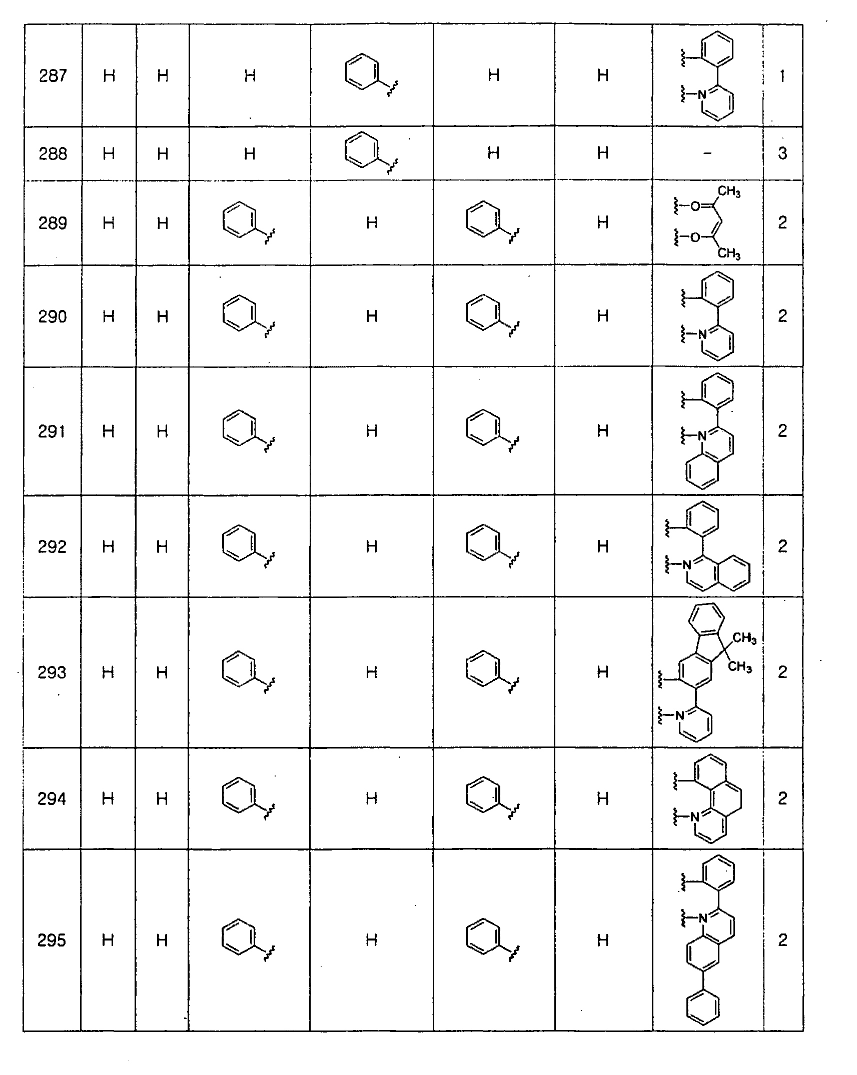

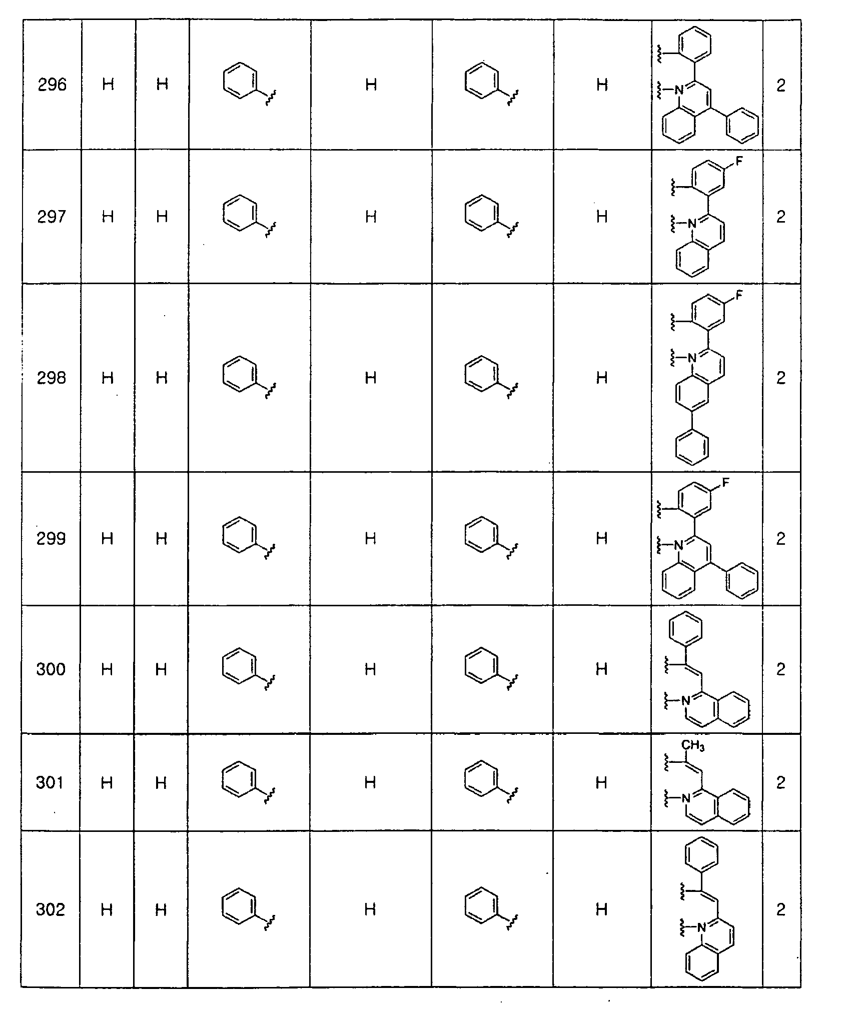

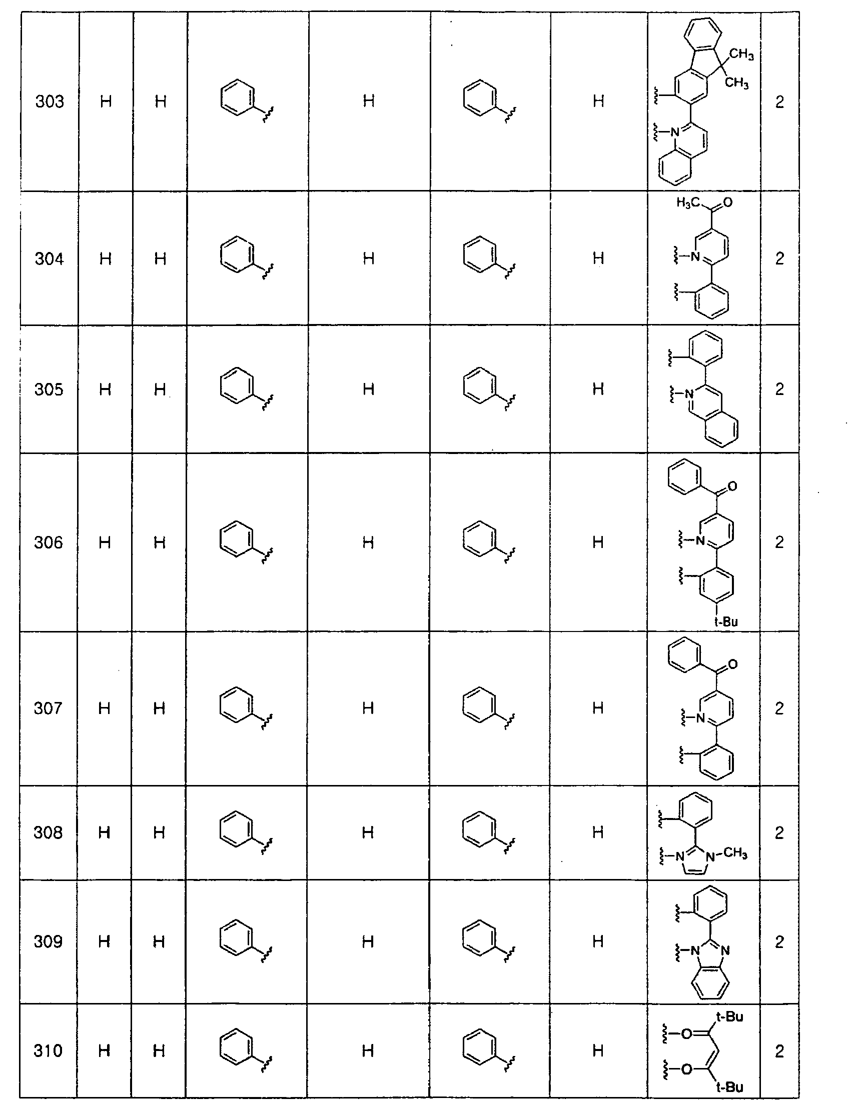

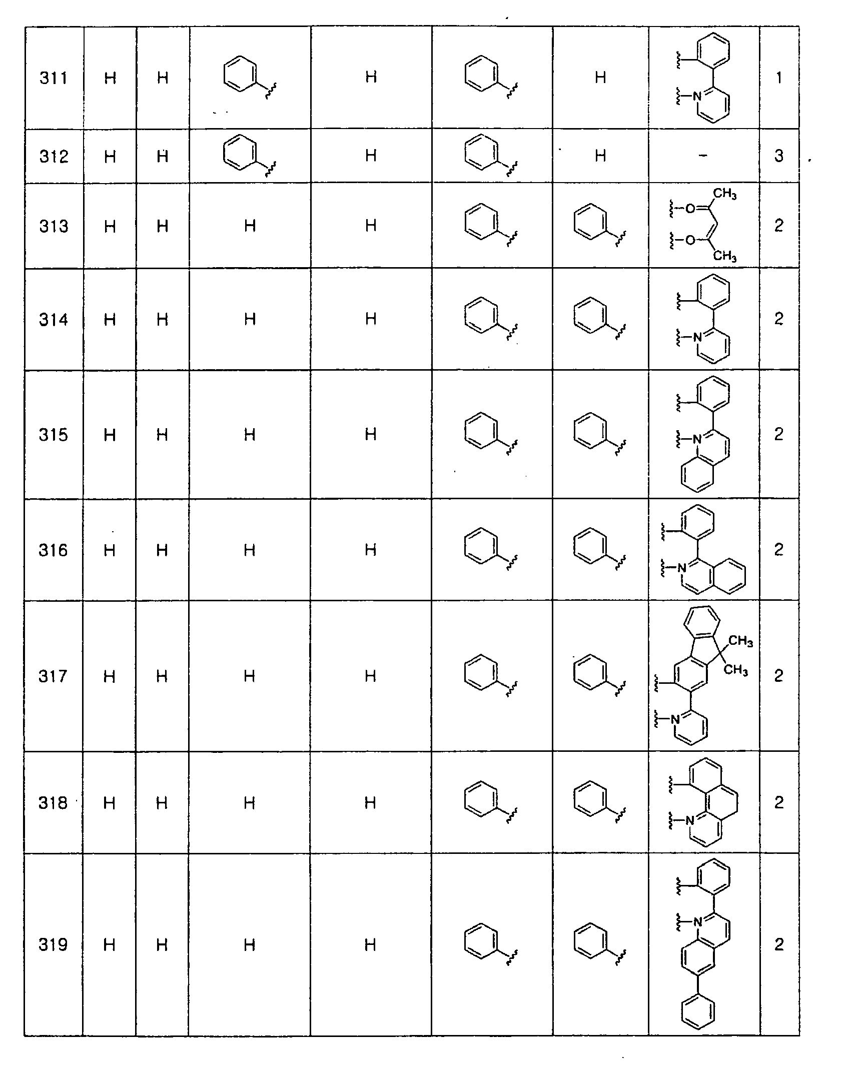

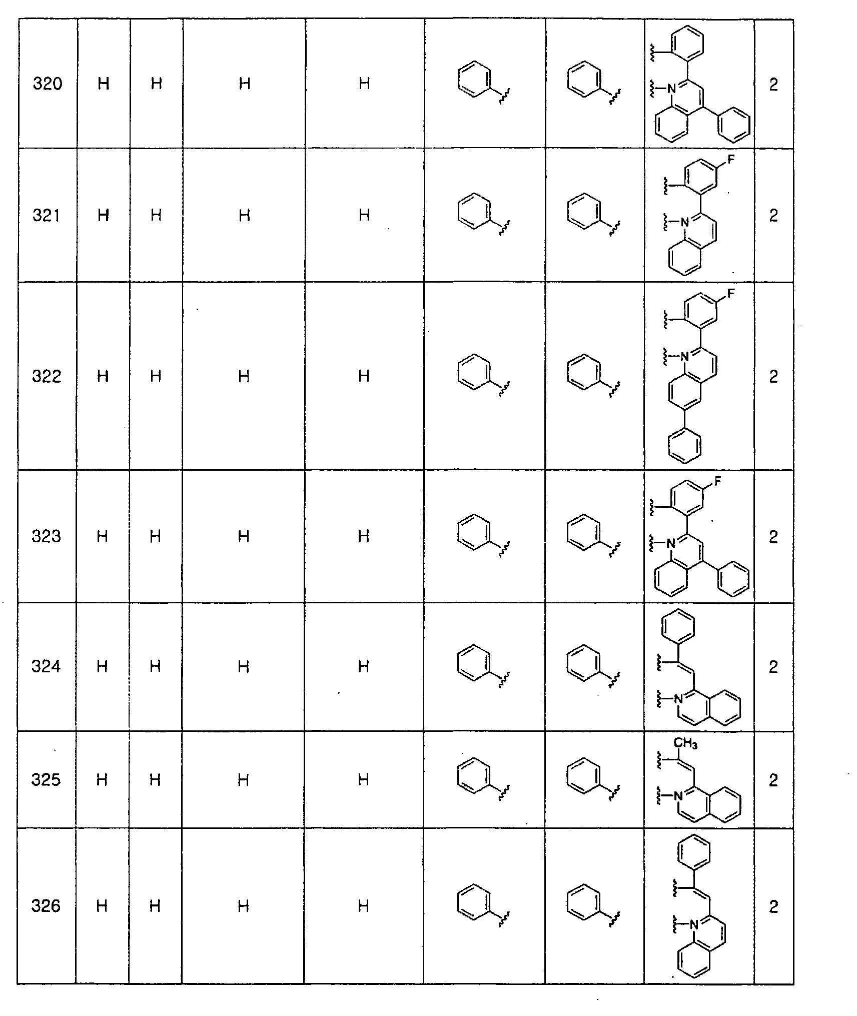

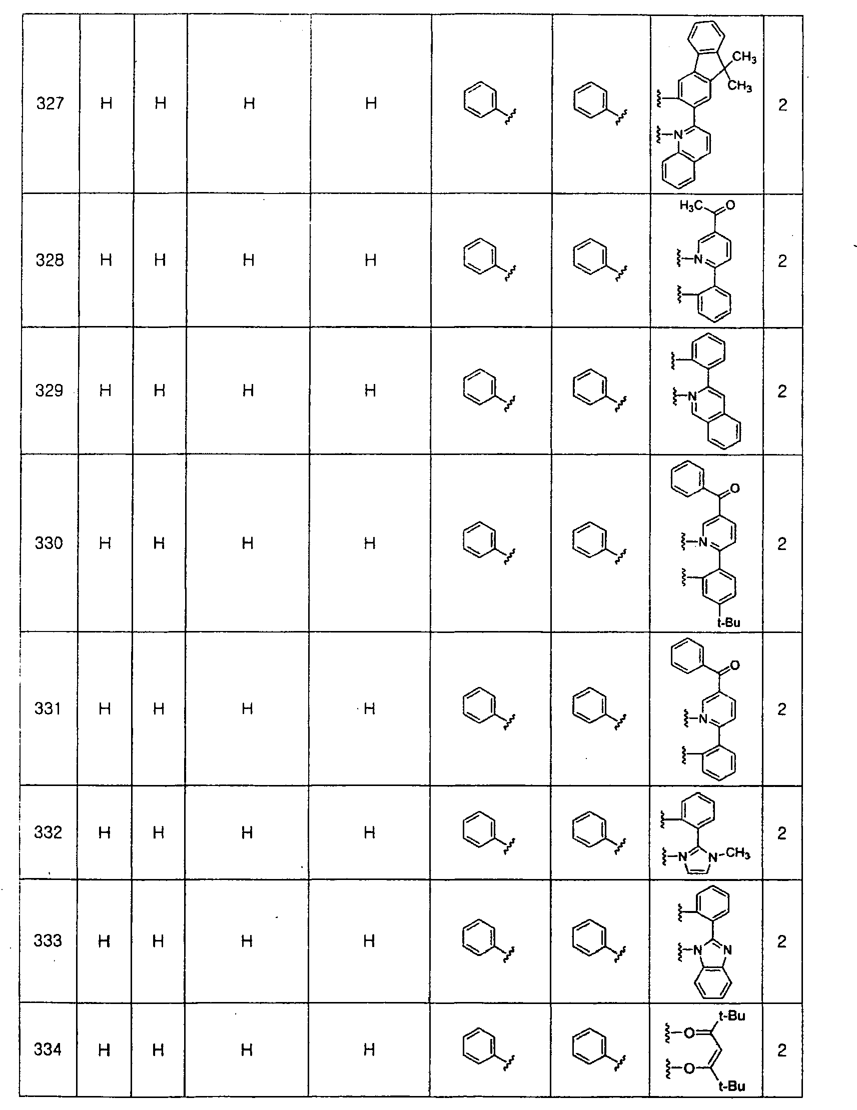

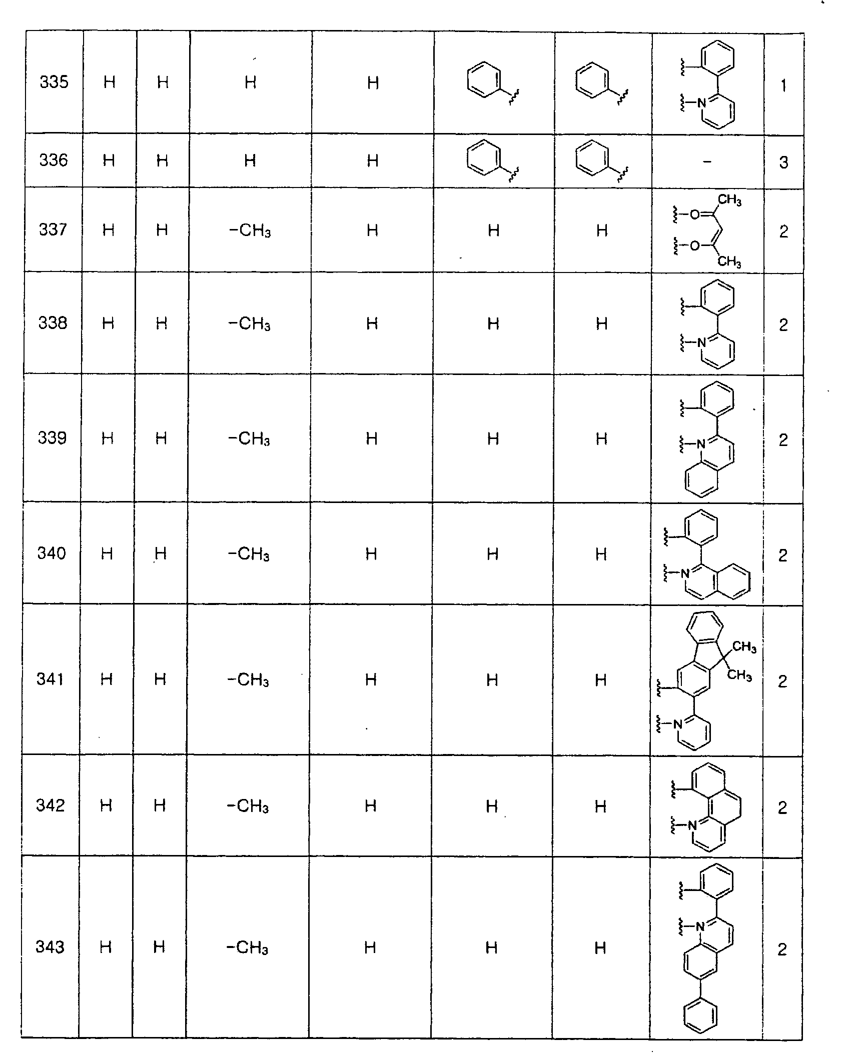

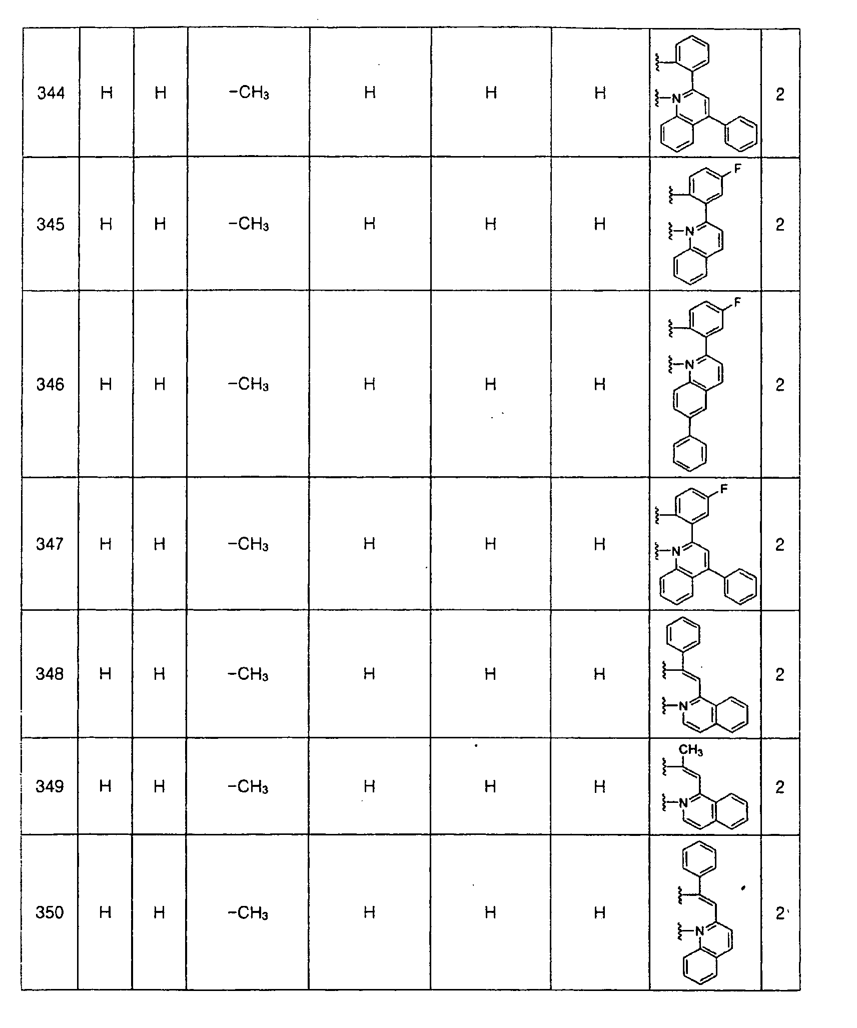

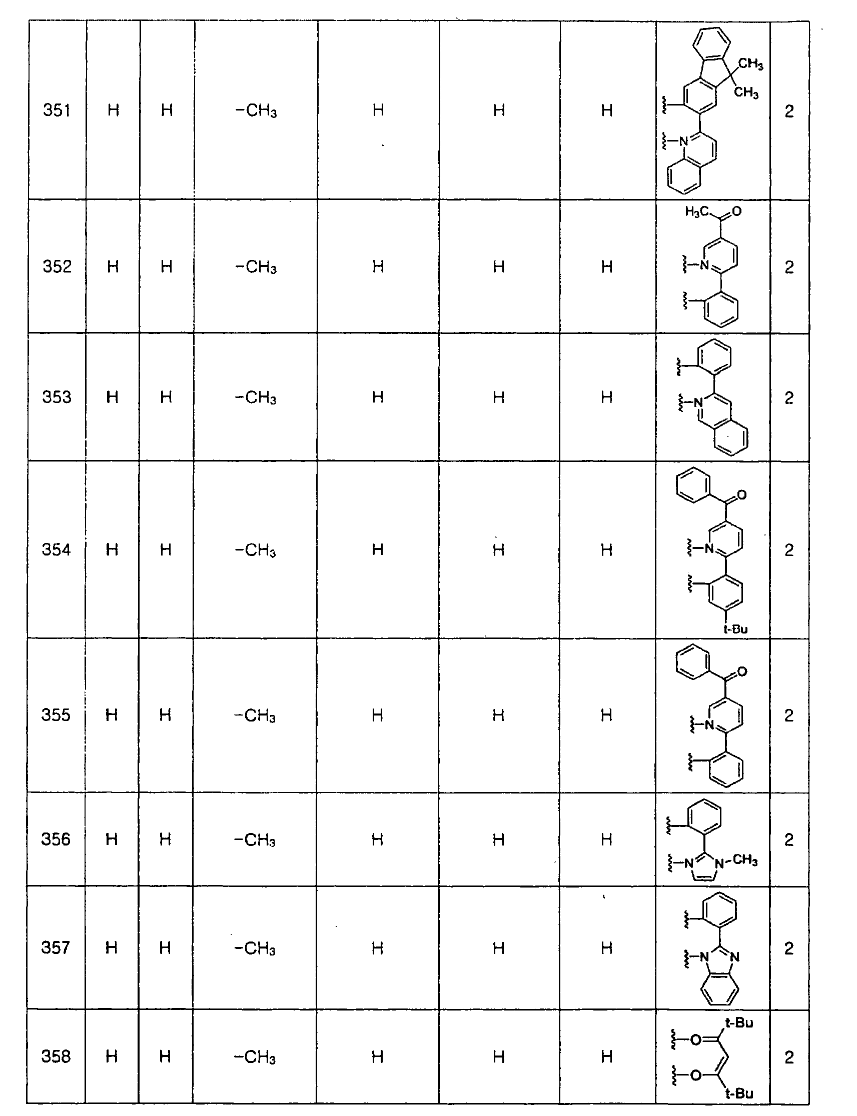

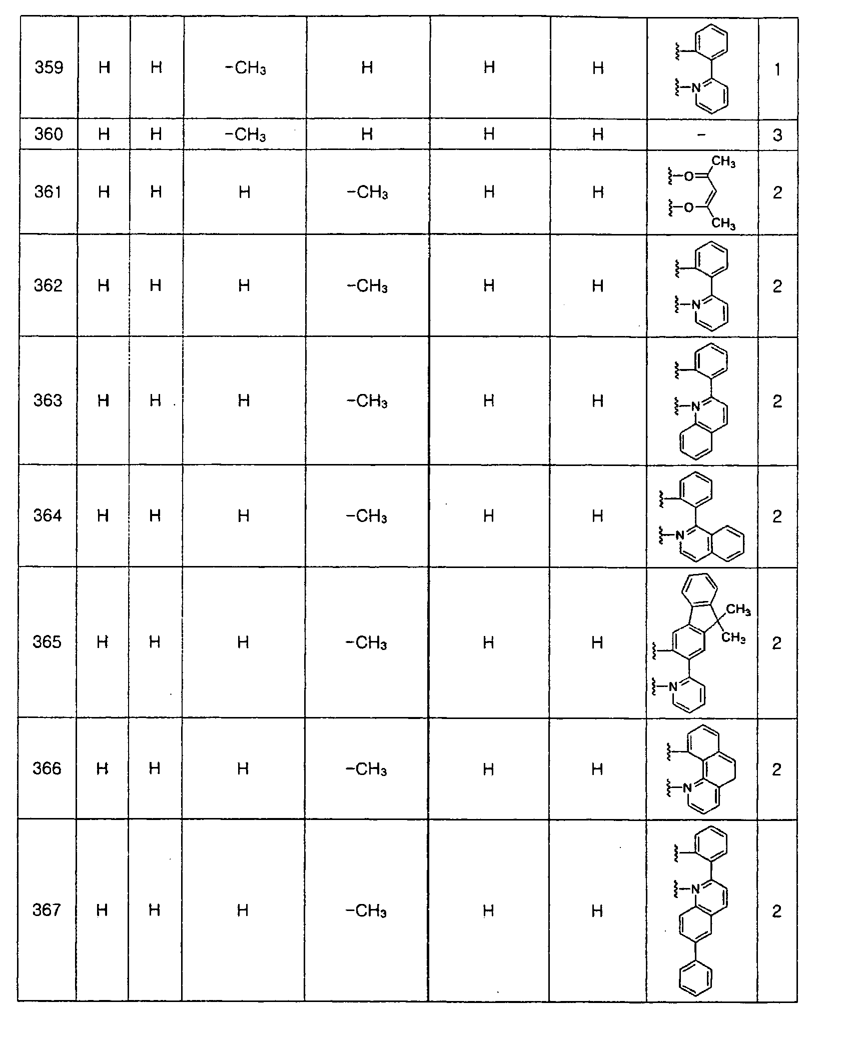

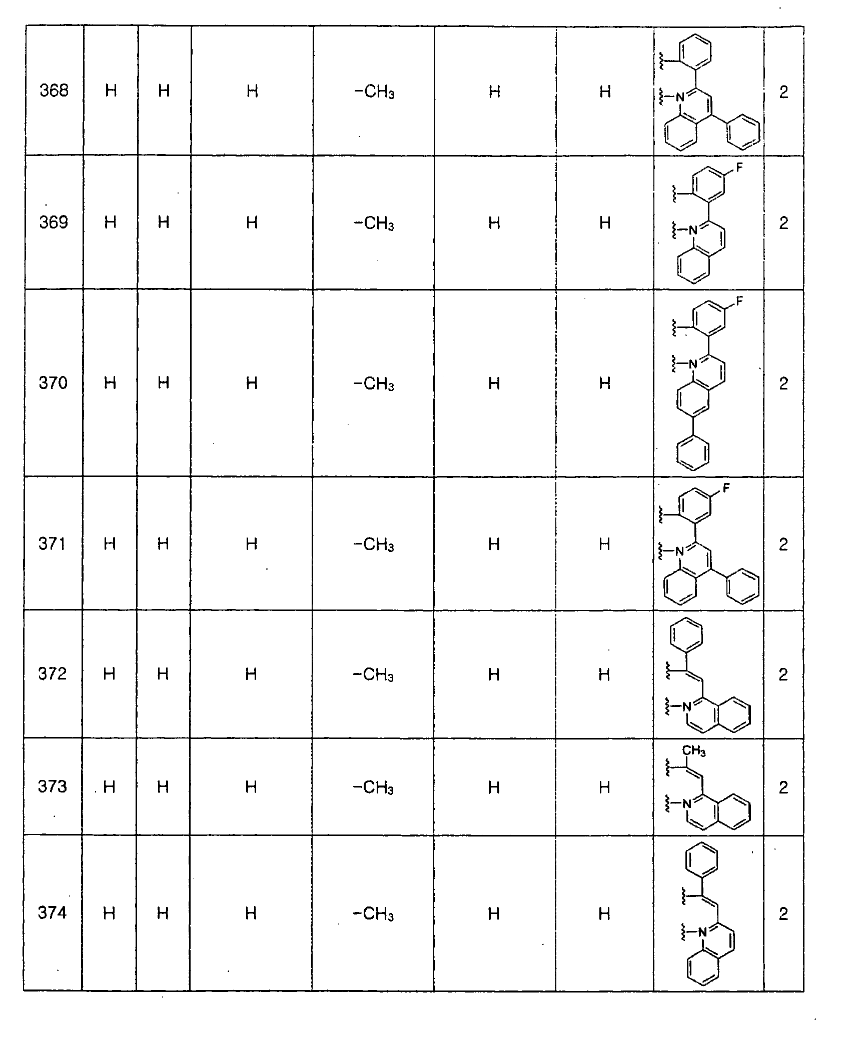

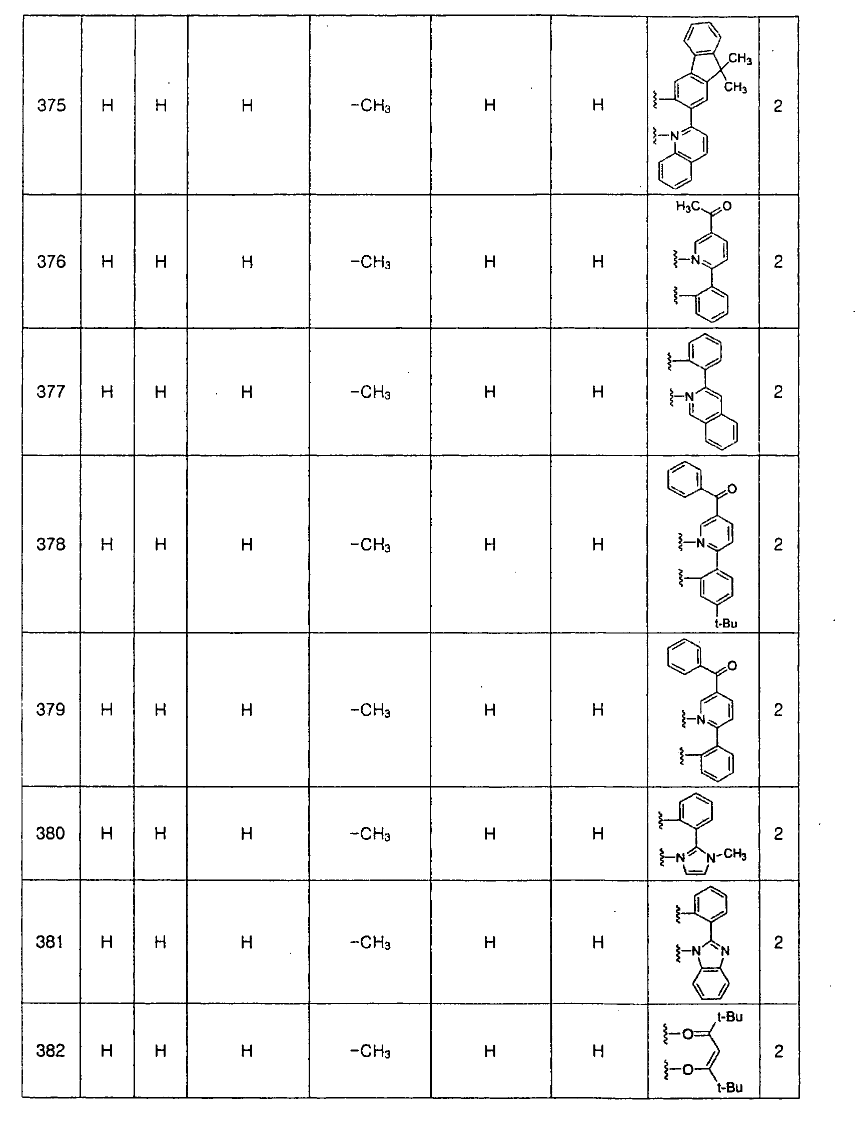

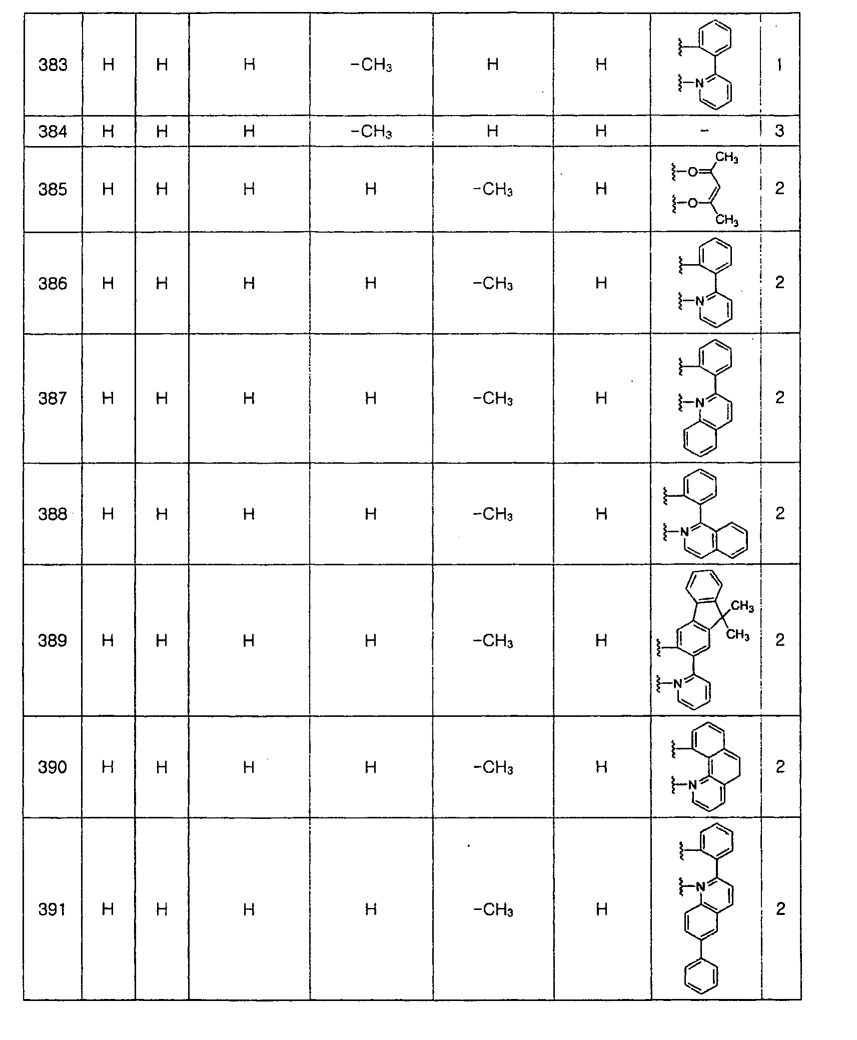

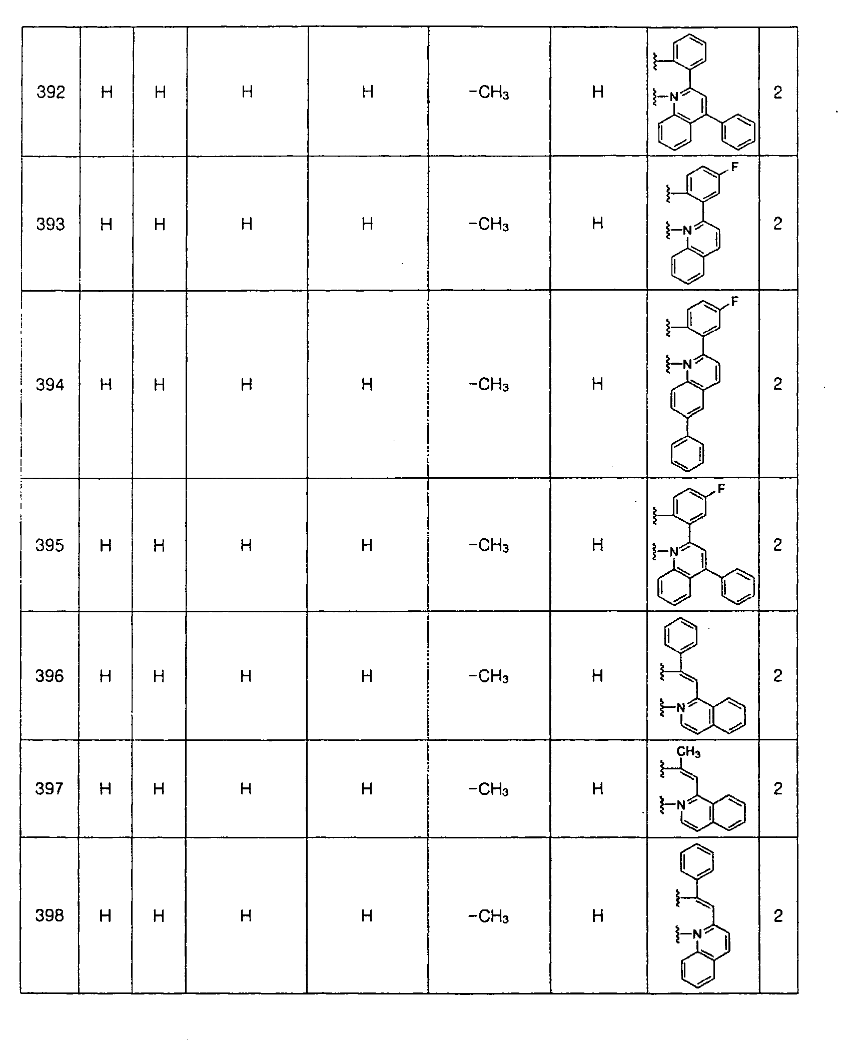

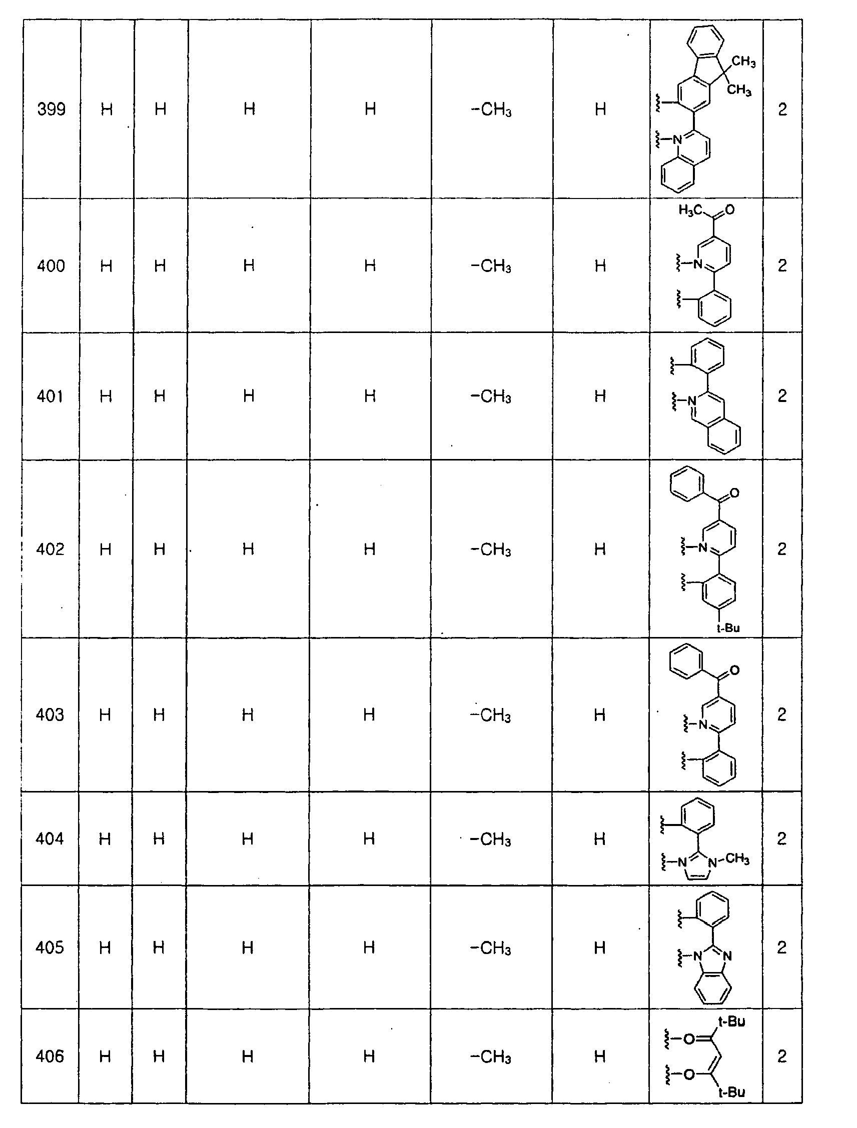

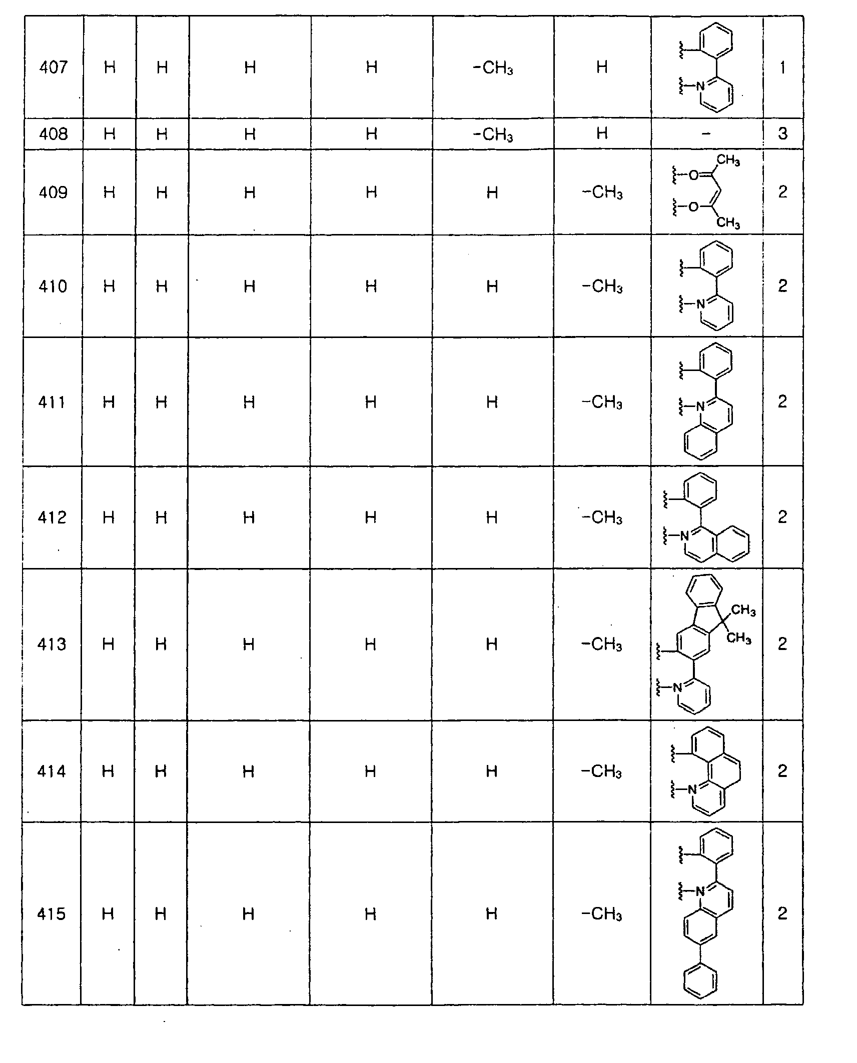

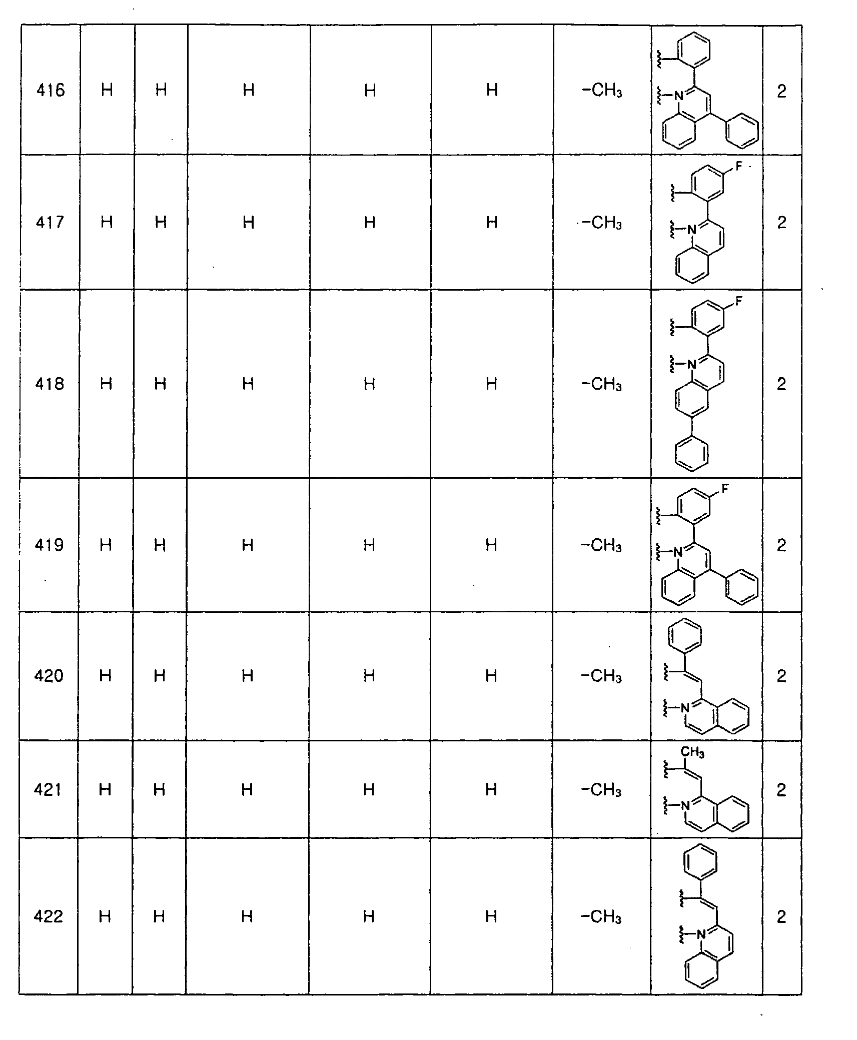

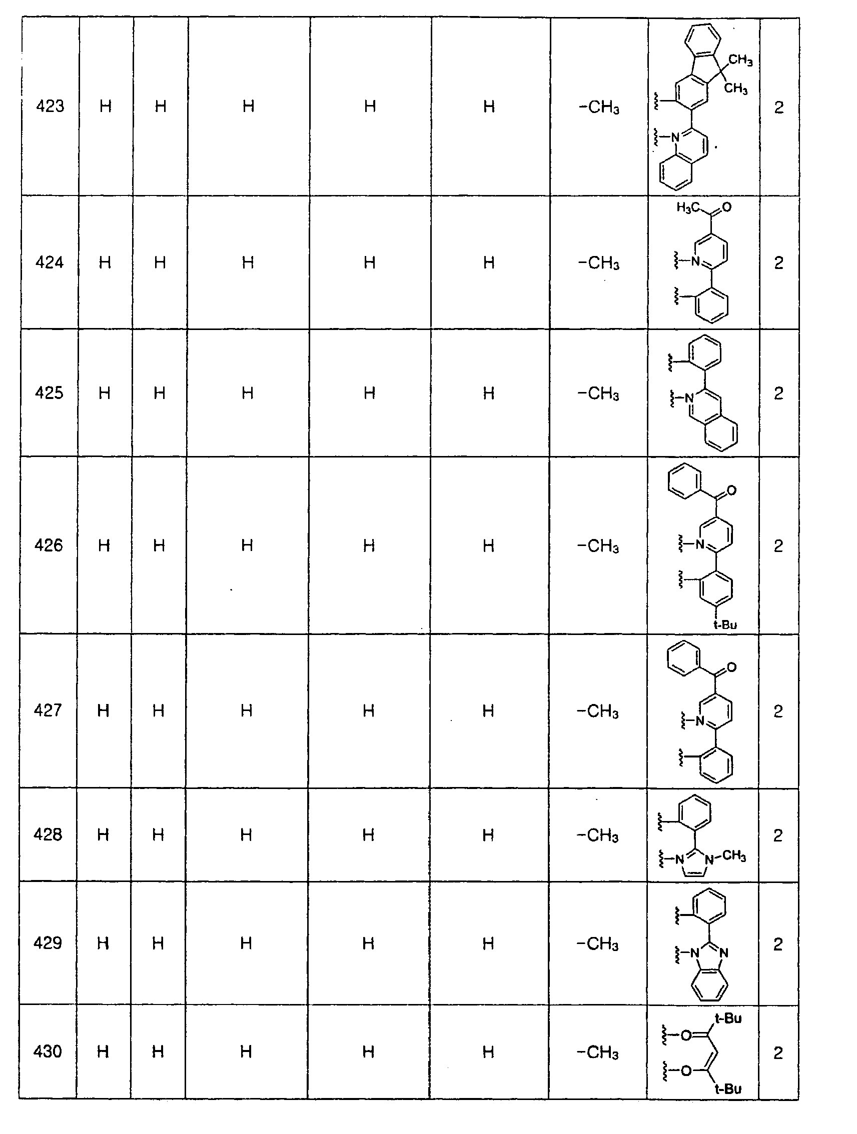

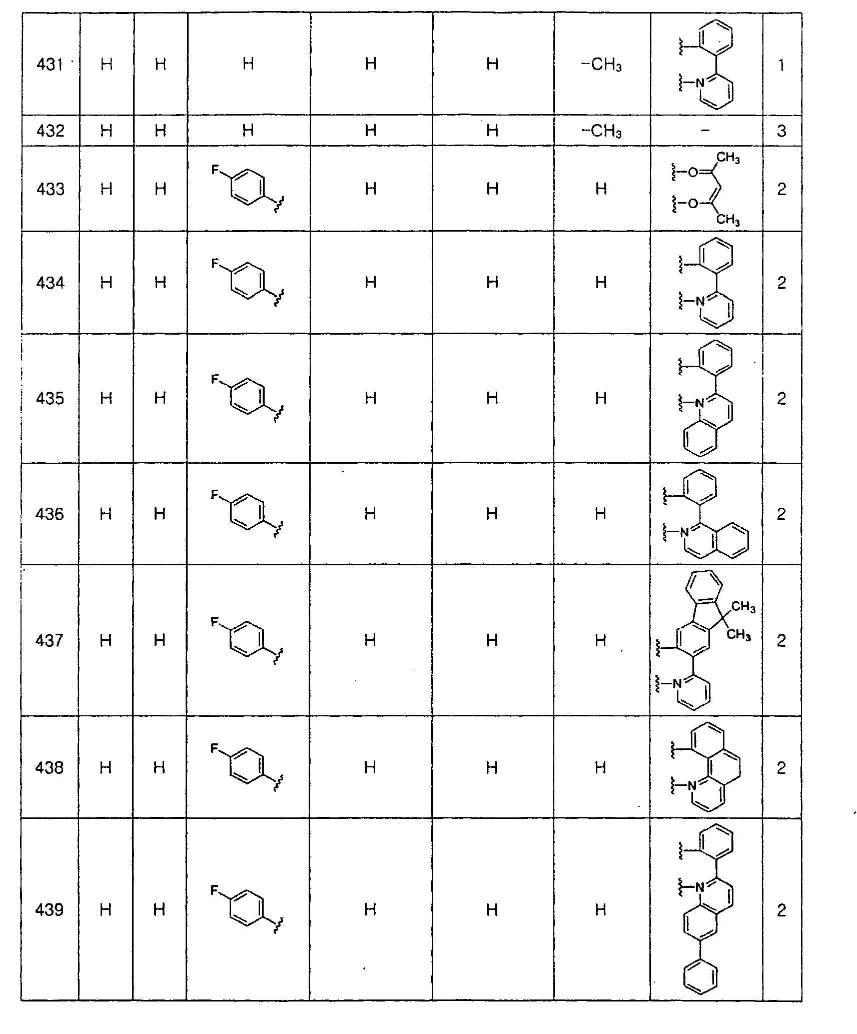

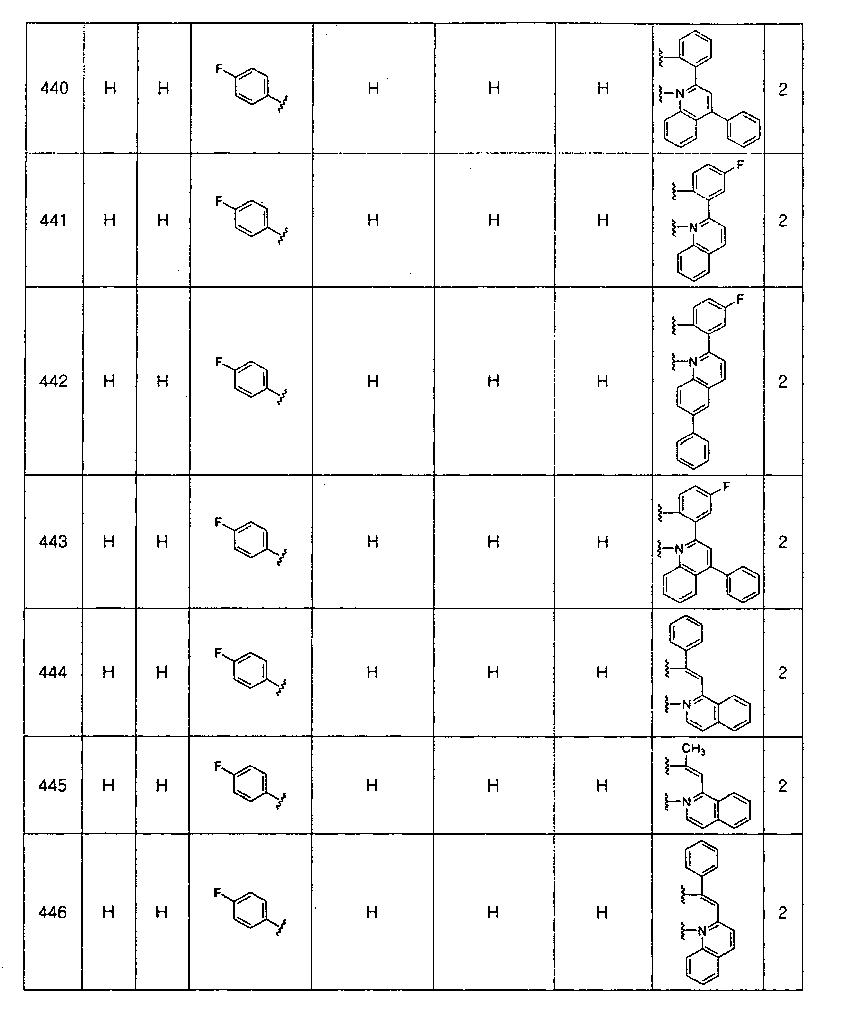

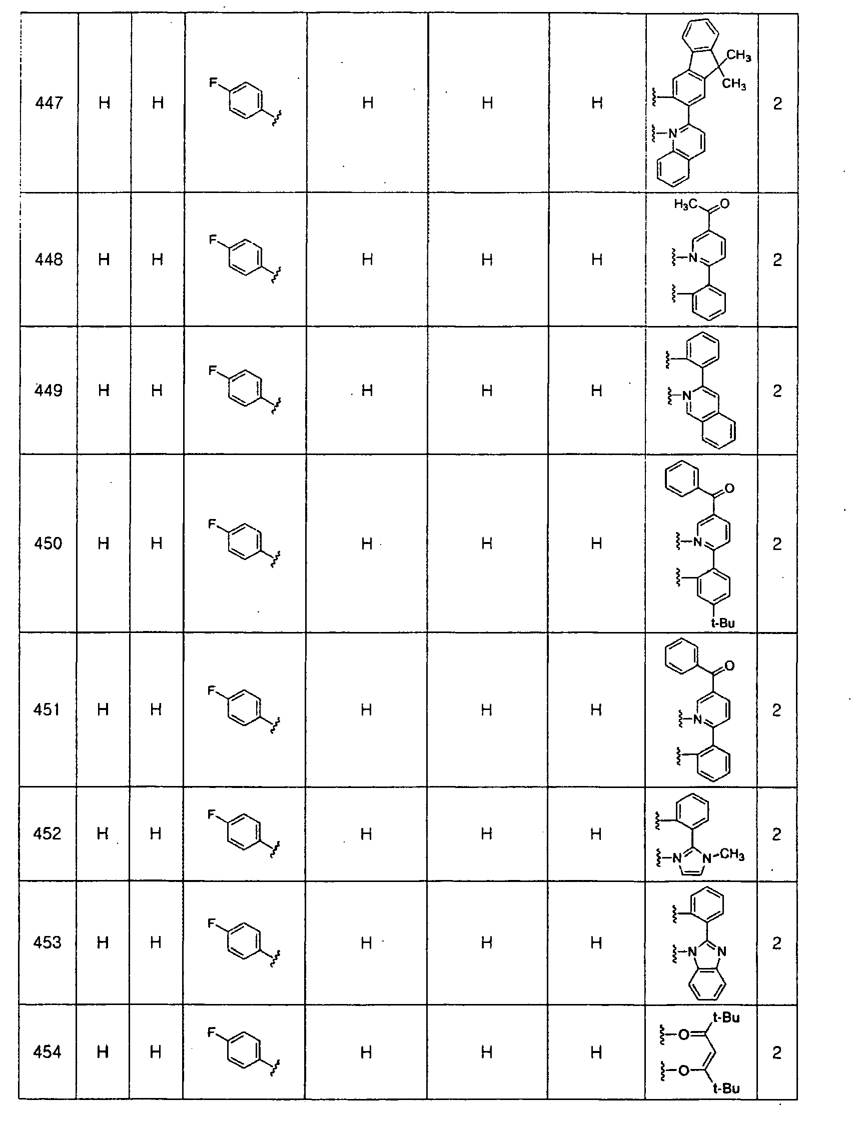

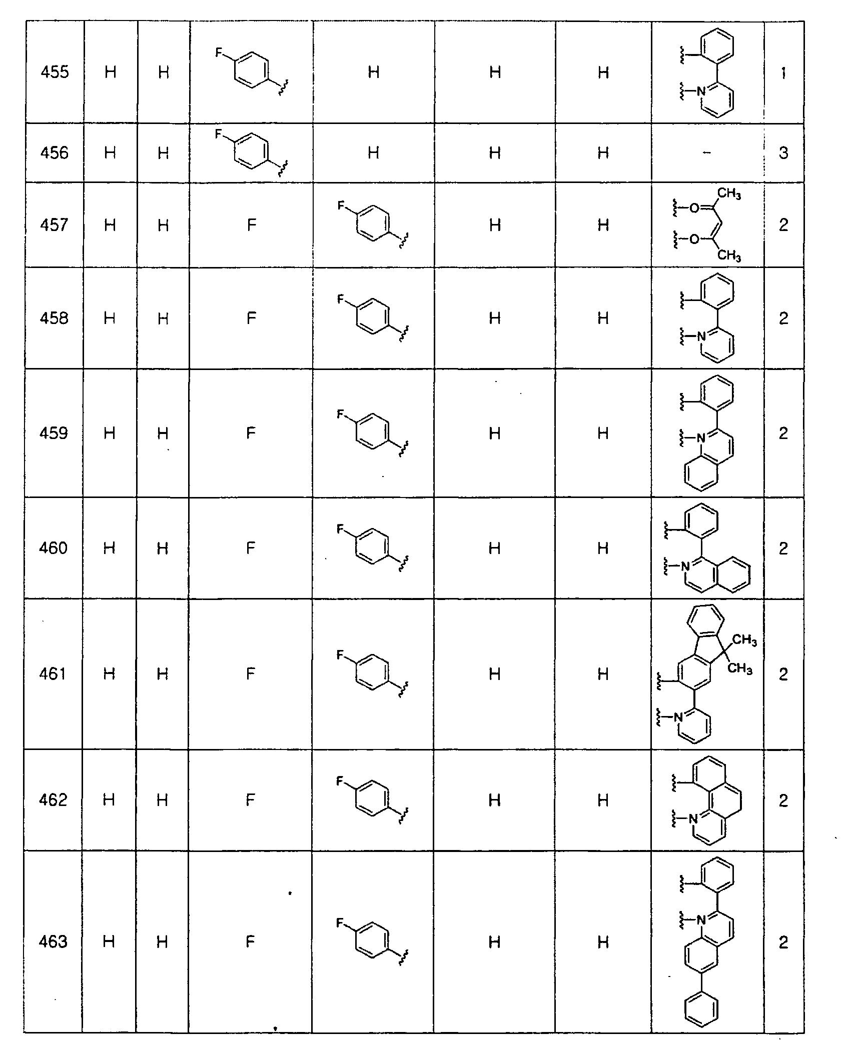

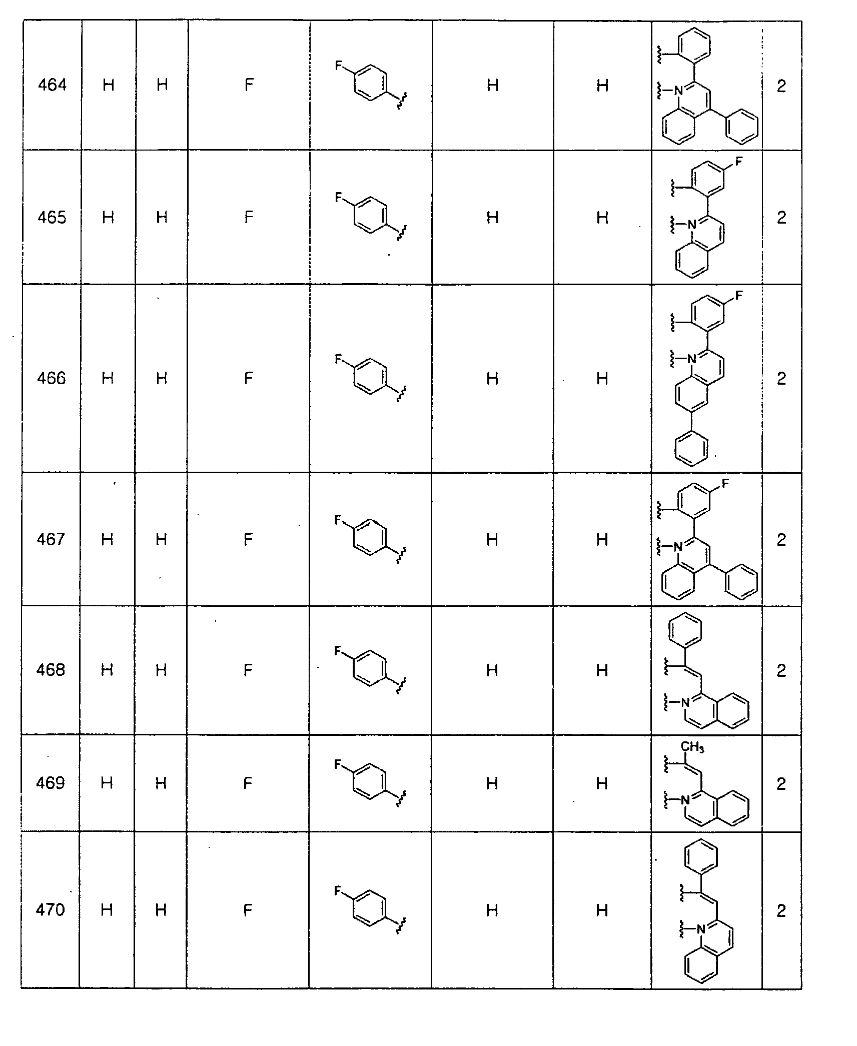

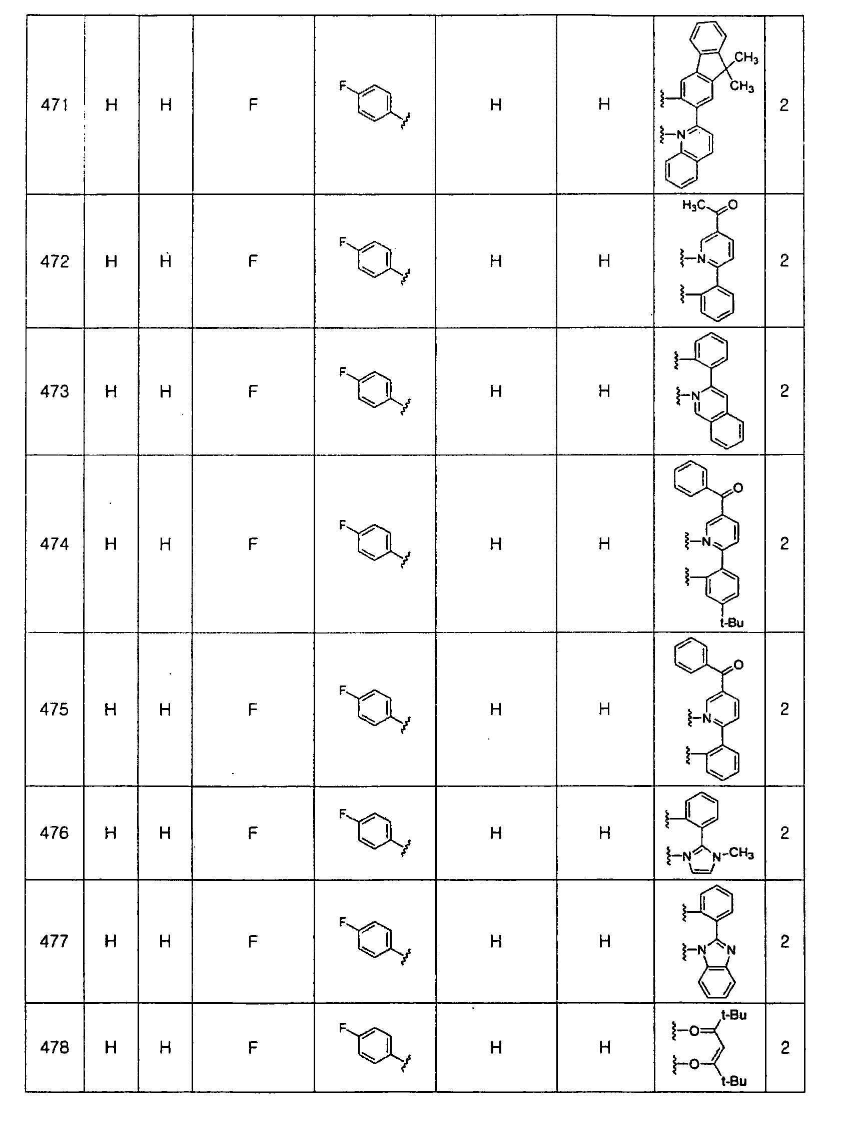

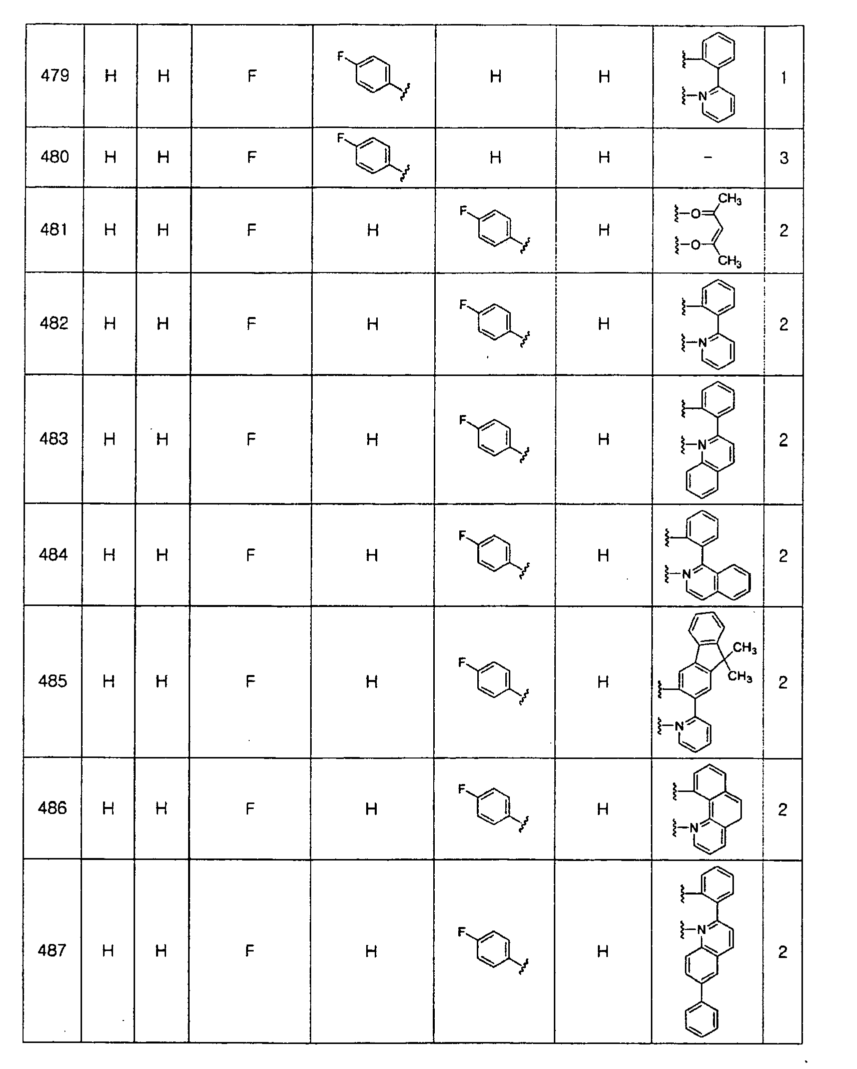

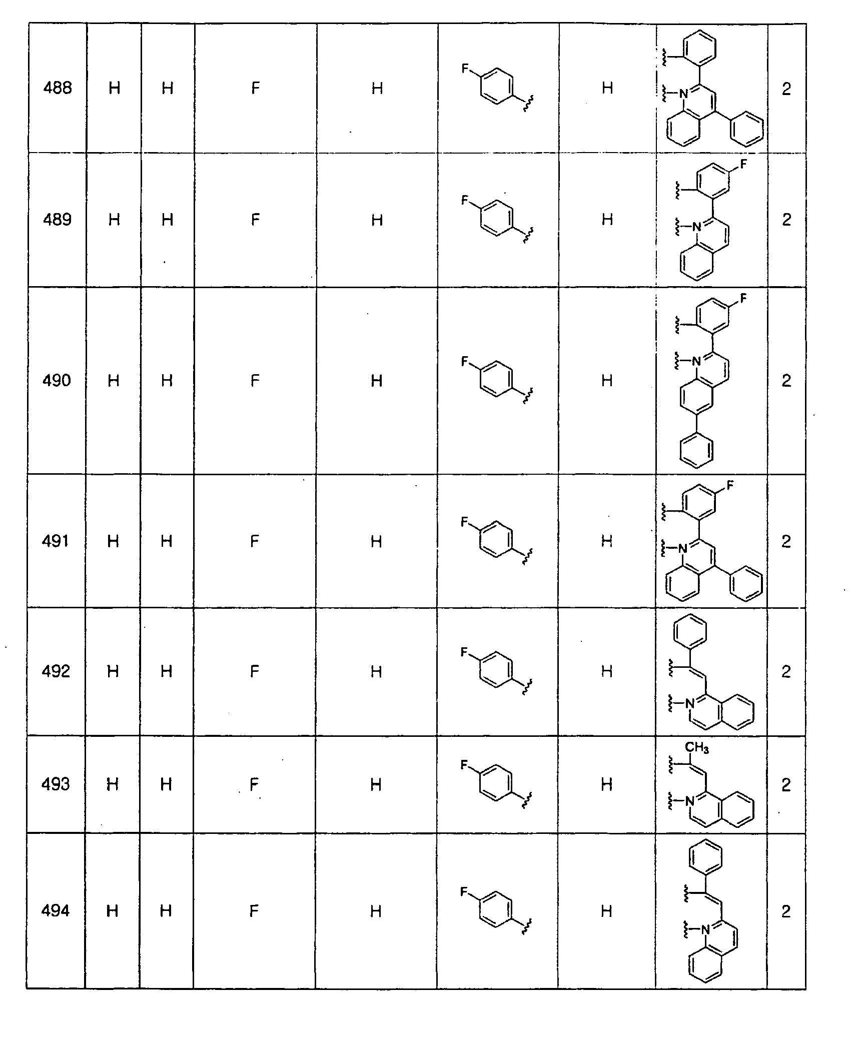

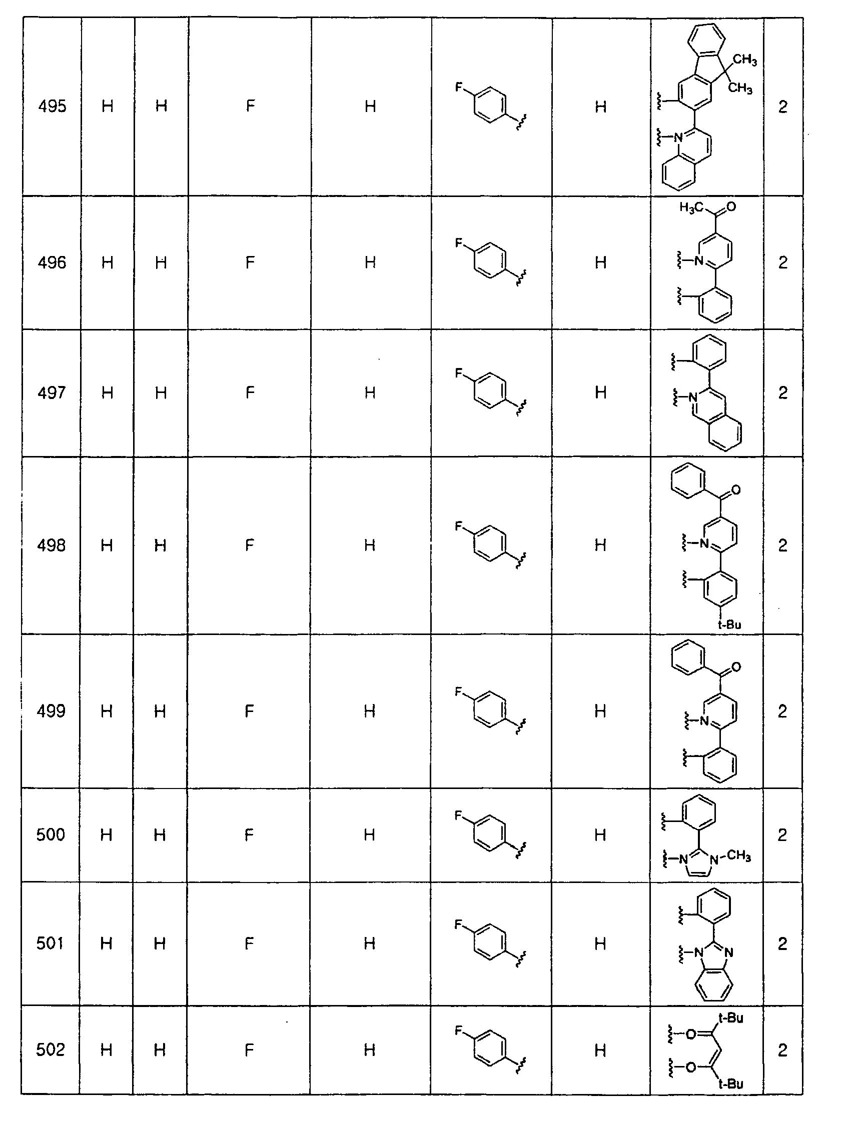

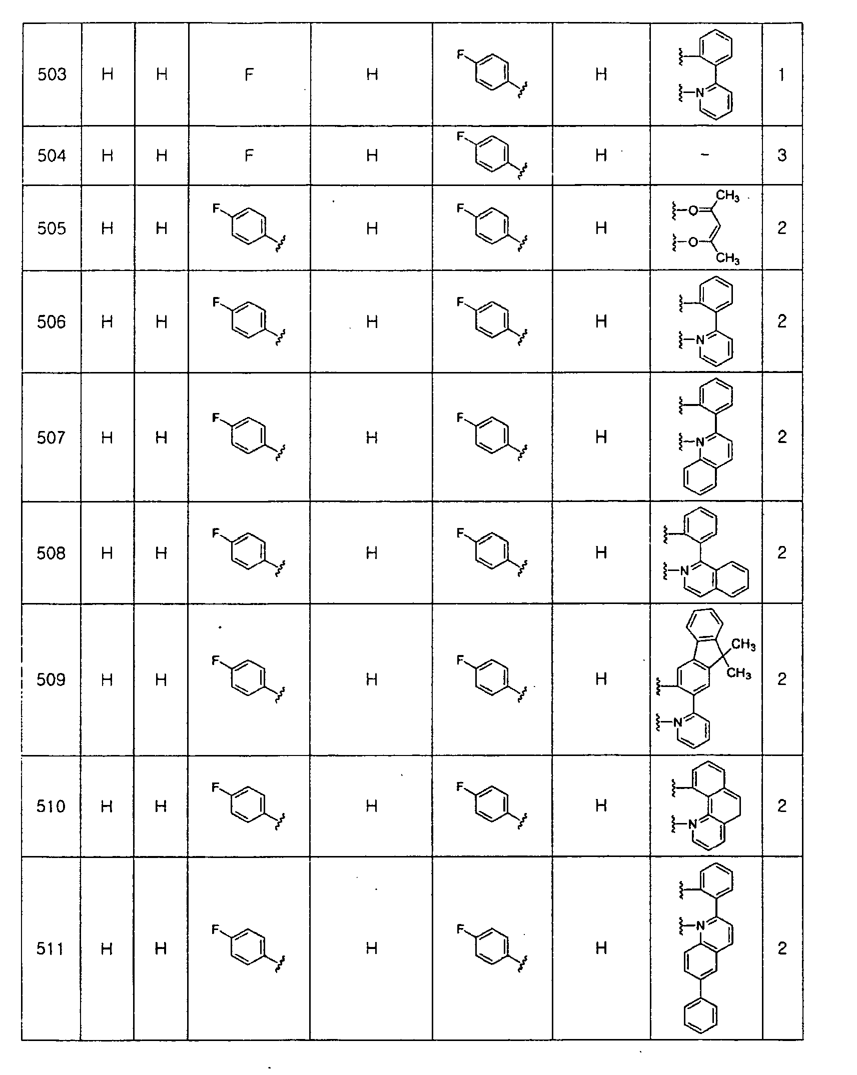

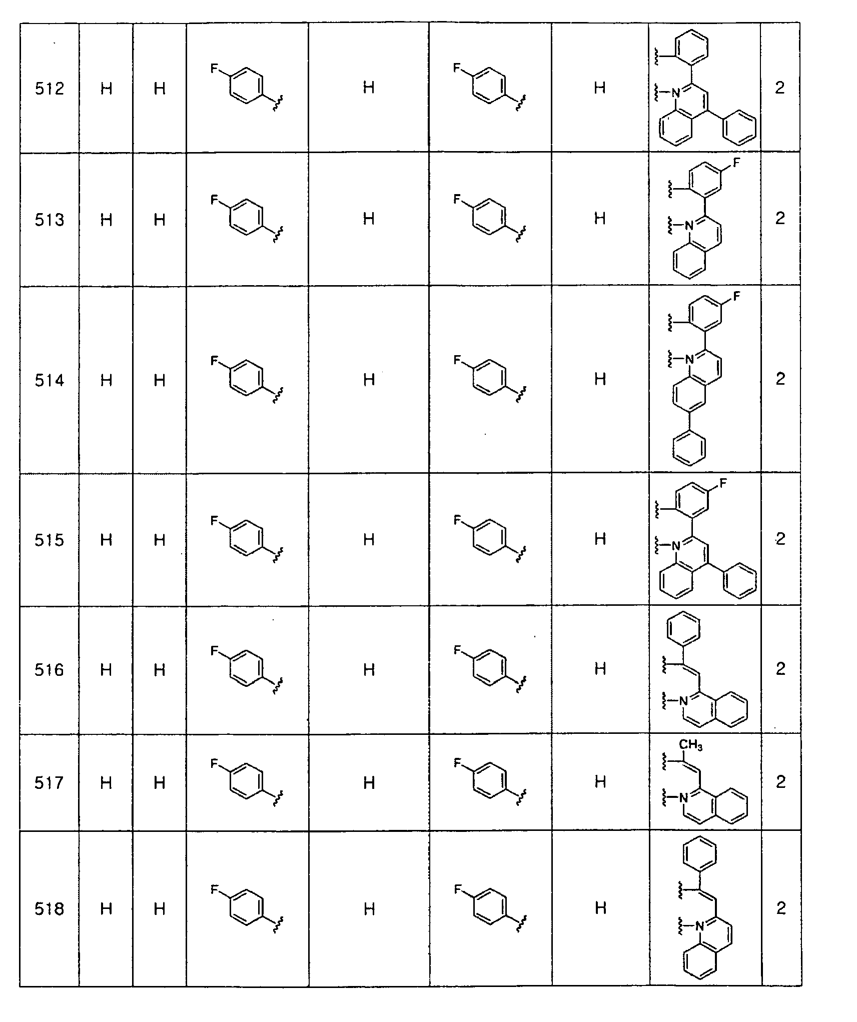

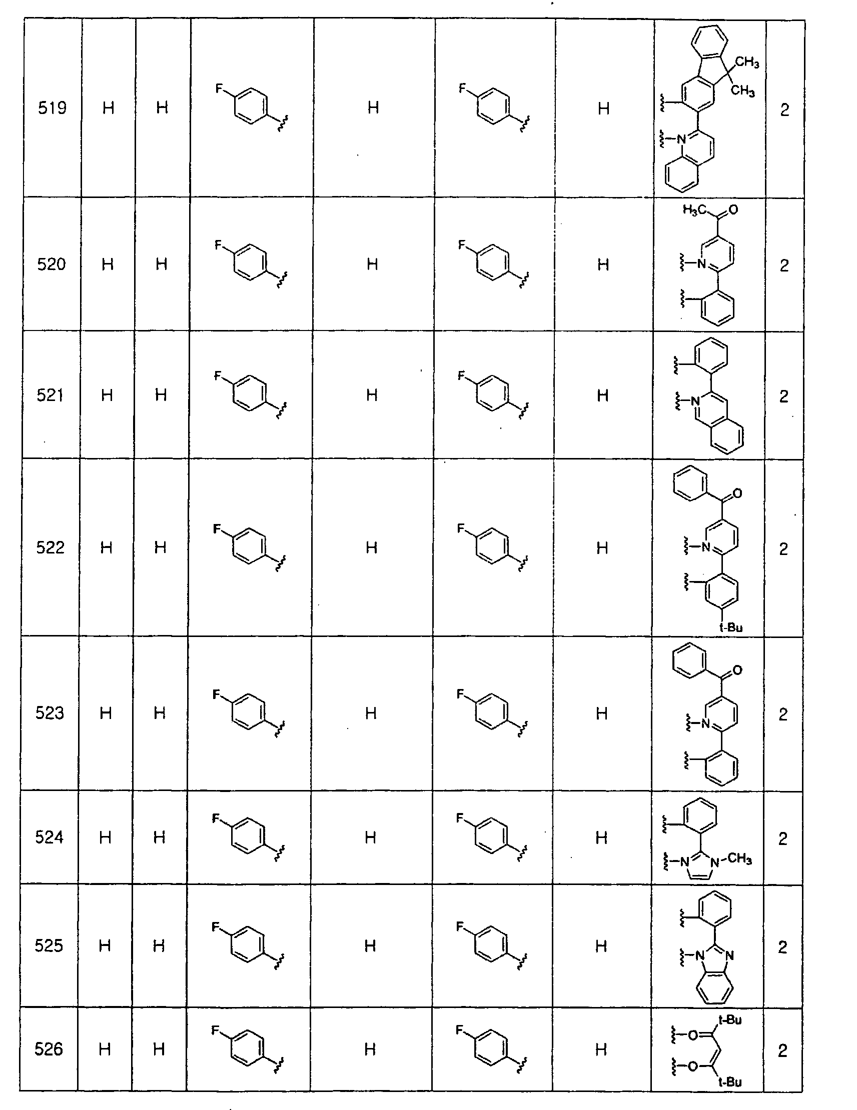

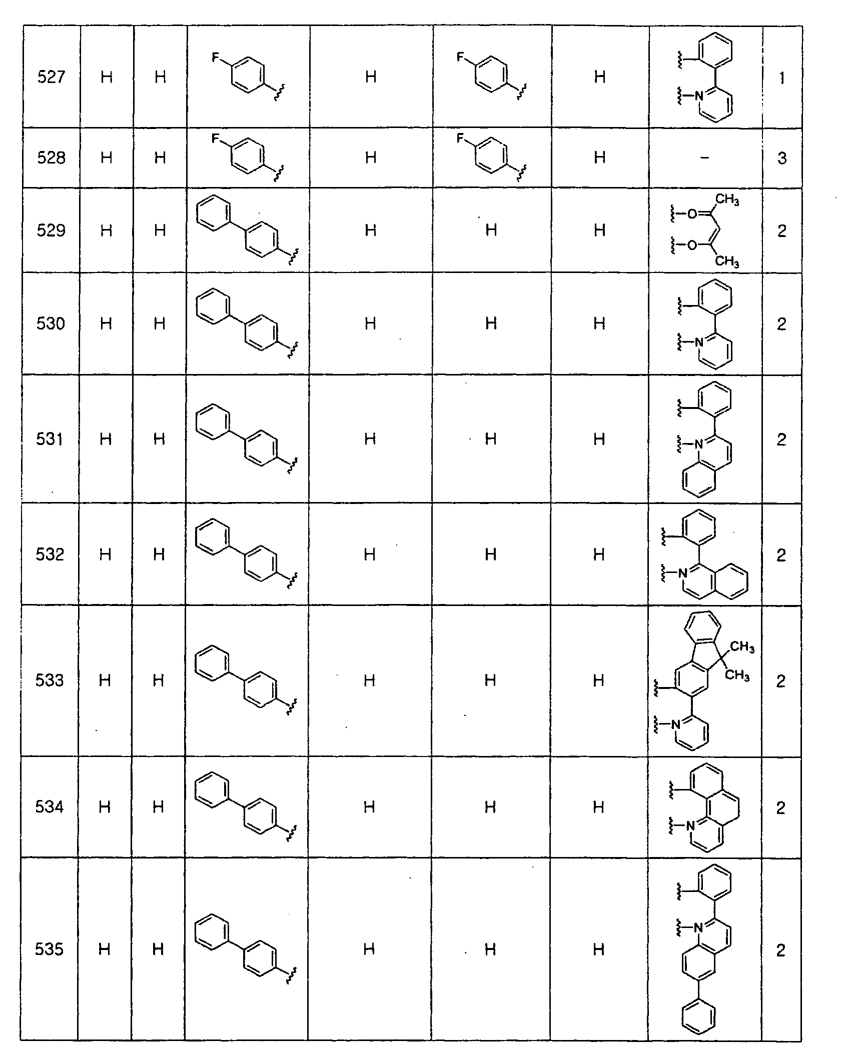

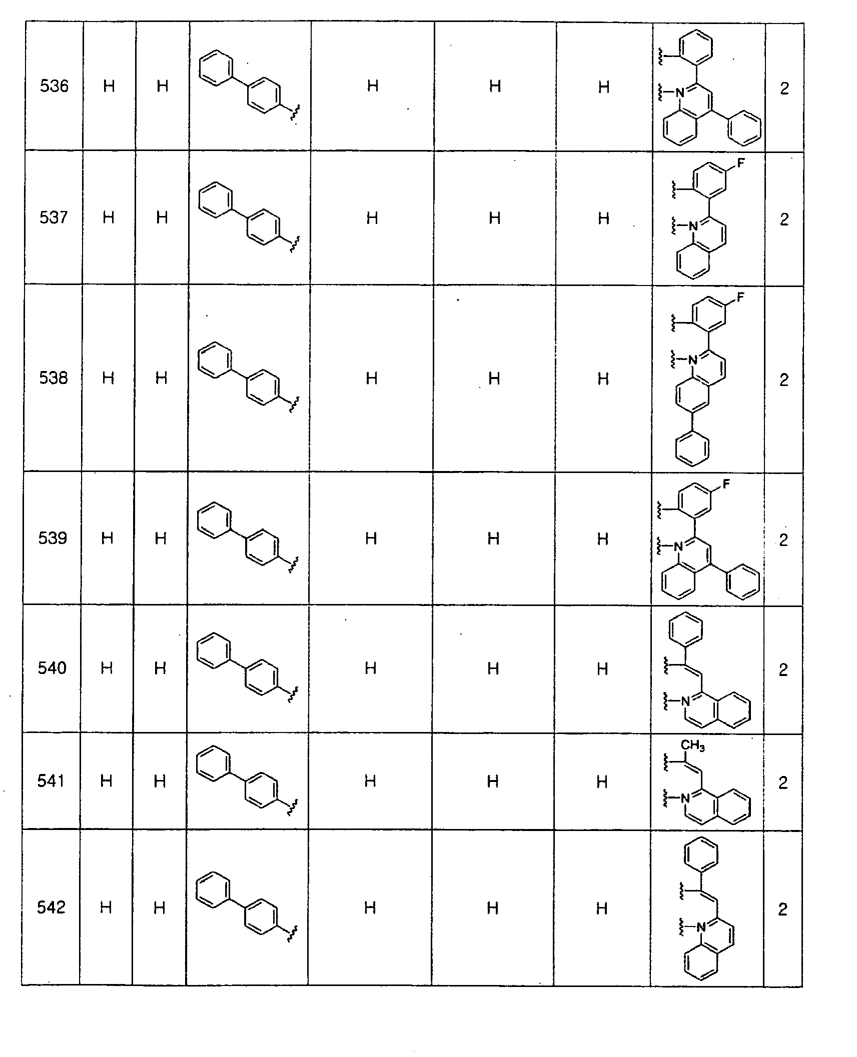

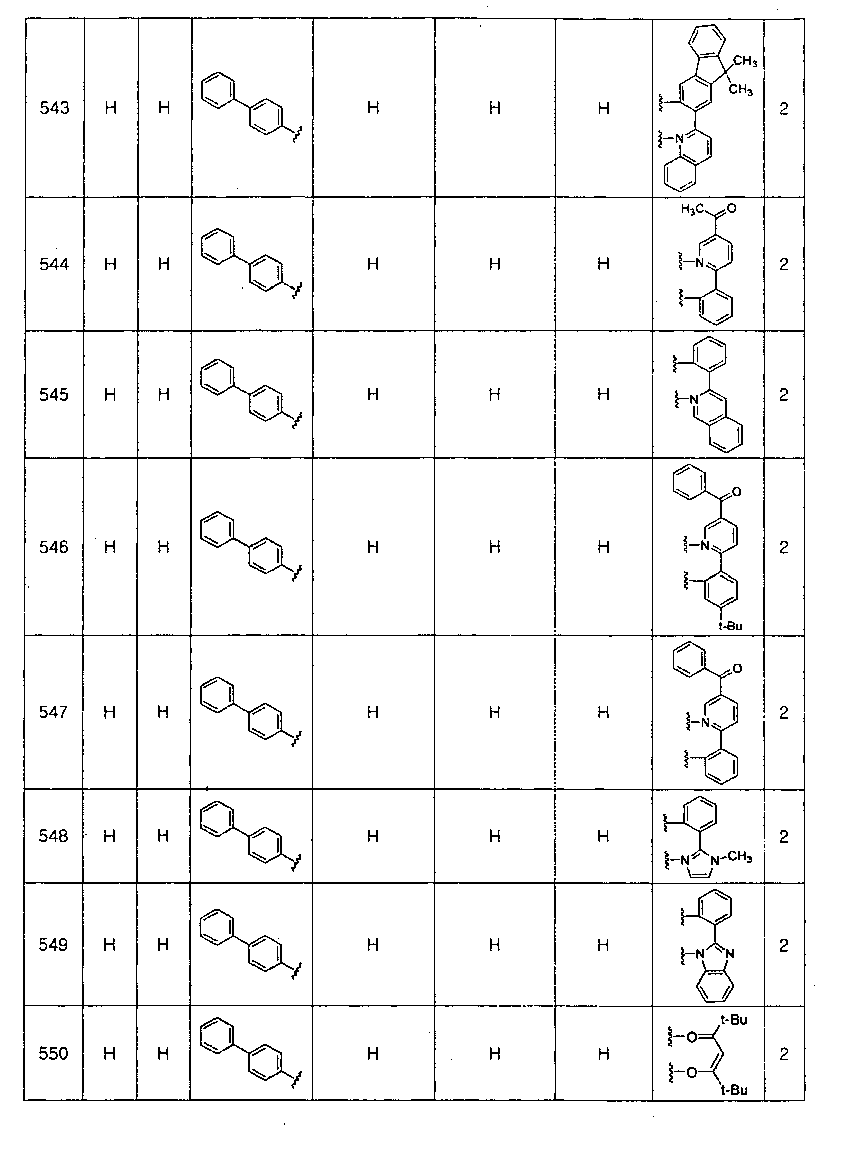

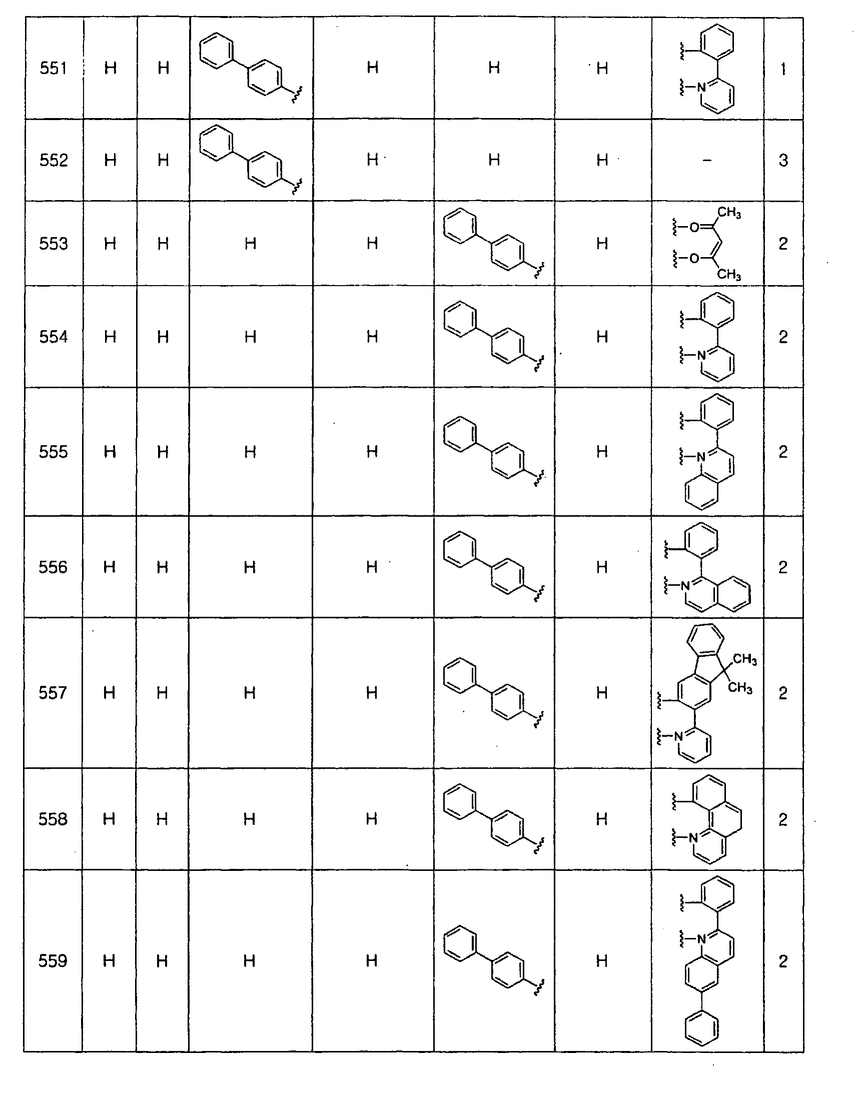

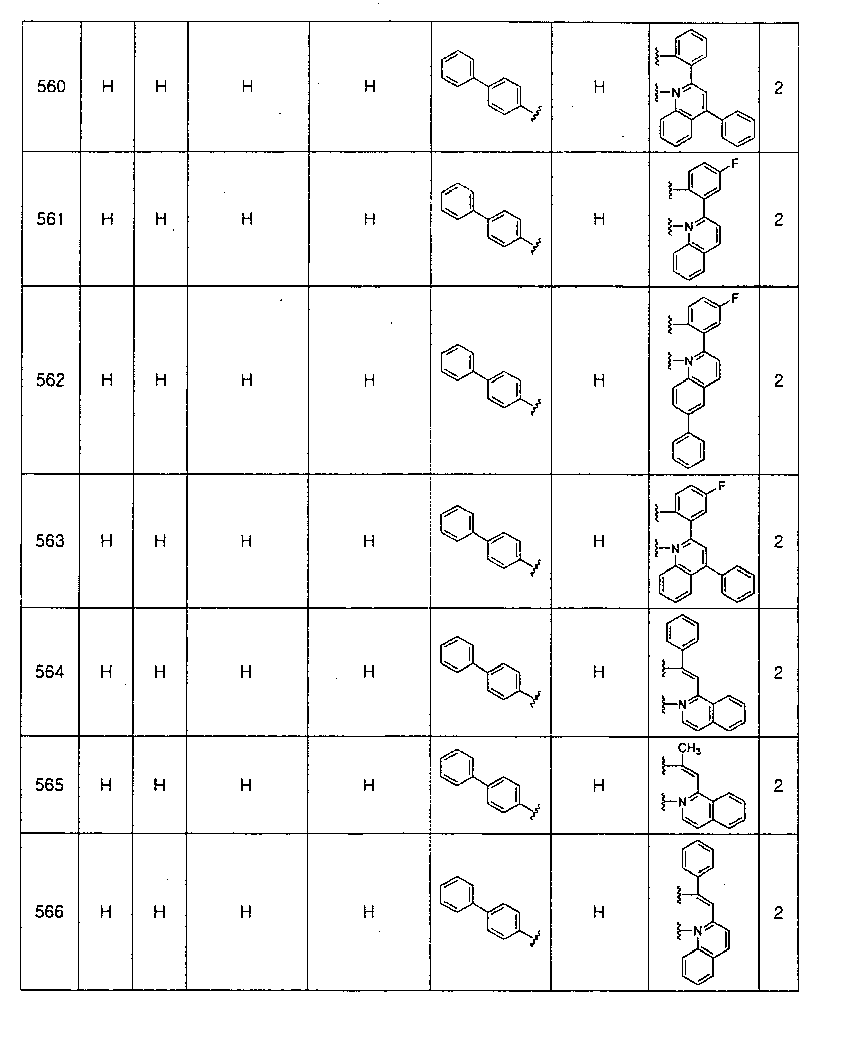

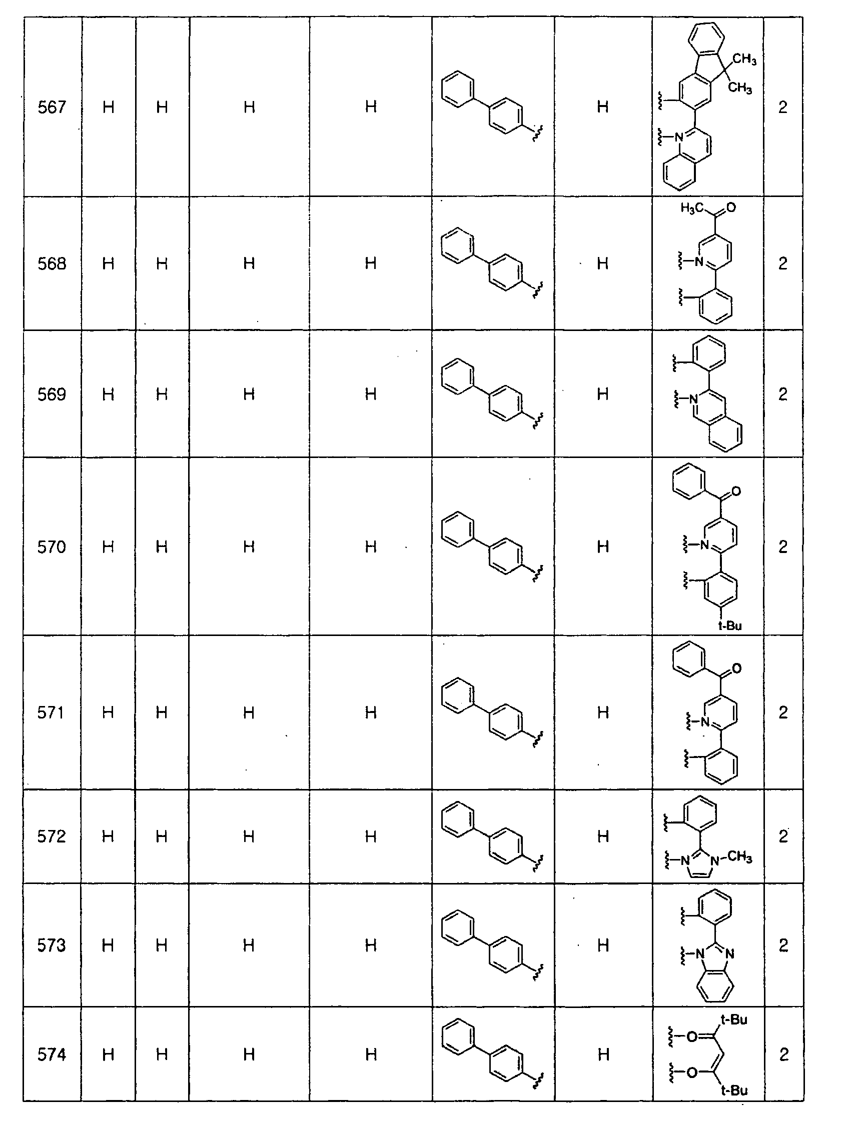

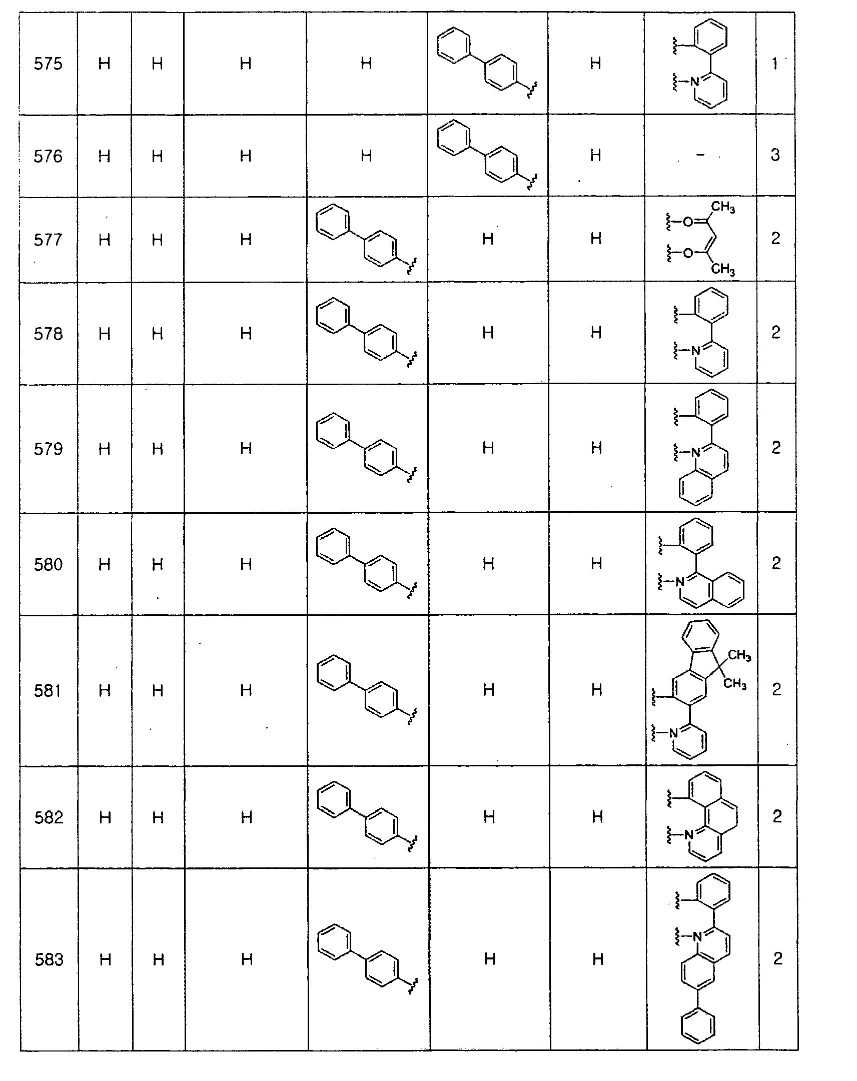

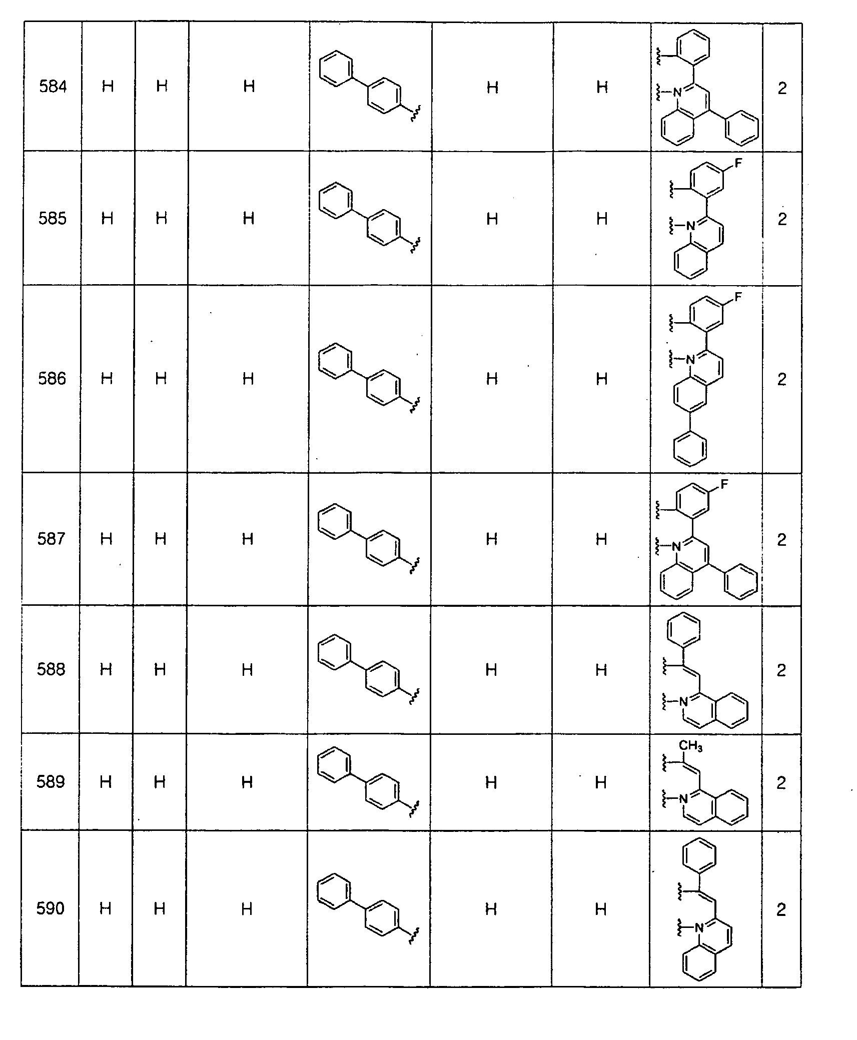

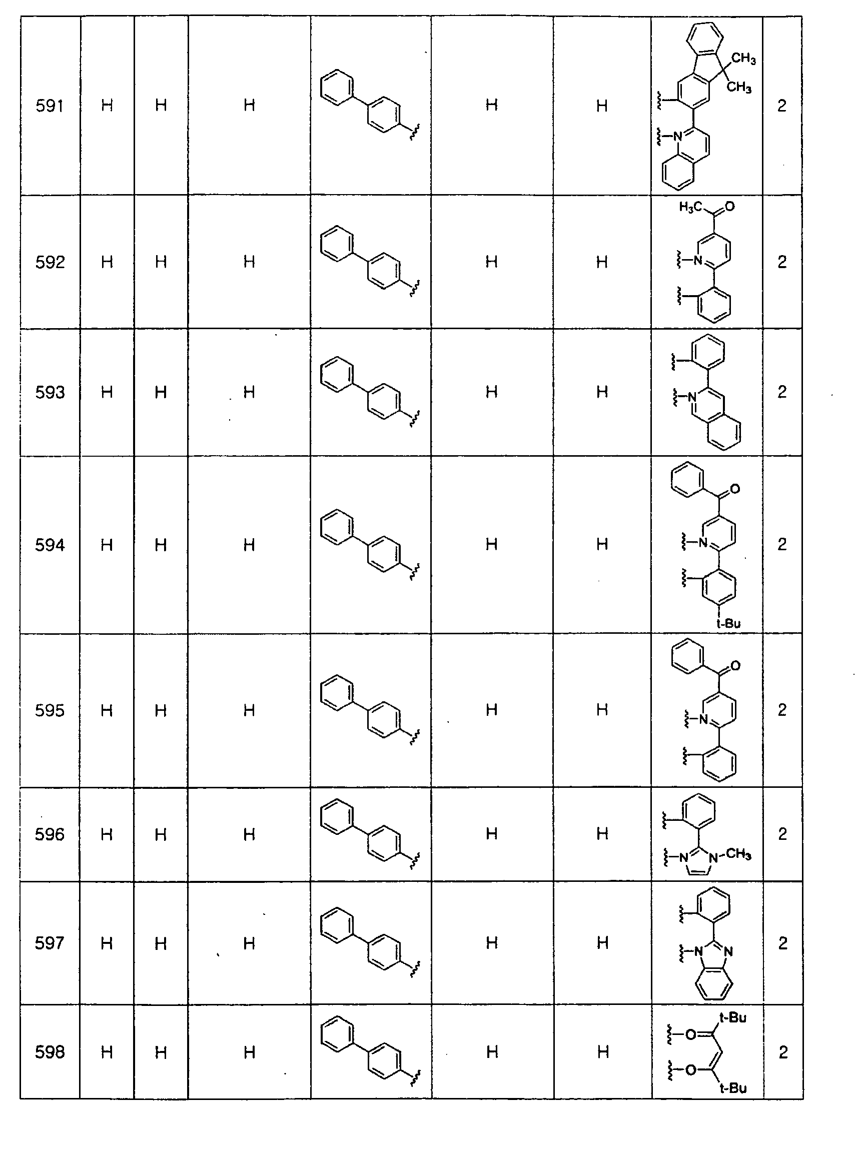

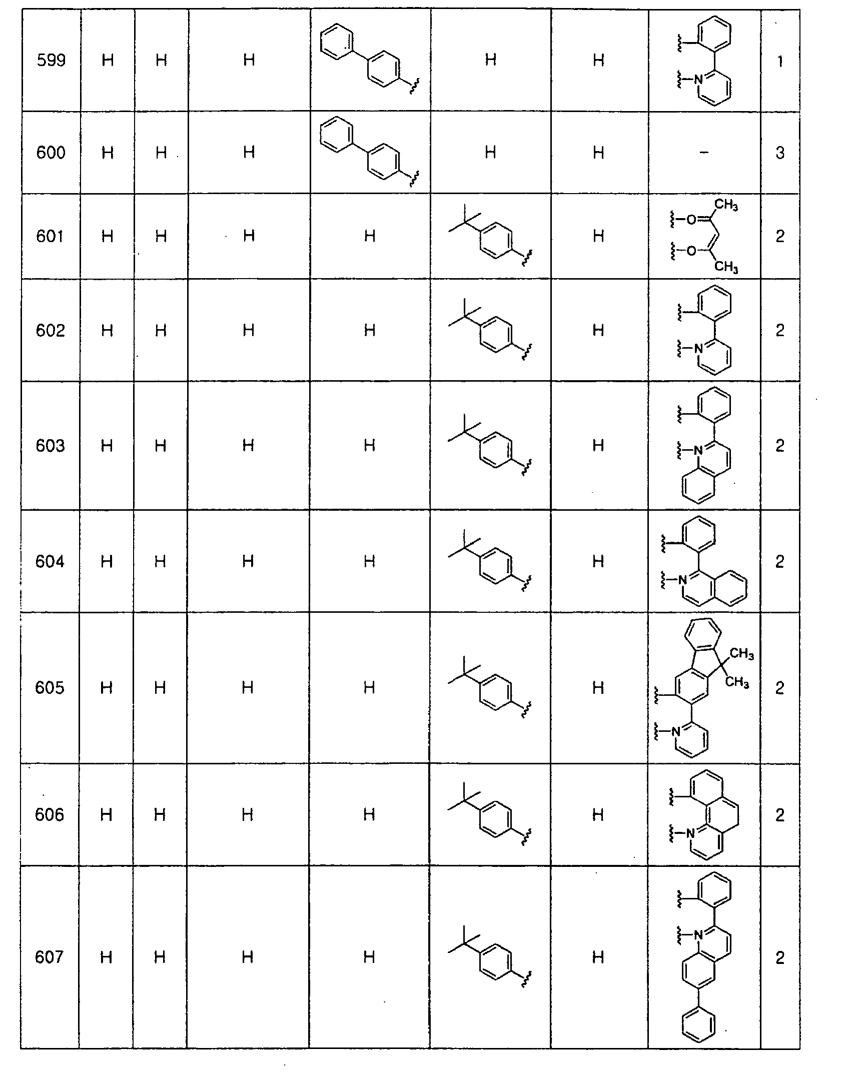

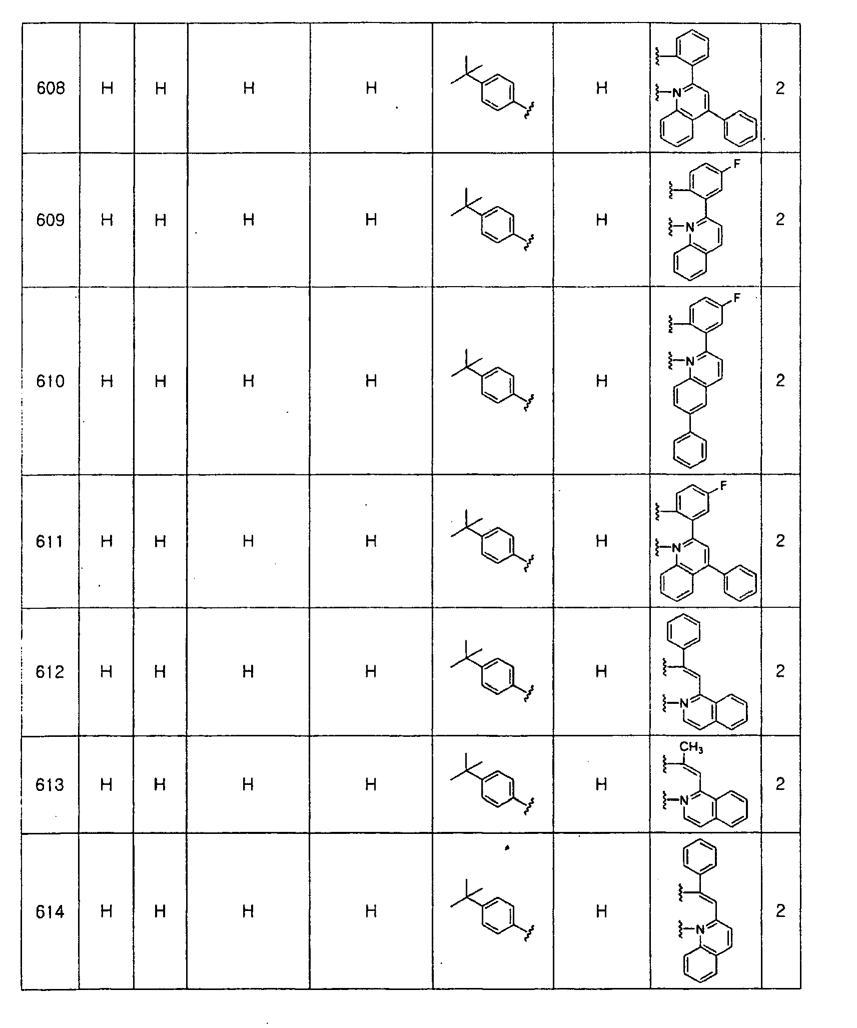

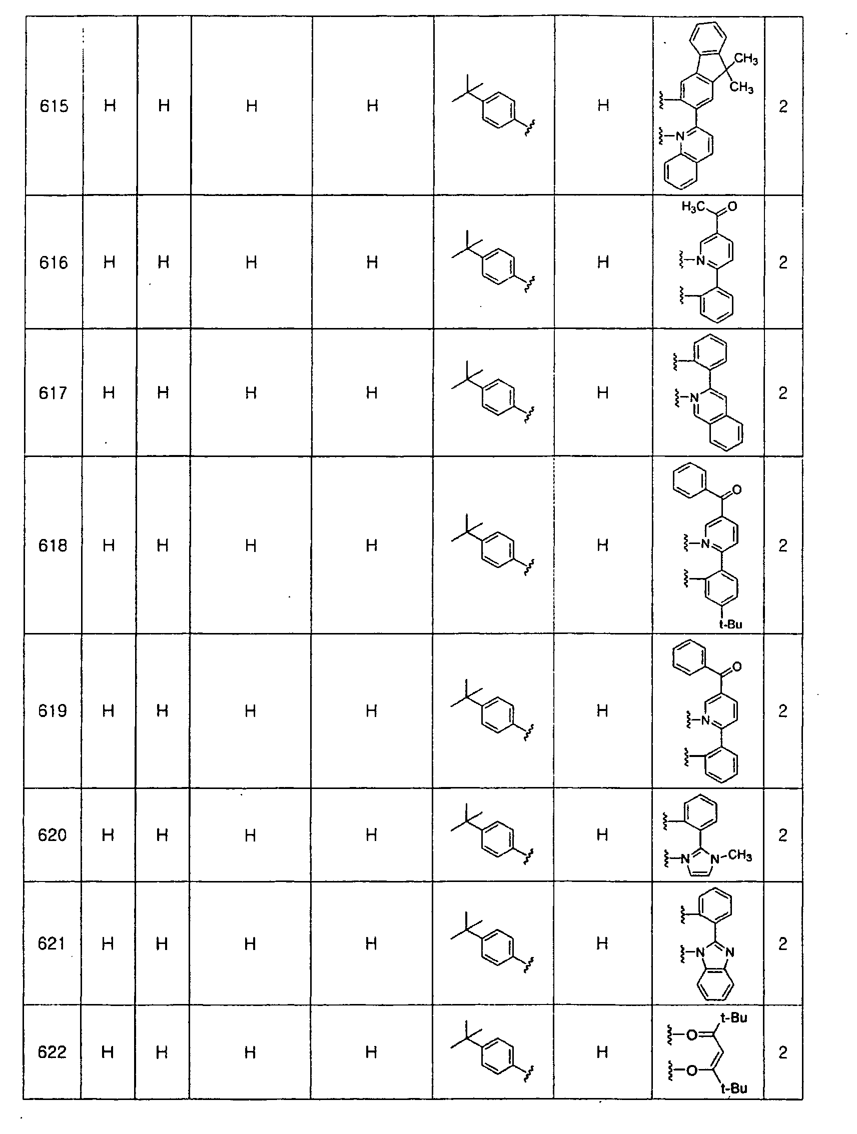

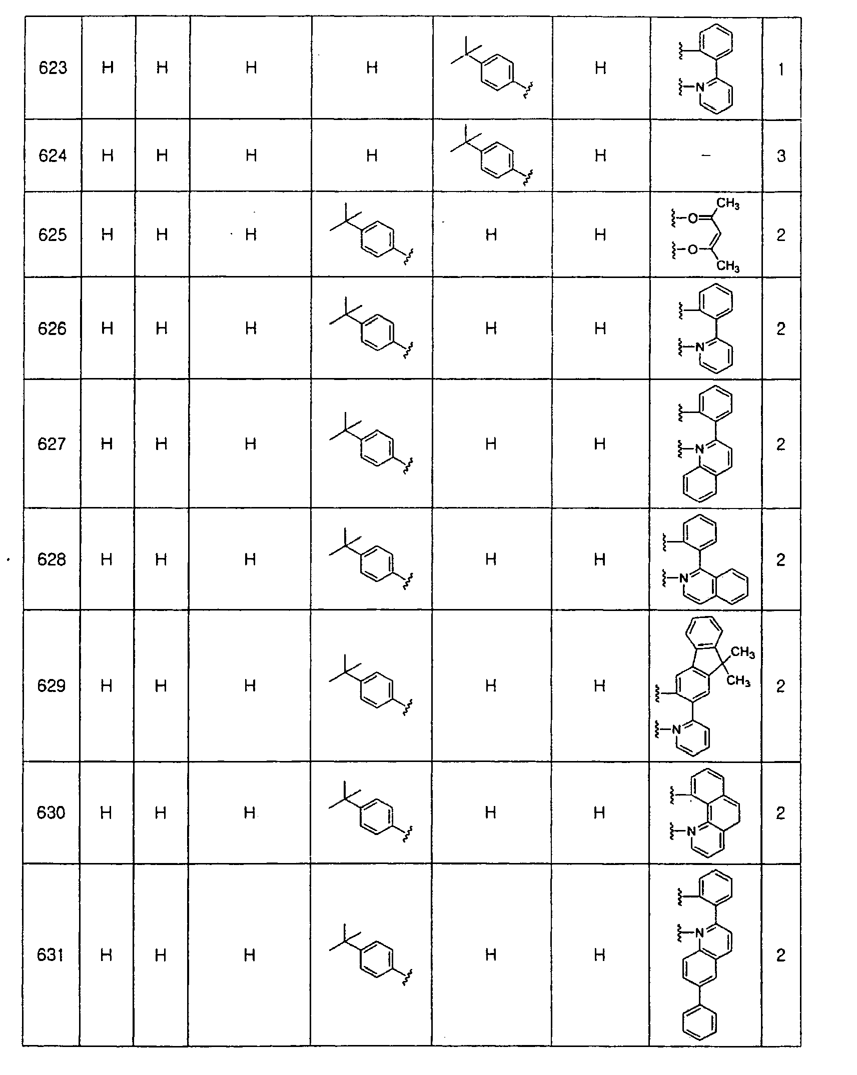

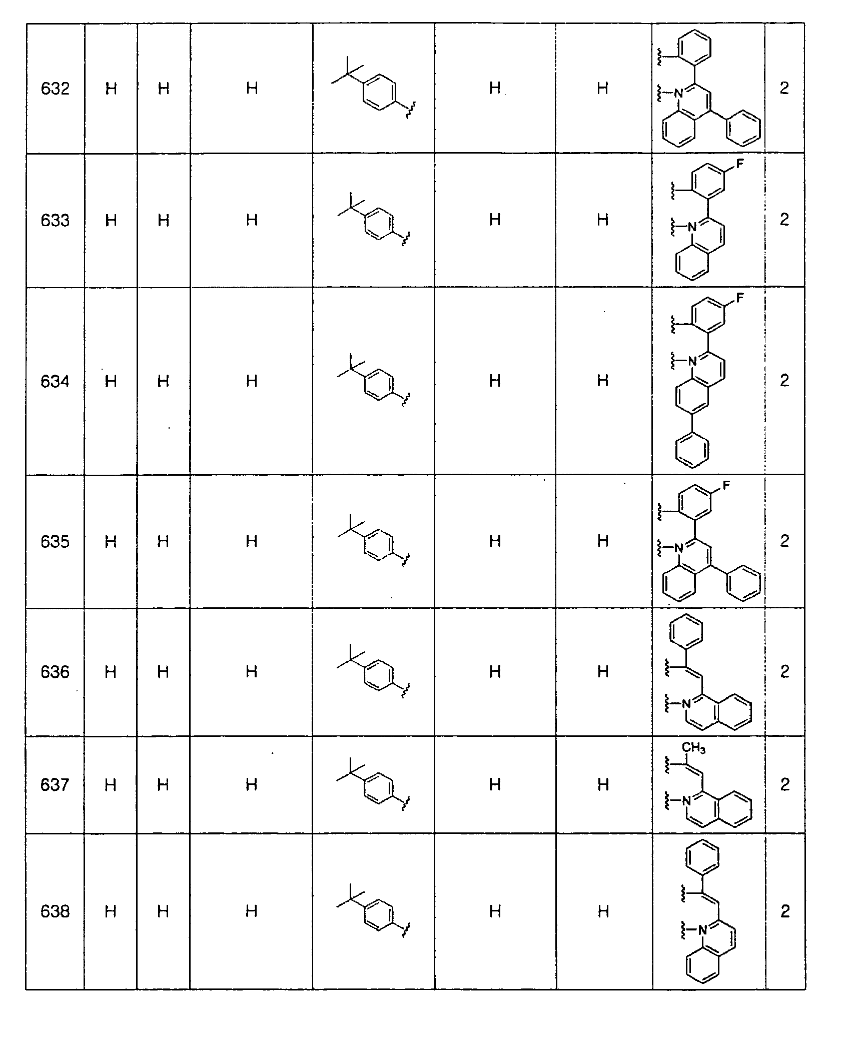

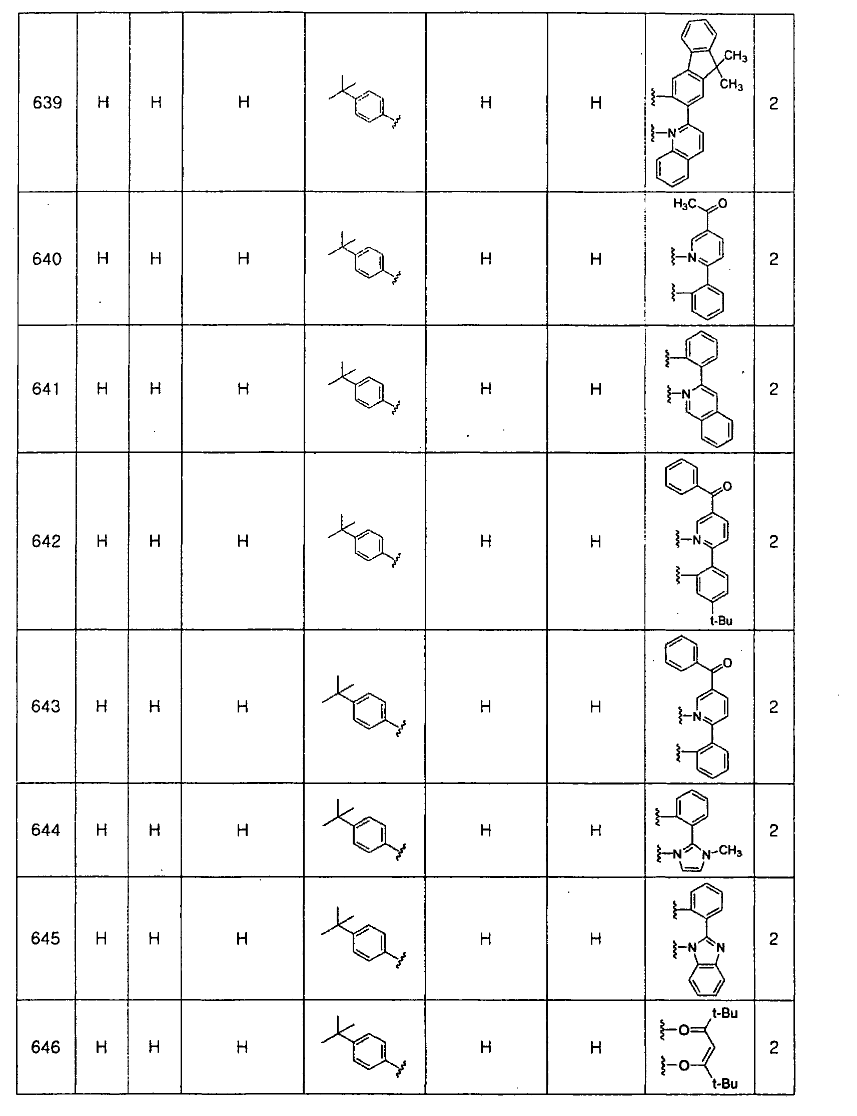

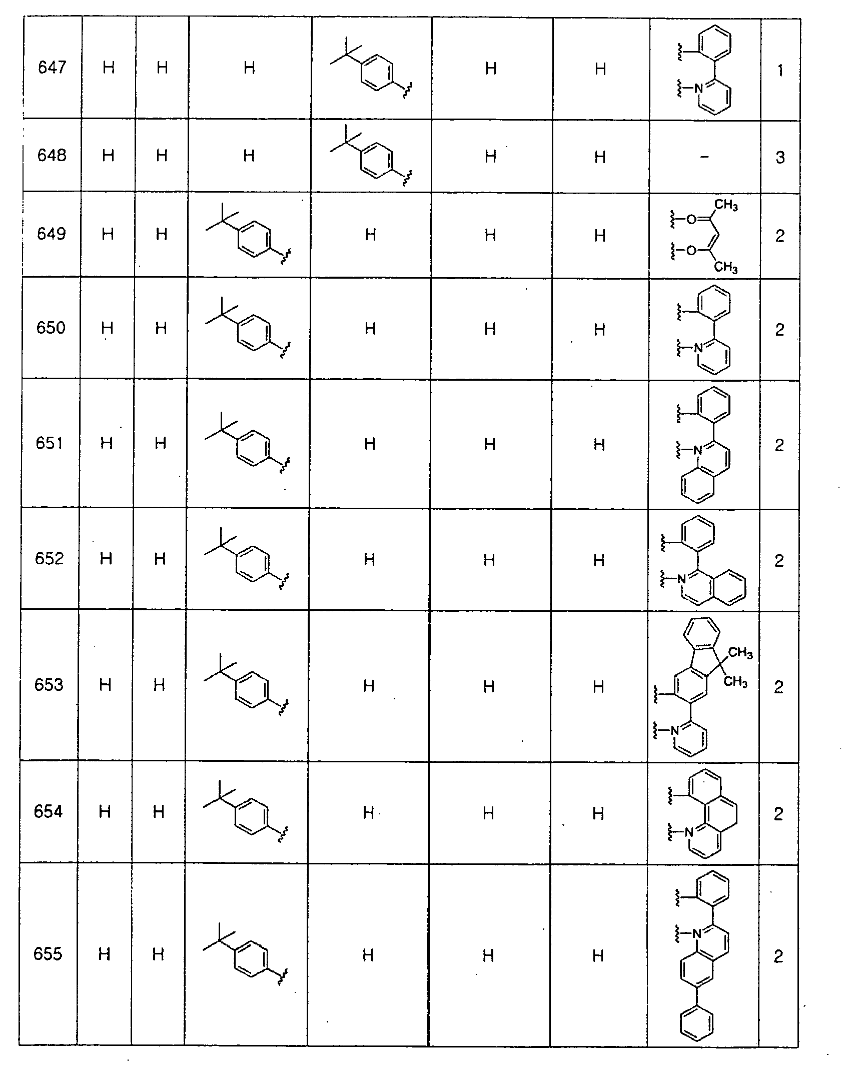

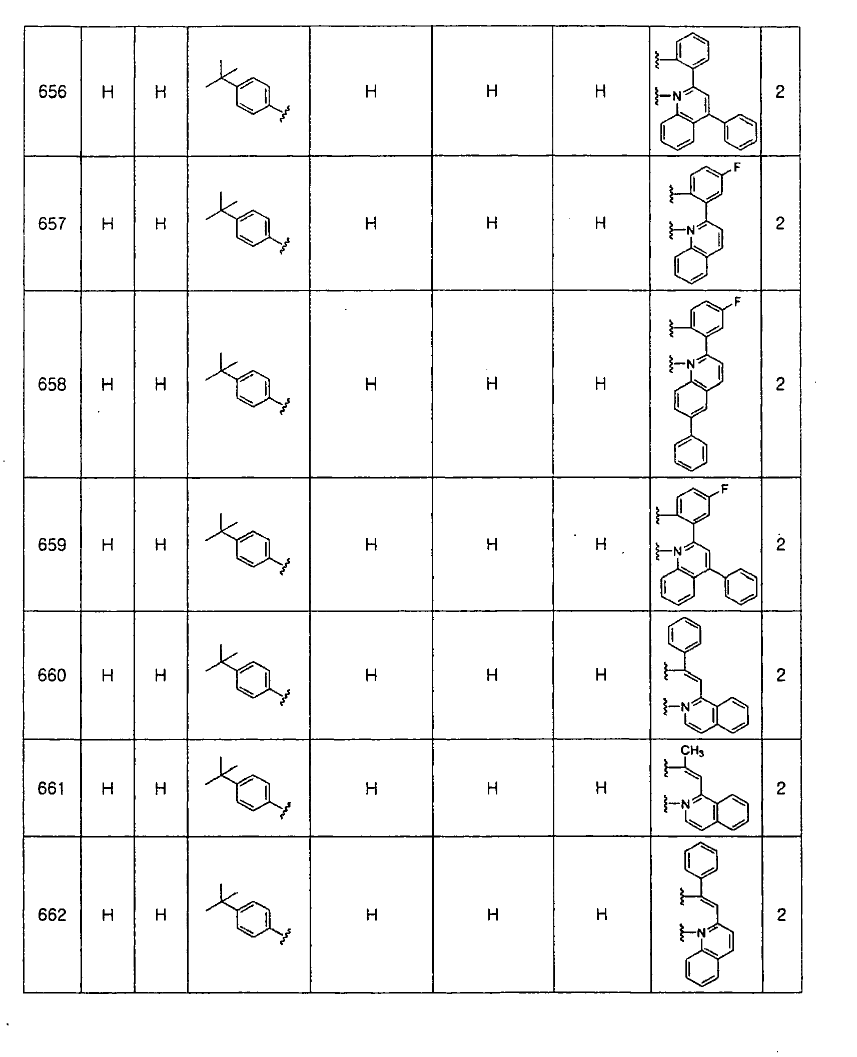

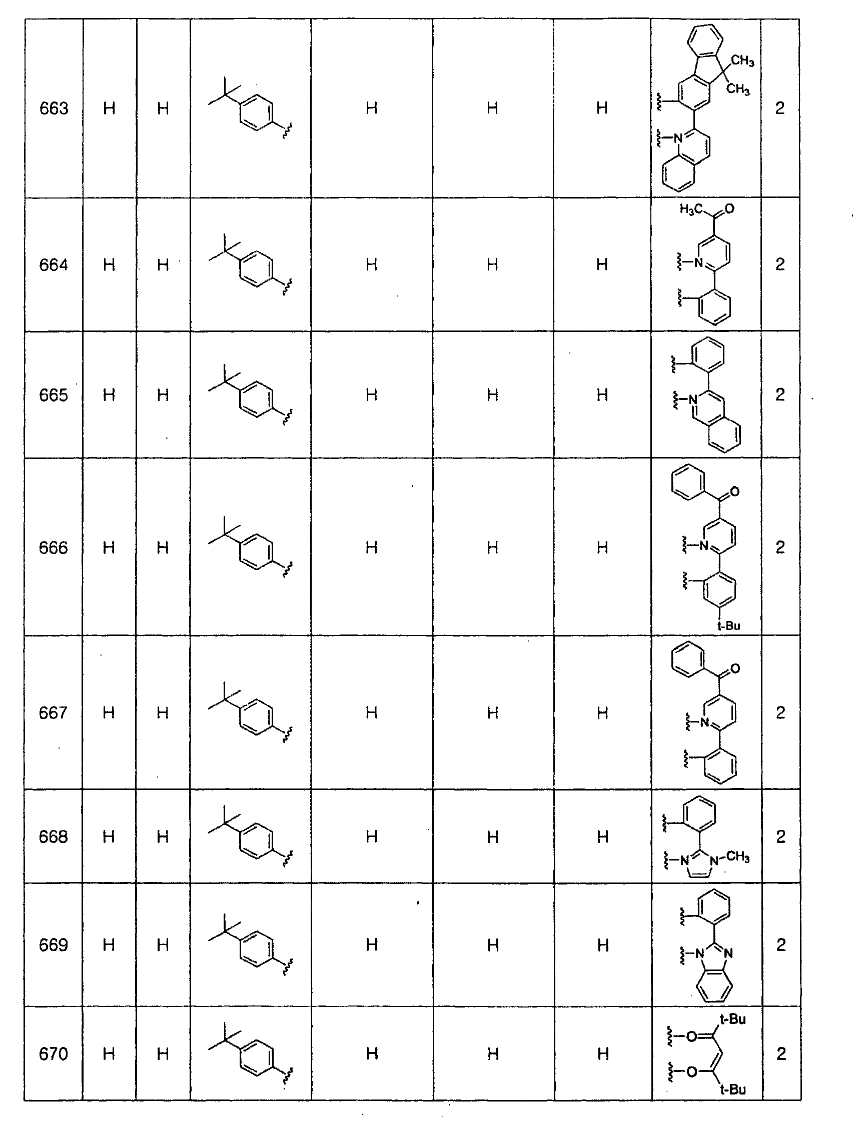

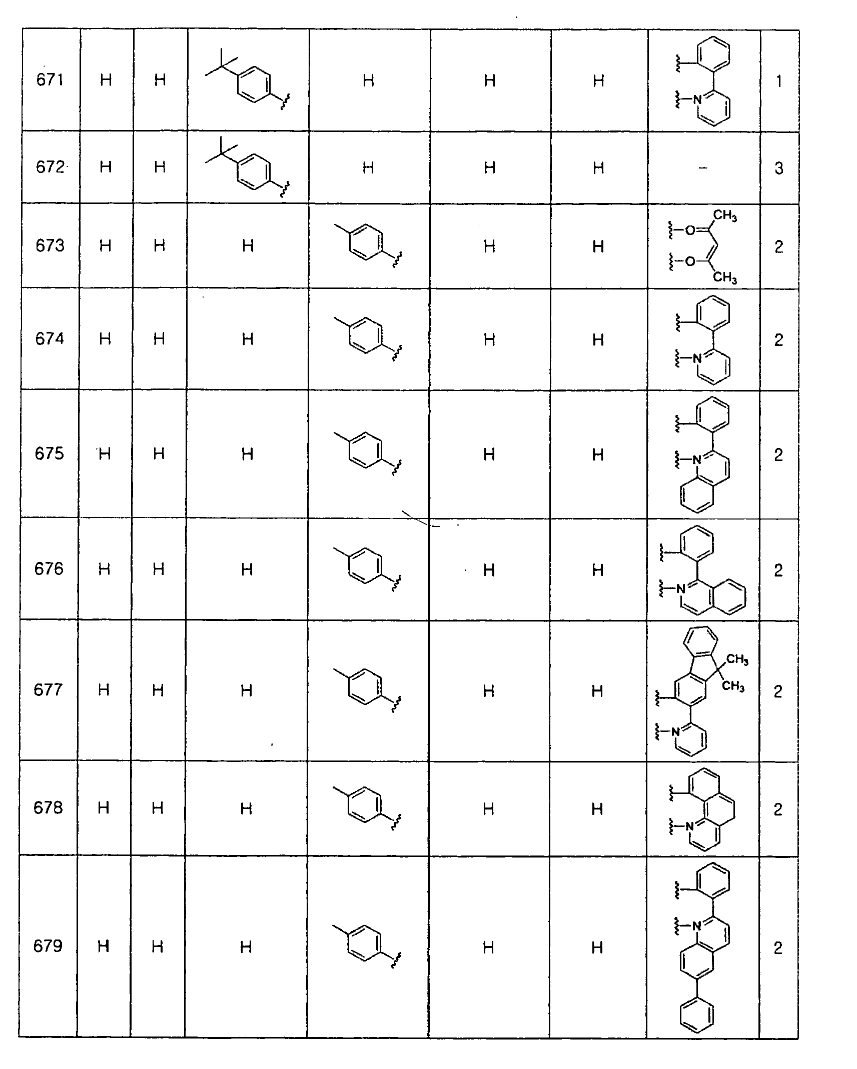

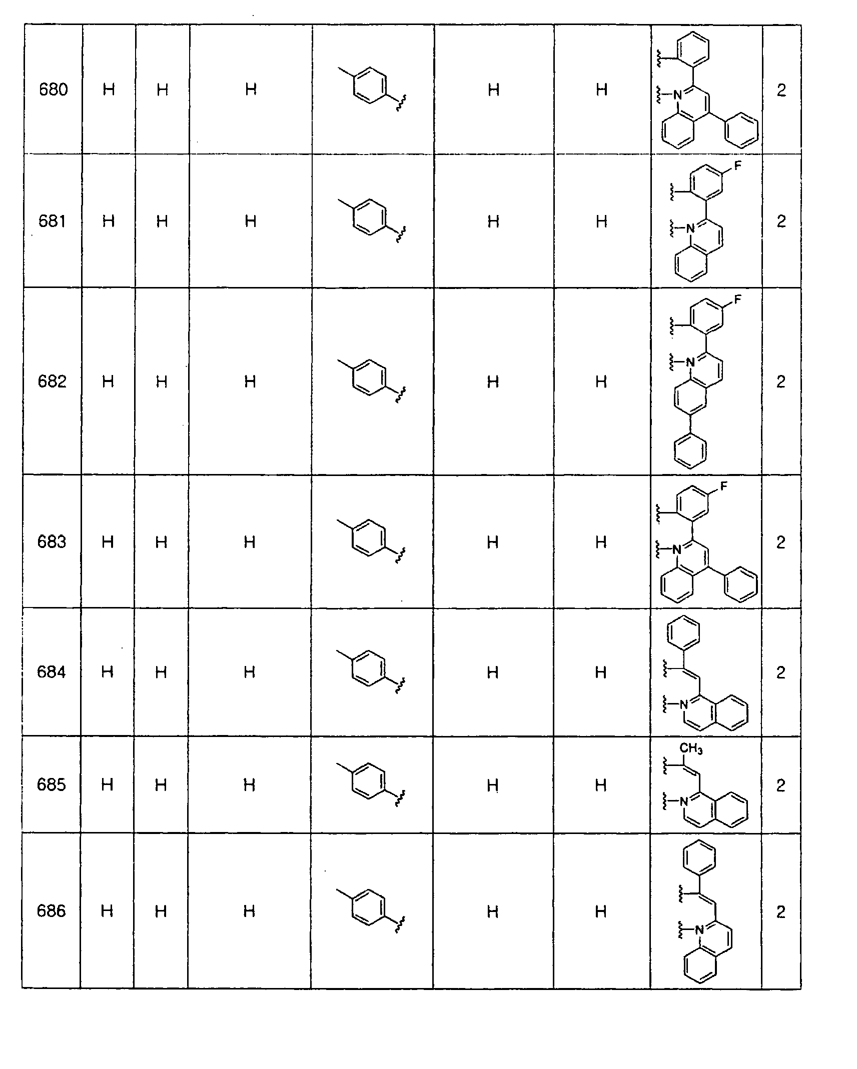

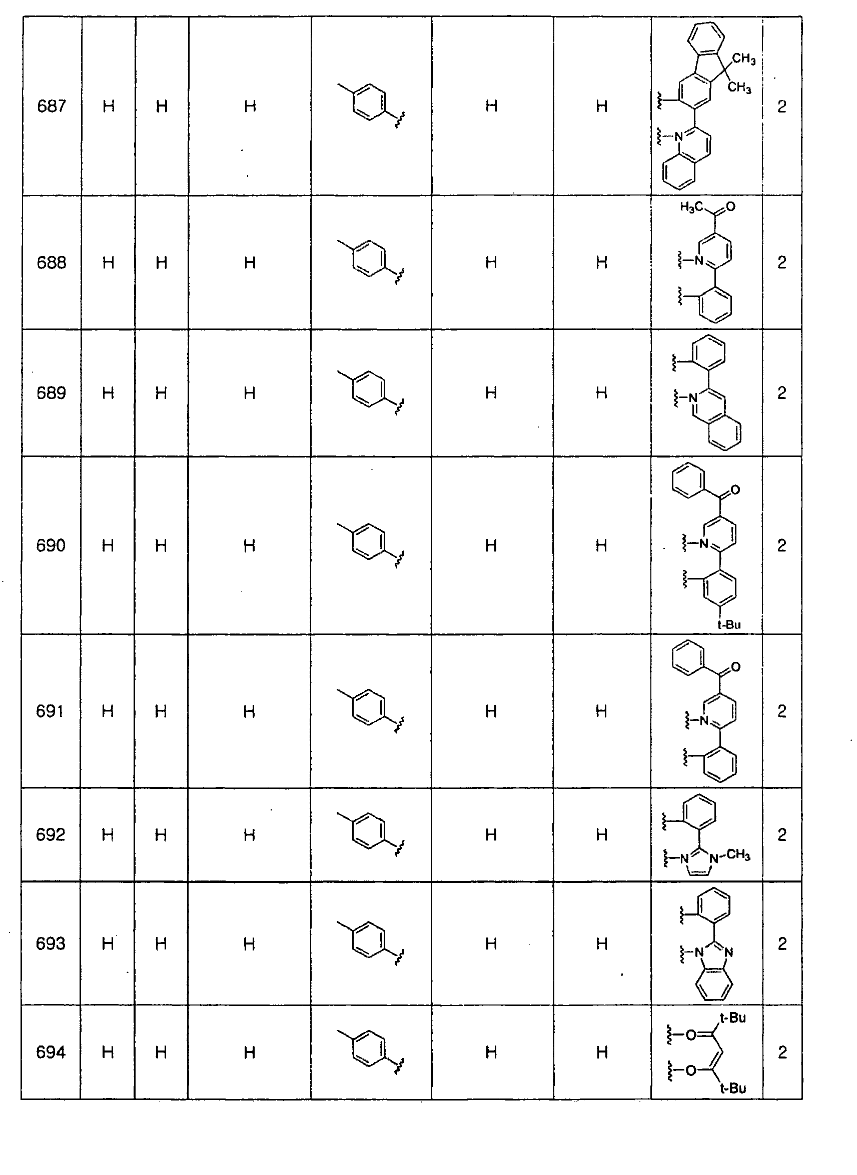

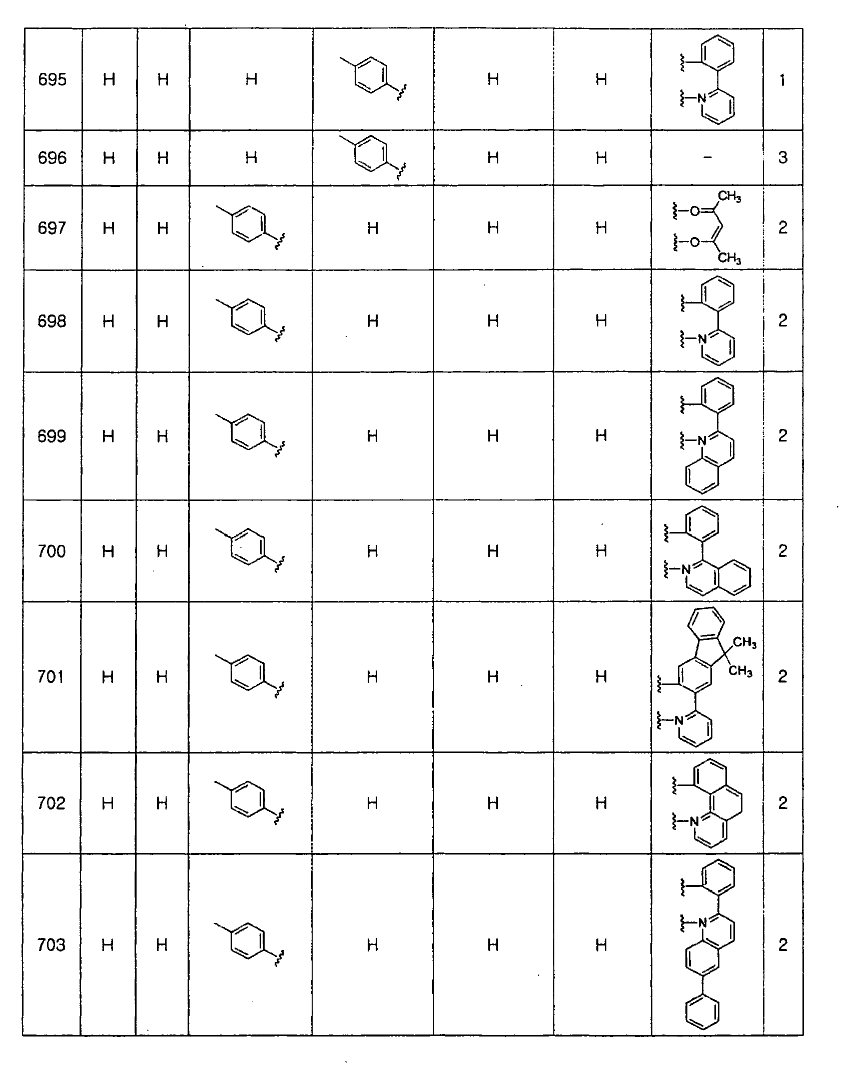

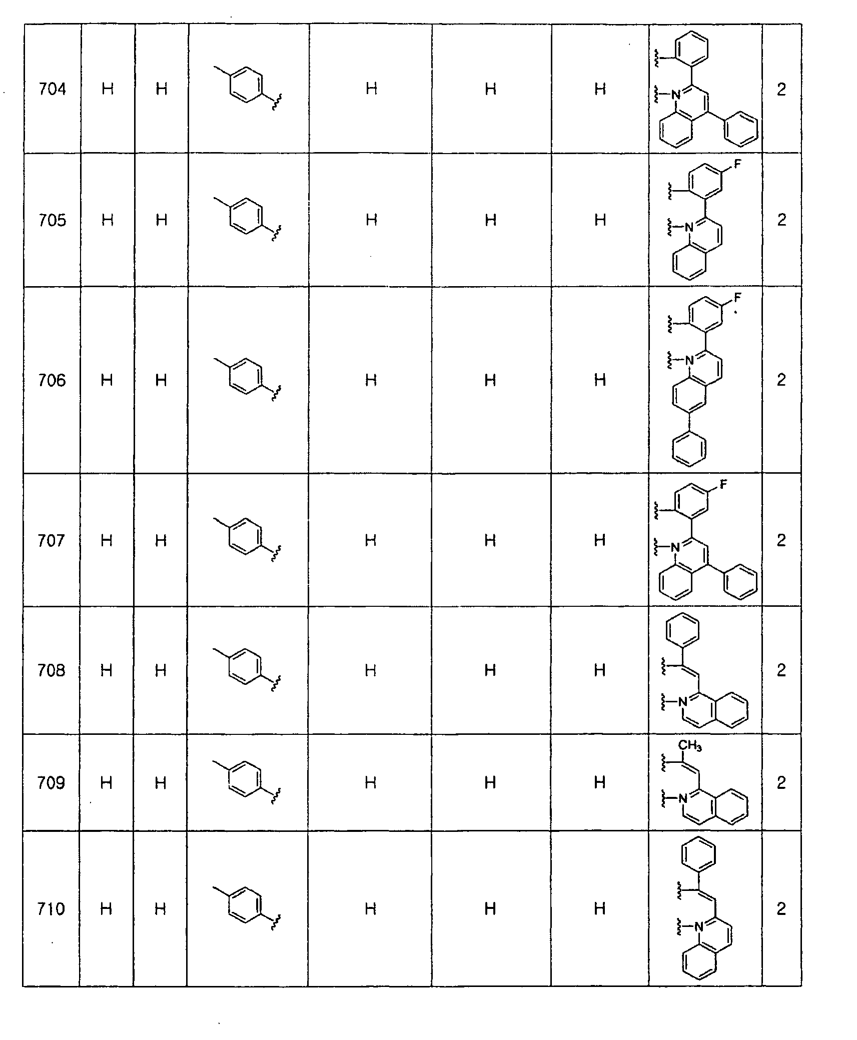

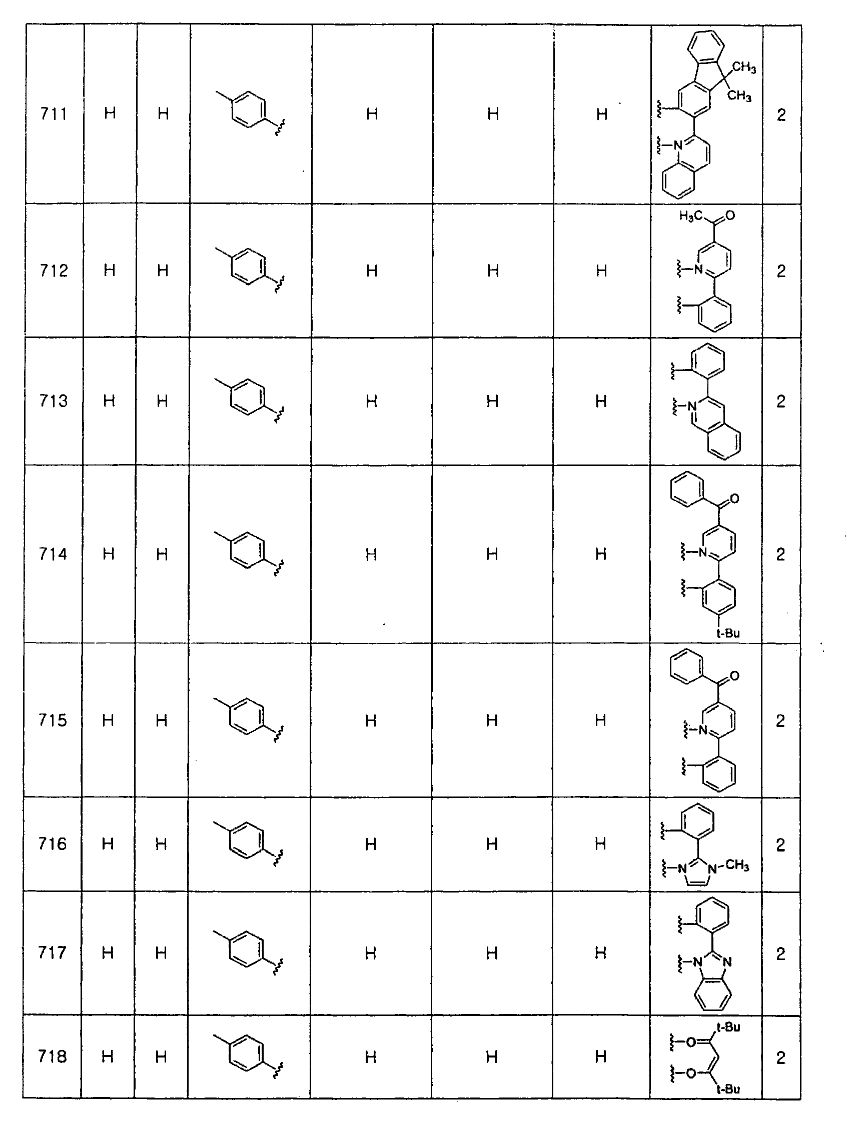

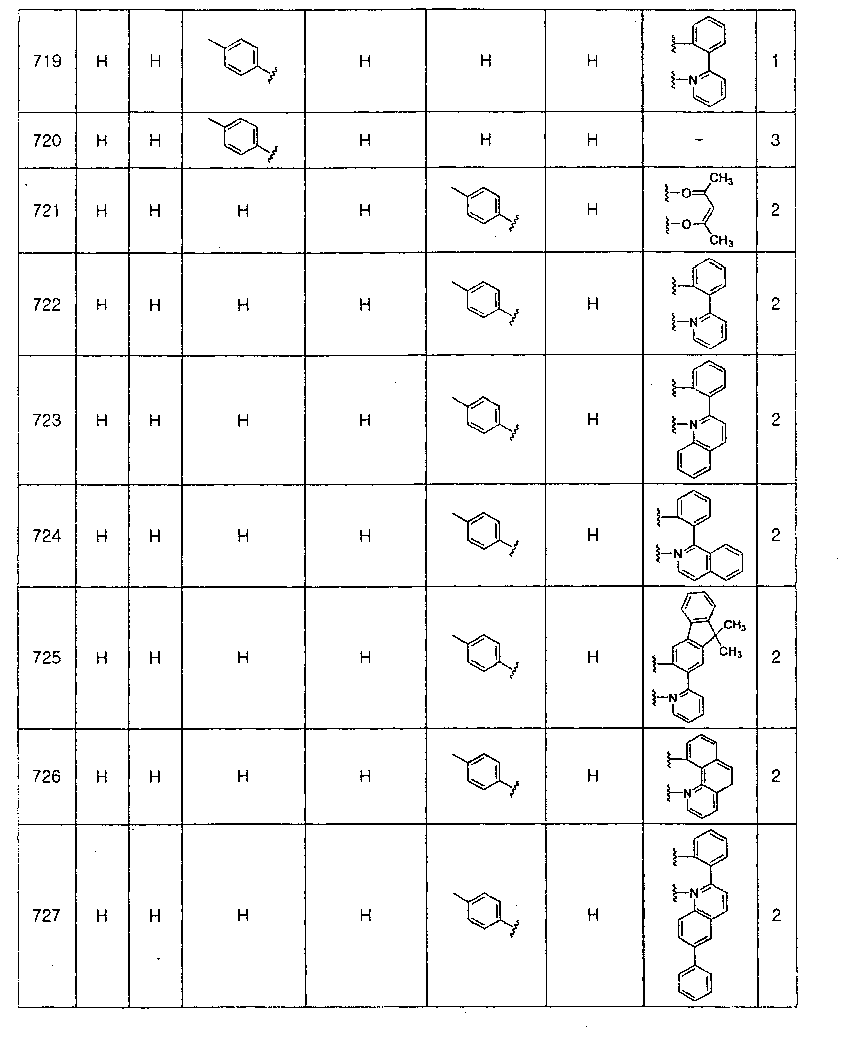

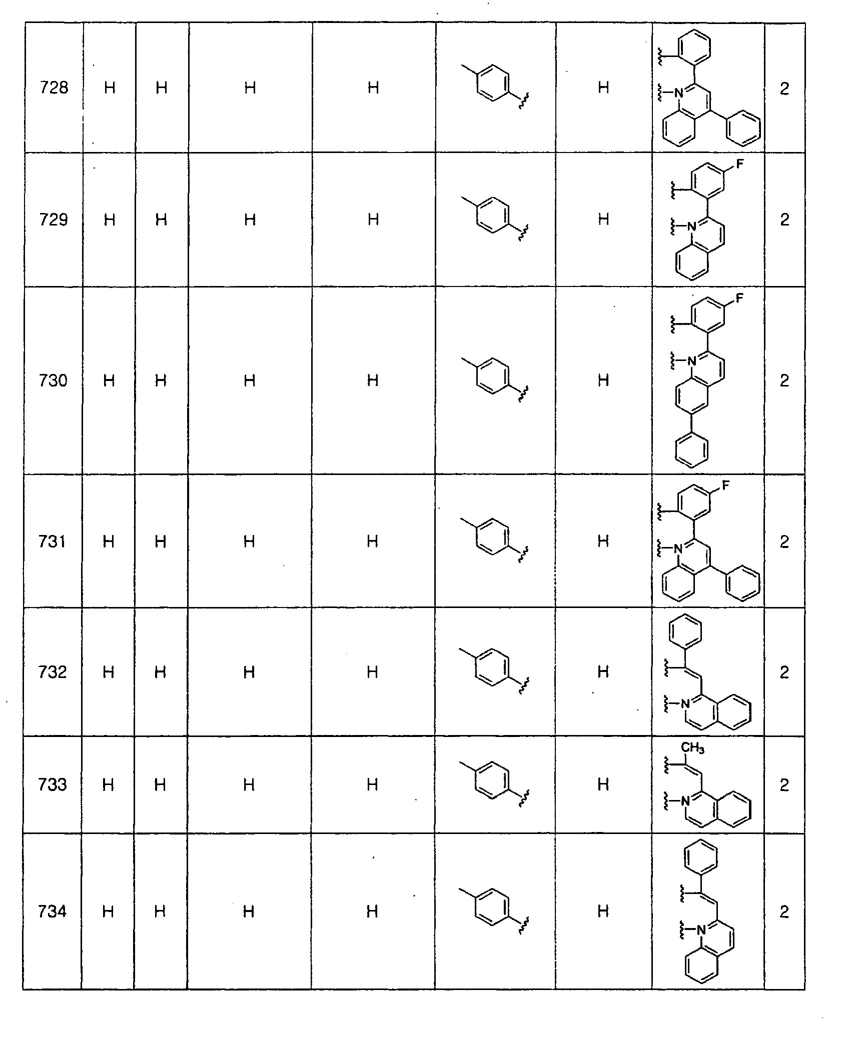

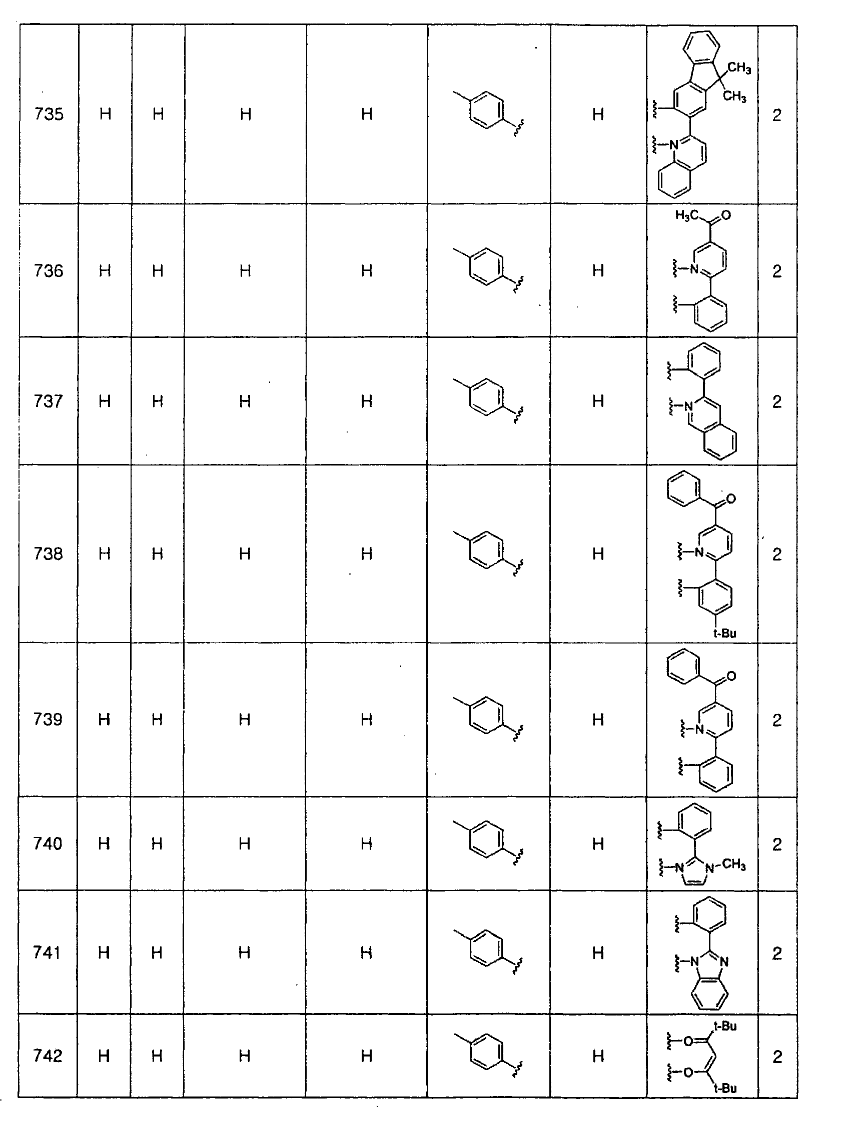

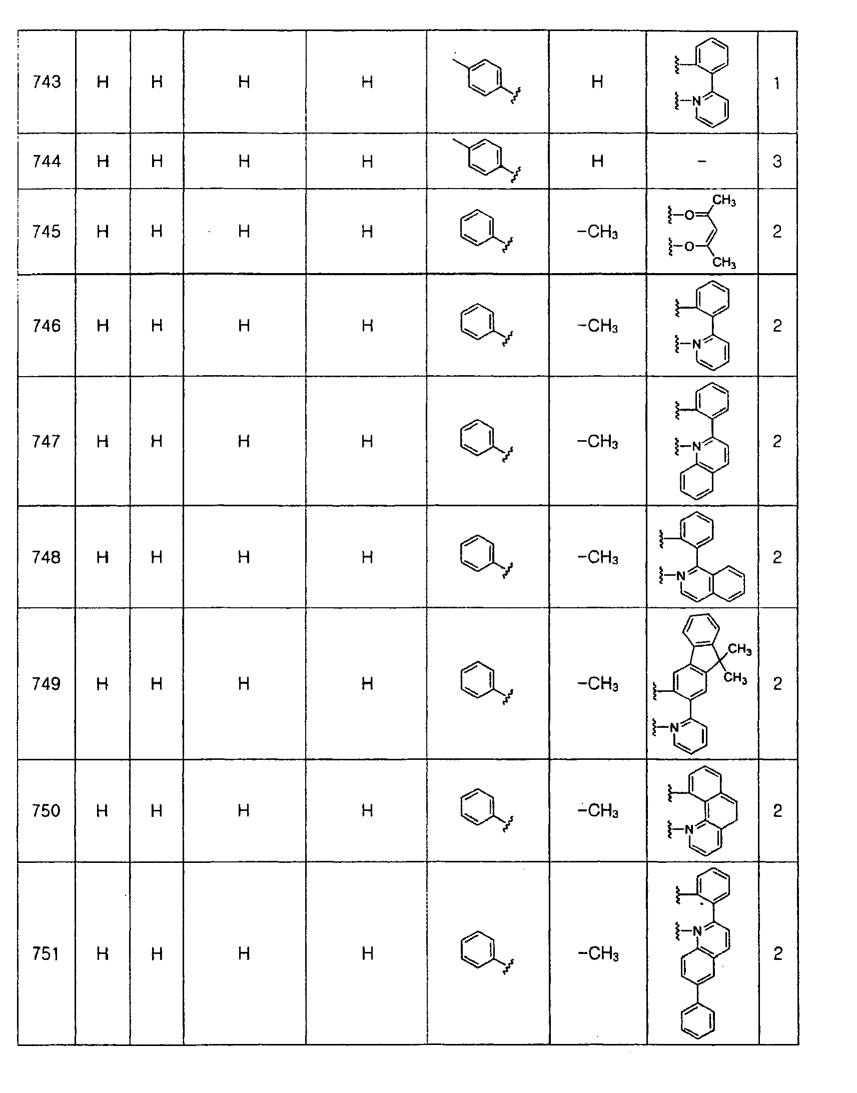

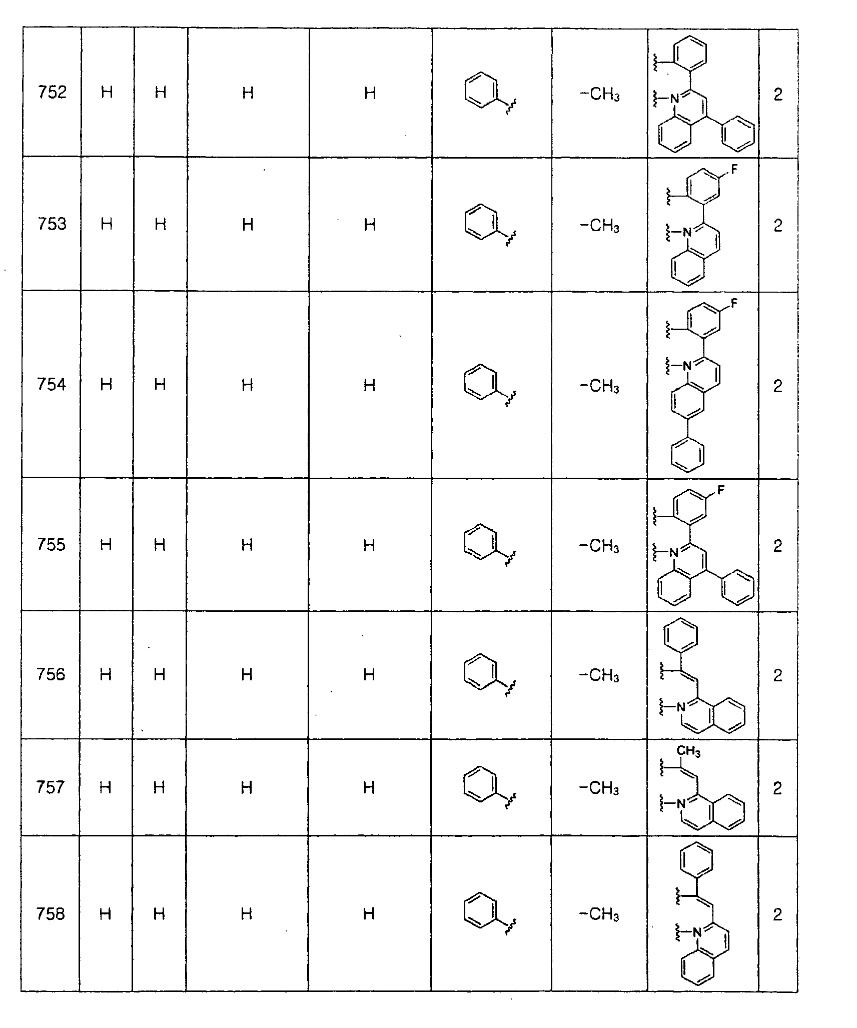

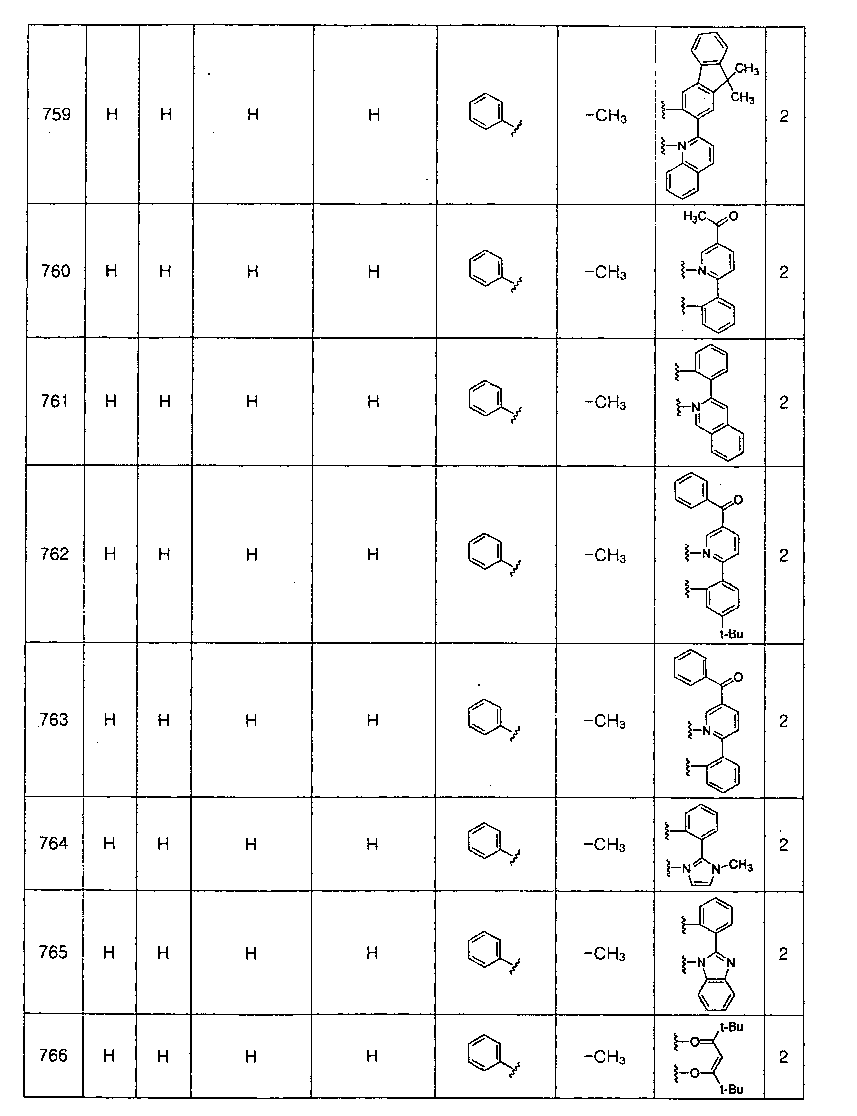

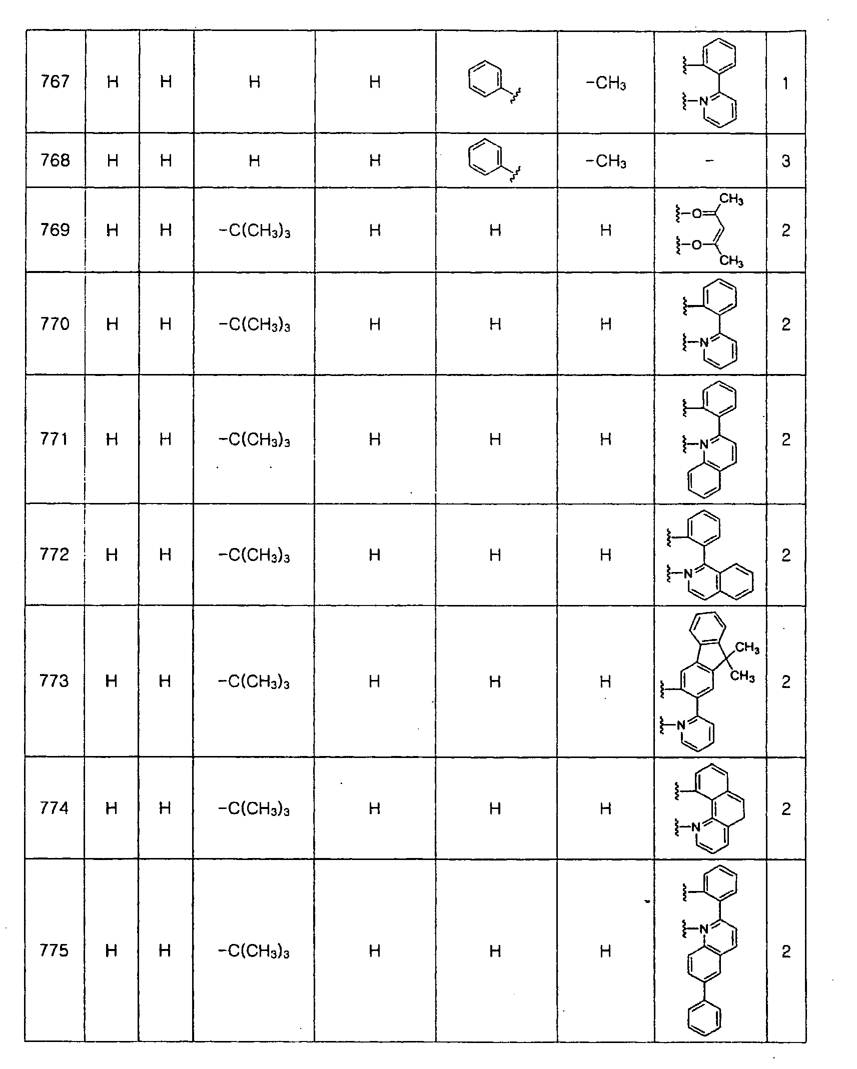

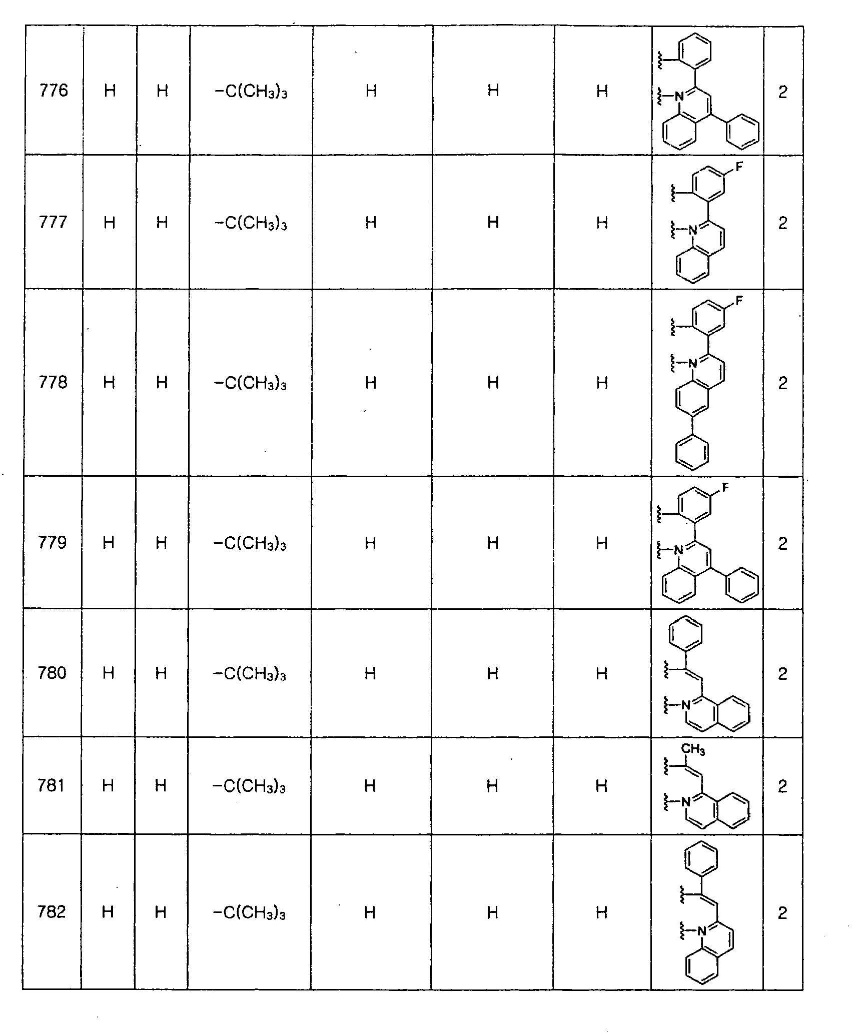

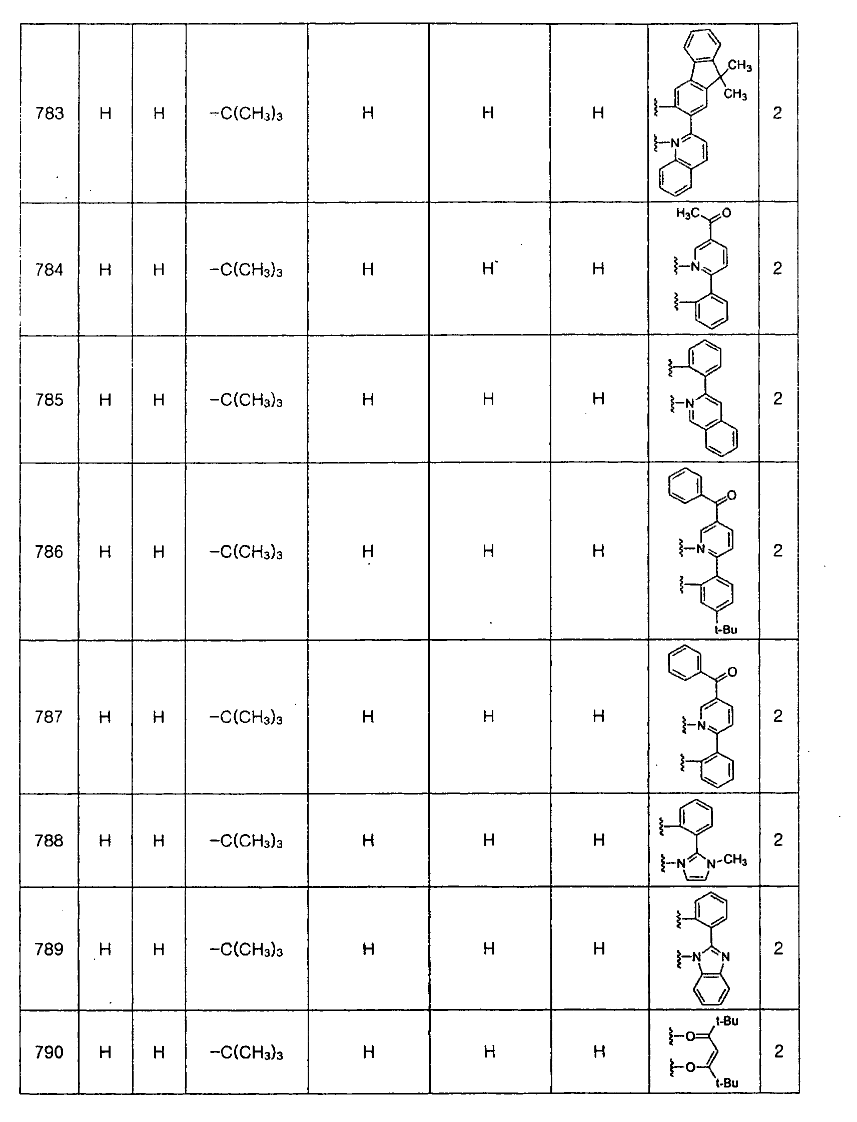

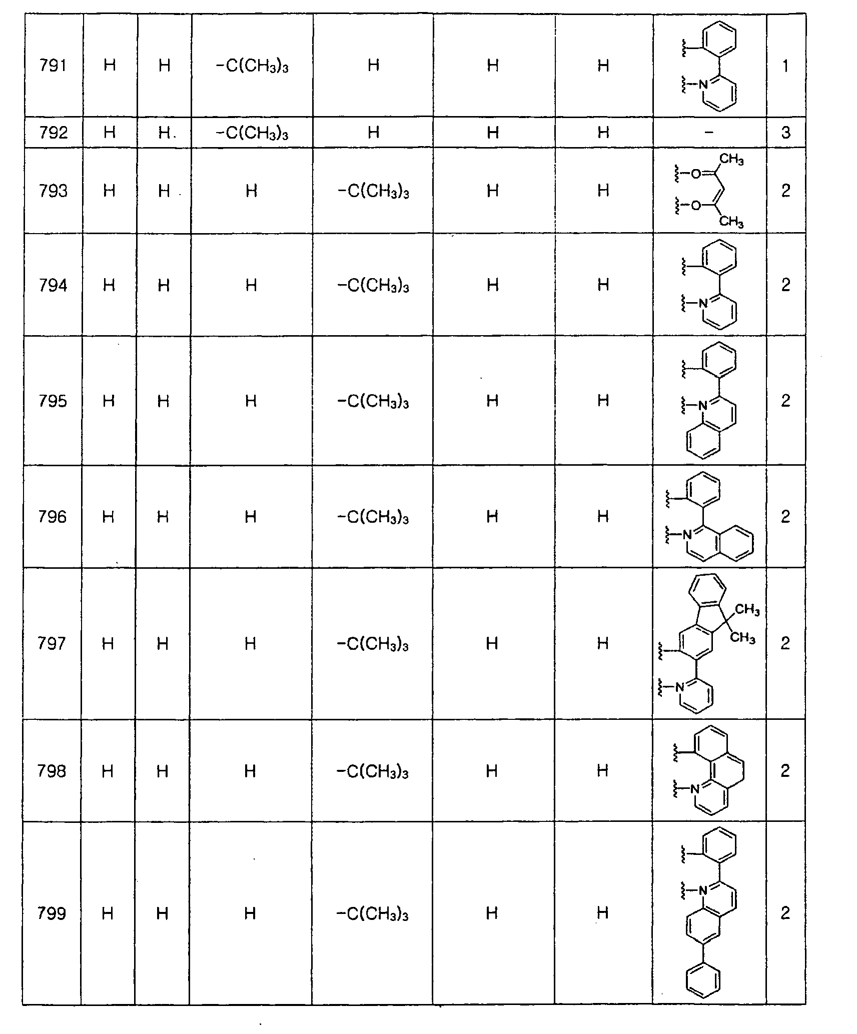

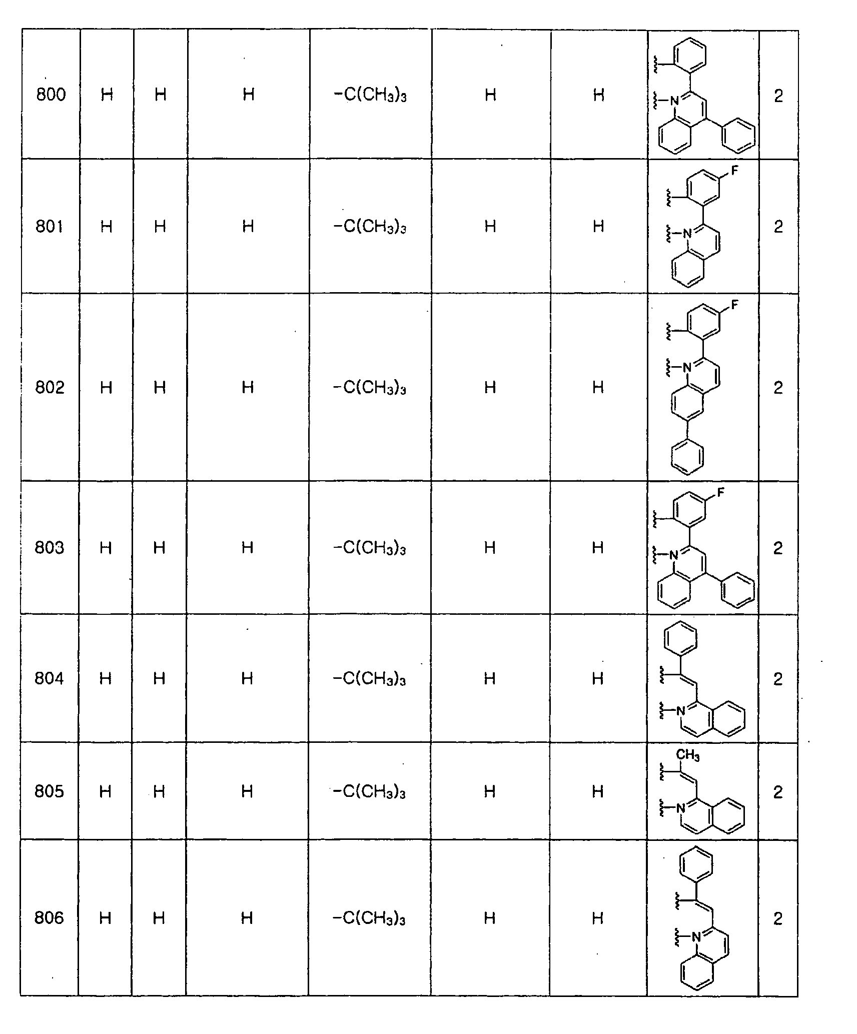

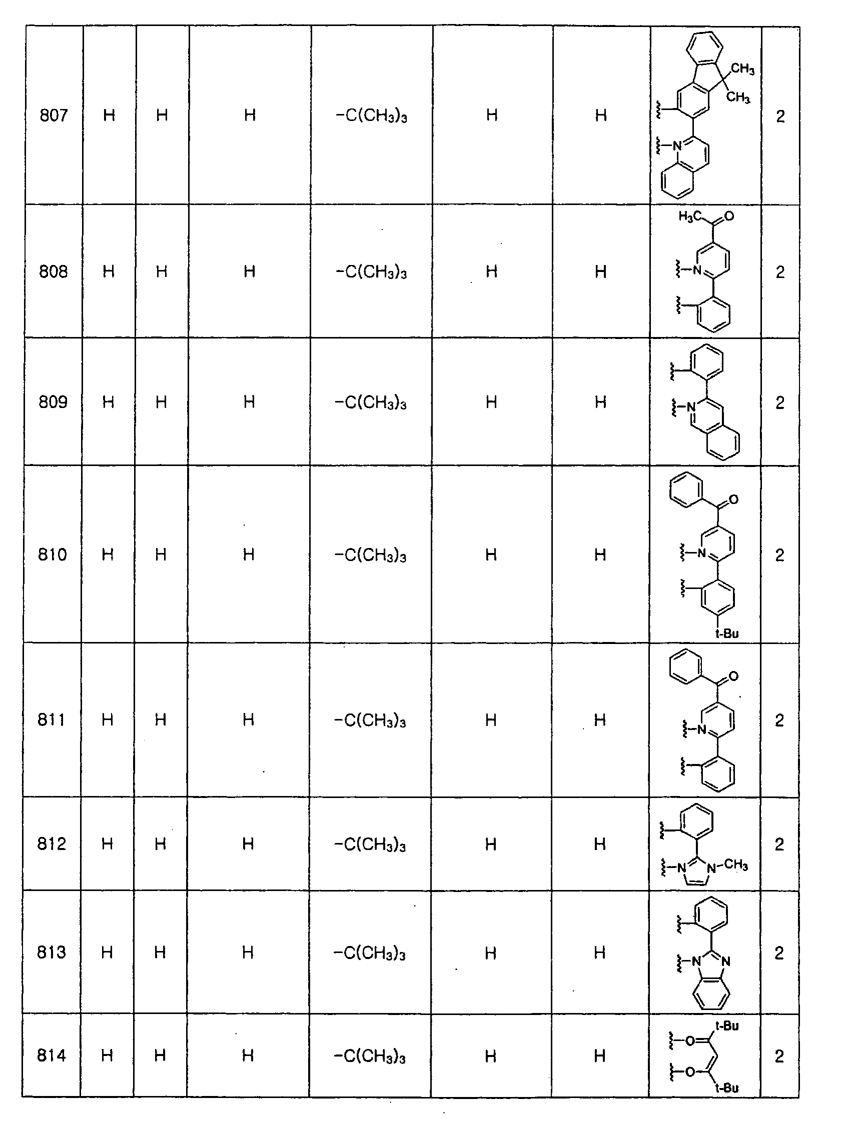

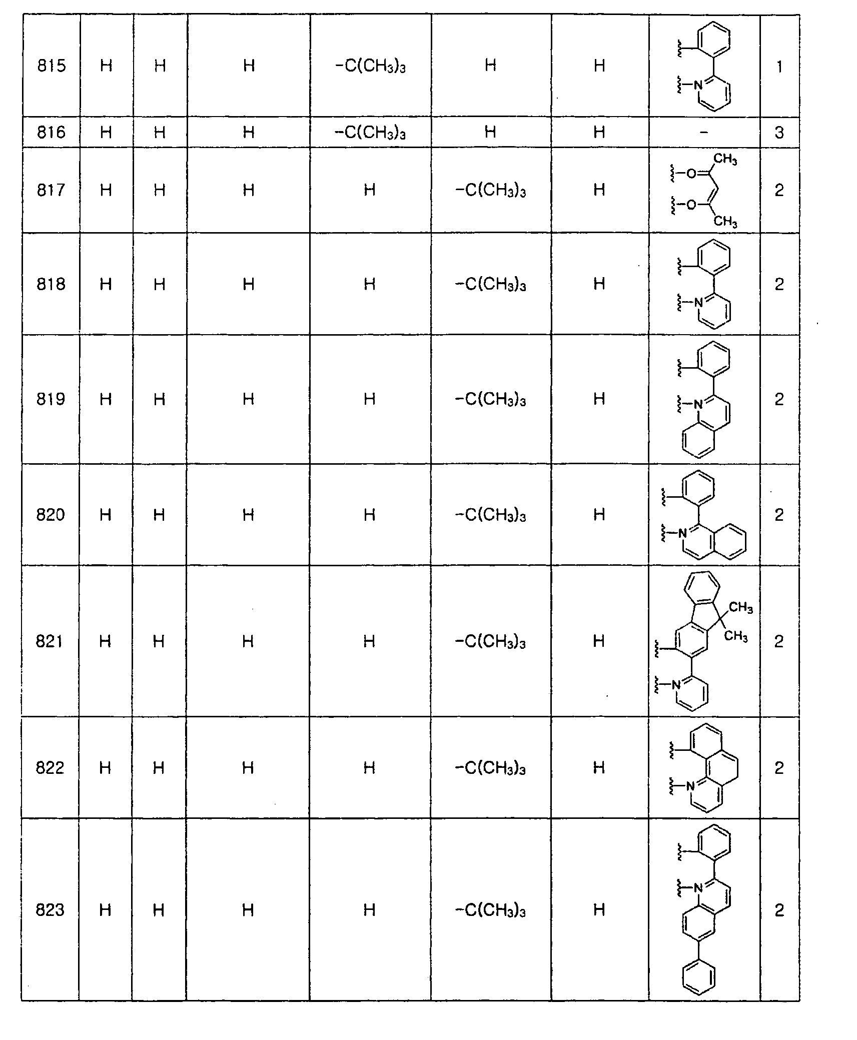

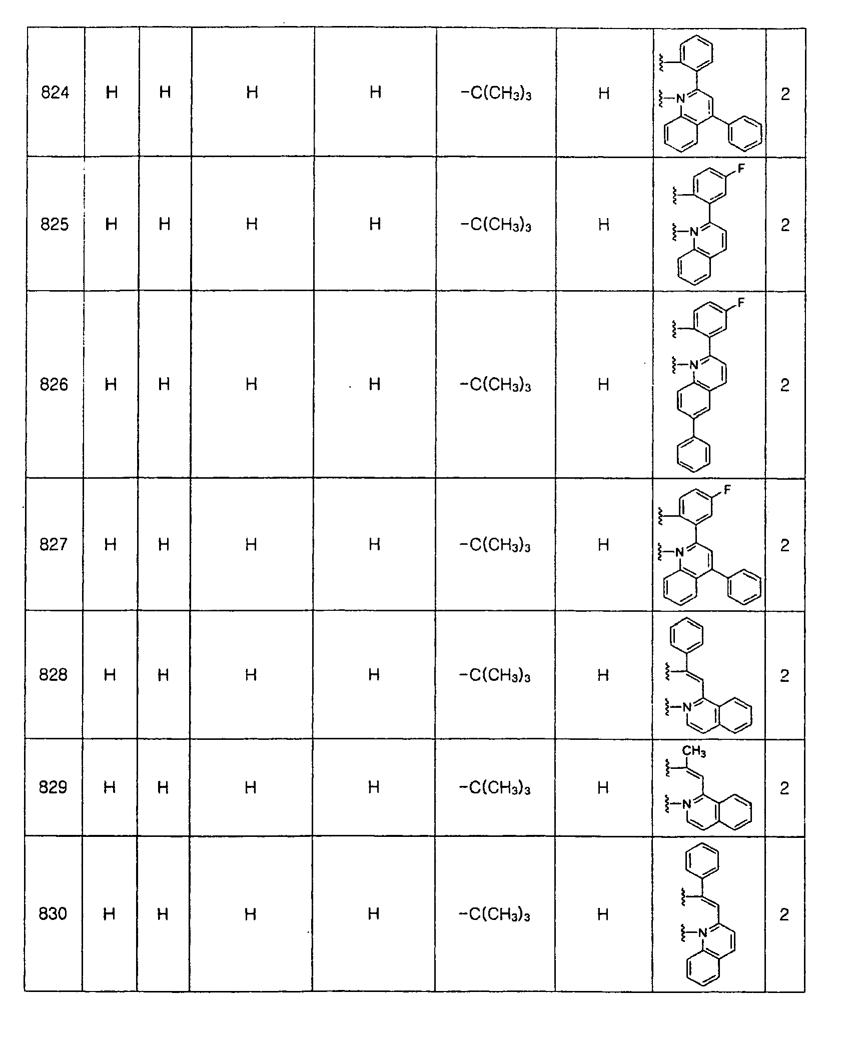

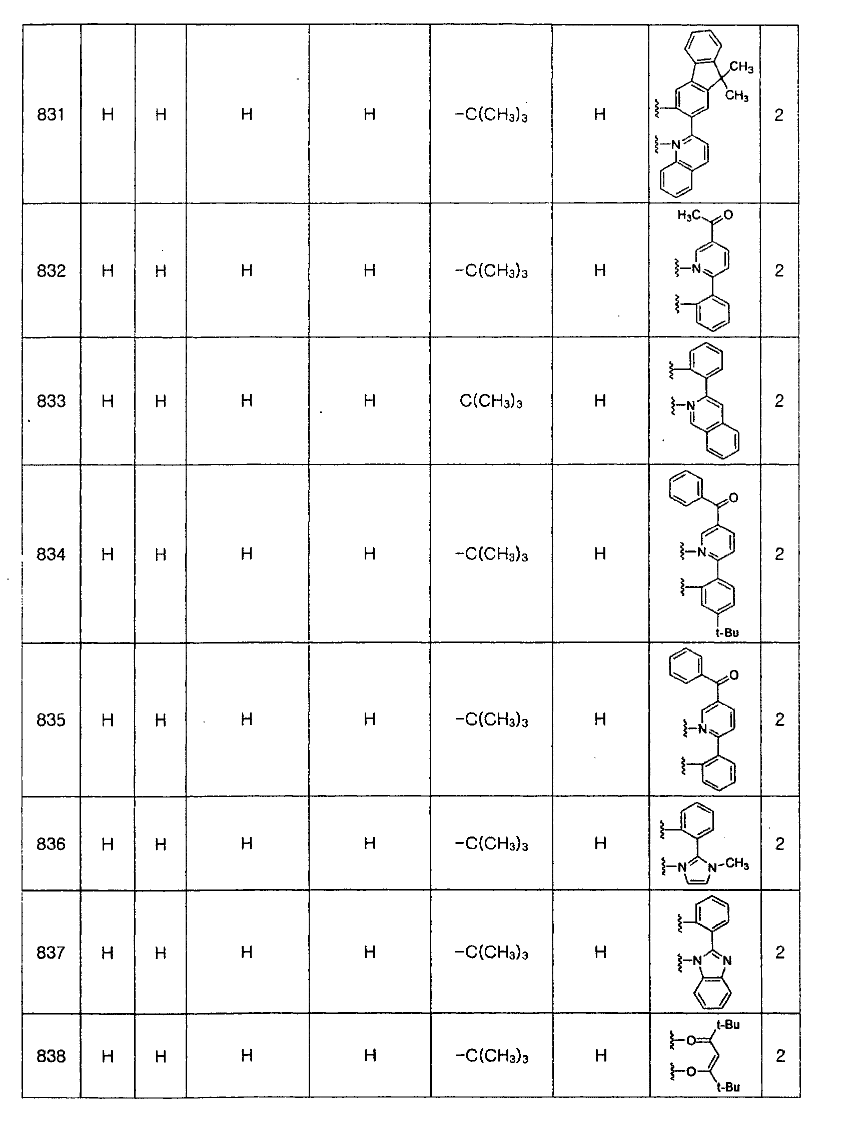

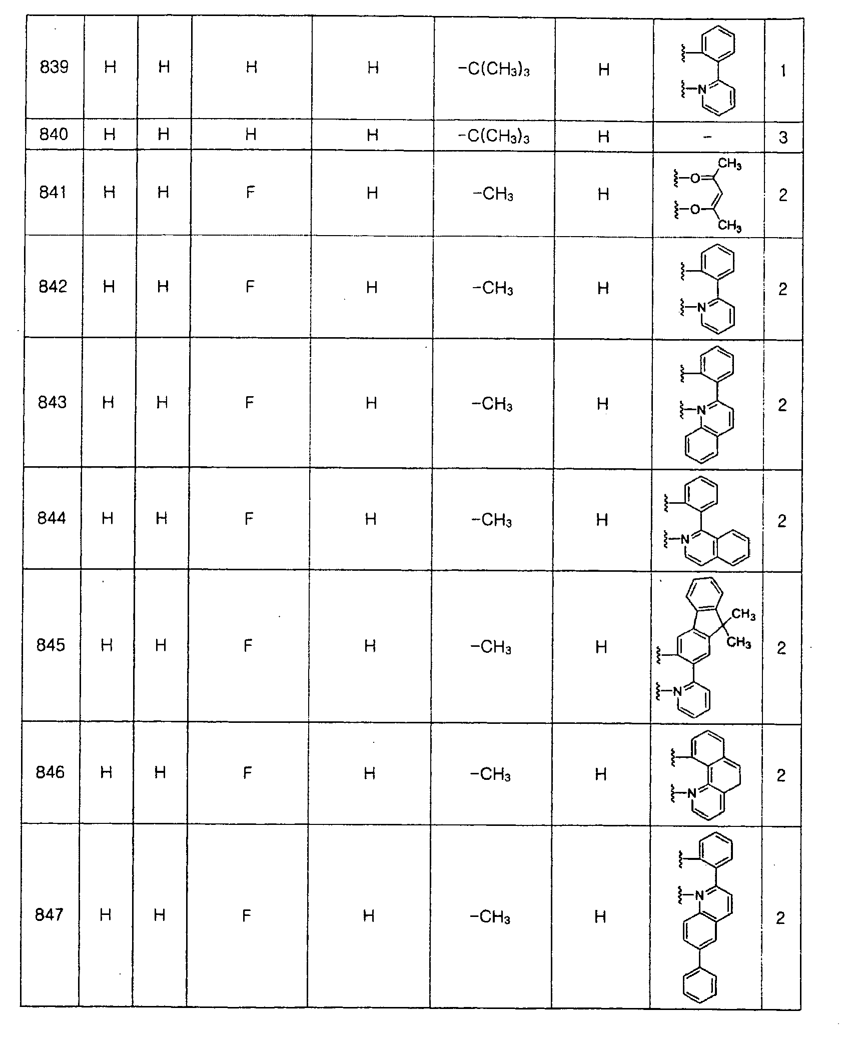

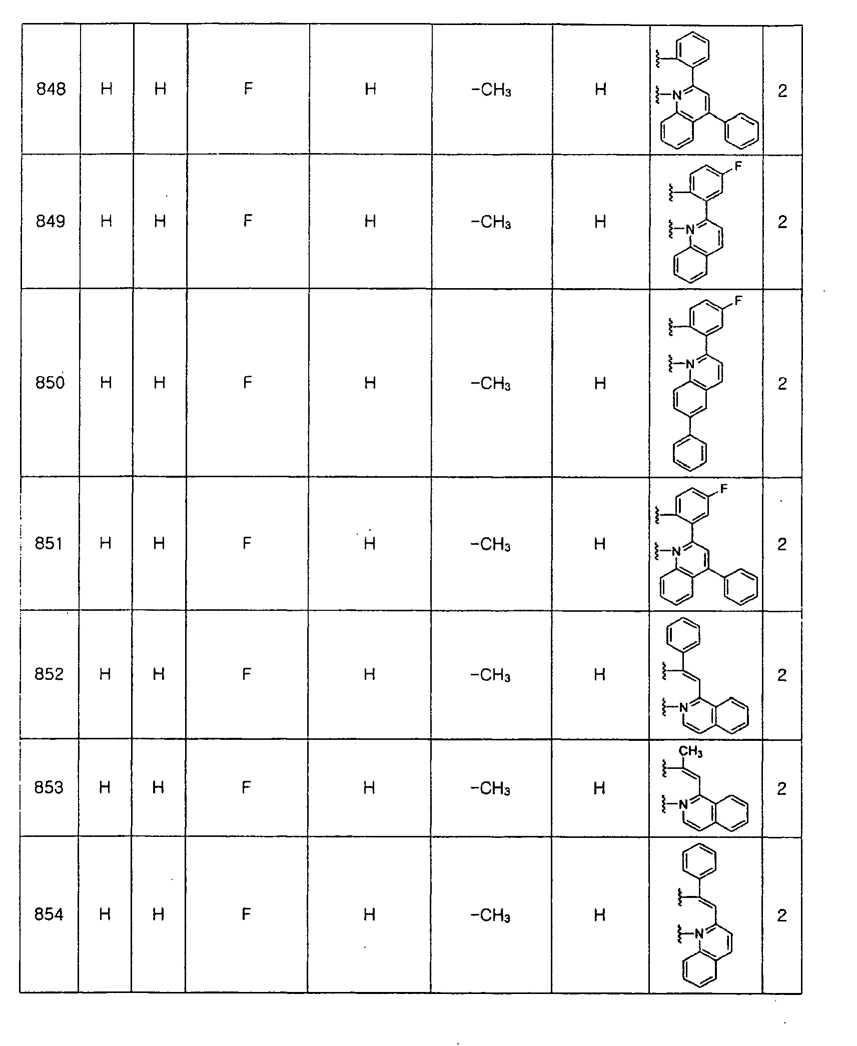

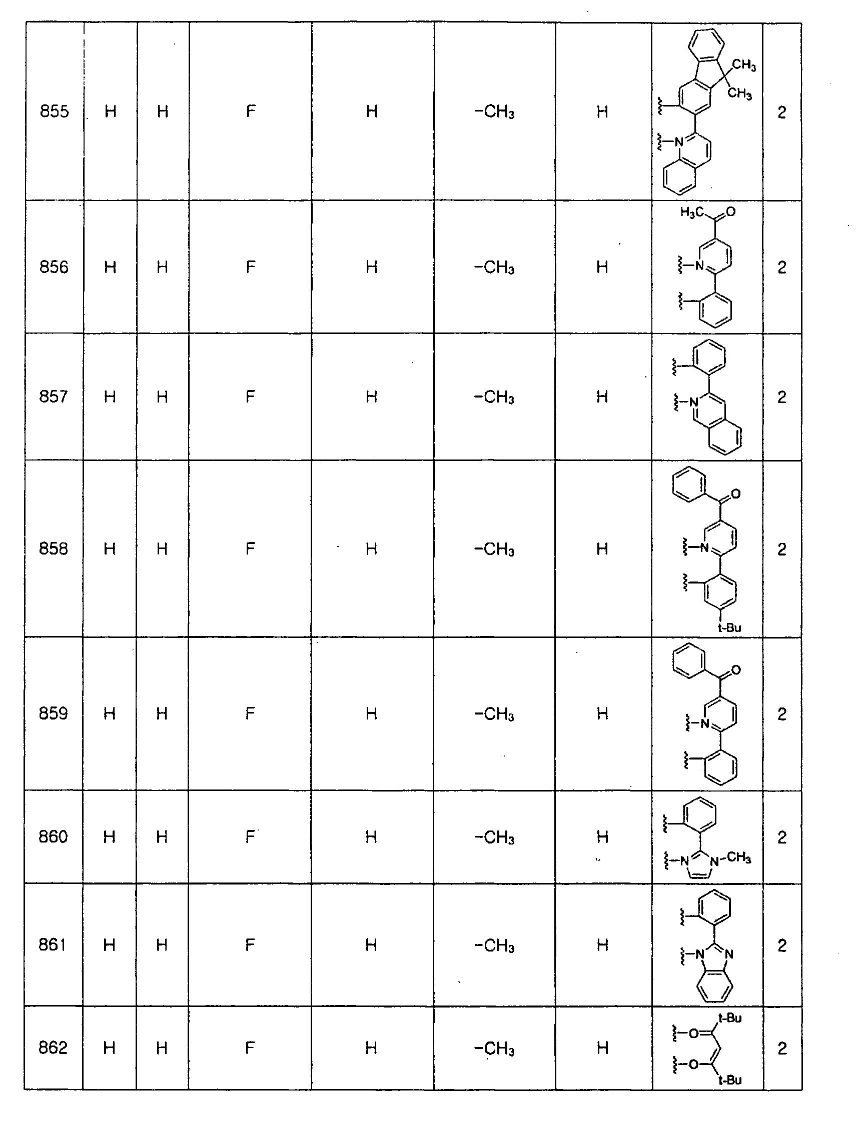

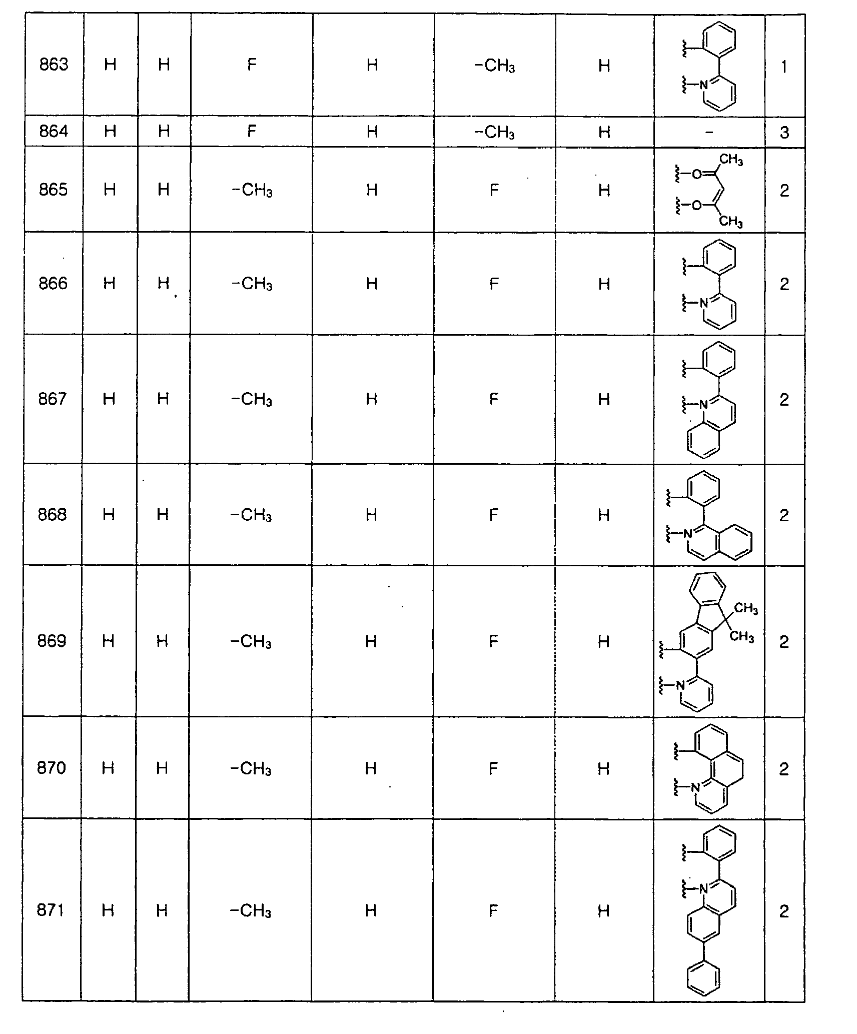

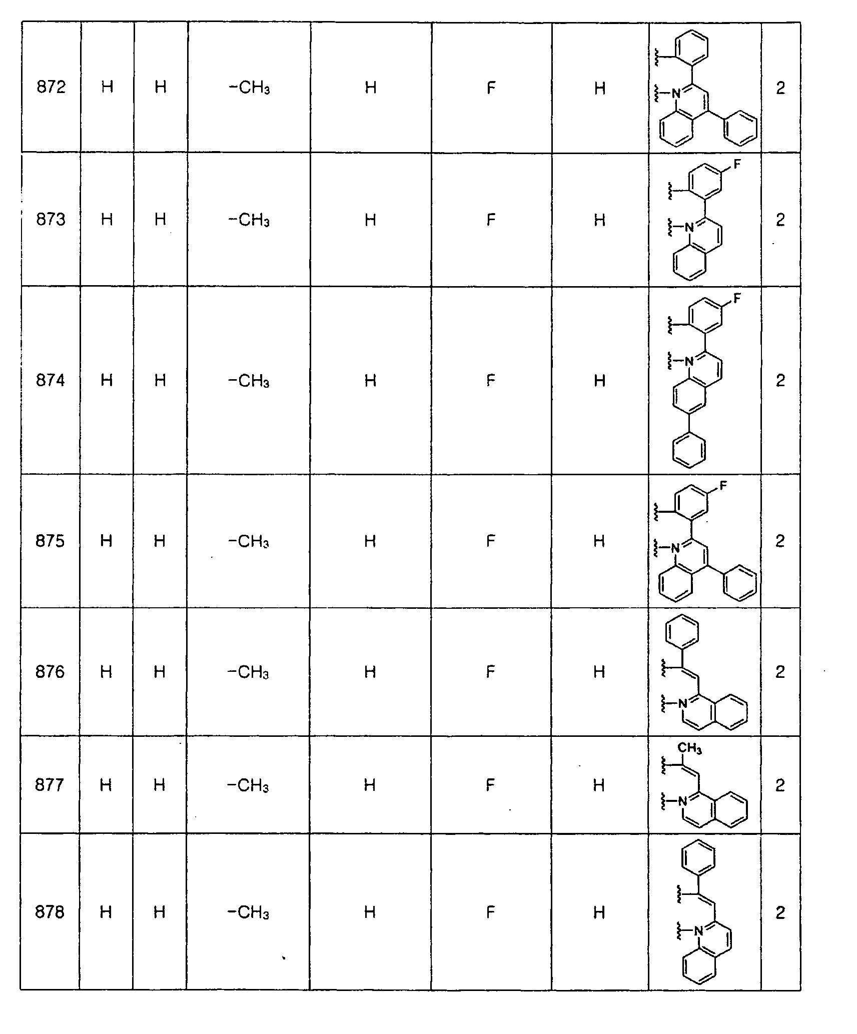

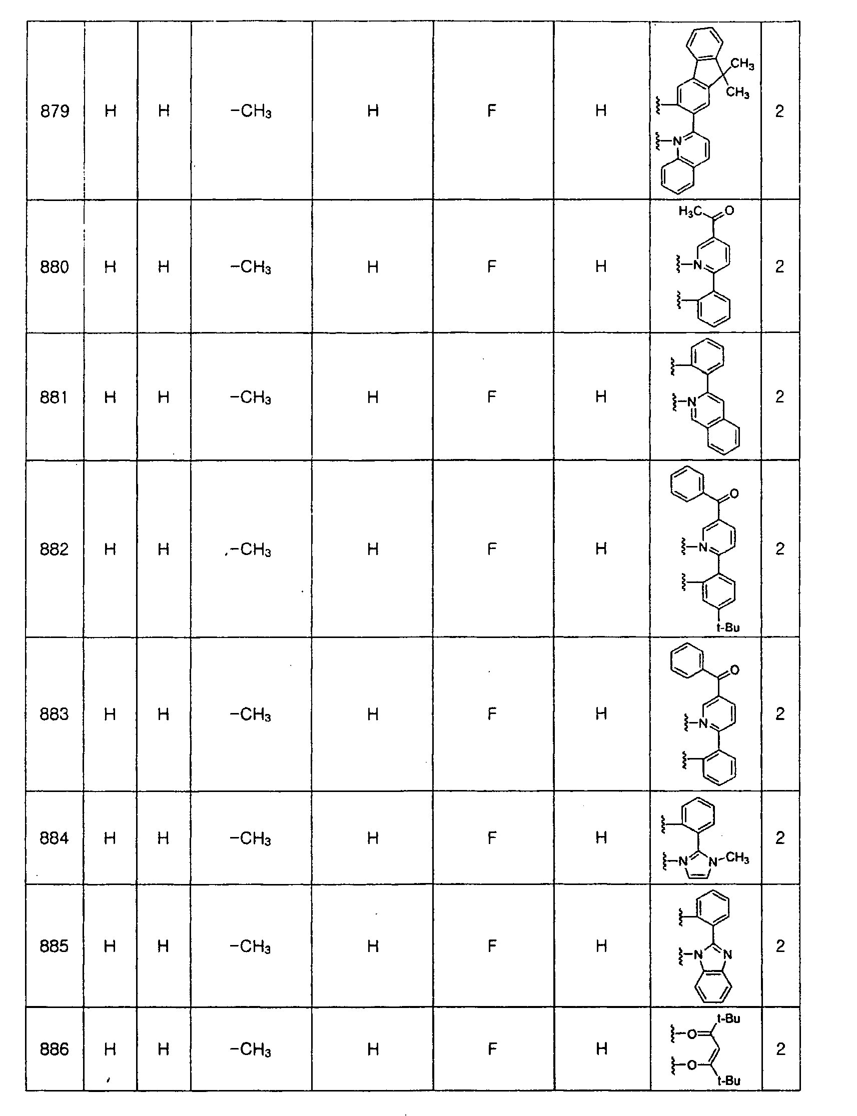

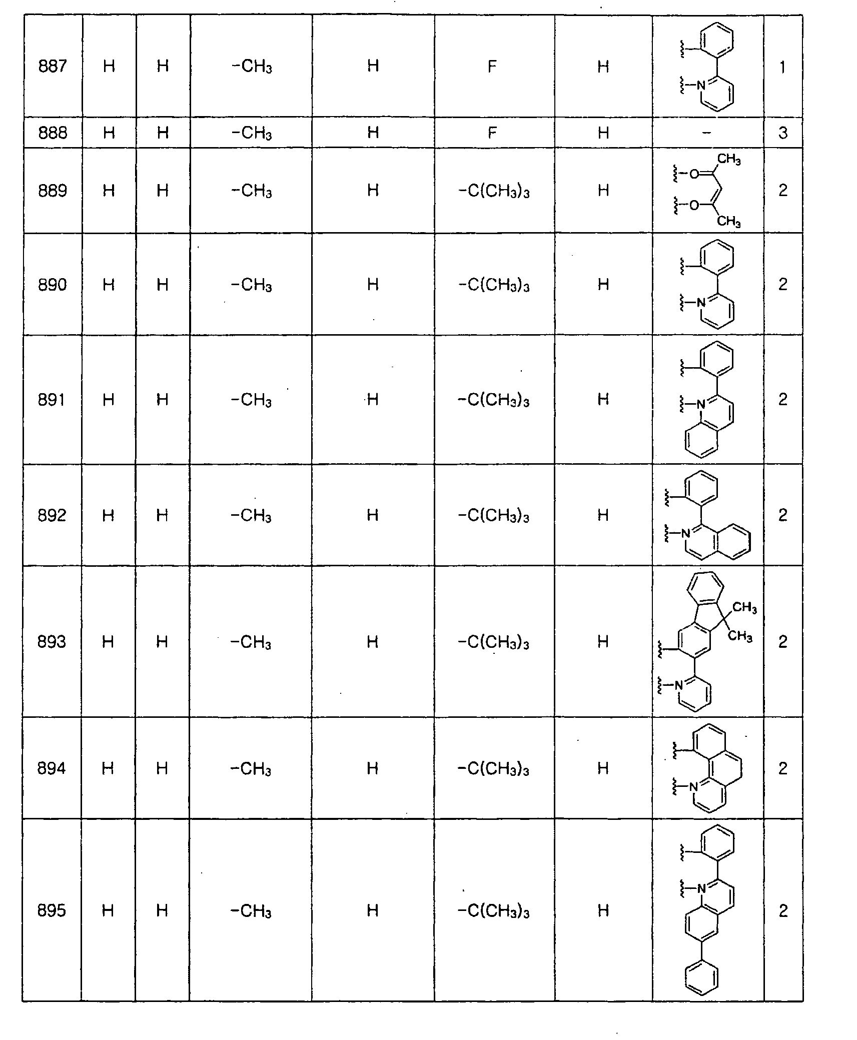

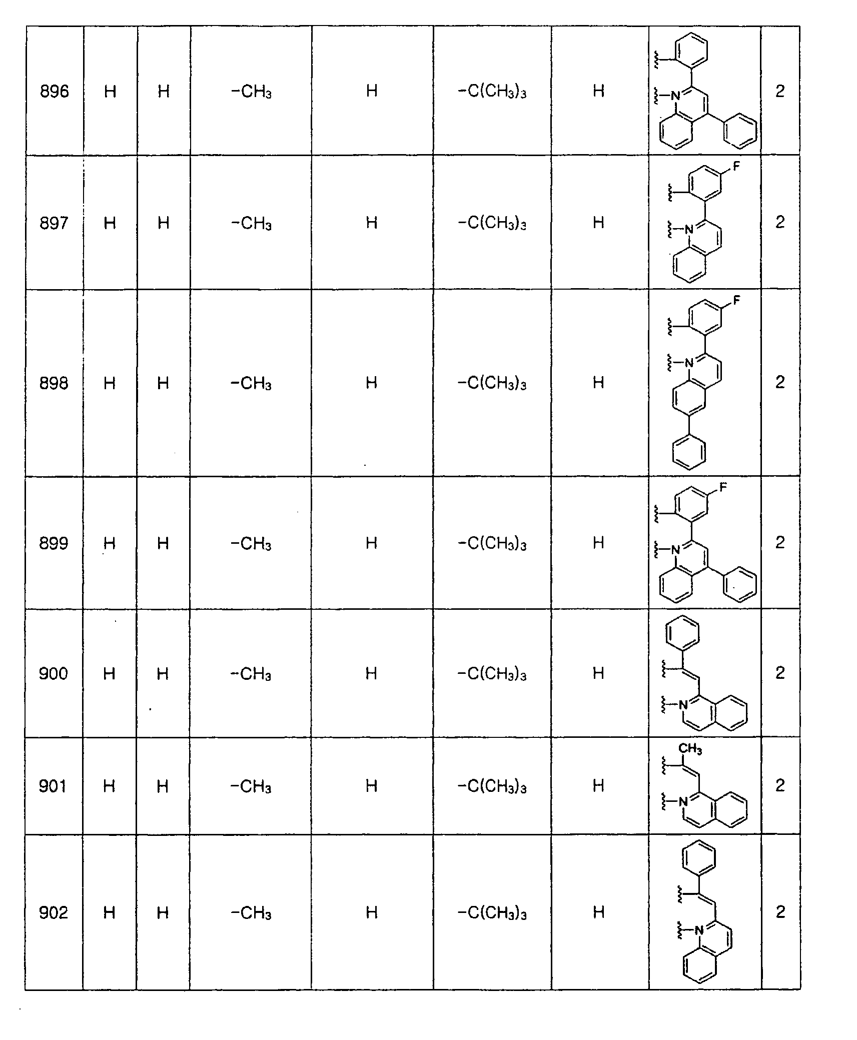

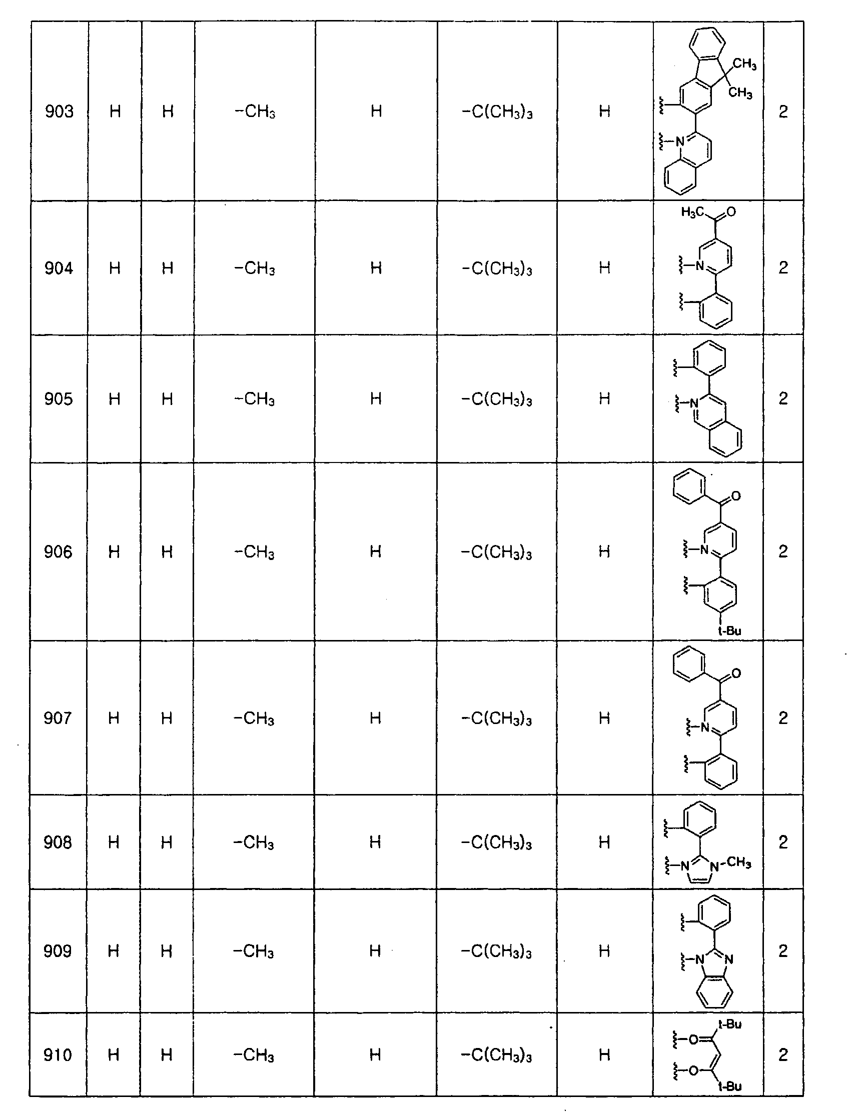

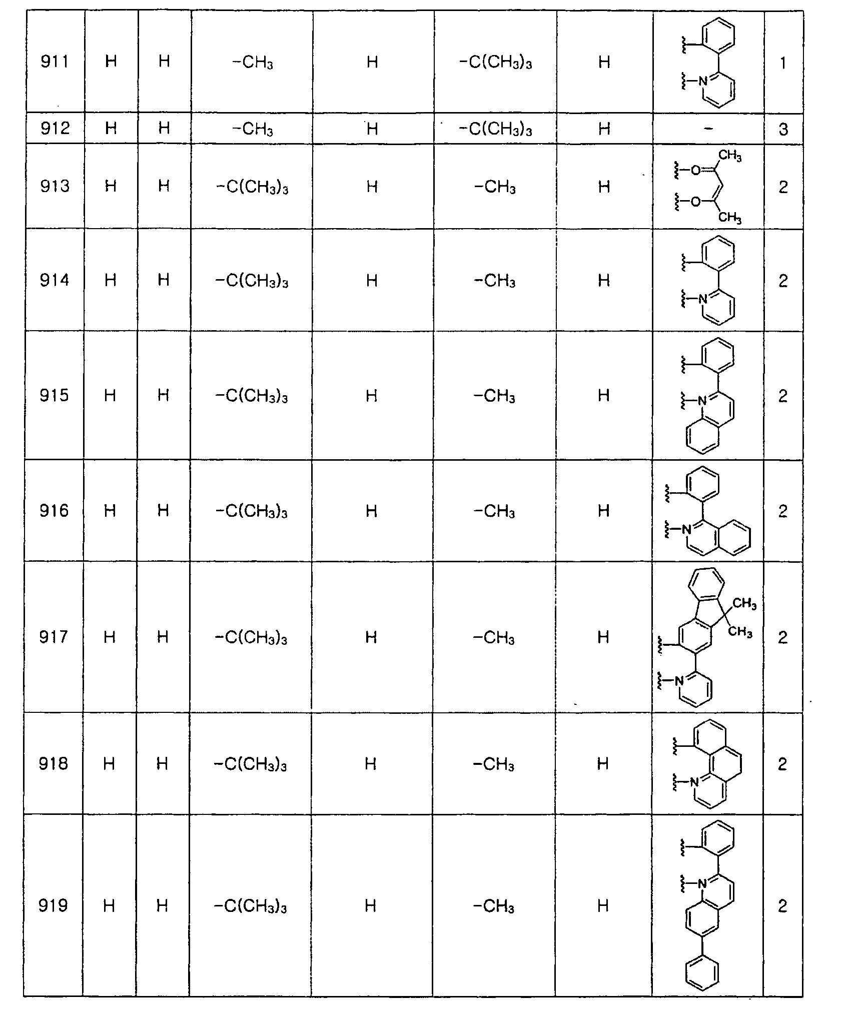

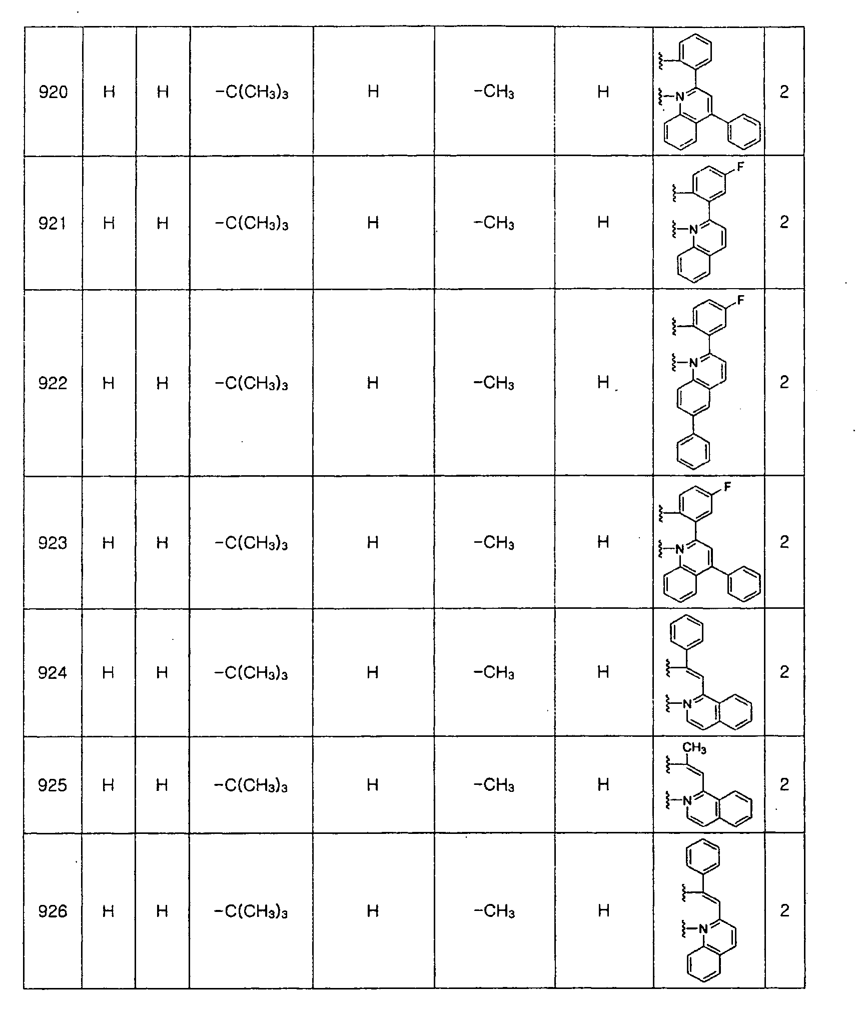

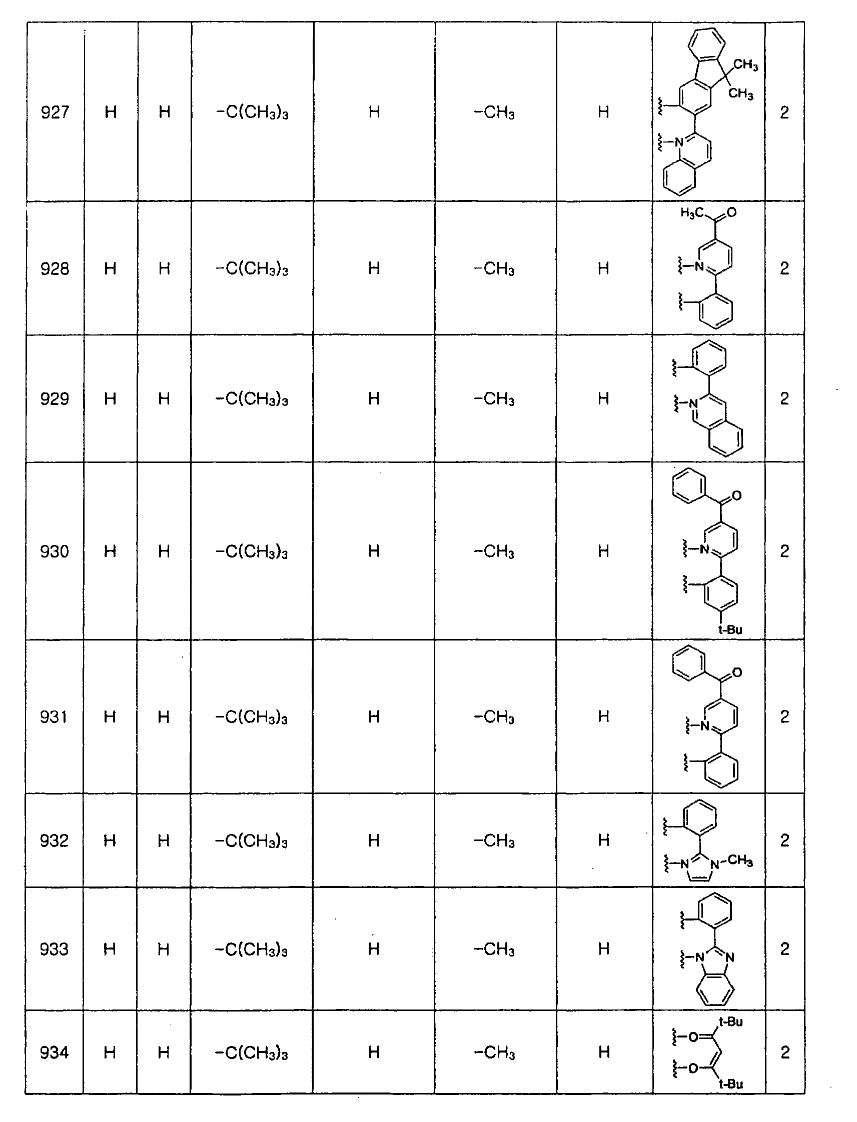

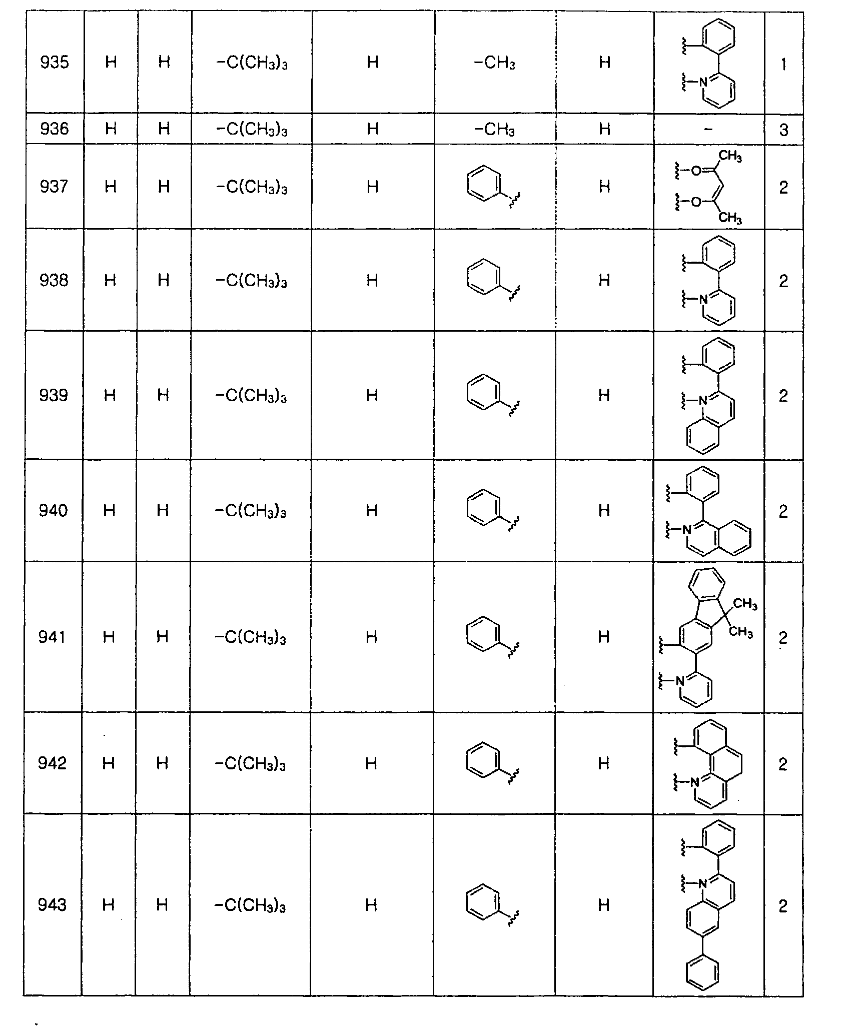

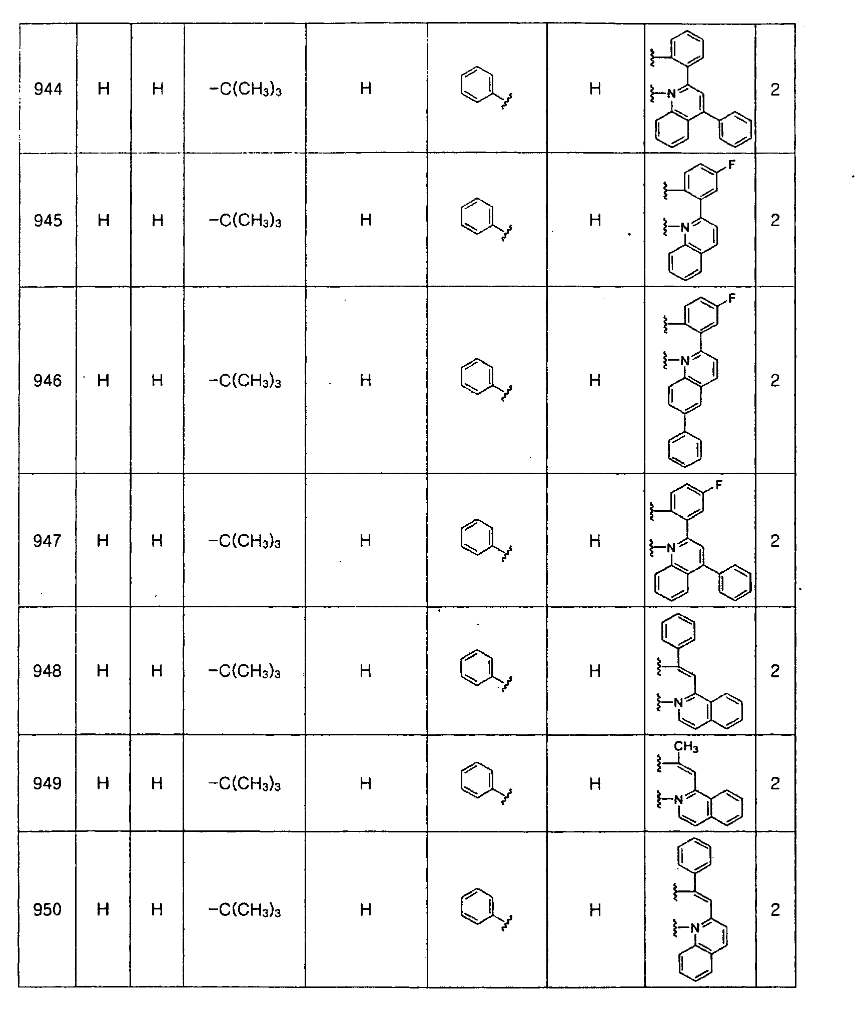

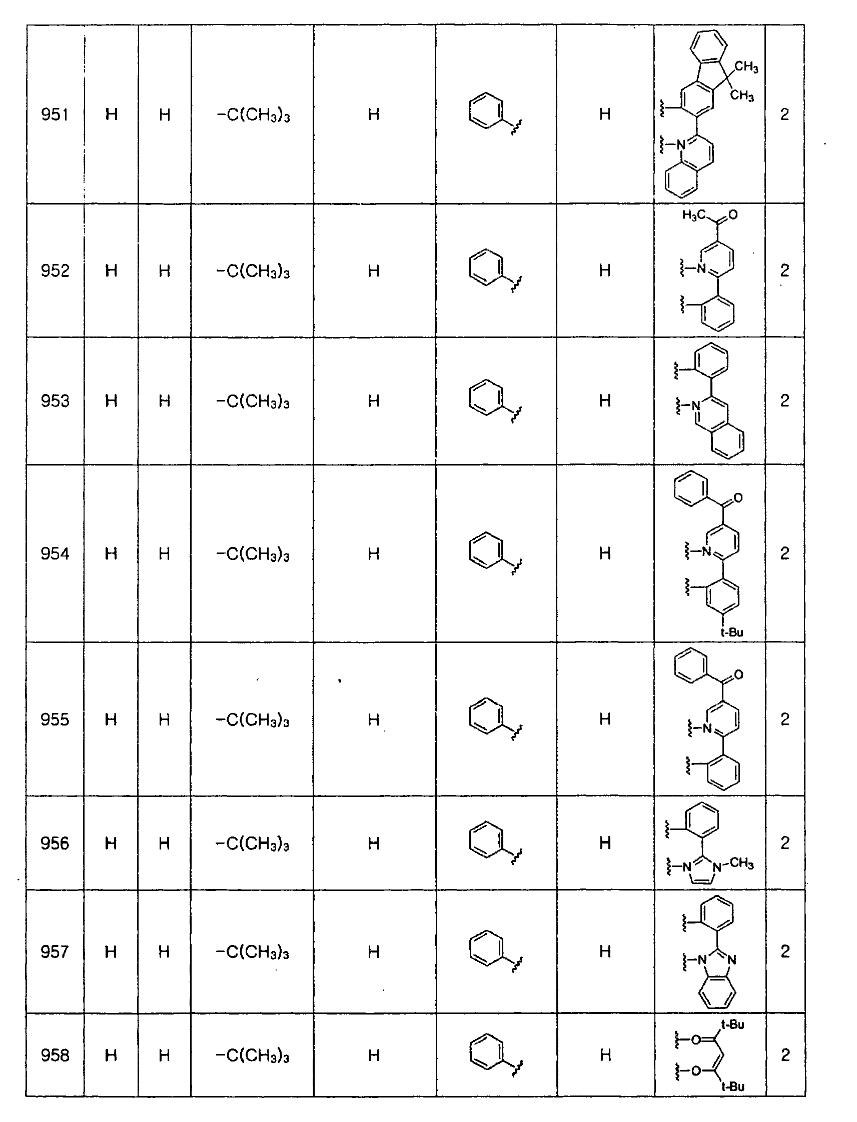

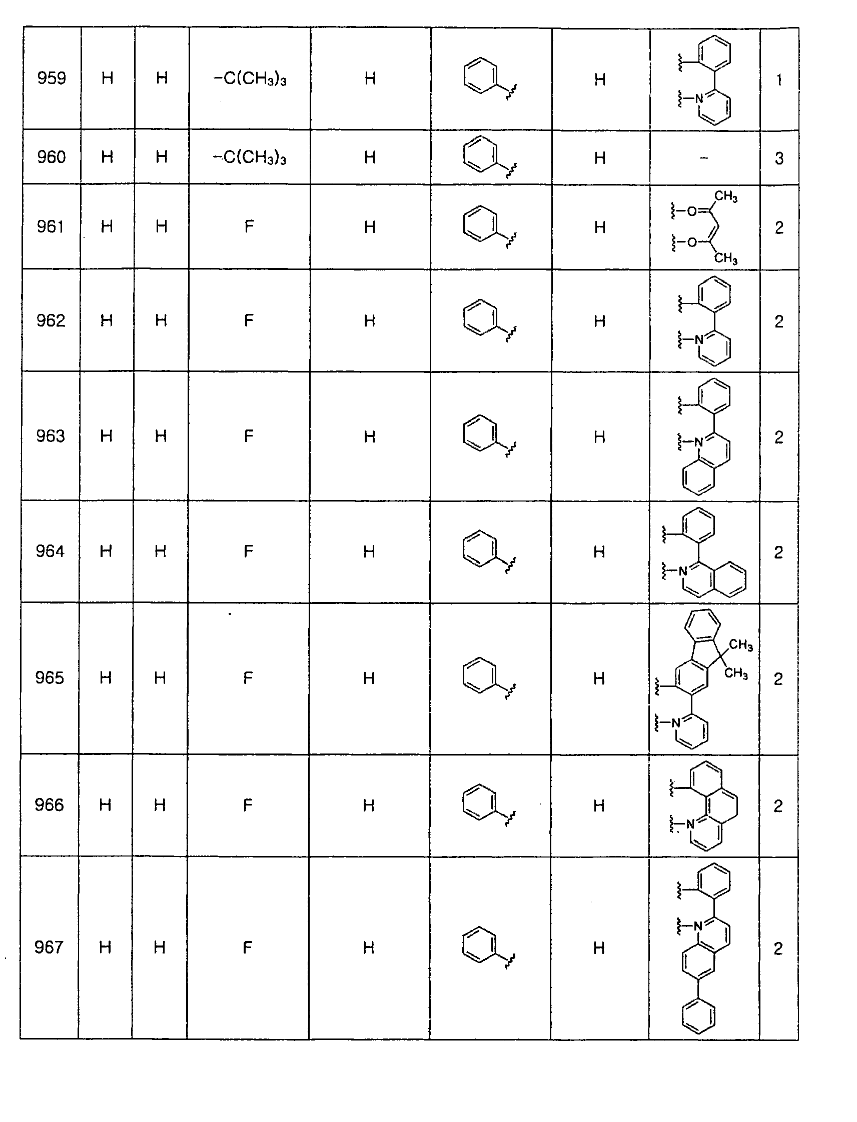

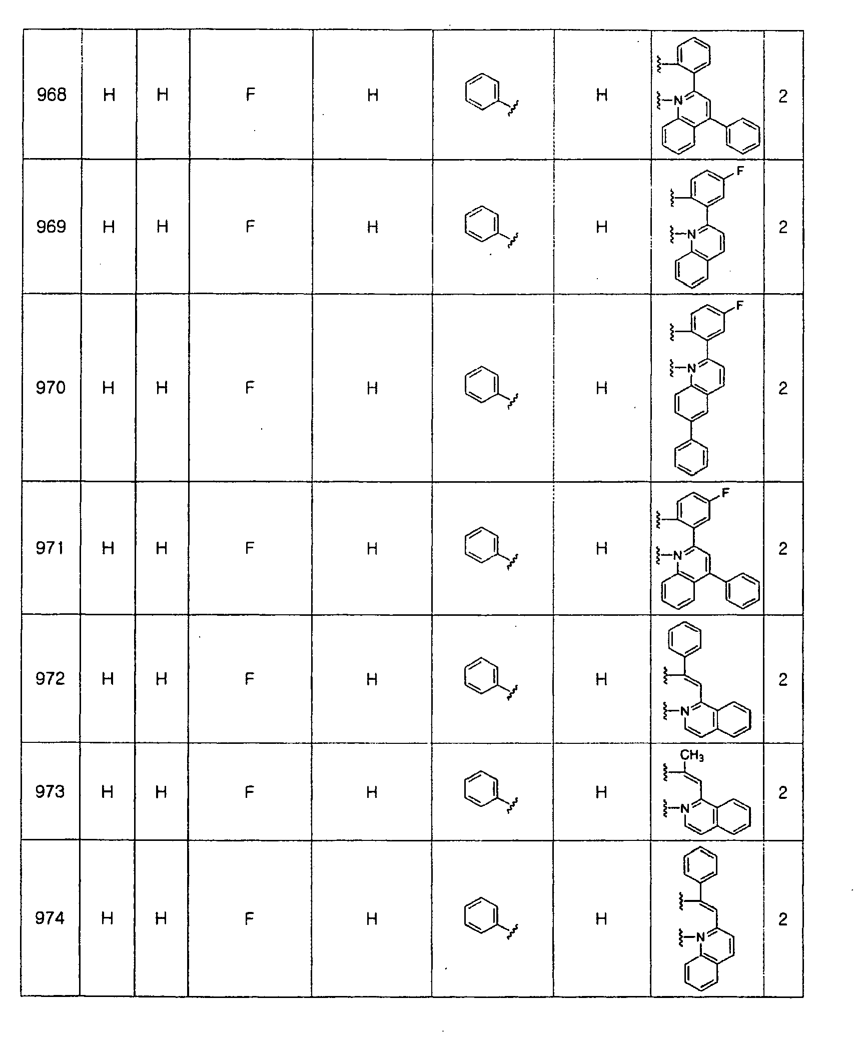

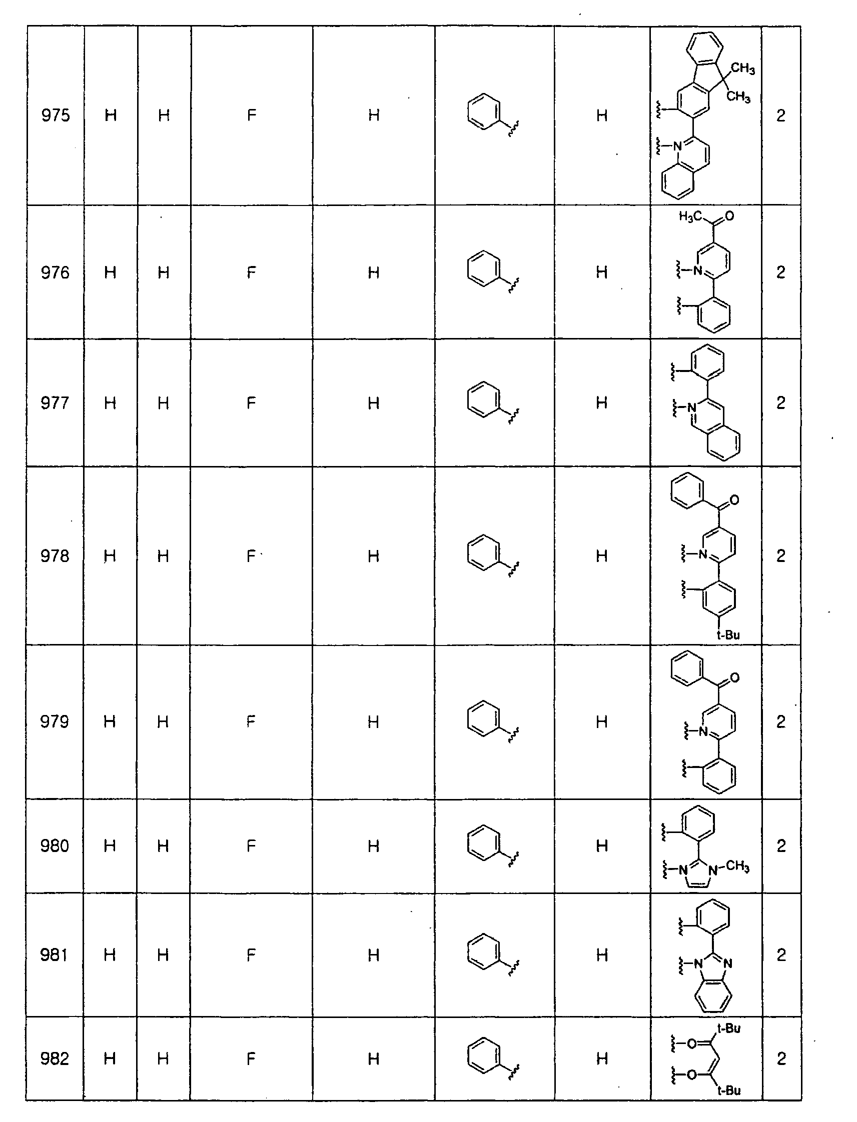

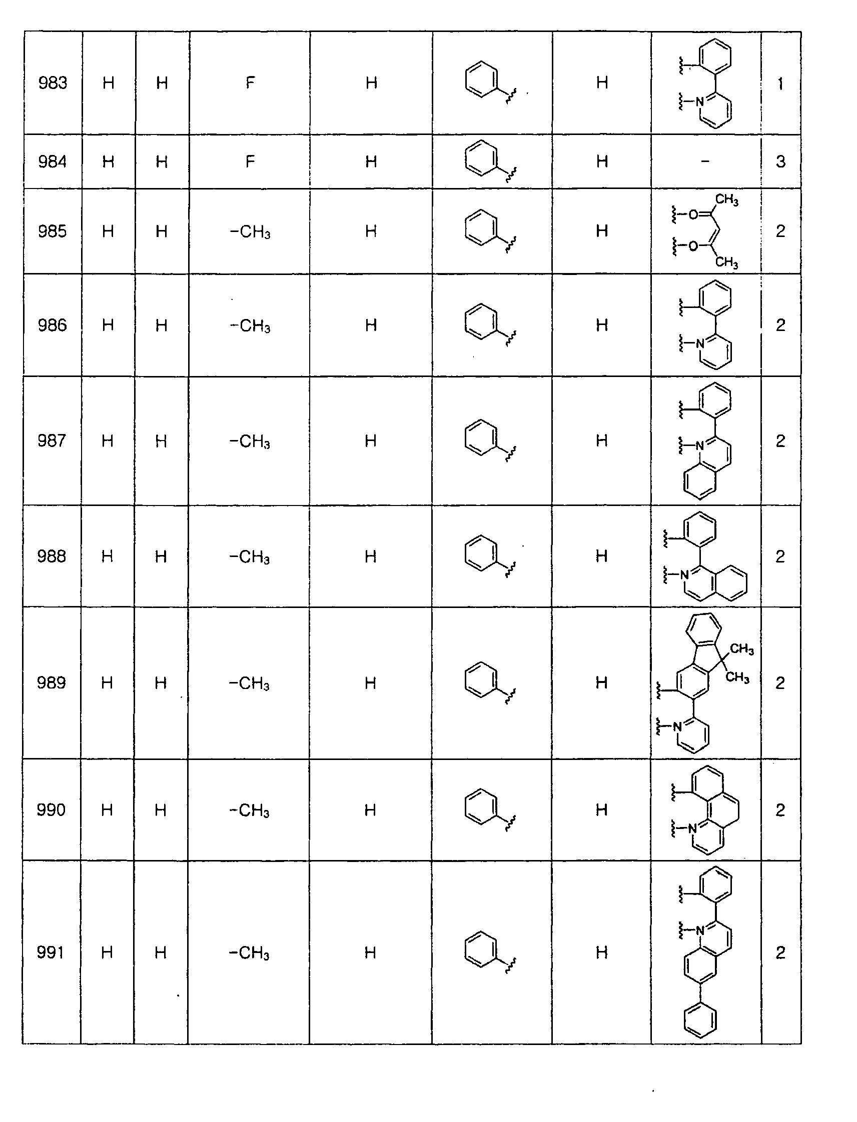

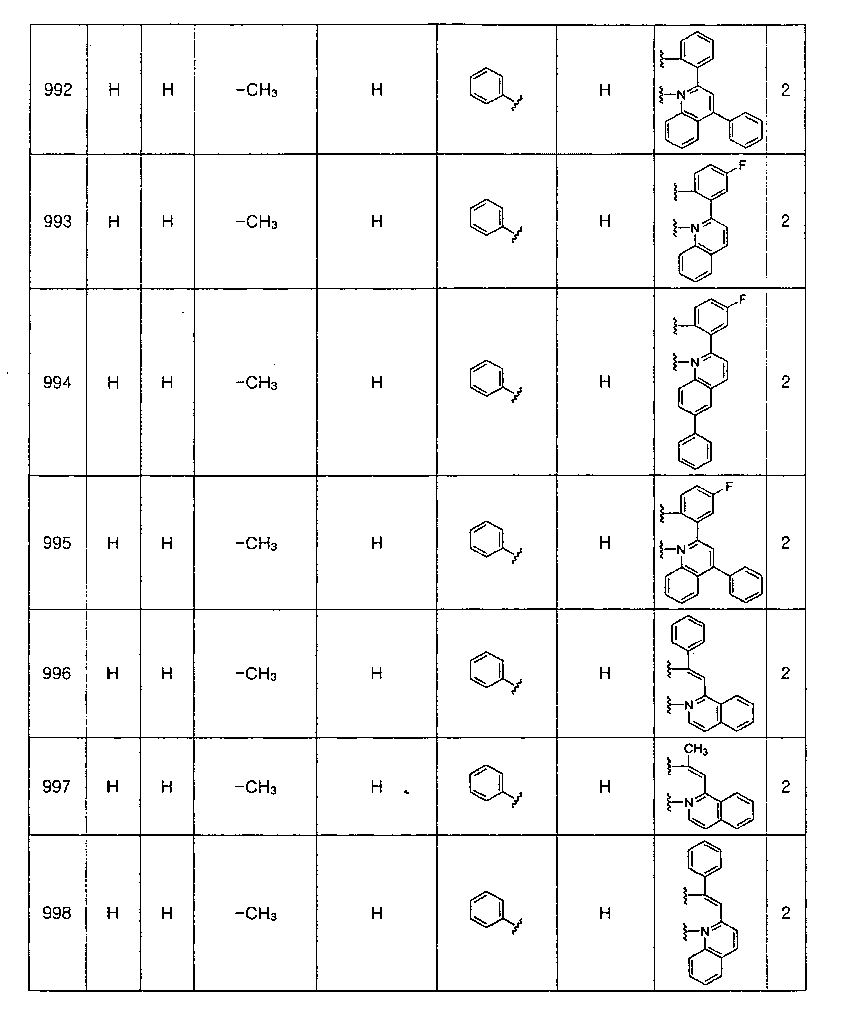

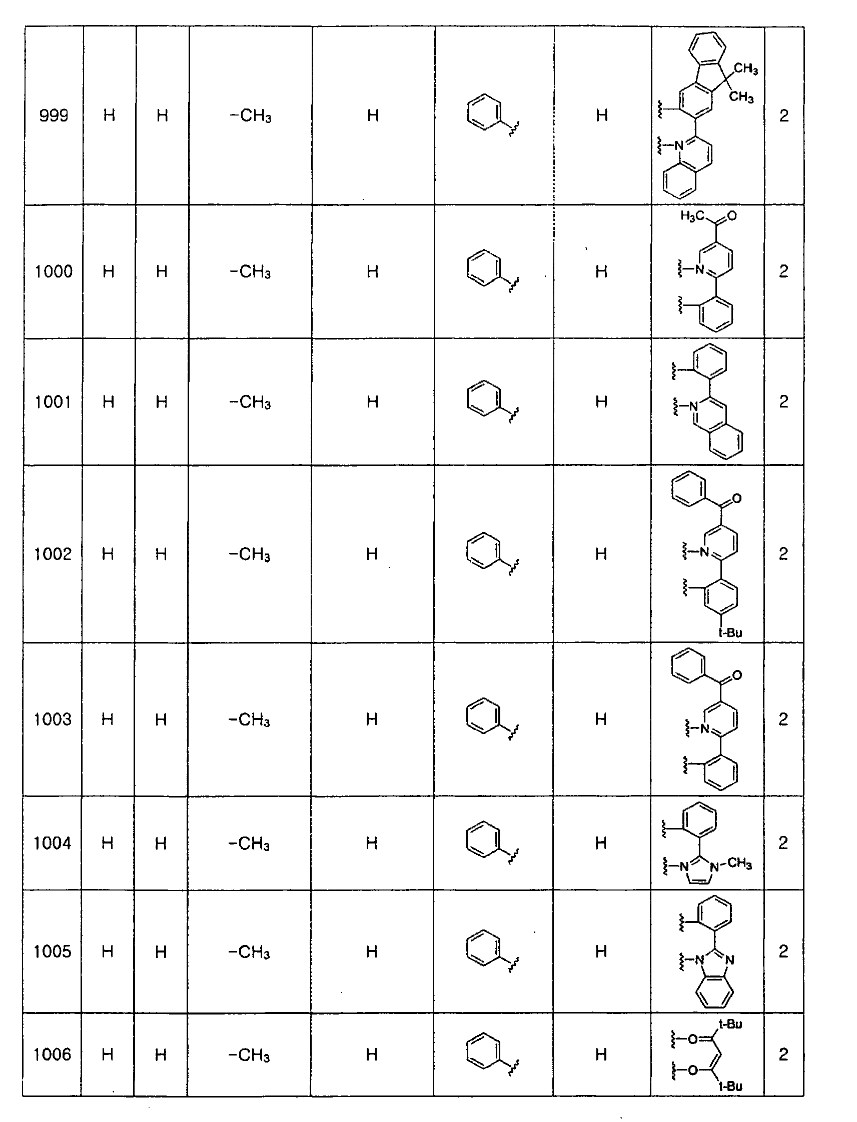

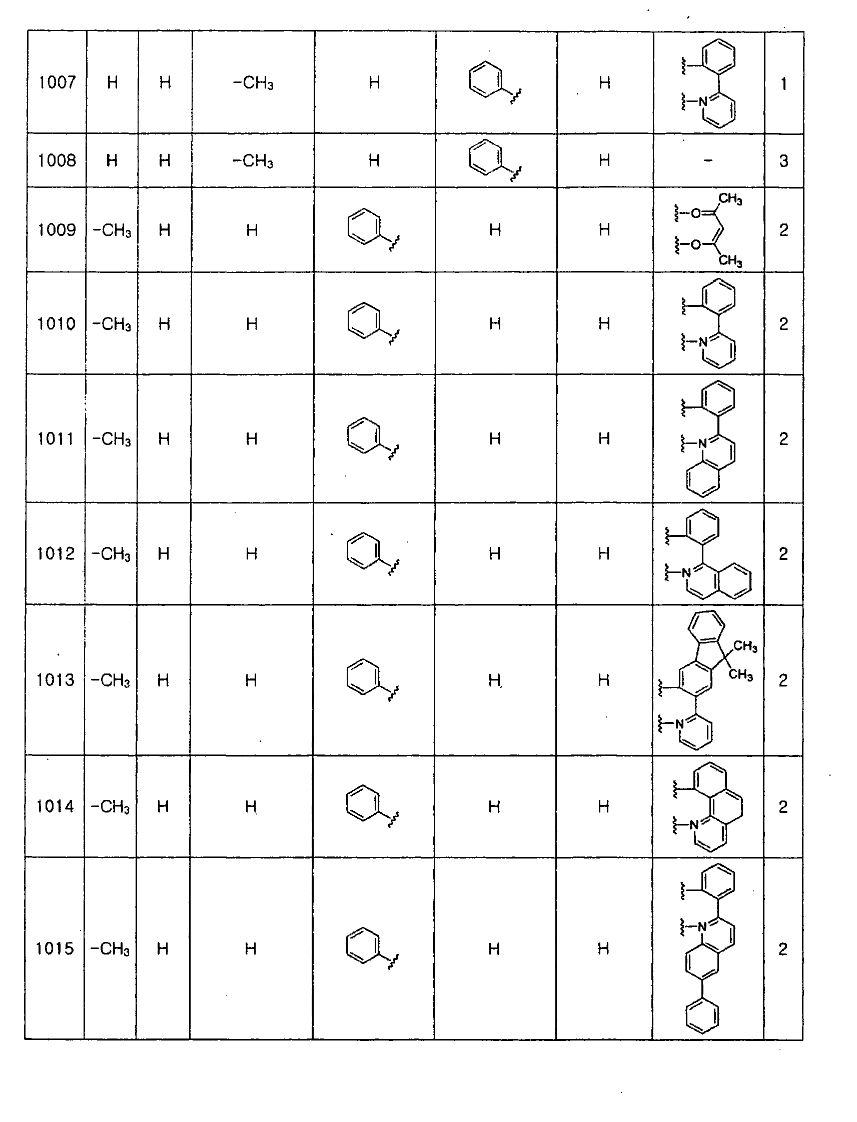

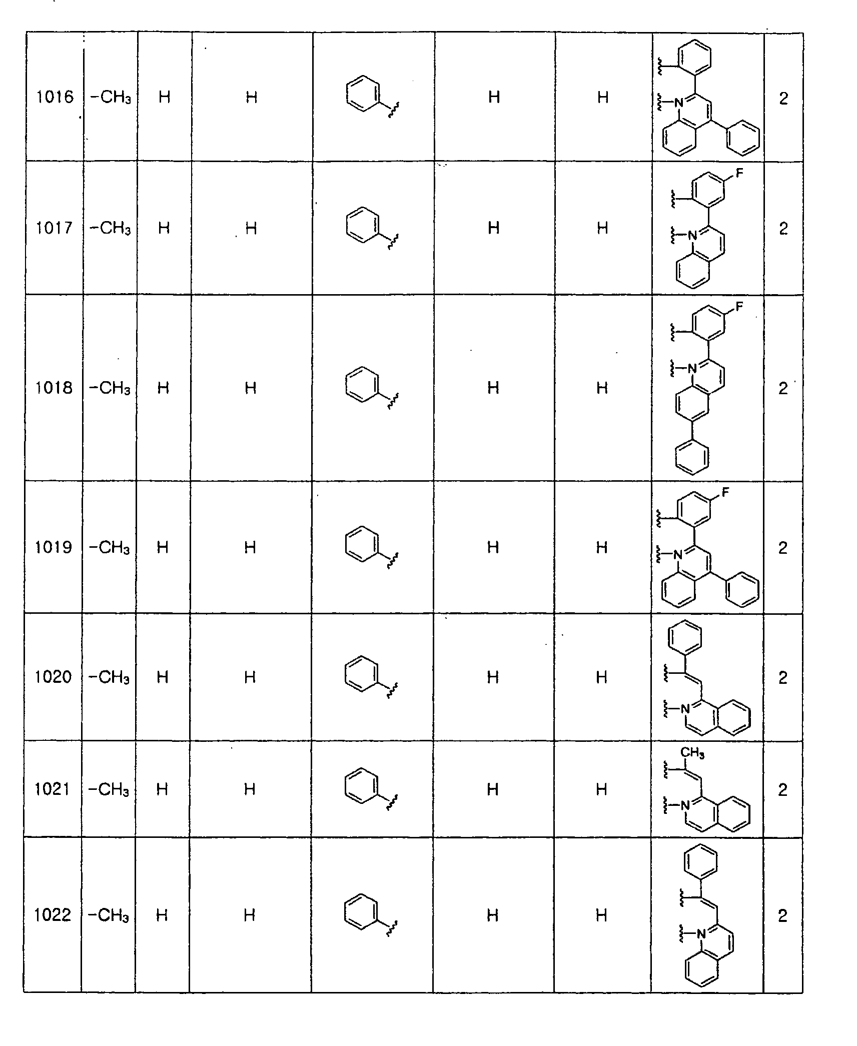

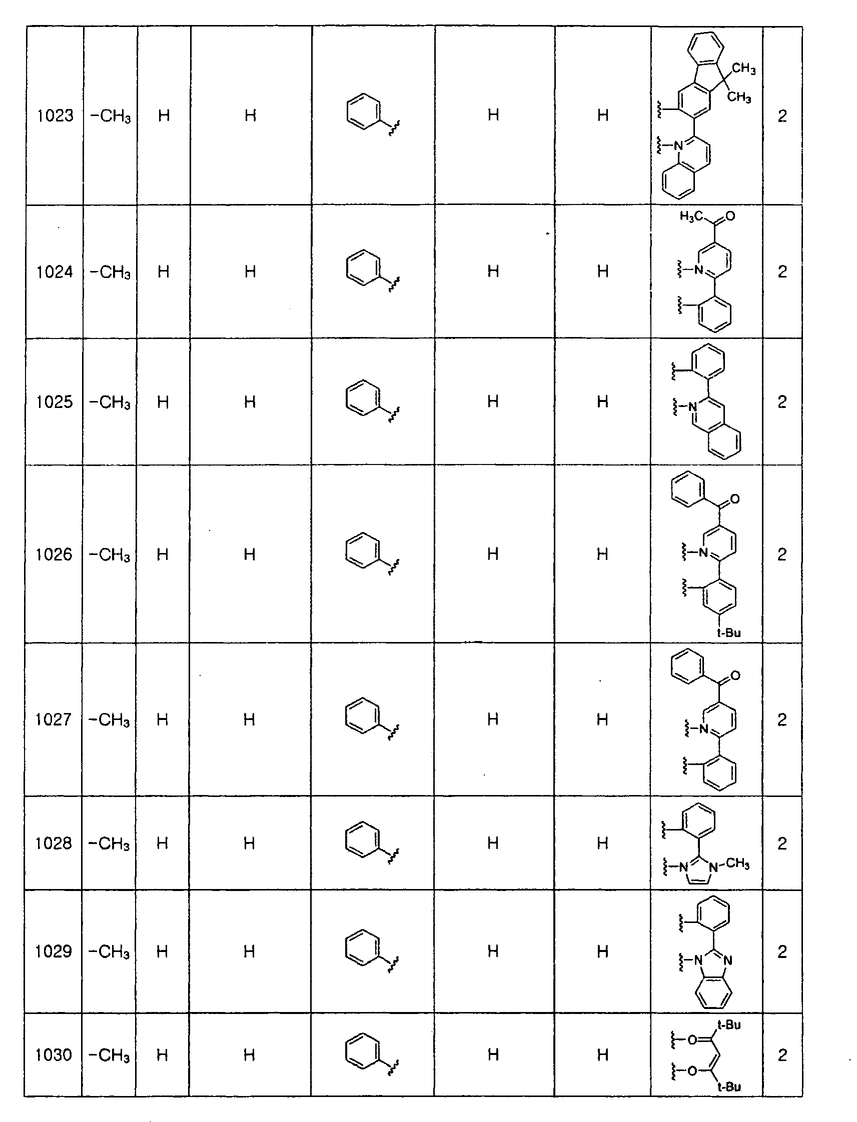

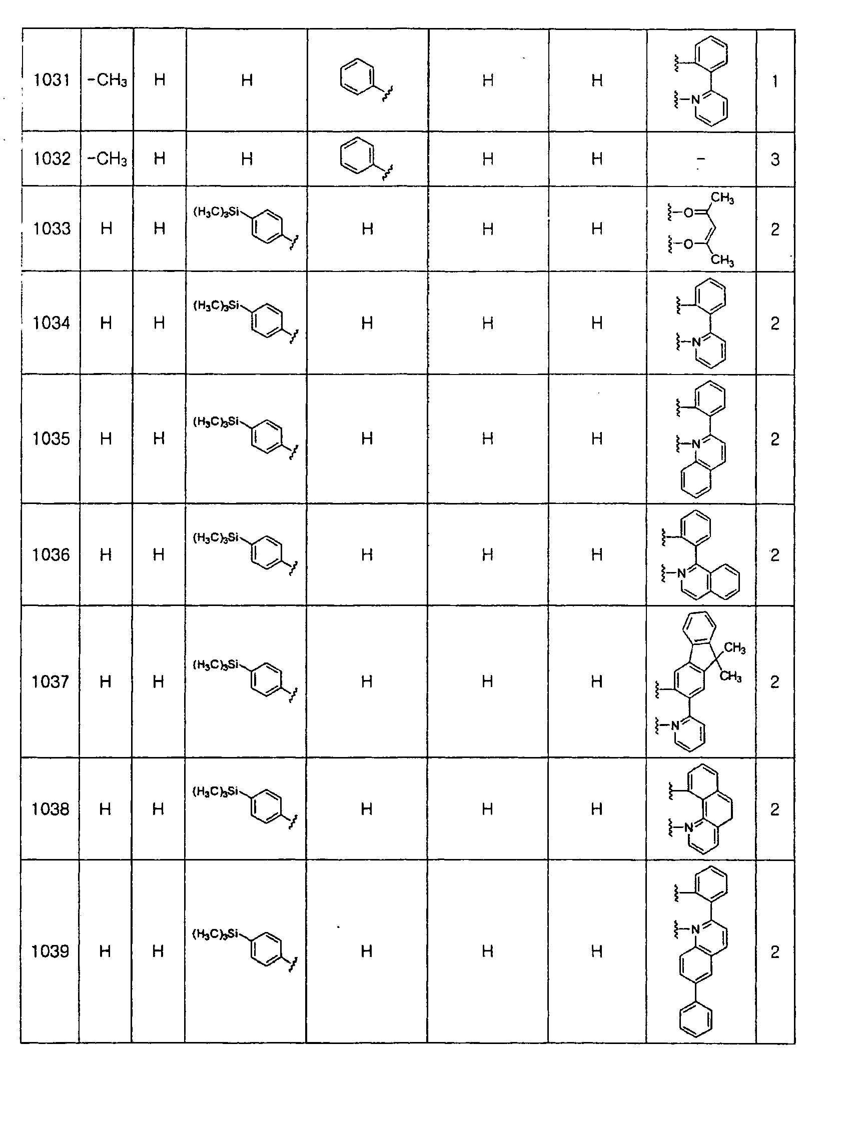

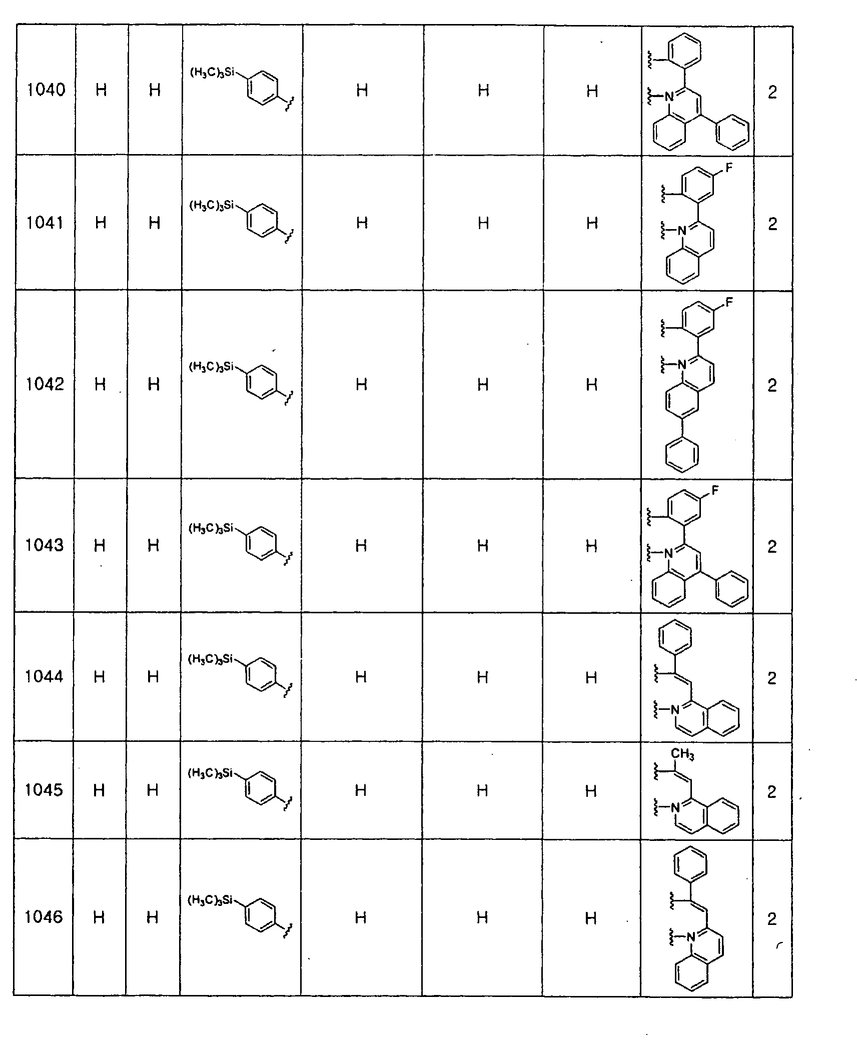

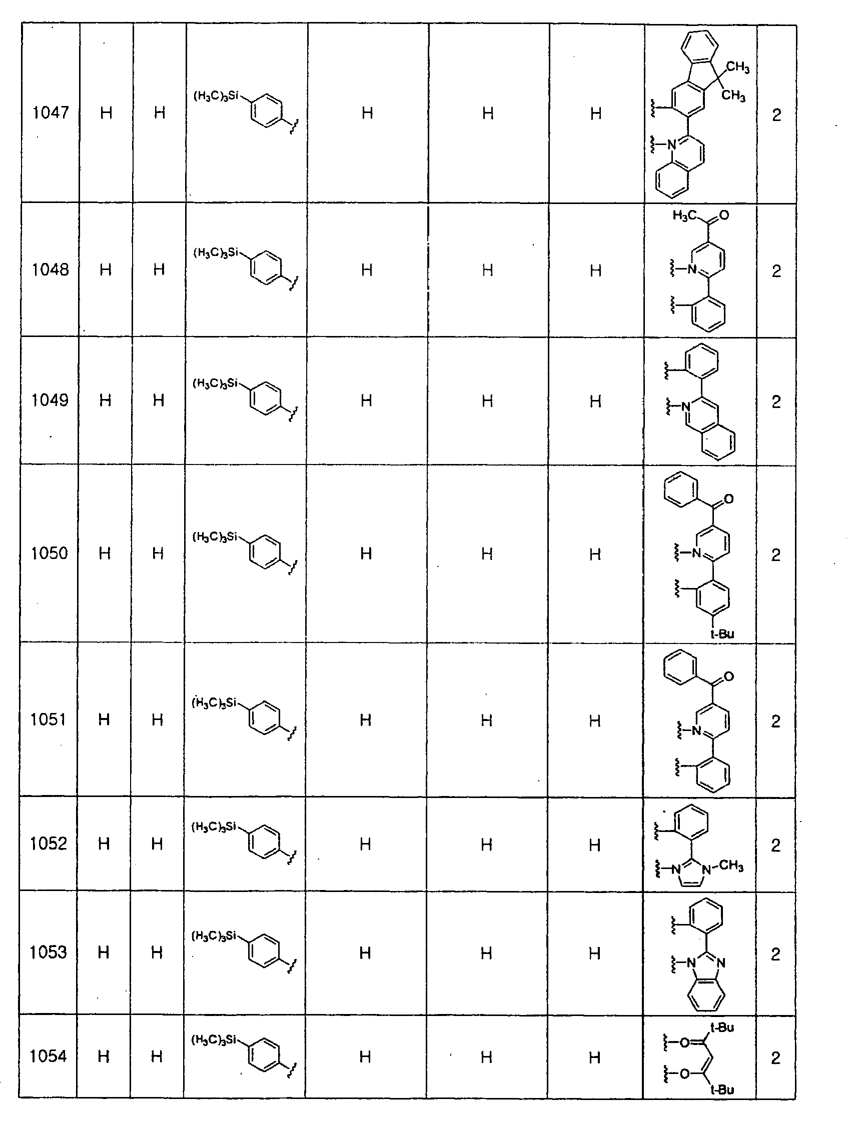

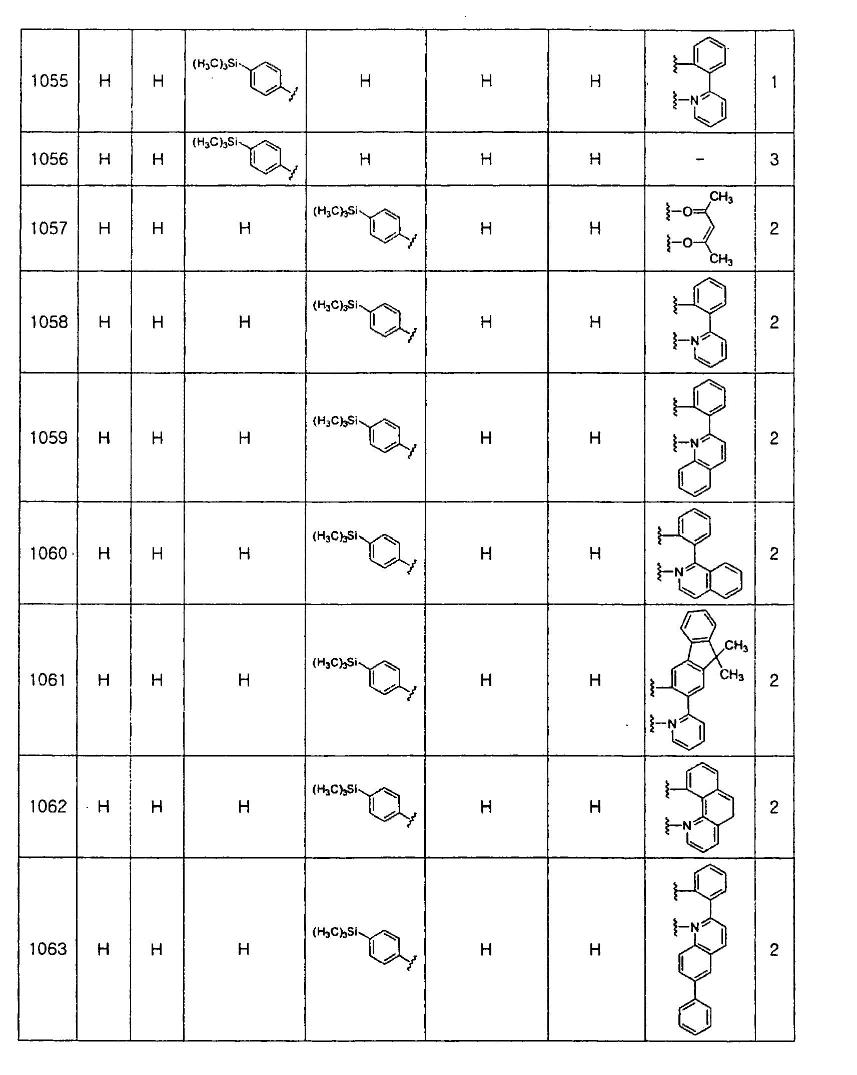

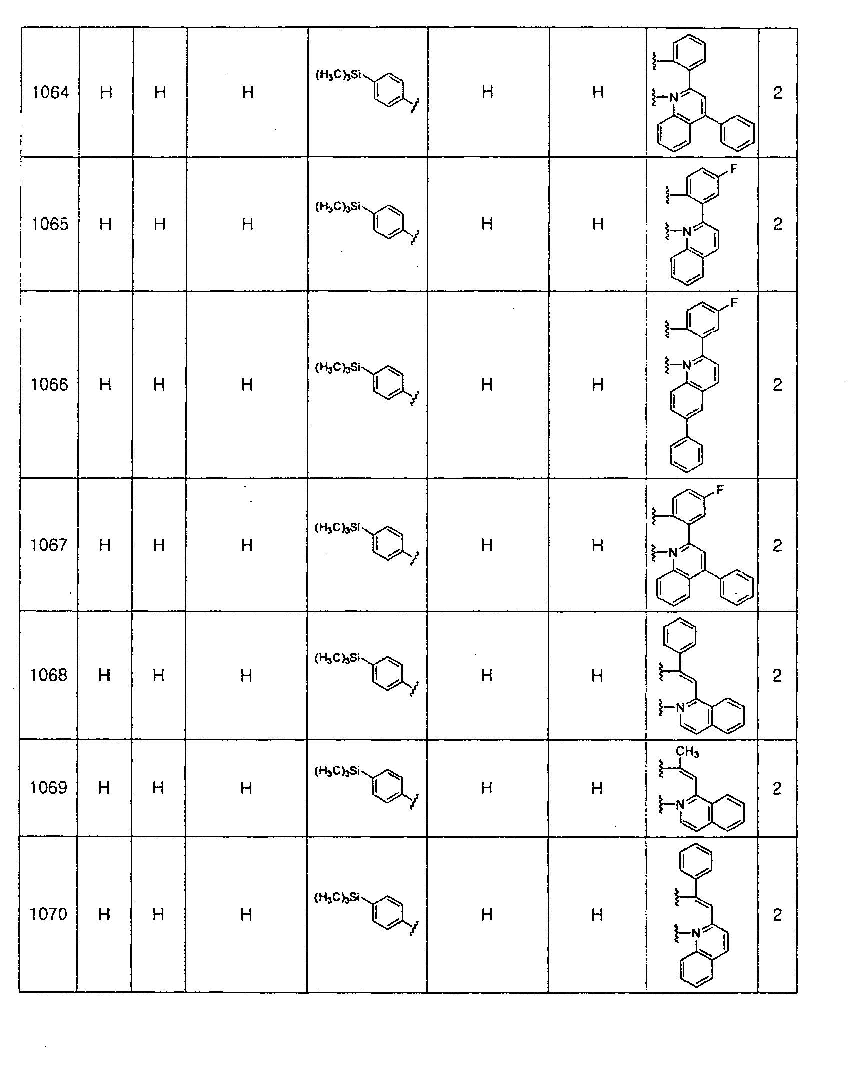

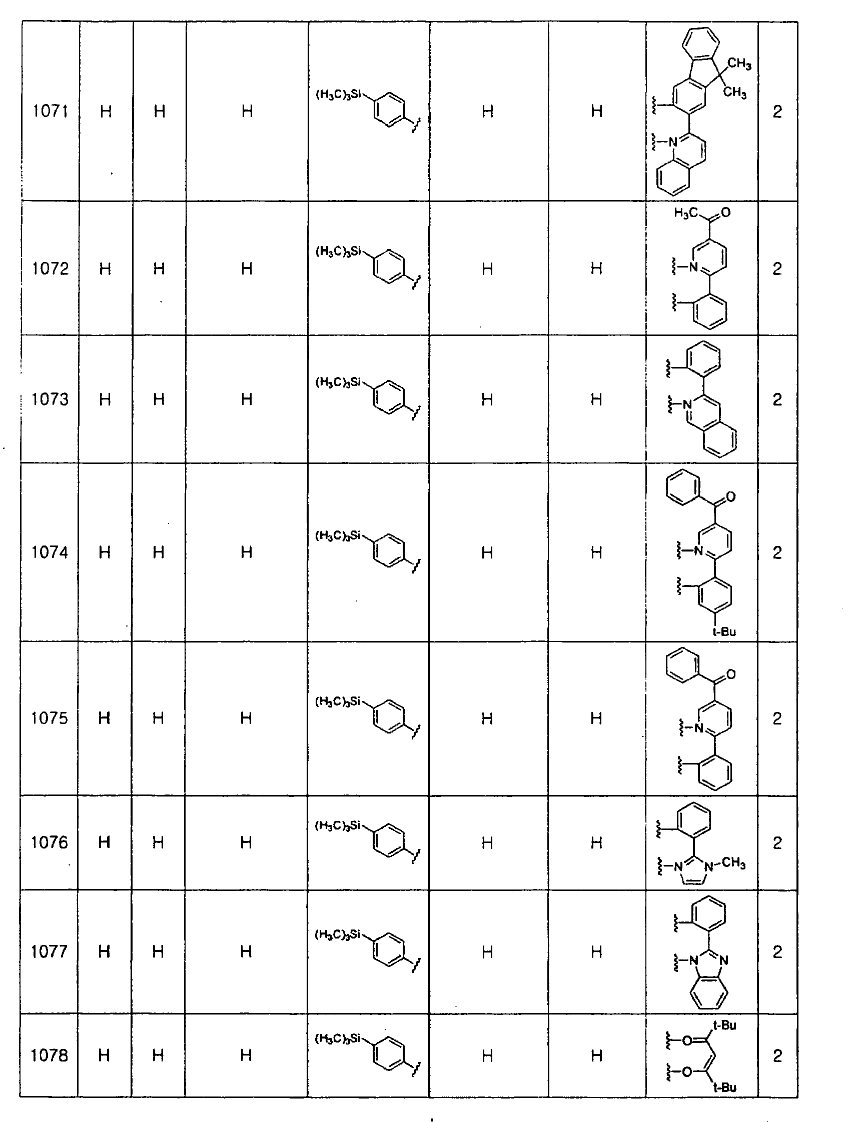

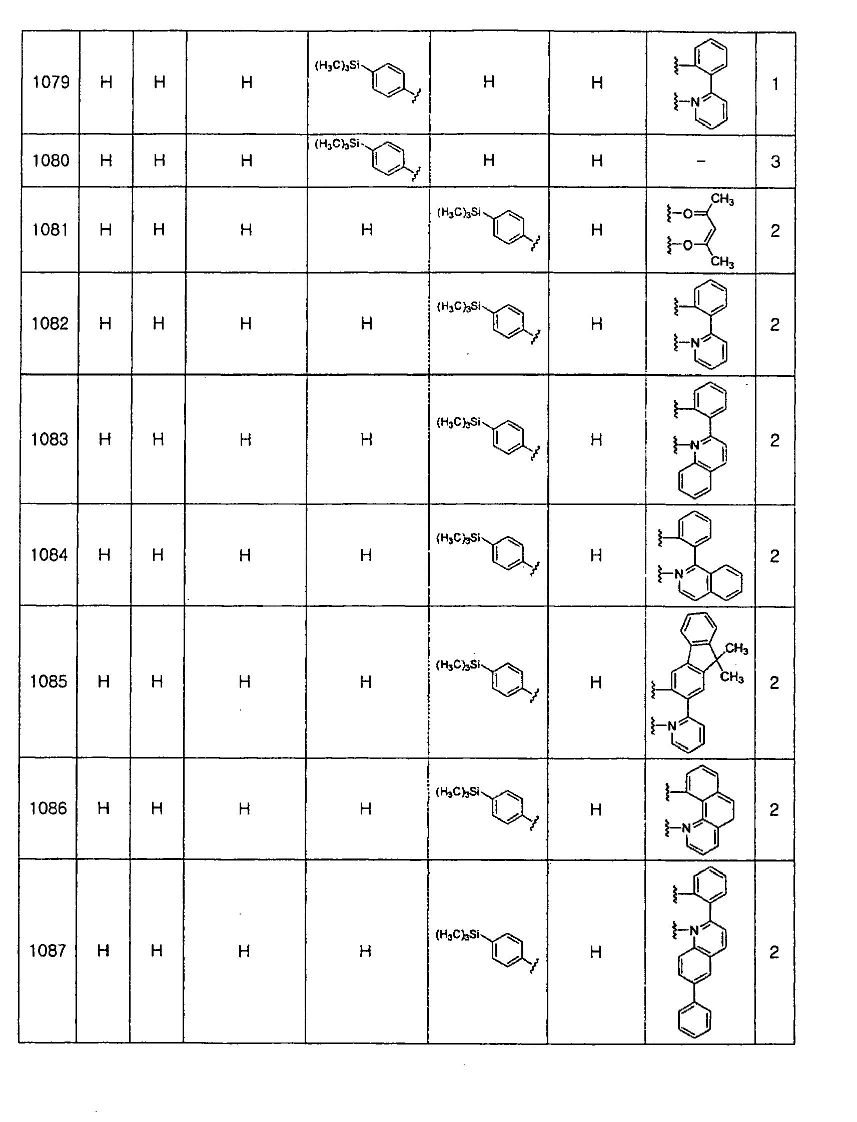

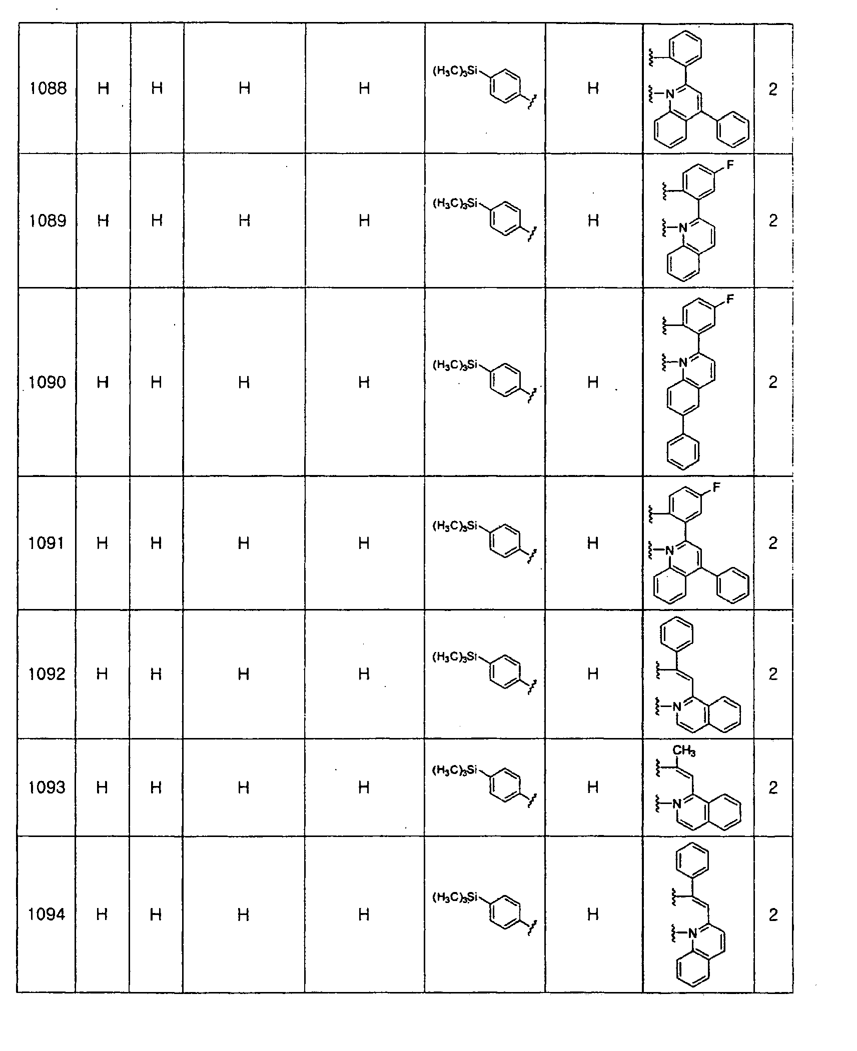

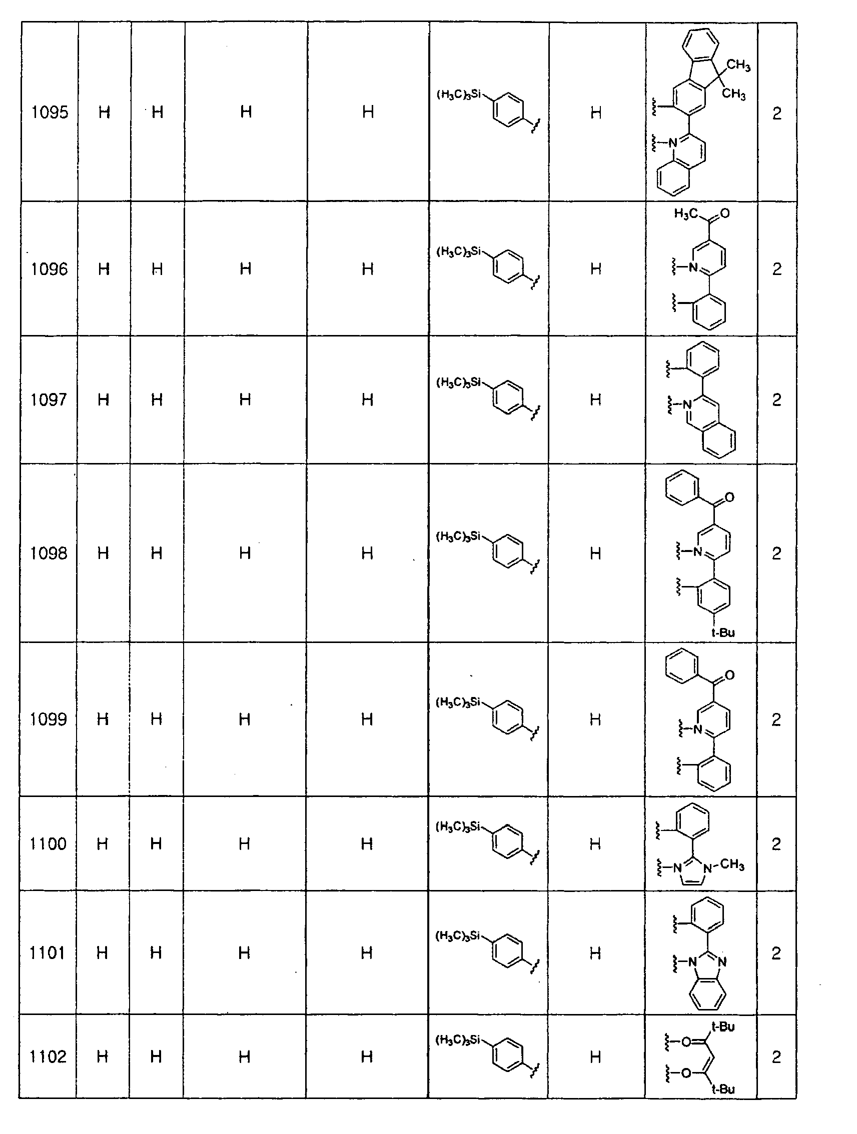

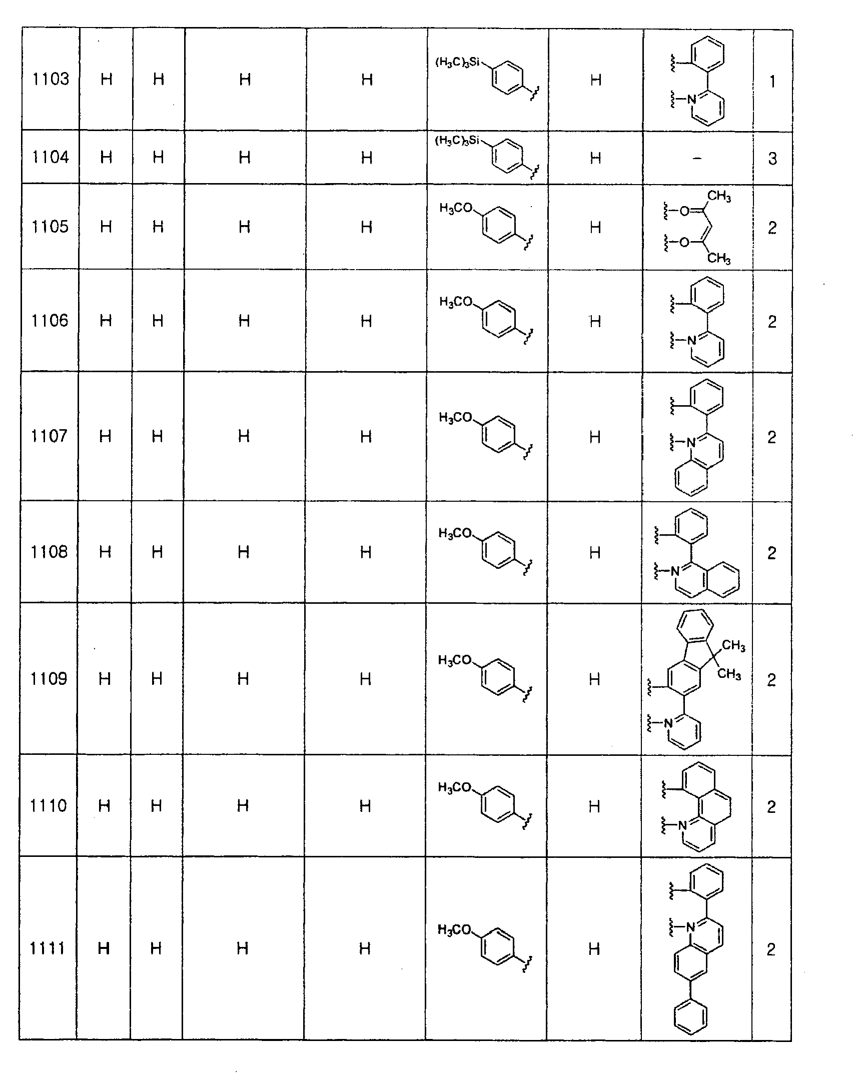

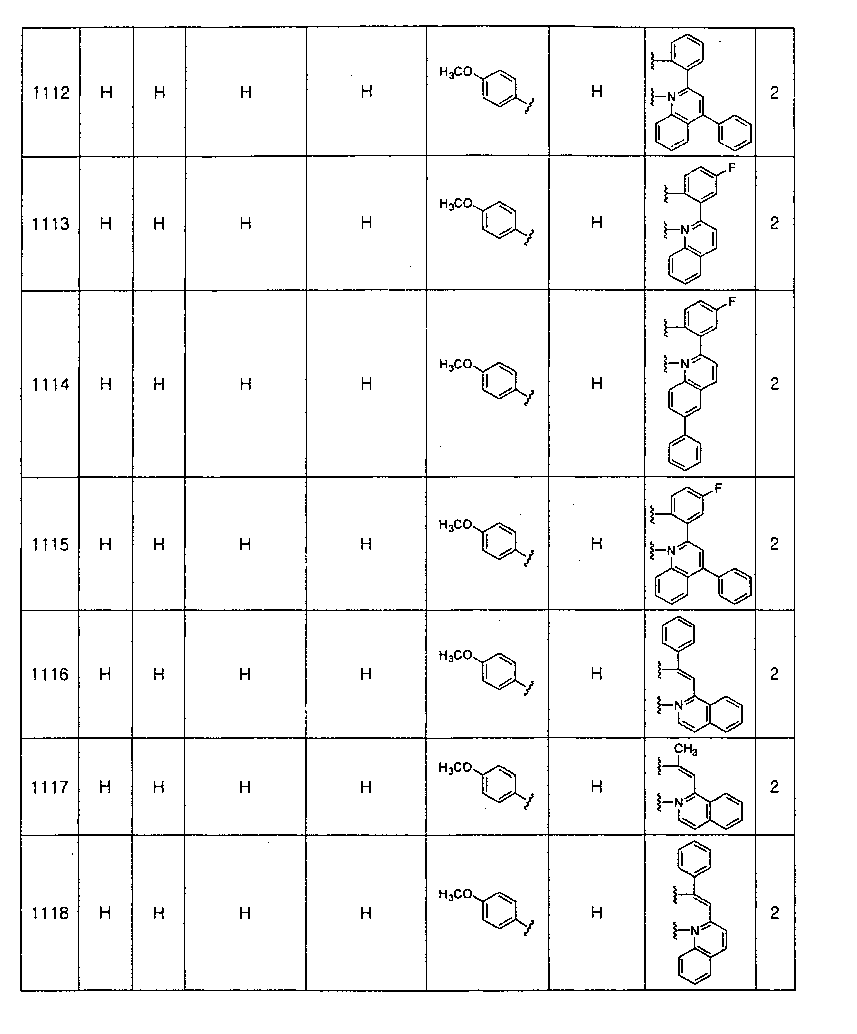

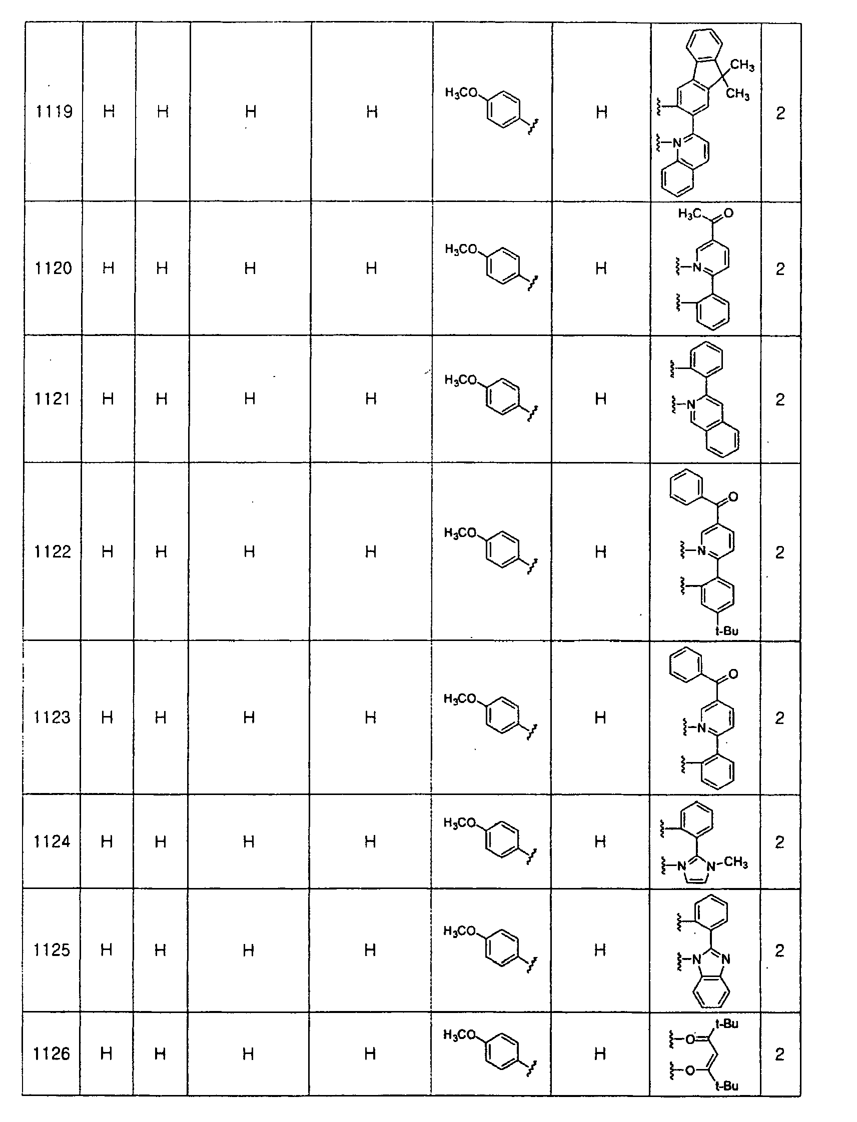

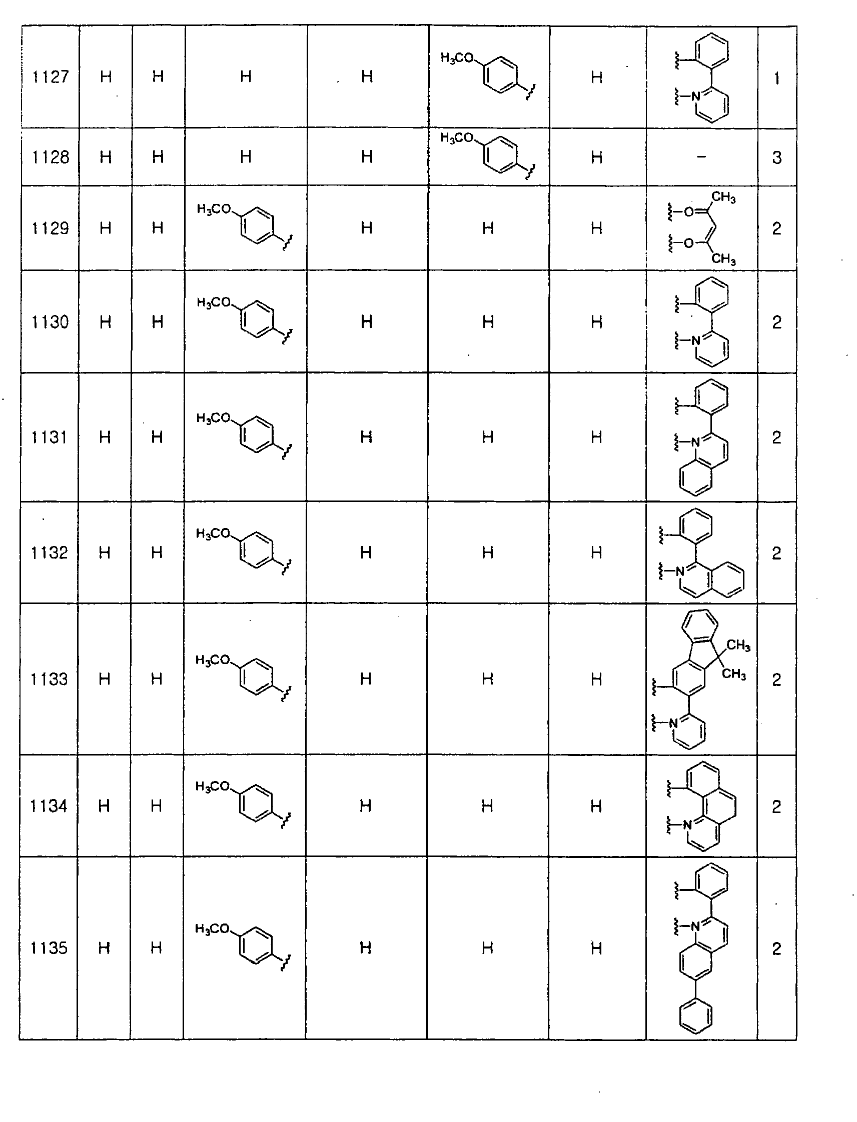

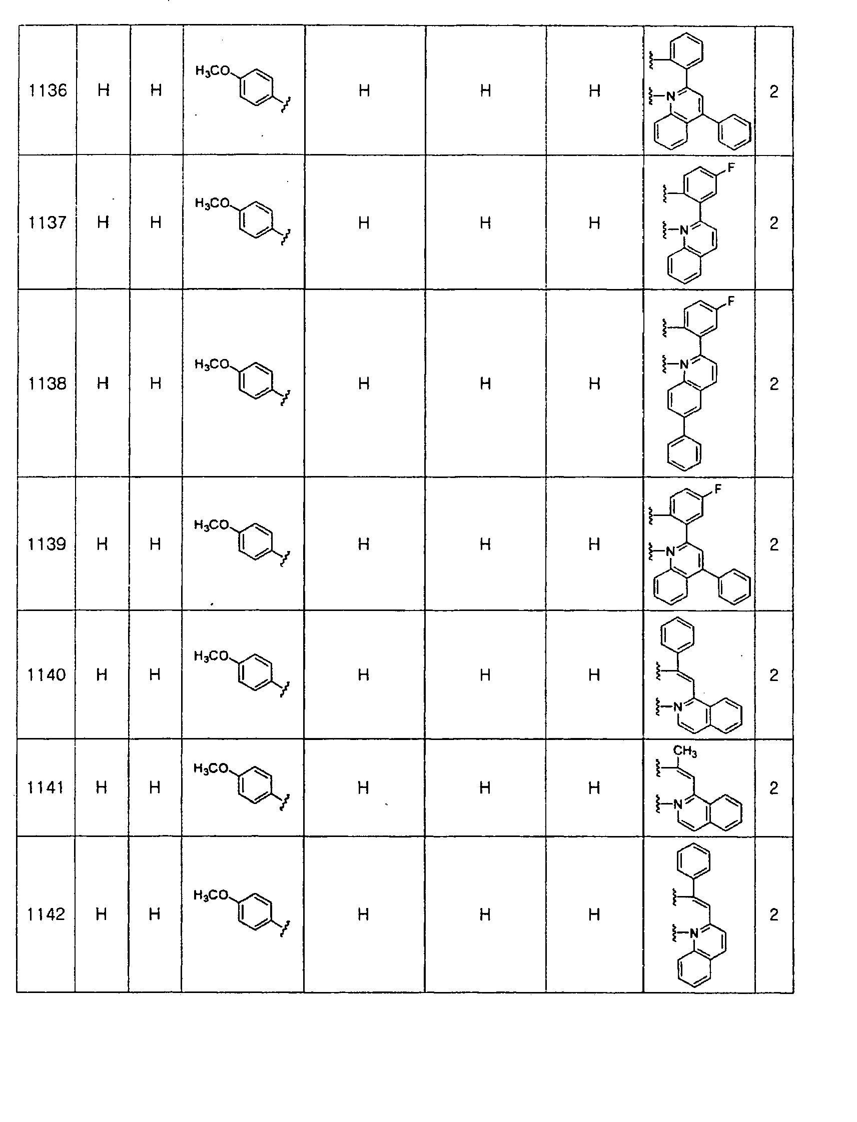

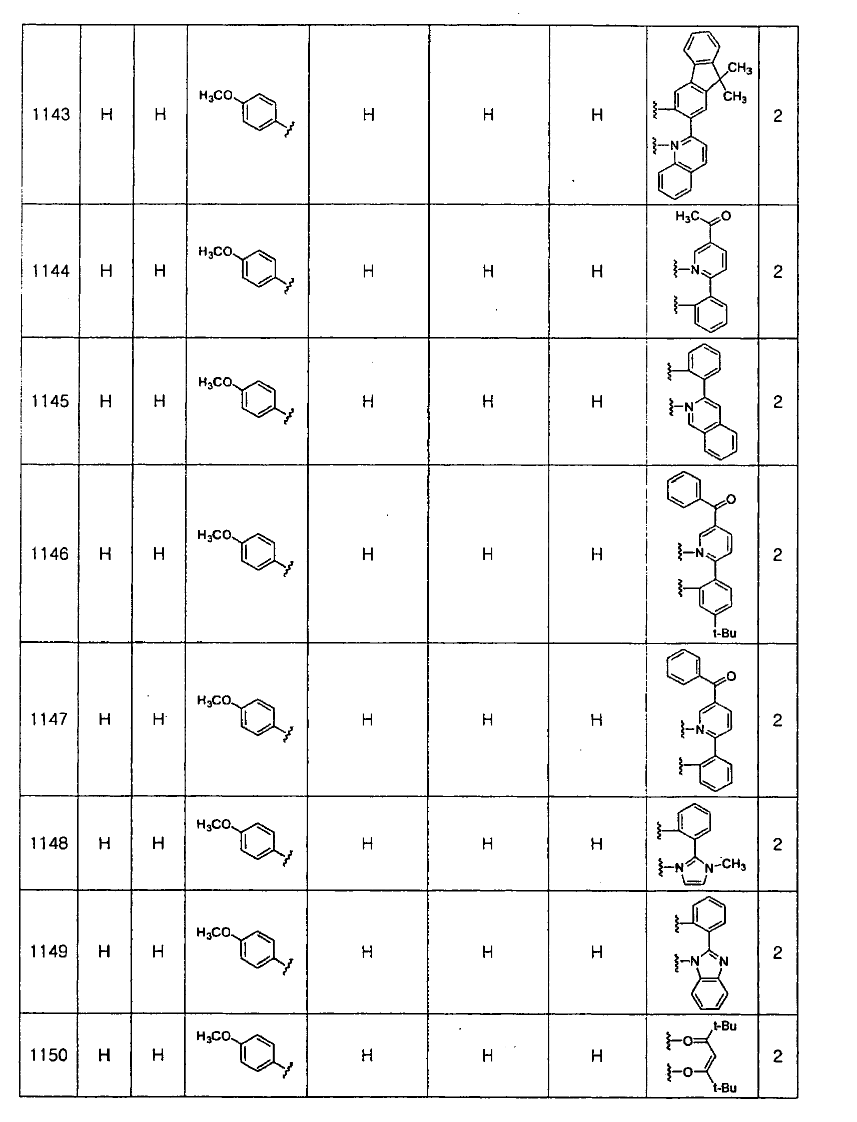

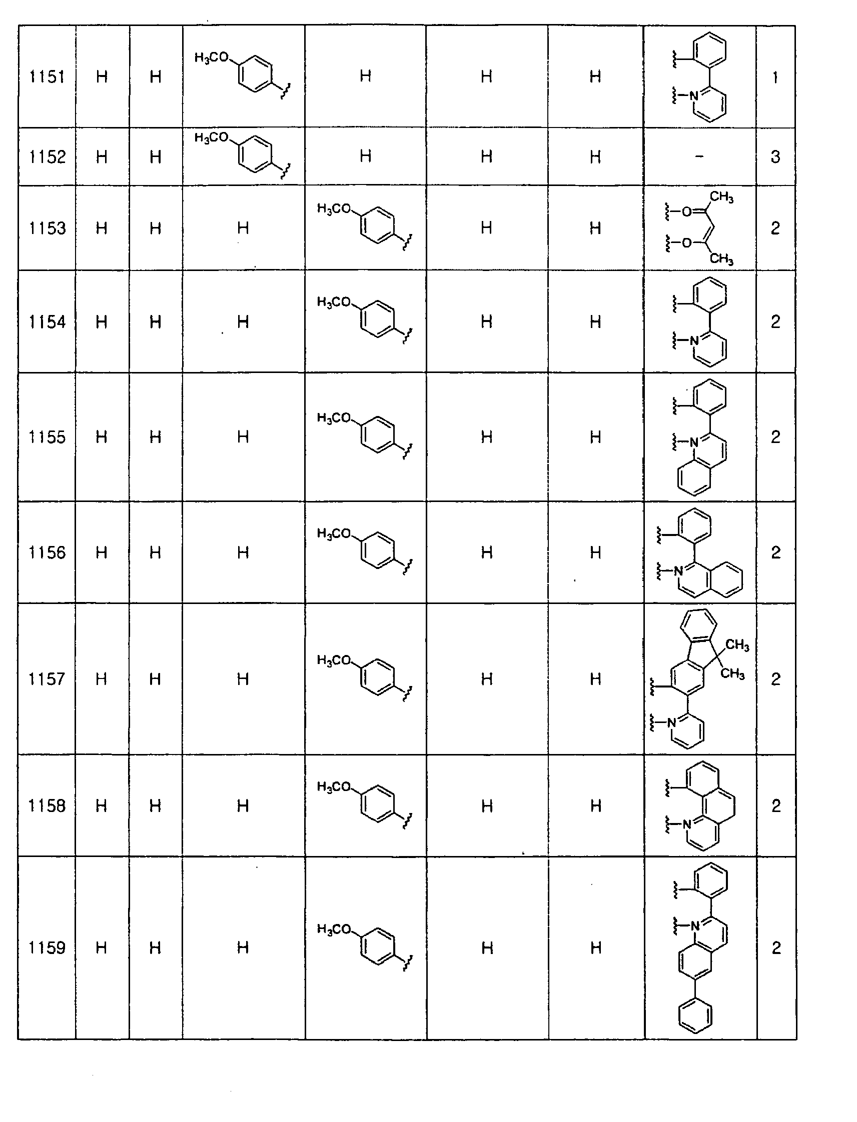

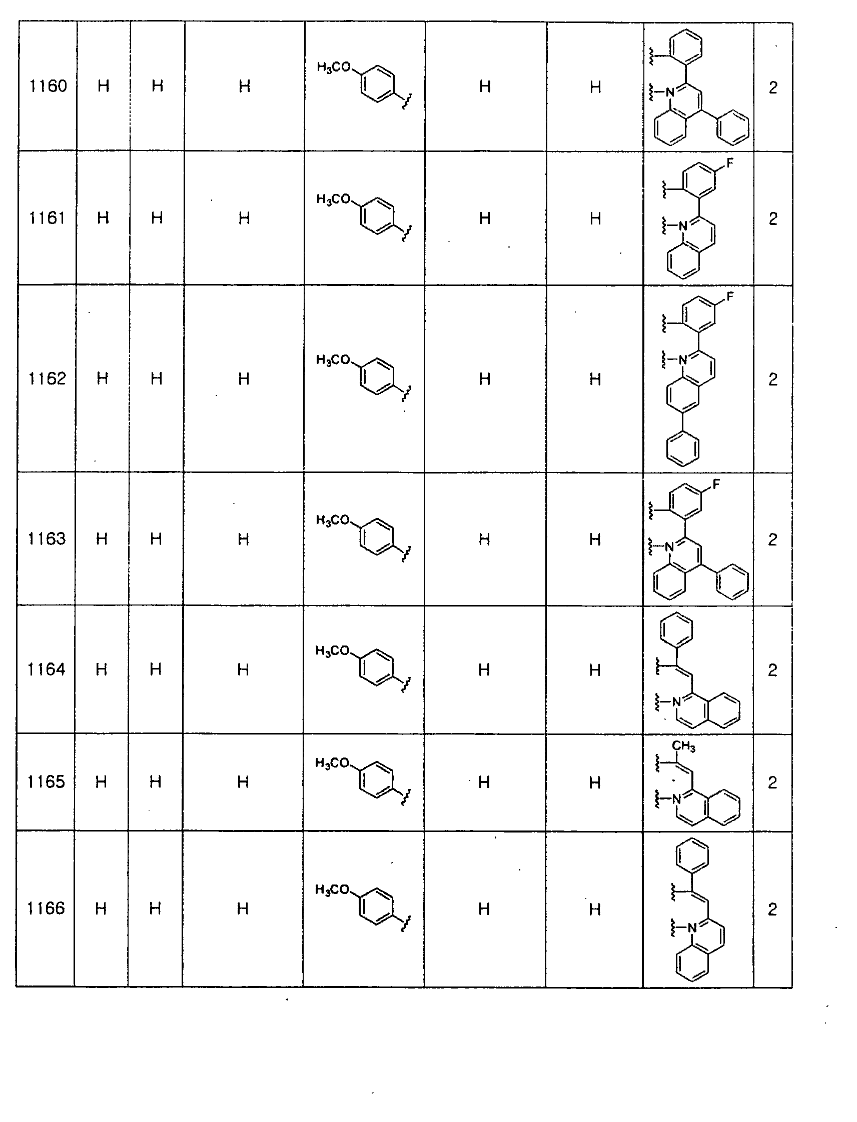

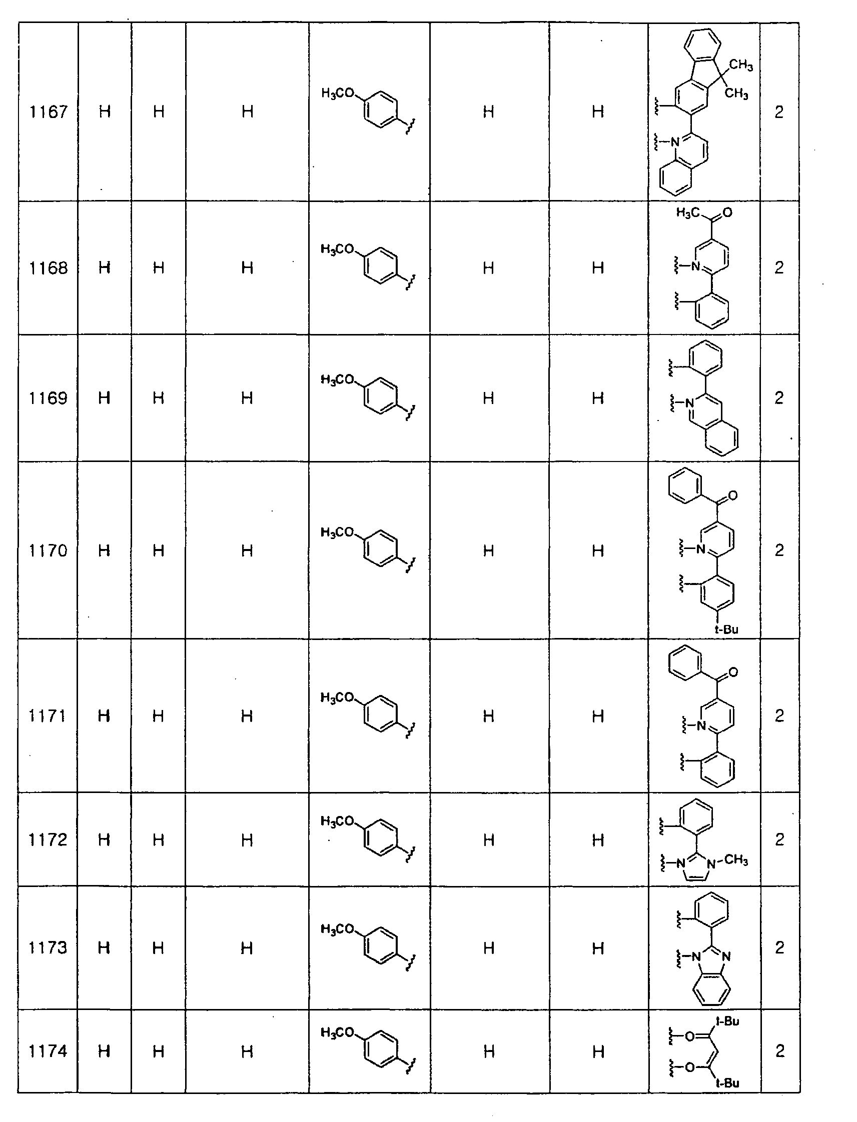

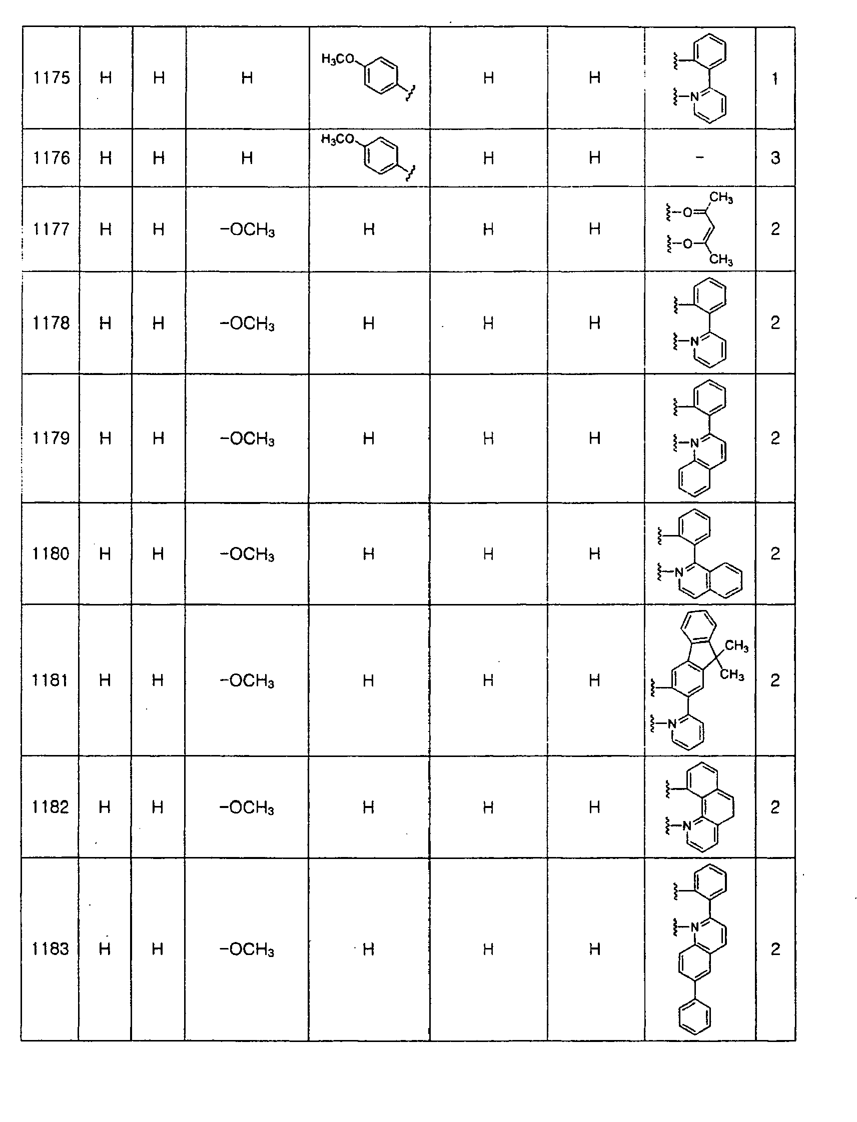

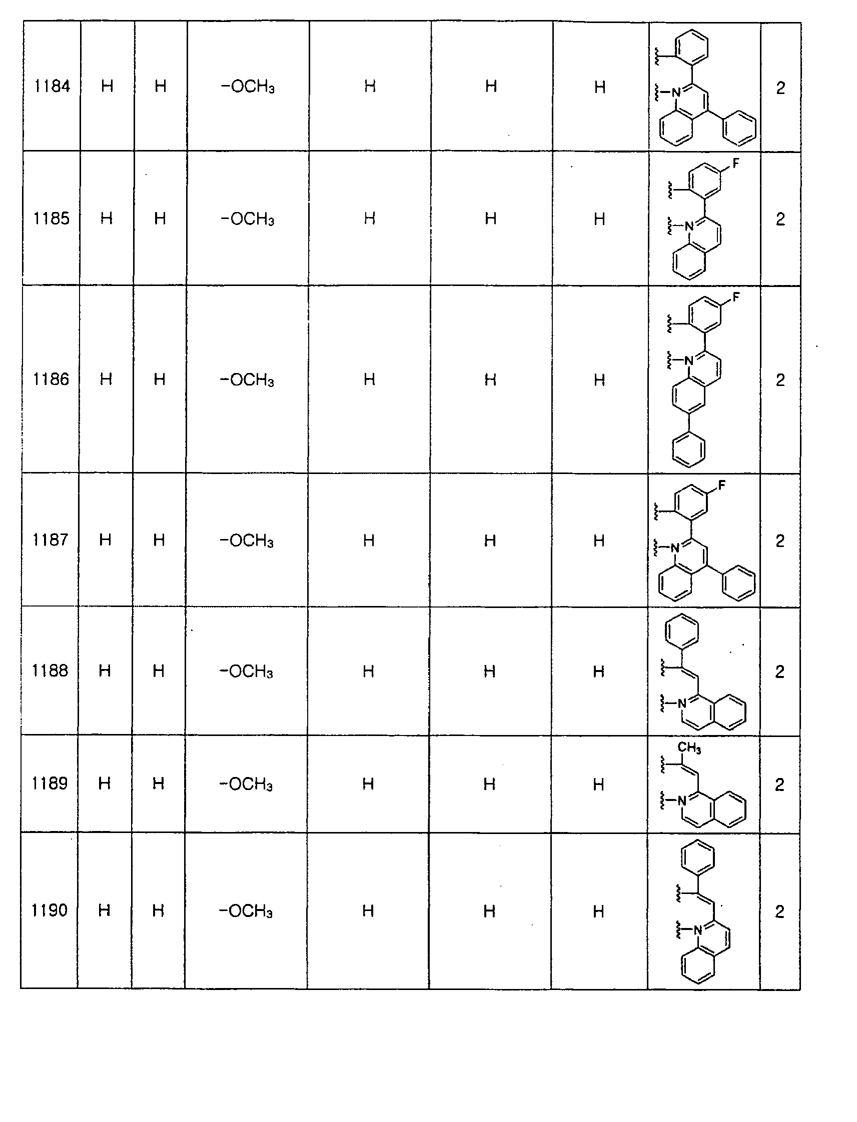

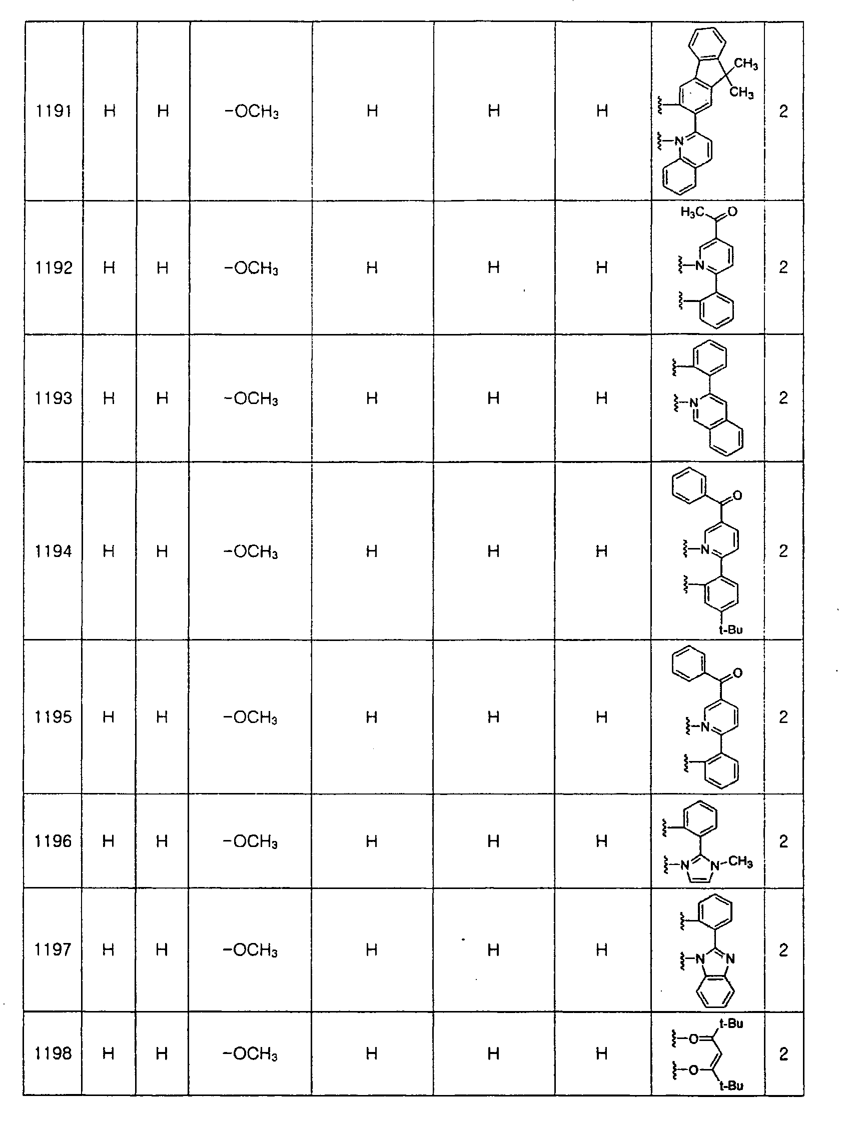

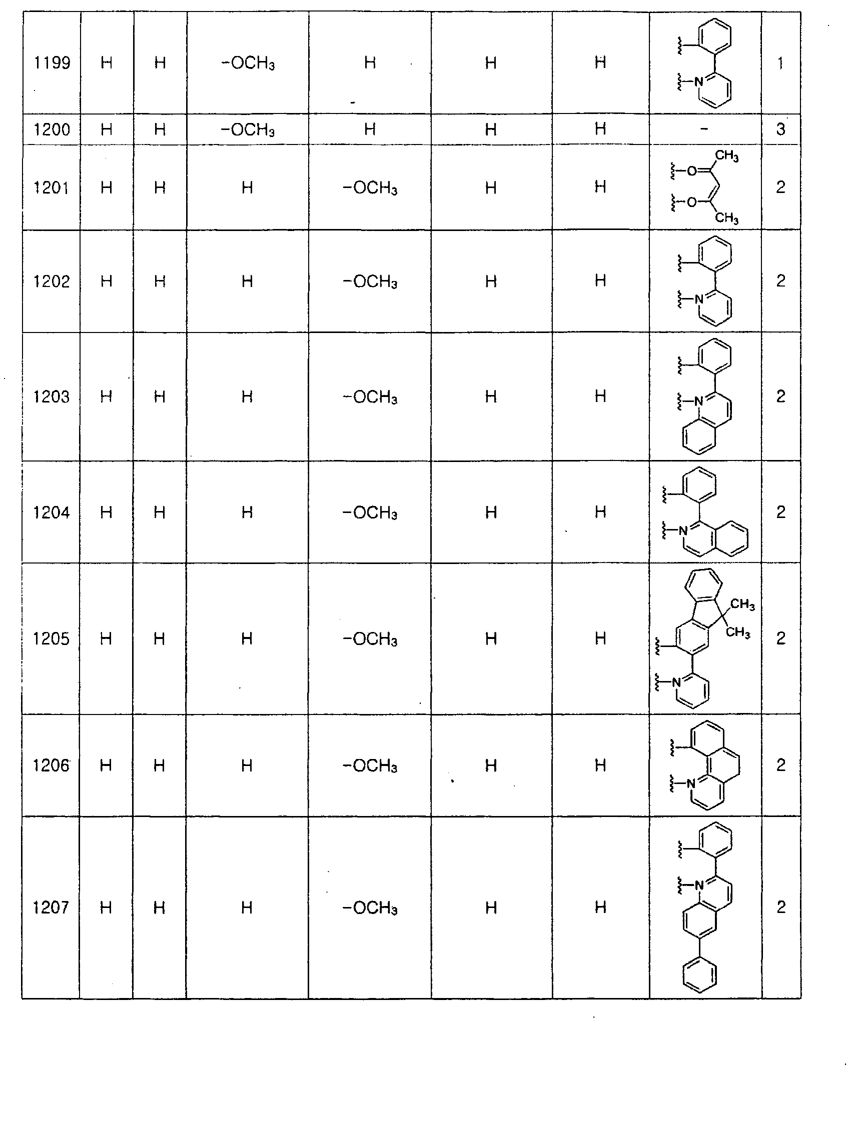

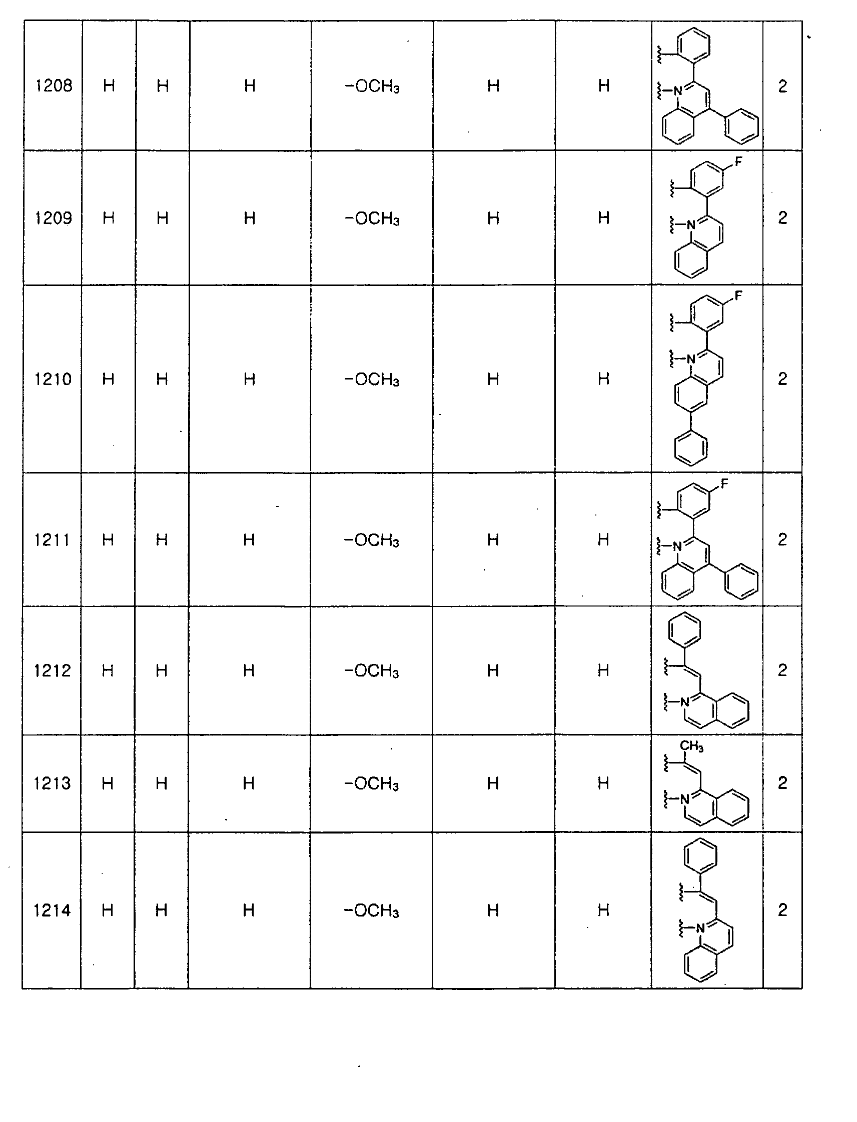

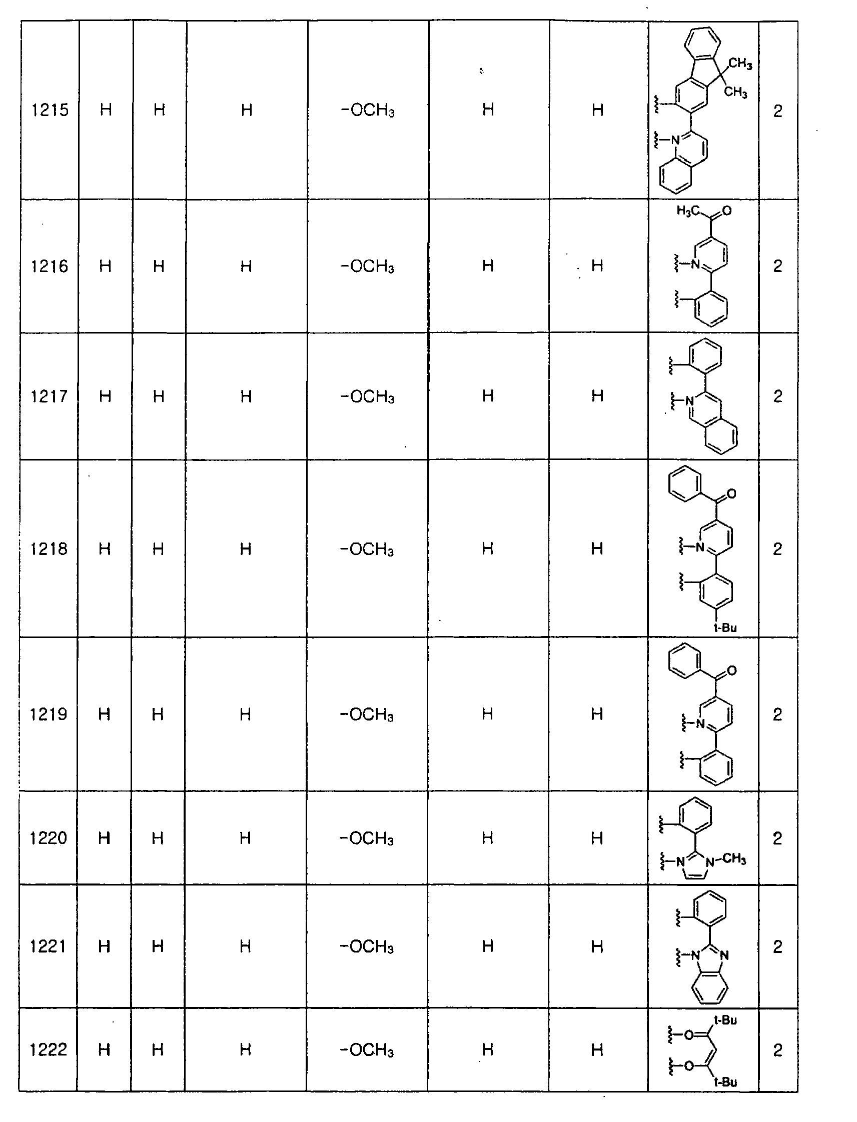

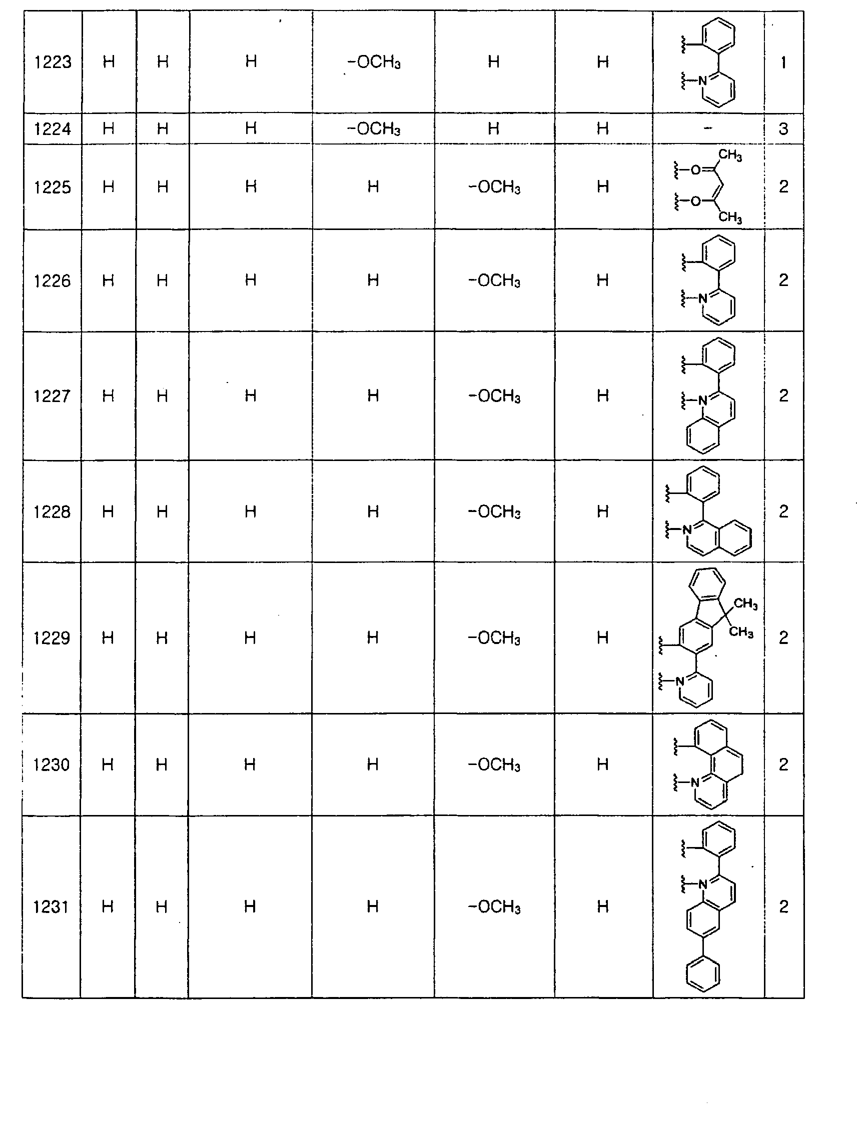

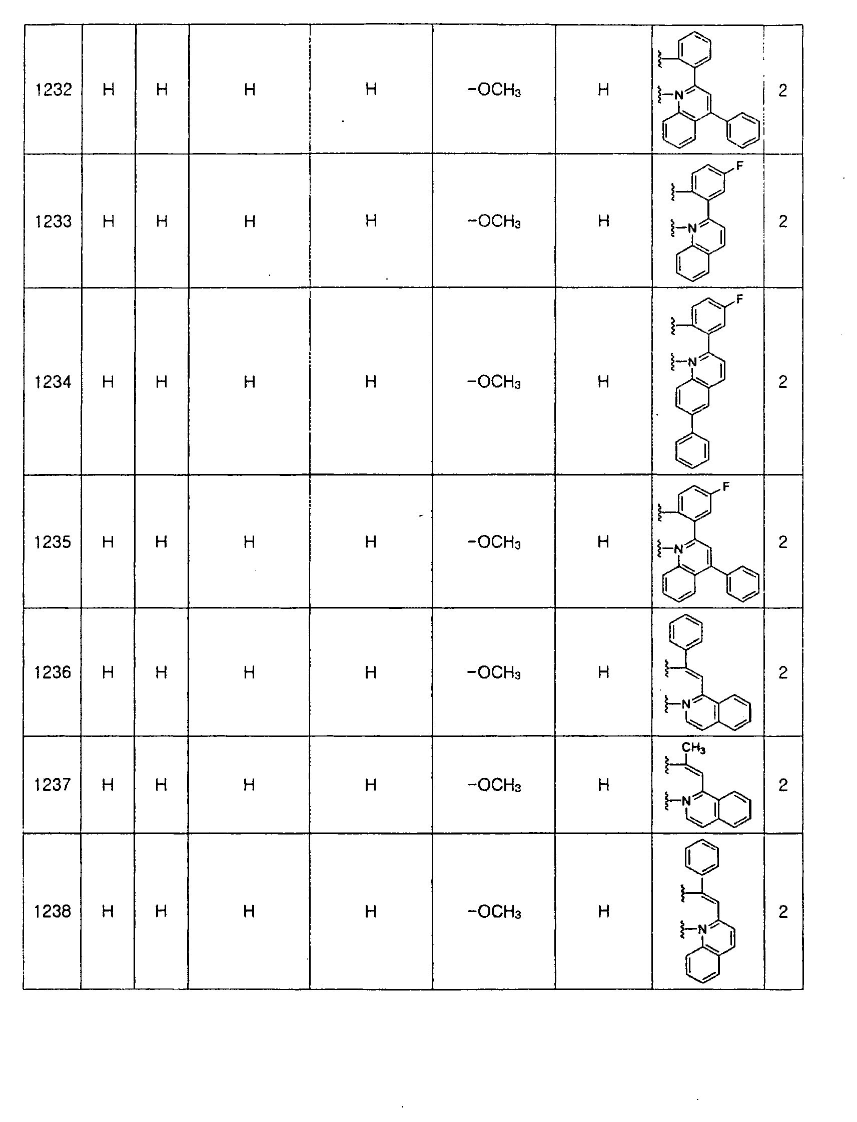

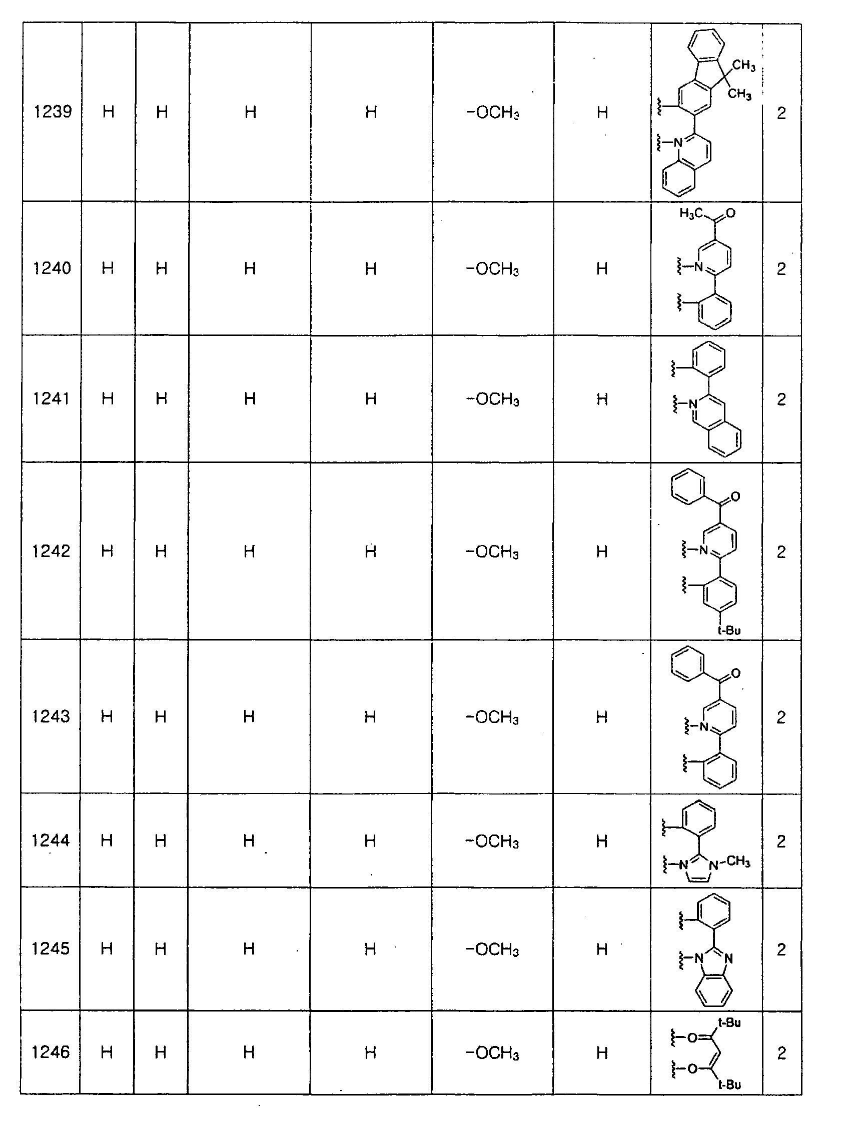

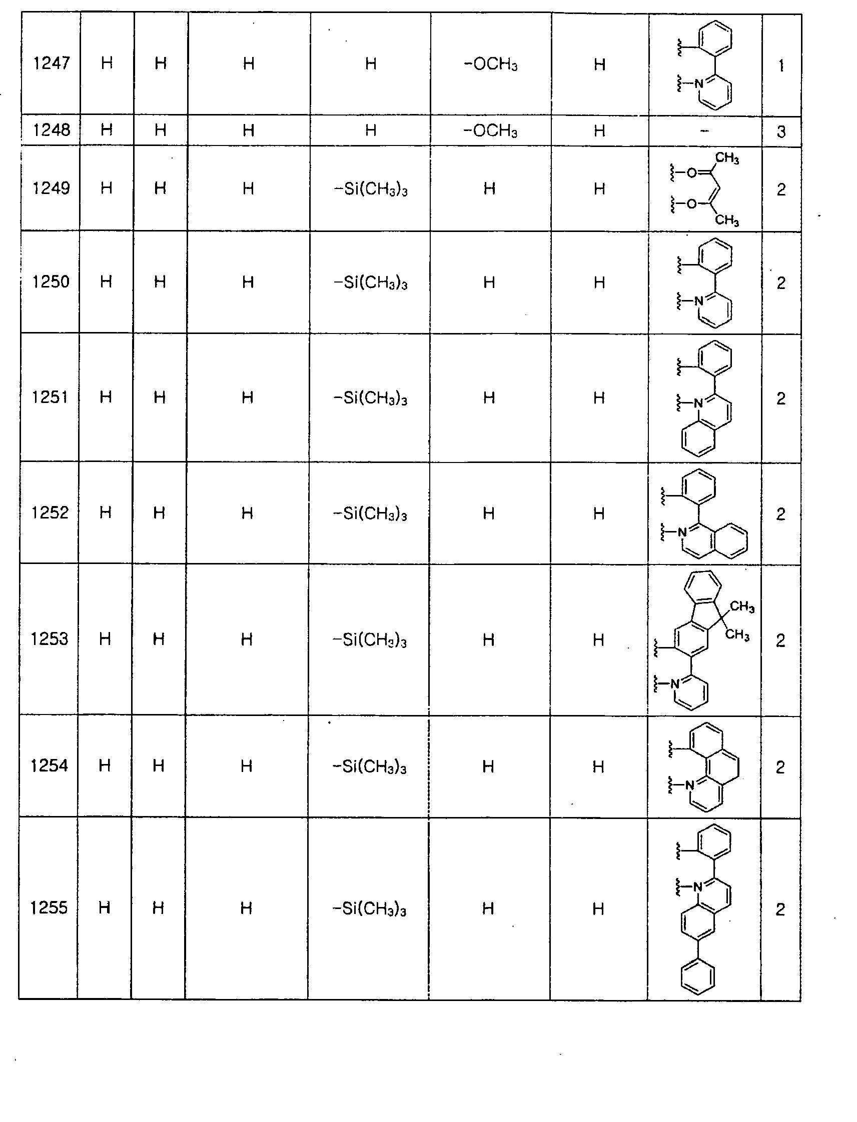

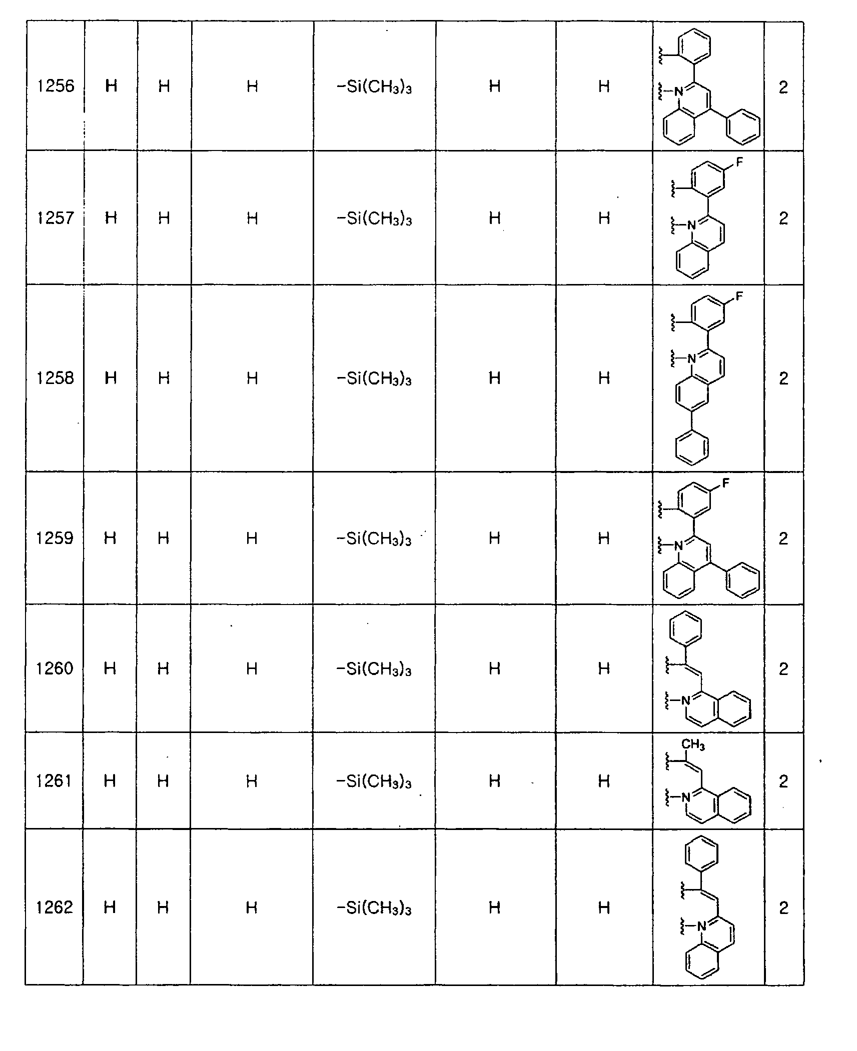

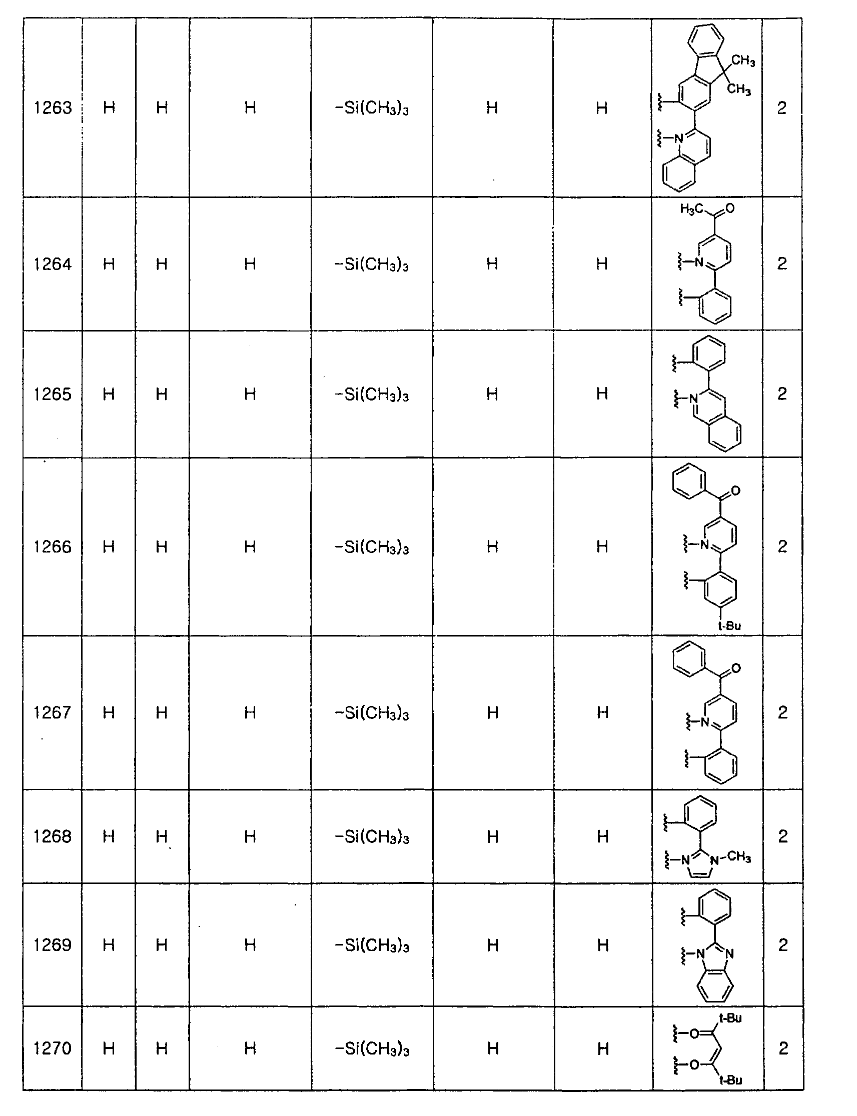

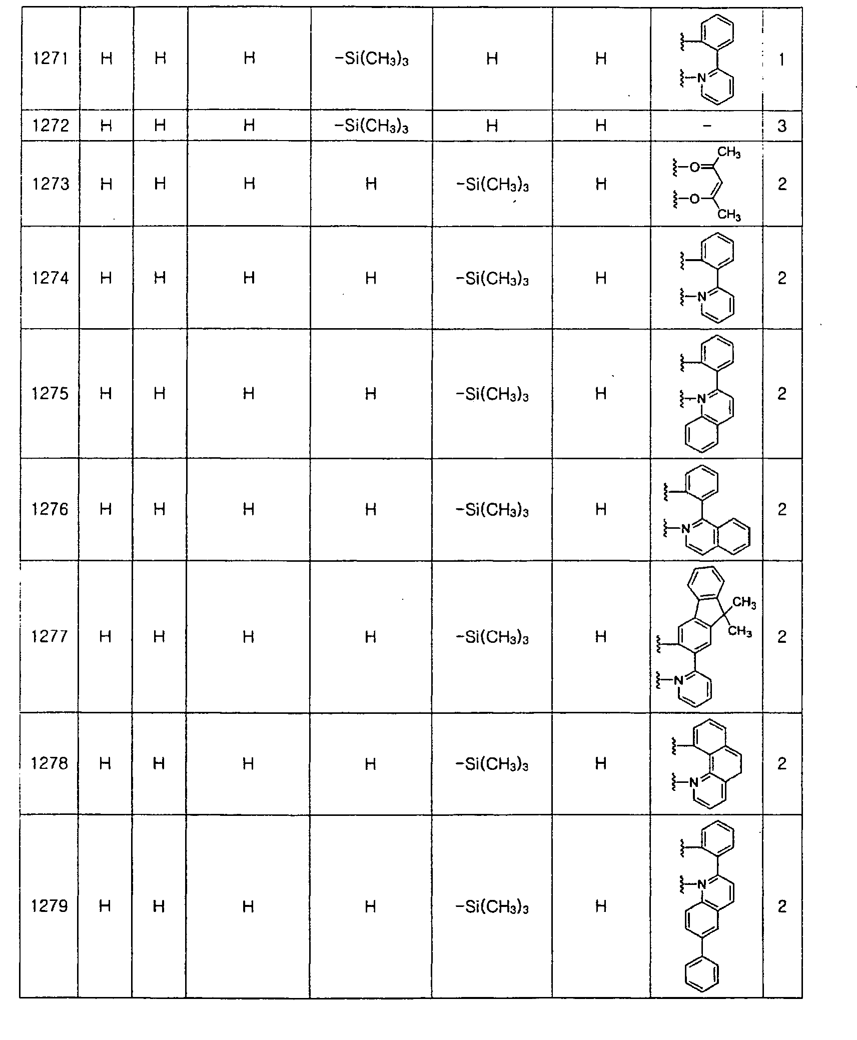

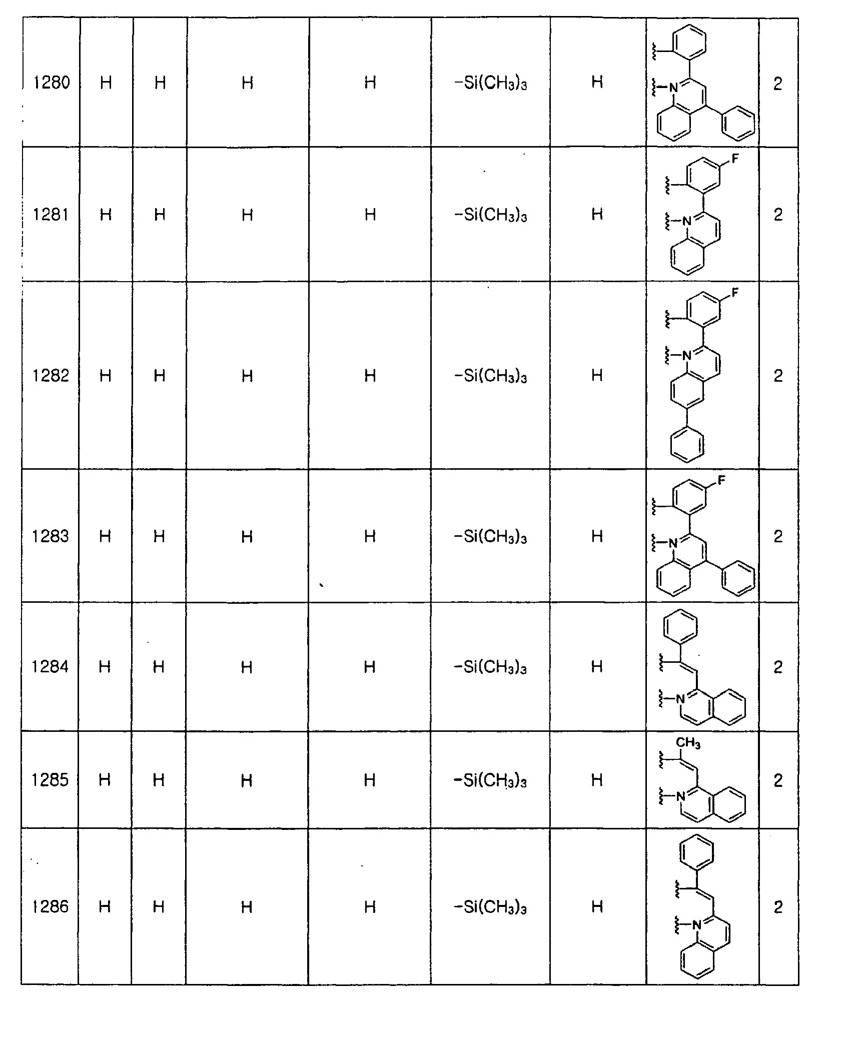

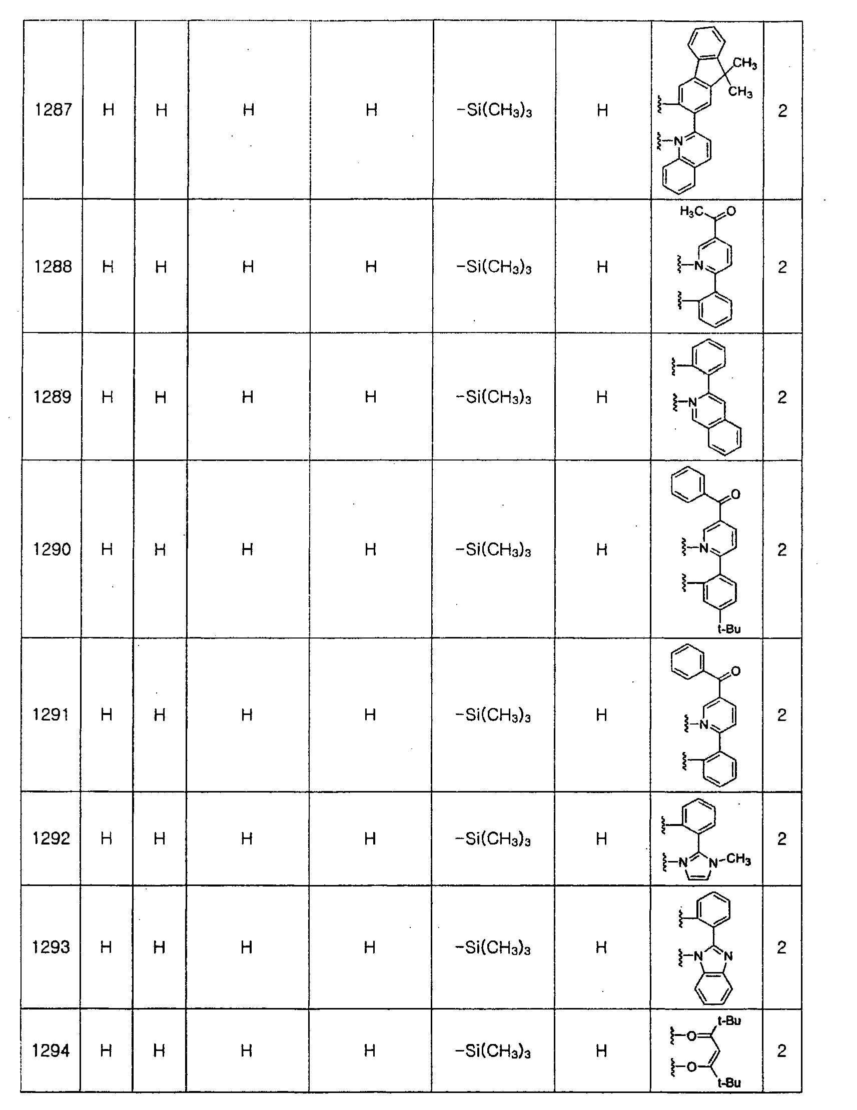

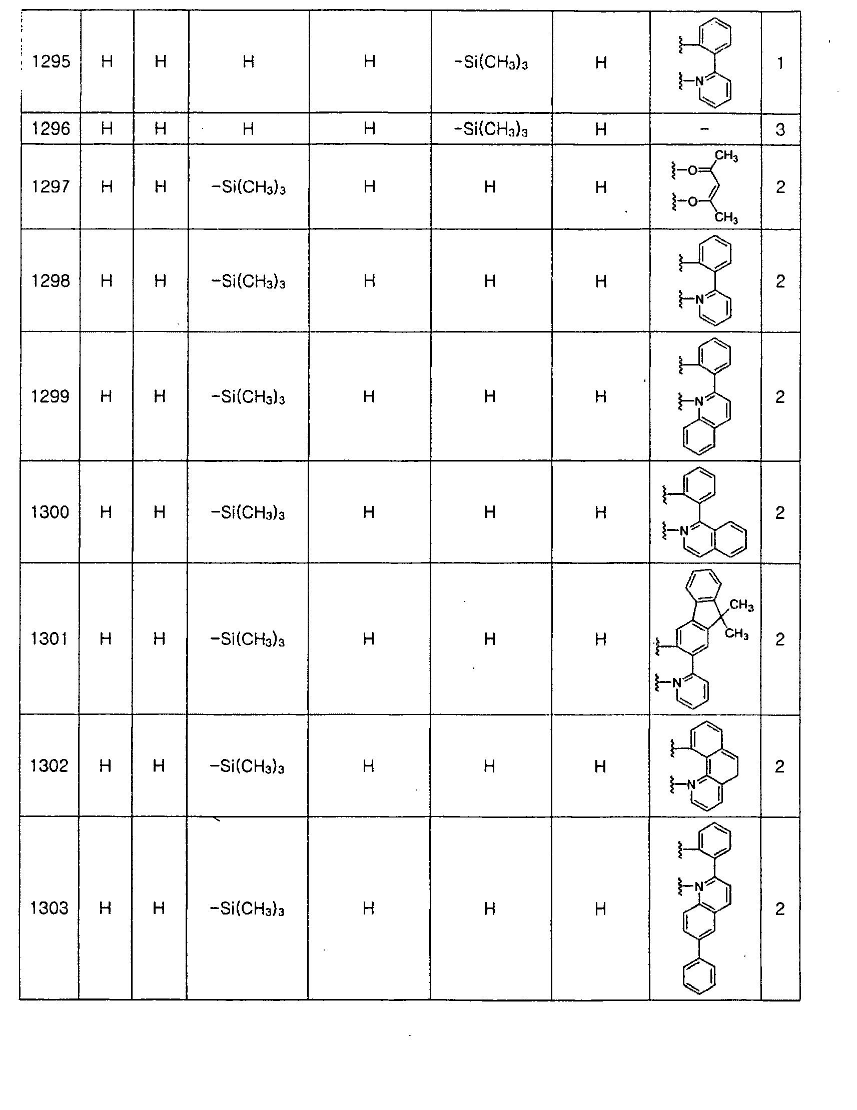

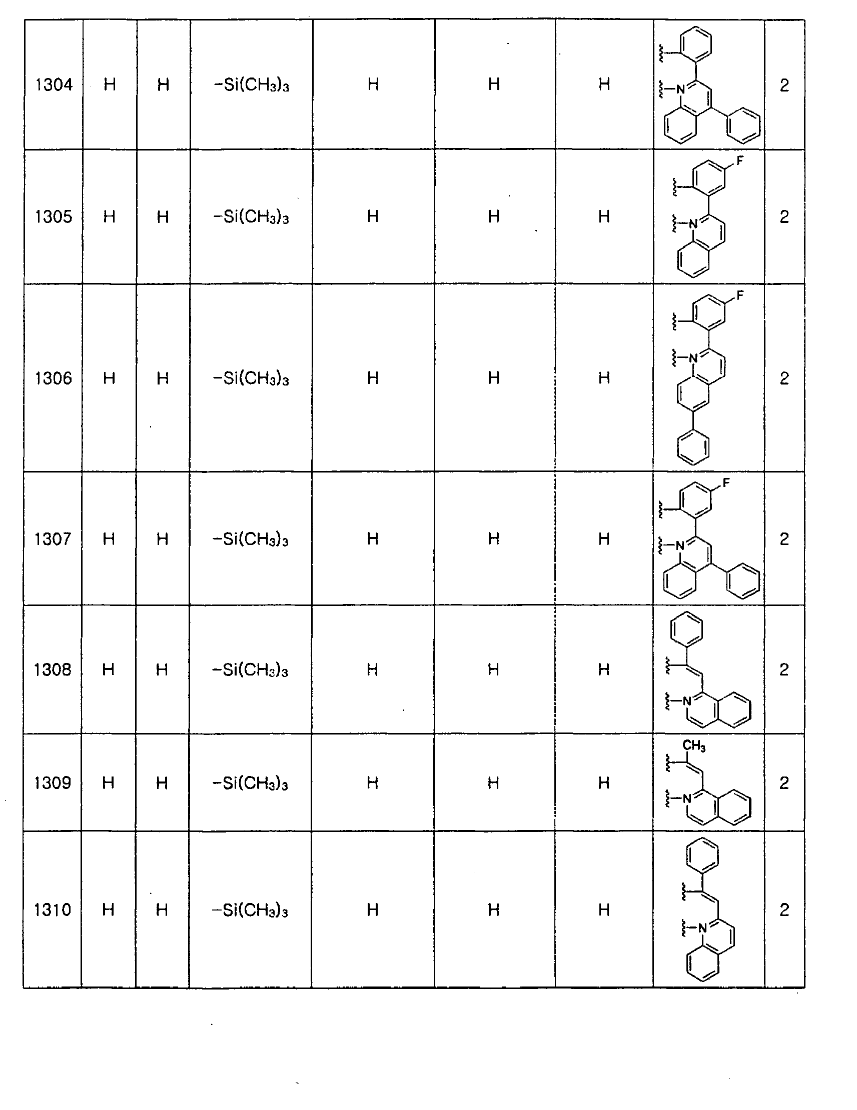

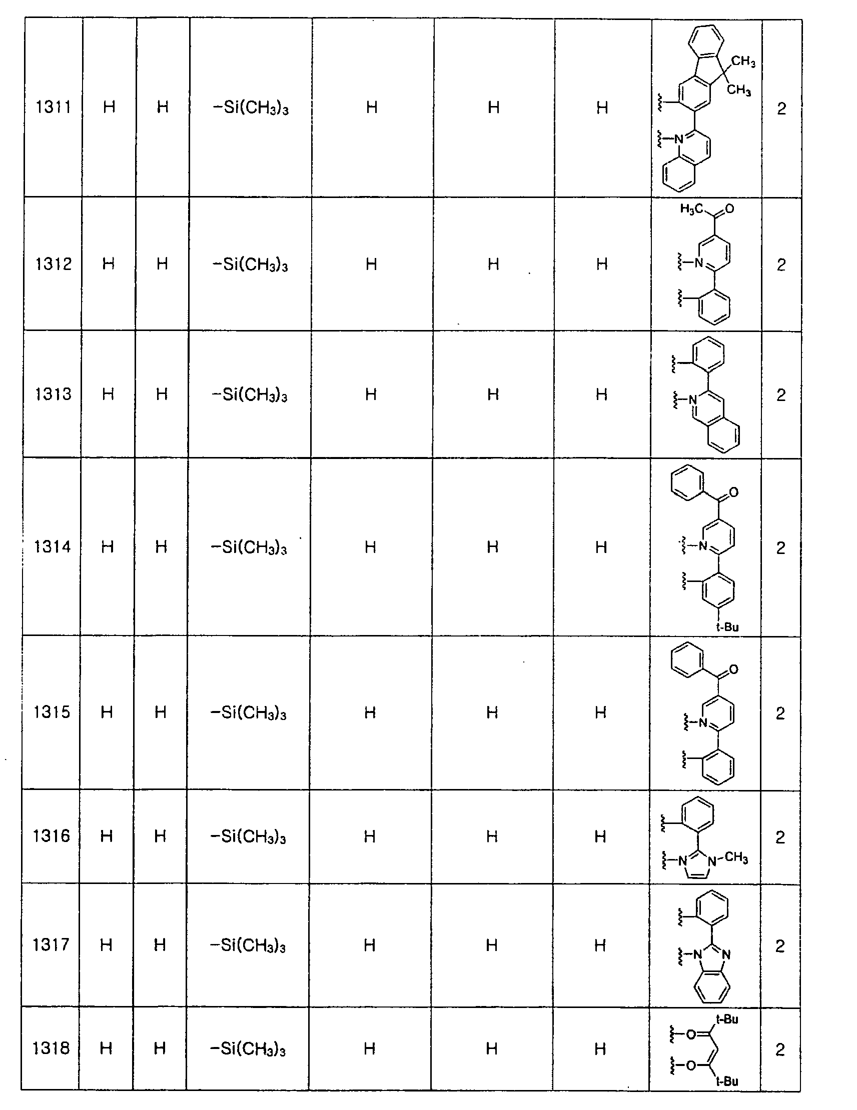

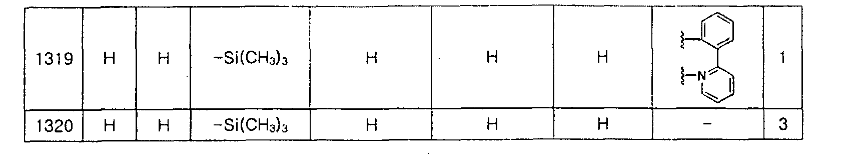

**Table 2**

| compound No. | ¹H NMR(CDCl₃, 200 MHz) | MS/FAB | |
|---|---|---|---|
| | | found | calculated |
| 1 | δ = 8,05 (d, 2H), 7.86 (d, 2H), 7.68 (m. 4H), 7.43 (m, 2H). 7.37 (d. 2H). 4.59 (s, 1H). 2.28 (m. 8H). 1.90 (m. 4H) 1.71 (s, 3H). 1.31(s. 3H) | 487 | 487.64 |
| 2 | δ = 8.56(m, 1H), 8.05-7.99(m, 3H), 7.86(m, 2H), 7.68-7.28(m, 13H), 6.98(m, 1H), 2.28(m, 8H). 1.90(m, 4H) | 542 | 542.7 |
| 4 | δ = 8.42(m, 1H), 8.05-7.98(m. 3H). 7.87-7.86(m, 3H), 771-7.28(m, 14H). 7.10(m, 1H), 2.28(m, 8H). 1.90(m, 4H) | 592 | 592.77 |
| 7 | δ = 8.05-7.99(m, 4H), 7.90-7.86(m, 4H), 7.72-7.61(m, 5H), 7.48-7.22(m. 13H). 2.28(m, 8H), 1.90(m, 4H) | 668 | 668.87 |
| 11 | δ = 8.05(m, 3H). 7.86(m. 2H). 7.70-7.61(m, 8H), 7.48-7.22(m, 11H). 6.99(m, 1H), 2.28(m, 8H), 1.90(m, 4H) | 686 | 686.86 |
| 17 | δ = 9.12(s, 1H), 8.05-7.99(m, 3H), 7.86(m, 3H), 7.71-7.28(m, 15H), 2.28(m, 8H), 1.90(m, 4H) | 592 | 592.77 |
| 18 | δ = 8.54(d, 1H), 8.09-8.05(m, 3H). 7.86(m, 2H), 7.79(m, 2H). 7.70-7.61 (m, 6H), 7.45-7.36(m, 9H). 2.28(m, 8H), 1.90(m, 4H), 1.34(s, 9H) | 702 | 702.93 |
| 24 | δ = 8.05(m, 3H), 7.86(m, 3H). 7.68-7.61(m, 6H), 7.43-7.37(m, 6H), 2.28(m. 12H), 1.90(m, 6H) | 582 | 582.78 |
| 97 | δ = 8.05(m, 2H), 7.68-7.61(m, 4H), 7.43(m, 2H), 7.08(m, 2H), 4.59(s, 1H), 2.28(m, 8H), 1.90(mm, 4H), 1.71(s, 3H), 1.31(s, 3H) | 523 | 523.62 |
| 148 | δ = 8.42(d, 1H). 8.03-7.98(m. 3H). 7.87(m. 1H), 7.71(m, 1H). 7.57-7.50(m, 2H), 7.39-7.28(m. 7H), 7.08(m, 2H), 2.28(m, 8H). 1.90(m, 4H) | 664 | 664.73 |
| 169 | δ = 7.86(m, 2H), 7.37(d. 2H). 4.59(s, 1H), 2.28(m, 8H), 1.90(m, 4H), 1.71(s, 3H). 1.31(s, 3H) | 631 | 631.56 |
| 200 | δ = 8.05-7.98(m, 2H). 7.86(m, 2H), 7.68-7.61(m, 3H), 7.48-7.12(m, 15H), 2.28(m, 8H), 1.90(m, 4H) | 740 | 740.83 |
| 217 | δ = 8.11(m, 2H), 7.90-7.83(m, 6H), 7.48(m, 4H), 7.37-7.32(m, 6H), 7.22(m, 2H). 4.60(s, 1H), 2.28(m. 8H), 1.90(m, 4H), 1.71(s, 3H), 1.30(s, 3H) | 639 | 639.84 |
| 295 | δ = 8.11(m, 3H), 7.99(m, 1H), 7.90(m, 3H), 7.83(m, 3H), 7.72(m, 1H), 7.59(s, 2H). 7.48-7.22(m, 29H), 2.28(m, 8H), 1.90(m, 4H) | 972 | 973.25 |
| 337 | δ = 7.99(d, 2H), 7.83(m, 2H), 7.47(m, 4H). 7.36(m, 2H), 4.62(s. 1H), 2.38(s, 6H), 2.28(m, 8H), 1.90(m, 4H), 1.72(s, 3H), 1.31(s, 3H) | 515 | 515.70 |
| 449 | δ = 9.12(s, 1H), 8.11(m, 2H), 7.99(m, 1H), 7.90-7.83(m, 6H), 7.71-7.66(m, 2H). 7.46-7.28(m. 11H), 7.03(m, 4H), 2.28(m, 8H). 1.90(m, 4H) | 780 | 780.95 |
| 505 | δ = 8.11 (m, 2H), 7.90(m. 2H), 7.83(m,2H), 7.59(s, 2H), 7.46(m, 8H), 7.03(m, 8H). 4.62(s, 1H), 2.28(m, 8H), 1.90(m, 4H), 1.71(s, 3H), 1.31(s, 3H) | 863 | 863.98 |
| 562 | δ = 8.11-8.05(m, 3H), 7.90(m, 1H), 7.72-7.70(m. 2H), 7.68-7.61(m. 4H), 7.59-7.42(m, 17H), 7.33-7.22(m, 11H), 6.99(m, 1H), 2.28(m. 8h), 1.90(m, 4H) | 990 | 991.24 |
| 634 | δ = 8.11(d, 1H), 8.01(m, 2H), 7.90-7.83(m, 4H), 7.72-7.65(m. 6H), 7.48-7.32(m, 16H), 7.22(m, 1H), 6.99(m, 1H), 2.28(m, 8H), 1.90(m. 4H). 1.34(s, 18H) | 950 | 951.26 |
| 745 | δ = 8.06(m. 2H), 7.65(m, 2H), 7.57(m, 2H). 7.48-7.42(m, 6H), 7.32(m. 4H), 7.22(m. 2H), 4.58(s, 1H). 2.42(s, 6H). 2.28(m. 8H). 1.90(m, 4h), 1.71(s, 3H), 1.32(s, 3H) | 667 | 667.88 |
| 817 | δ = 8.02(m, 2H), 7.78(m. 2H). 7.58(m, 2H). 7.42(m. 2H), 7.15(s. 2H), 4.58(s, 1H), 2.28(m. 8H), 1.90(m, 4H), 1.71(s, 3H), 1.34(s, 18H), 1.30(s, 3H) | 599 | 599.86 |
| 880 | δ = 8.56(m, 1H), 8.10(m, 1H), 7.99-7.95(m. 4H), 7.54-7.47(m, 6H). 7.07(m, 2H), 6.98(m, 2H), 2.55(s, 3H), 2.40(s, 6H), 2.28(m. 8H), 1.90(m. 4H) | 648 | 648.79 |
| 889 | δ = 7.96(m, 2H). 7.57(s. 2H). 7.44(m, 2H), 7.14(s. 2H), 4.63(s, 1H), 2.41(s, 6H). 2.28(m, 8H), 1.90(m. 4H), 1.71(s, 3H), 1.35(s, 18H). 1.30(s. 3H) | 627 | 627.9 |
| 985 | δ = 7.99(m, 2H), 7.58(s, 2H), 7.48(m, 8H), 7.32(m. 4H), 7.22(m. 2H), 4.63(s, 1H), 2.43(s, 6H), 2.28(m, 8H), 1.90(m, 4H), 1.71(s, 3H), 1.30(s, 3H) | 667 | 667.88 |
| 1081 | δ = 8.05(m. 2H) 7.68-7.61 (m, 4H), 7.59-7.54(m, 6H), 7.46-7.43(m. 6H). 4.63(s, 1H), 2.28(m. 8H), 1.90(m, 4H), 1.71(s, 3H), 1.31 (m. 3H), 0.66(s, 18H) | 783 | 784.20 |
| 1177 | δ = 7.98(m. 2H). 7.79(m, 2H), 7.37-7.33(m, 4H), 6.98(m, 2H), 4.62(s. 1H), 3.82(s, 6H), 2.28(m, 8H). 1.90(m, 4H). 1.70(s, 3H), 1.32(s, 3H) | 547 | 547.70 |
| 1249 | δ = 8.03(m, 2H). 7.86(m. 2H), 7.65(m. 2H), 7.59(m, 2H), 7.37(m. 2H). 4.63(s, 1H), 2.28(m. 8H), 1.90(m. 4H). 1.71(s, 3H), 1.32(s, 3H), 0.66(s,18H) | 631 | 632.00 |

### [Example 1] Manufacture of an OLED (1)

An OLED device was manufactured by using a red phosphorescent compound according to the invention.

First, a transparent electrode ITO thin film (15 Ω/□) (2) prepared from glass for OLED (produced by Samsung Corning) (1) was subjected to ultrasonic washing with trichloroethylene, acetone, ethanol and distilled water, sequentially, and stored in isopropanol before use.

Then, an ITO substrate was equipped in a substrate folder of a vacuum vapor-deposit device, and 4,4',4"-tris(N,N-(2-naphthyl)-phenylamino)triphenylamine (2-TNATA) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injection layer (3) having 60 nm of thickness on the ITO substrate.

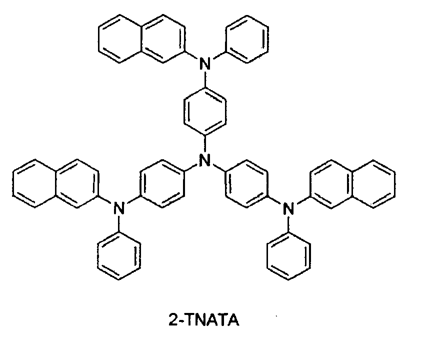

Then, to another cell of the vacuum vapor-deposit device, charged was N,N'-bis(α-naphthyl)-N,N'-diphenyl-4,4'-diamine (NPB), and electric current was applied to the cell to evaporate NPB, thereby providing vapor-deposit of a hole transport layer (4) of 20 nm of thickness on the hole injection layer.

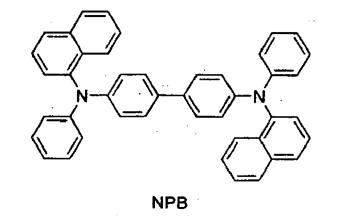

To another cell of said vacuum vapor-deposit device, charged was 4,4'-N,N'-dicarbazole-biphenyl (CBP) as an electroluminescent host material, and an organic electroluminescent compound (Compound 1) according to the present invention was charged to still another cell. The two materials were evaporated at different rates to carry out doping to vapor-deposit an electroluminescent layer (5) having 30 nm of thickness on the hole transport layer. The suitable doping concentration is 4 to 10 mol% on the basis of CBP.

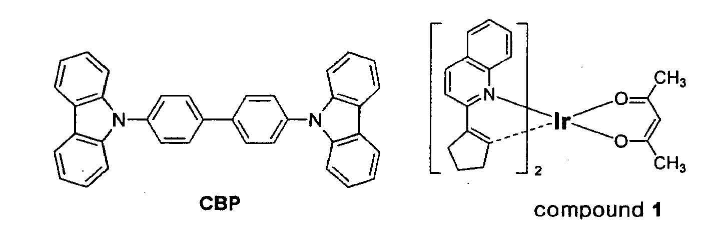

Then, on the electroluminescent layer, bis(2-methyl-8-quinolinato)(p-phenylphenolato)aluminum (III) (BAlq) was vapor-deposited as a hole blocking layer with a thickness of 10 nm in the same manner for NPB, tris(8-hydroxyquinoline)aluminum (III) (Alq) was vapor-deposited as an electron transport layer (6) with a thickness of 20 nm, and then lithium quinolate (Liq) was vapor-deposited as an electron injection layer (7) with a thickness of 1 to 2 nm. Thereafter, an A1 cathode (8) was vapor-deposited with a thickness of 150 nm by using another vacuum vapor-deposit device to manufacture an OLED.

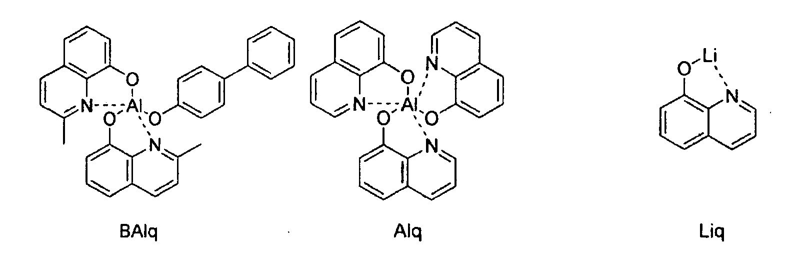

### [Example 2] Manufacture of an OLED (2)

A hole injection layer and a hole transport layer were formed according to the procedure of Example 1, and an electroluminescent layer was vapor-deposited thereon as follows. To another cell of said vacuum vapor-deposit device, charged was H-2 as an electroluminescent host material according to the invention, and an organic electroluminescent compound (Compound 75) according to the present invention was charged to still another cell. The two materials were evaporated at different rates to carry out doping to vapor-deposit an electroluminescent layer (5) having 30 nm of thickness on the hole transport layer. The suitable doping concentration is 4 to 10 mol% on the basis of the host. Then, a hole blocking layer, an electron transport layer and an electron injection layer were vapor-deposited according to the same procedure as in Example 1, and then A1 cathode was vapor-deposited in a thickness of 150 nm by using another vacuum vapor-deposit device to manufacture an OLED.

### [Example 3] Manufacture of an OLED (3)

A hole injection layer, a hole transport layer and an electroluminescent layer were formed according to the same procedure as in Example 2, and then an electron transport layer and an electron injection layer were vapor-deposited. Thereafter, Al cathode was vapor-deposited in a thickness of 150 nm by using another vacuum vapor-deposit device to manufacture an OLED.

In order to confirm the performance of the OLED's prepared according to Examples 1 to 3, the luminous efficiencies of the OLED's were measured at 10 mA/cm². Various properties are shown in Tables 3.

**Table 3**

| | Material | Host | Hole blocking layer | EL color | Operation voltage | Max. luminous efficiency (cd/A) |
|---|---|---|---|---|---|---|
| Ex. 1 | Compound 1 | CBP | BAlq | Red | 7.5 | 12.3 |
| | Compound 51 | CBP | BAlq | Red | 7.8 | 11.1 |
| | Compound 75 | CBP | BAlq | Red | 7.6 | 11.8 |
| | Compound 110 | CBP | BAlq | Red | 7.6 | 11.2 |
| | Compound 167 | CBP | BAlq | Red | 7.9 | 10.8 |
| | Compound 230 | CBP | BAlq | Red | 7.8 | 10.9 |
| | Compound 313 | CBP | BAlq | Red | 8.4 | 8.1 |
| | Compound 439 | CBP | BAlq | Red | 7.8 | 11.3 |
| | Compound 479 | CBP | BAlq | Red | 7.4 | 11.5 |
| | Compound 483 | CBP | BAlq | Red | 8.1 | 10.6 |
| | Compound 493 | CBP | BAlq | Red | 8.3 | 9.2 |
| | Compound 523 | CBP | BAlq | Red | 7.6 | 11.4 |
| | Compound 723 | CBP | BAlq | Red | 7.6 | 12.6 |
| Ex. 2 | Compound 75 | H-2 | BAlq | Red | 7.8 | 11.9 |
| | Compound 479 | H-7 | BAlq | Red | 7.5 | 11.5 |
| | Compound 523 | H-40 | BAlq | Red | 7.5 | 11.4 |
| Ex. 3 | Compound 75 | H-2 | - | Red | 6.6 | 11.7 |
| | Compound 230 | H-12 | - | Red | 6.9 | 11.1 |
| | Compound 723 | H-67 | - | Red | 6.5 | 12.9 |

For Compound (51), incorporation of F in the primary ligand affected the LUMO level, and provided the effect of red shift of the color coordinate, even though the efficiency was somewhat lowered as compared to the compound before incorporating F. Compound (75) also exhibited enhanced color coordinate due to incorporation of F at another position. For Compound (230), wherein incorporation of phenyl provided increase in resonance, exhibited enhanced color coordinate. Compound (313) exhibited higher red shift effect of the color coordinate by incorporating two phenyl groups in LUMO level, but with abruptly decreased efficiency. Likewise, electroluminescent substances having appropriate color coordinates and efficiences can be synthesized by employing various substituents in LUMO level of the primary ligand.

With identical device structure, using the host according to the present invention instead of CBP in an EL device did not provide significant change in efficiency, color coordinate and operation voltage from those of CBP. Thus it is anticipated that those hosts can be employed as a phosphorescent host, when being used with dopants according to the invention, instead of CBP as a conventional electroluminescent host. When the host according to the invention is employed without using a hole blocking layer, the device exhibits comparable or higher luminous efficiency as compared to that using a conventional host, and provides decreased power consumption of the OLED due to lowered operation voltage by at least 0.9∼1.2 V. If the invention is applied to mass production of OLED's, the time for mass production can be also shortened to give great benefit on the commercialization.

## Claims

1. An organic electroluminescent compound represented by Chemical Formula (1): 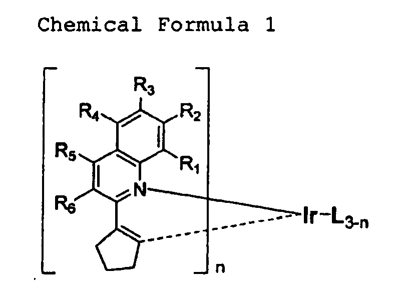 wherein, L is an organic ligand;
R₁ through R₆ independently represent hydrogen, (C1-C60)alkyl, (C1-C60)alkoxy, (C3-C60)cycloalkyl, a 5- or 6-membered heterocycloalkyl containing oxygen, nitrogen or sulfur, (C6-C60)aryl, (C5-C60)heteroaryl, halogen, mono or di(C1-C6)alkylamino, mono or di(C6-C60)arylamino, tri(C1-C60)alkylsilyl, di(C1-C60)alkyl(C6-C60)arylsilyl or tri(C6-C60)arylsilyl, or each of R₁ through R₆ may be linked to another adjacent group from R₁ through R₆ via (C3-C12)alkylene or (C3-C12)alkenylene with or without a fused ring to form an alicyclic ring, or a monocyclic or polycyclic aromatic ring;
the alkyl, alkoxy, cycloalkyl, aryl, heteroaryl of R₁ through R₆, or the alicyclic ring, or the monocyclic or polycyclic aromatic ring formed therefrom by linkage via (C3-C12) alkylene or (C3-C12)alkenylene may be further substituted by one or more substituent(s) selected from (C1-C60)alkyl with or without halogen substituent(s), halogen, cyano, tri(C1-C60)alkylsilyl, di(C1-C60)alkyl(C6-C60)arylsilyl, tri(C6-C60)arylsilyl, (C1-C60)alkoxy, (C3-C60)cycloalkyl, mono or di(C1-C60)alkylamino, mono or di(C6-C60)arylamino, (C1-C60)alkylcarbonyl, (C6-C60)arylcarbonyl and (C6-C60)aryl; and
n is an integer from 1 to 3.

2. The organic electroluminescent compound according to claim 1, wherein R₁ through R₆ independently represent hydrogen, methyl, ethyl, n-propyl, i-propyl, n-butyl, i-butyl, t-butyl, n-pentyl, i-pentyl, n-hexyl, n-heptyl, n-octyl, ethylhexyl, trifluoromethyl, methoxy, ethoxy, butoxy, cyclopropyl, cyclobutyl, cyclopentyl, cyclohexyl, cycloheptyl, morpholine, fluoro, phenyl, naphthyl, anthryl, fluorenyl, spirobifluorenyl, furyl, pyrrolyl, imidazolyl, pyrazolyl, thiazolyl, pyridyl, quinolyl, thiophenyl, dimethylamino, methylethylamino, diphenylamino, trimethylsilyl, triethylsilyl, tripropylsilyl, tri(t-butyl)silyl, t-butyldimethylsilyl or triphenylsilyl; and the phenyl, naphthyl, anthryl, fluorenyl, furyl, pyrrolyl, imidazolyl, pyrazolyl, thiazolyl, pyridyl, quinolyl and thiophenyl of R₁ through R₆ may be further substituted by one or more substituent(s) selected from methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, trifluoromethyl, fluoro, cyano, trimethylsilyl, tripropylsilyl, tri(t-butyl)silyl, t-butyldimethylsilyl, triphenylsilyl, methoxy, ethoxy, butoxy, cyclopropyl, cyclobutyl, cyclopentyl, cyclohexyl, cycloheptyl, dimethylamino, diphenylamino, methylcarbonyl, ethylcarbonyl, t-butylcarbonyl, phenylcarbonyl, phenyl, naphthyl, anthryl and fluorenyl.

3. The organic electroluminescent compound according to claim 1, wherein the ligand (L) has a structure represented by one of the following chemical formulas: 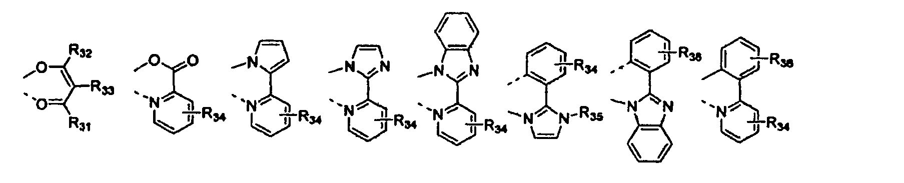 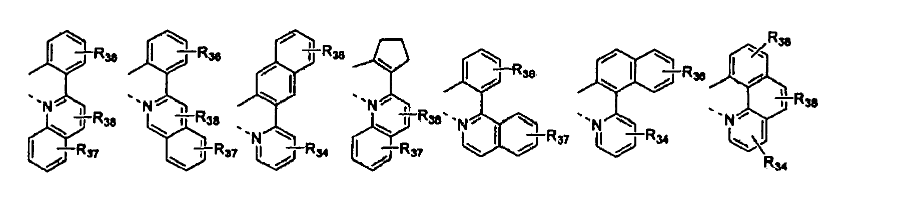 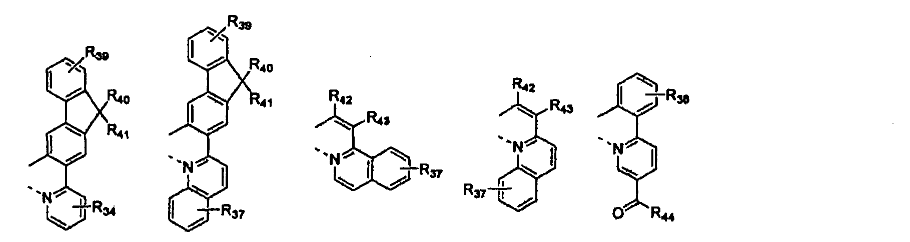 wherein, R₃₁ and R₃₂ independently represent hydrogen, (C1-C60)alkyl with or without halogen substituent(s), phenyl with or without (C1-C60)alkyl substituent(s), or halogen;
R₃₃ through R₃₉ independently represent hydrogen, (C1-C60)alkyl, phenyl with or without (C1-C60)alkyl substituent(s), tri(C1-C60)alkylsilyl or halogen;
R₄₀ through R₄₃ independently represent hydrogen, (C1-C60)alkyl, phenyl with or without (C1-C60)alkyl substituent(s); and
R₄₄ represents (C1-C60)alkyl, phenyl with or without (C1-C60)alkyl substituent(s), or halogen.

4. An organic electroluminescent device which is comprised of a first electrode; a second electrode; and at least one organic layer(s) interposed between the first electrode and the second electrode; wherein the organic layer comprises an electroluminescent region comprising an organic electroluminescent compound represented by Chemical Formula (1) : 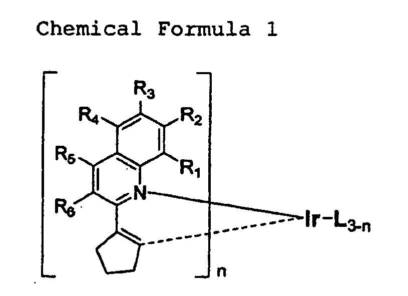 wherein, L is an organic ligand;
R₁ through R₆ independently represent hydrogen, (C1-C60)alkyl, (C1-C60)alkoxy, (C3-C60)cycloalkyl, a 5- or 6-membered heterocycloalkyl containing oxygen, nitrogen or sulfur, (C6-C60)aryl, (C5-C60)heteroaryl, halogen, mono or di(C1-C6)alkylamino, mono or di(C6-C60)arylamino, tri(C1-C60)alkylsilyl, di(C1-C60)alkyl(C6-C60)arylsilyl or tri(C6-C60)arylsilyl, or each of R₁ through R₆ may be linked to another adjacent group from R₁ through R₆ via (C3-C12)alkylene or (C3-C12)alkenylene with or without a fused ring to form an alicyclic ring, or a monocyclic or polycyclic aromatic ring;
the alkyl, alkoxy, cycloalkyl, aryl, heteroaryl of R₁ through R₆, or the alicyclic ring, or the monocyclic or polycyclic aromatic ring formed therefrom by linkage via (C3-C12) alkylene or (C3-C12)alkenylene may be further substituted by one or more substituent(s) selected from (C1-C60)alkyl with or without halogen substituent(s), halogen, cyano, tri(C1-C60)alkylsilyl, di(C1-C60)alkyl(C6-C60)arylsilyl, tri(C6-C60)arylsilyl, (C1-C60)alkoxy, (C3-C60)cycloalkyl, mono or di(C1-C60)alkylamino, mono or di(C6-C60)arylamino, (C1-C60)alkylcarbonyl, (C6-C60)arylcarbonyl and (C6-C60)aryl; and n is an integer from 1 to 3, and one or more host(s) selected from 1,3,5-tricarbazolylbenzene, polyvinylcarbazole, m-biscarbazolylphenyl, 4,4'4"-tri(N-carbazolyl)triphenylamine, 1,3,5-tri(2-carbazolylphenyl)benzene, 1,3,5-tris(2-carbazolyl-5-methoxyphenyl)benzene, bis(4-carbazolylphenyl)silane and one or more host(s) selected from the compounds represented by one of Chemical Formulas (2) to (5): 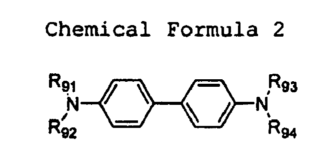 In Chemical Formula (2), R₉₁ through R₉₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₉₁ through R₉₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, or arylamino of R₉₁ through R₉₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C9-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl. 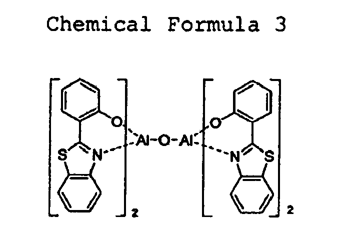 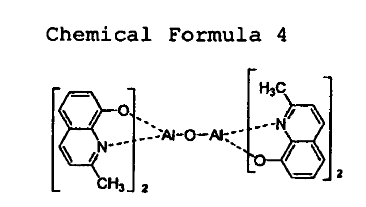 Chemical Formula 5
L¹L²M¹(Q)_{y}
In Chemical Formula (5), the ligands, L¹ and L² are independently selected from the following structures: 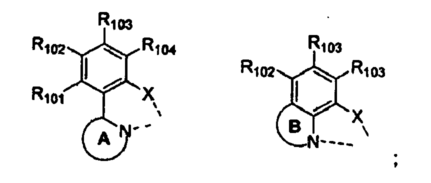 M¹ is a bivalent or trivalent metal;
y is 0 when M¹ is a bivalent metal, while y is 1 when M¹ is a trivalent metal;
Q represents (C6-C60)aryloxy or tri(C6-C60)arylsilyl, and the aryloxy and triarylsilyl of Q may be further substituted by (C1-C60)alkyl or (C6-C60)aryl;
X represents O, S or Se;
ring A represents oxazole, thiazole, imidazole, oxadiazole, thiadiazole, benzoxazole, benzothiazole, benzimidazole, pyridine or quinoline;
ring B represents pyridine or quinoline, and ring B may be further substituted by (C1-C60)alkyl, or phenyl or naphthyl with or without (C1-C60)alkyl substituent(s);
R₁₀₁ through R₁₀₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring; and the pyridine or quinoline may form a chemical bond with R₁₀₁ to form a fused ring;
the alkyl, alkenyl, alkynyl, cycloalkyl, heterocycloalkyl, aryl, heteroaryl, arylsilyl, alkylsilyl, alkylamino, or arylamino of ring A and R₁₀₁ through R₁₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

5. The organic electroluminescent device according to claim 4, wherein the organic layer comprises one or more compound(s) selected from a group consisting of arylamine compounds and styrylarylamine compounds, or one or more metal(s) selected from a group consisting of organic metals of Group 1, Group 2, 4^{th} period and 5^{th} period transition metals, lanthanide metals and d-transition elements.

6. The organic electroluminescent device according to claim 4, having the electroluminescent peak with wavelength of blue and green at the same time.

7. The organic electroluminescent device according to claim 4, wherein the organic layer comprises an electroluminescent layer and a charge generating layer.

8. The organic electroluminescent device according to claim 4, wherein a mixed region of reductive dopant and organic substance, or a mixed region of oxidative dopant and organic substance is placed on the inner surface of one or both electrode(s) among the pair of electrodes.

## Patentansprüche

1. Organische elektrolumineszierende Verbindung, dargestellt durch die chemische Formel (1): 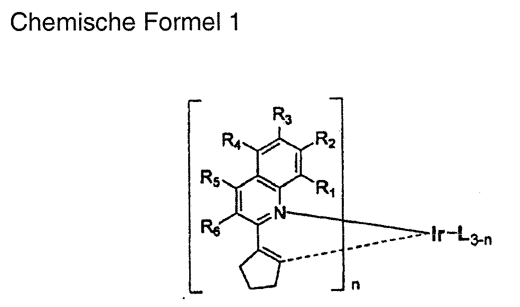 worin L ein organischer Ligand ist,
R₁ bis R₆ unabhängig voneinander Wasserstoff, (C1-C60)Alkyl, (C1-C60)Alkoxy, (C3-C60)Cycloalkyl, ein 5- oder 6-gliedriges Heterocycloalkyl, enthaltend Sauerstoff, Stickstoff oder Schwefel, (C6-C60)Aryl, (C5-C60)Heteroaryl, Halogen, Mono- oder Di(C1-C6)alkylamino, Mono- oder Di(C6-C60)arylamino, Tri(C1-C60)alkylsilyl, Di(C1-C60)alkyl(C6-C60)arylsilyl oder Tri(C6-C60)arylsilyl bedeuten oder jedes von R₁ bis R₆ an eine andere angrenzende Gruppe von R₁ bis R₆ über (C3-C12)Alkylen oder (C3-C12)Alkenylen mit oder ohne einen anellierten Ring unter Bildung eines alicyclischen Rings oder eines monocyclischen oder polycyclischen aromatischen Rings verknüpft sein kann,
das Alkyl, Alkoxy, Cycloalkyl, Aryl, Heteroaryl von R₁ bis R₆ oder der alicyclische Ring oder der monocyclische oder polycyclische aromatische Ring gebildet daraus durch Verknüpfung über (C3-C12) Alkylen oder (C3-C12)Alkenylen weiter mit einem oder mehreren Substituenten, ausgewählt aus (C1-C60)Alkyl mit oder ohne Halogensubstituent(en), Halogen, Cyan, Tri(C1-C60)Alkylsilyl, Di(C1-C60)alkyl(C6-C60)arylsilyl, Tri(C6-C60)arylsilyl, (C1-C60)Alkoxy, (C3-C60)Cycloalkyl, Mono- oder Di(C1-C60)alkylamino, Mono- oder Di(C6-C60)arylamino, (C1-C60)Alkylcarbonyl, (C6-C60)Arylcarbonyl und (C6-C60)Aryl, substituiert sein kann, und
n eine ganze Zahl von 1 bis 3 ist.

2. Organische elektrolumineszierende Verbindung gemäß Anspruch 1, wobei Ei bis R₆ unabhängig voneinander Wasserstoff, Methyl, Ethyl, n-Propyl, i-Propyl, n-Butyl, i-Butyl, t-Butyl, n-Pentyl, i-Pentyl, n-Hexyl, n-Heptyl, n-Octyl, Ethylhexyl, Trifluormethyl, Methoxy, Ethoxy, Butoxy, Cyclopropyl, Cyclobutyl, Cyclopentyl, Cyclohexyl, Cycloheptyl, Morpholine, Fluor, Phenyl, Naphthyl, Anthryl, Fluorenyl, Spirobifluorenyl, Furyl, Pyrrolyl, Imidazolyl, Pyrazolyl, Thiazolyl, Pyridyl, Chinolyl, Thiophenyl, Dimethylamin, Methylethylamino, Diphenylamino, Trimethylsilyl, Triethylsilyl, Tripropylsilyl, Tri(t-butyl)silyl, t-Butyldimethylsilyl oder Triphenylsilyl darstellen und das Phenyl, Naphthyl, Anthryl, Fluorenyl, Furyl, Pyrrolyl, Imidazolyl, Pyrazolyl, Thiazolyl, Pyridyl, Chinolyl und Thiophenyl von R₁ bis R₆ weiter mit einem oder mehreren Substituenten, ausgewählt aus Methyl, Ethyl, n-Propyl, i-Propyl, n-Butyl, i-Butyl, t-Butyl, n-Pentyl, i-Pentyl, n-Hexyl, n-Heptyl, n-Octyl, 2-Ethylhexyl, n-Nonyl, Trifluormethyl, Fluor, Cyano, Trimethylsilyl, Tripropylsilyl, Tri(t-butyl)silyl, t-Butyldimethylsilyl, Triphenylsilyl, Methoxy, Ethoxy, Butoxy, Cyclopropyl, Cyclobutyl, Cyclopentyl, Cyclohexyl, Cycloheptyl, Dimethylamino, Diphenylamino, Methylcarbonyl, Ethylcarbonyl, t-Butylcarbonyl, Phenylcarbonyl, Phenyl, Naphthyl, Anthryl und Fluorenyl, substituiert sein kann.

3. Organische elektrolumineszierende Verbindung gemäß Anspruch 1, wobei der Ligand (L) eine Struktur aufweist, dargestellt durch eine der folgenden chemischen Formeln: 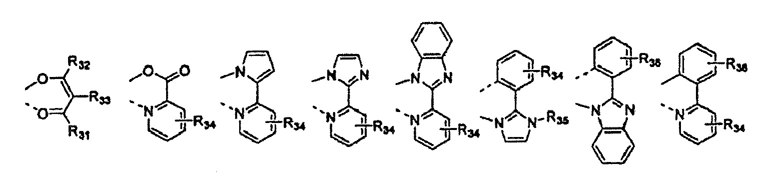 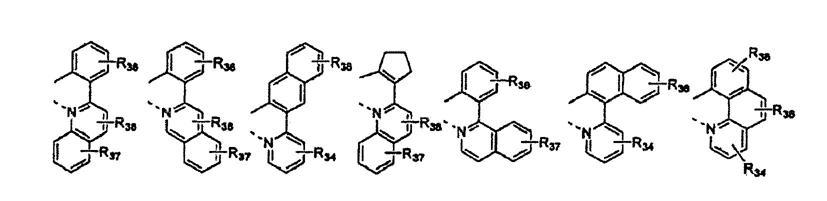 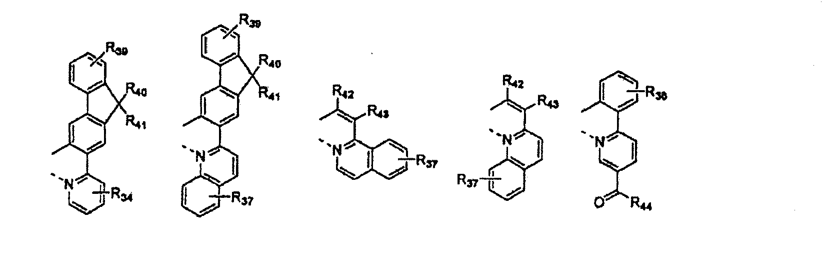 worin R₃₁ und R₃₂ unabhängig voneinander Wasserstoff, (C1-C60)Alkyl mit oder ohne Halogensubstituet(en), Phenyl mit oder ohne (C1-C60)Alkylsubstituent(en) oder Halogen darstellen, R₃₃ bis R₃₉ unabhängig voneinander Wasserstoff, (C1-C60)Alkyl, Phenyl mit oder ohne (C1-C60)Alkylsubstituent(en), Tri(C1-C60)Alkylsilyl oder Halogen darstellen,
R₄₀ bis R₄₃ unabhängig voneinander Wasserstoff, (C1-C60)Alkyl, Phenyl mit oder ohne (C1-C60)Alkylsubstituent(en) darstellen, und
R₄₄ (C1-C60)Alkyl, Phenyl mit oder ohne (C1-C60)Alkylsubstituent(en) oder Halogen darstellt.

4. Organische elektrolumineszierende Vorrichtung, welche eine erste Elektrode, eine zweite Elektrode und mindestens eine organische Schicht, zwischengelegt zwischen die erste Elektrode und die zweite Elektrode, umfaßt, wobei die organische Schicht einen elektrolumineszierenden Bereich umfaßt, welcher eine organische elektrolumineszierende Verbindung, dargestellt durch die chemische Formel (1), umfaßt: 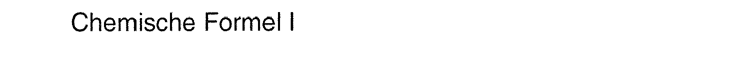 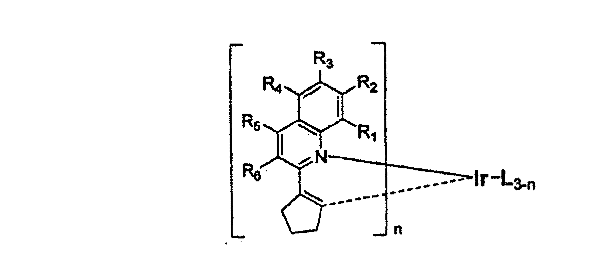 worin L ein organischer Ligand ist R₁ bis R₆ unabhängig voneinander Wasserstoff, (C1-C60)Alkyl, (C1-C60)Alkoxy, (C3-C60)Cycloalkyl, ein 5- oder 6-gliedriges Heterocycloalkyl, enthaltend Sauerstoff, Stickstoff oder Schwefel, (C6-C60)Aryl, (C5-C60)Heteroaryl, Halogen, Mono- oder Di(C1-C6)alkylamino, Mono- oder Di(C6-C60)arylamino, Tri(C1-C60)alkylsilyl, Di(C1-C60)alkyl(C6-C60)arylsilyl oder Tri(C6-C60)arylsilyl bedeuten oder jedes von R₁ bis R₆ an eine andere angrenzende Gruppe von R₁ bis R₆ über (C3-C12)Alkylen oder (C3-C12)Alkenylen mit oder ohne einen anellierten Ring unter Bildung eines alicyclischen Rings oder eines monocyclischen oder polycyclischen aromatischen Rings verknüpft sein kann,
das Alkyl, Alkoxy, Cycloalkyl, Aryl, Heteroaryl von R₁ bis R₆ oder der alicyclische Ring oder der monocyclische oder polycyclische aromatische Ring gebildet daraus durch Verknüpfung über (C3-C12) Alkylen oder (C3-C12)Alkenylen weiter mit einem oder mehreren Substituenten, ausgewählt aus (C1-C60)Alkyl mit oder ohne Halogensubstituent(en), Halogen, Cyan, Tri(C1-C60)Alkylsilyl, Di(C1-C60)alkyl(C6-C60)arylsilyl, Tri(C6-C60)arylsilyl, (C1-C60)Alkoxy, (C3-C60)Cycloalkyl, Mono- oder Di(C1-C60)alkylamino, Mono- oder Di(C6-C60)arylamino, (C1-C60)Alkylcarbonyl, (C6-C60)Arylcarbonyl und (C6-C60)Aryl, substituiert sein kann, und
n eine ganze Zahl von 1 bis 3 ist, und ein oder mehrere Wirte, ausgewählt aus 1,3,5-Tricarbazolylbenzol, Polyvinylcarbazol, m-Biscarbazolylphenyl, 4,4',4"-Tri(N-carbazolyl)triphenylamin, 1,3,5-Tri(2-carbazolylphenyl)benzol, 1,3,5-Tris(2-carbazolyl-5-methoxyphenyl)-benzol, Bis(4-carbazolylphenyl)silan und ein oder mehreren Gästen, ausgewählt aus den Verbindungen, dargestellt durch eine der chemischen Formeln (2) bis (5): 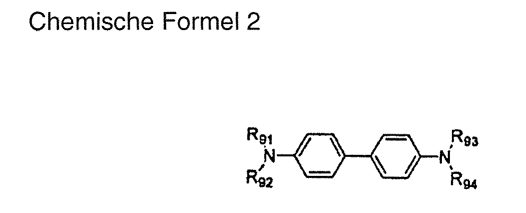 In der chemischen Formel (2) stellen R₉₁ bis R₉₄ unabhängig voneinander Wasserstoff, Halogen (C1-C60)Alkyl, (C6-C60)Aryl, (C4-C60)Heteroaryl, ein 5- oder 6-gliedriges Heterocycloalkyl, enthaltend ein oder mehrere Heteroatome, ausgewählt aus N, O und S, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyan, (C1-C60)Alkylamino, (C6-C60)Arylamino, (C6-C60)Ar(C1-C60)alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl, dar oder jedes von R₉₁ bis R₉₄ kann an einen angrenzenden Substituenten über (C3-C60)Alkylen oder (C3-C60)Alkenylen mit oder ohne einen anellierten Ring unter Bildung eines alicyclischen Rings oder eines monocyclischen oder polycyclischen aromatischen Rings verknüpft sein, wobei das Alkyl, Alkenyl, Alkinyl, Cycloalkyl, Heterocycloalkyl, Aryl, Heteroaryl, Arylsilyl, Alkylsilyl, Alkylamino oder Arylamino von R₉₁ bis R₉₄ oder der alicyclische Ring oder der monocyclische oder polycyclische aromatische Ring daraus gebildet durch Verknüpfung an einen angrenzenden Substituenten über (C3-C60)Alkylen oder (C3-C60)Alkenylen mit oder ohne einen anellierten Ring weiter mit einem oder mehreren Substituenten, ausgewählt aus Halogen, (C1-C60)Alkyl, (C6-C60)Aryl, (C4-C60)Heteroaryl, einem 5-gliedrigen oder 6-gliedrigen Heterocycloalkyl, enthaltend ein oder mehrere Heteroatome, ausgewählt aus N, O und S (C3-C60)Cycloalkyl, Tri(C1-C60)Alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyan, (C1-C60)Alkylamino, (C6-C60)Arylamino, (C6-C60)Ar(C1-C60)alkyl, (C1-G60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro und Hydroxyl, substituiert sein. 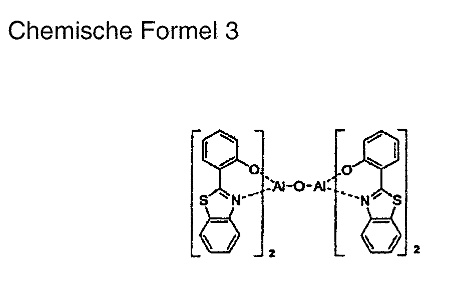 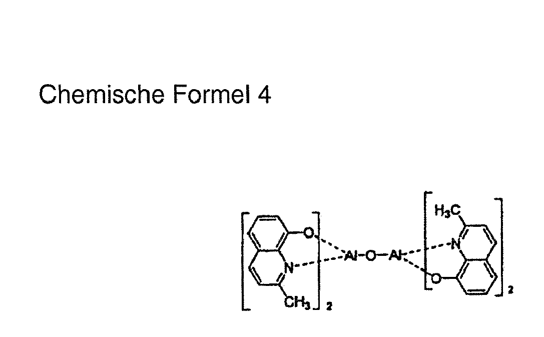 Chemische Formel 5
L¹L²M¹(Q)_{y}
In der chemischen Formel (5) sind die Liganden L1 und L2 unabhängig voneinander aus den folgenden Strukturen ausgewählt: 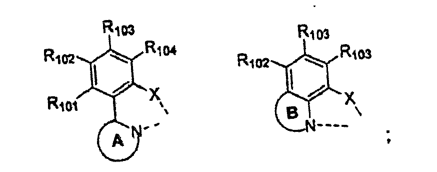 M¹ ist ein zweiwertiges oder dreiwertiges Metall,
y ist 0, wenn M¹ ein zweiwertiges Metall ist, während y 1 ist, wenn M¹ ein dreiwertiges Metall ist,
Q stellt (C6-C60)Aryloxy oder Tri(C6-C60)Arylsilyl dar und das Aryloxy und Triarylsilyl von Q können weiter mit (C1-C60)Alkyl oder (C6-C60)Aryl substituiert sein,
X stellt O, S oder Se dar,
der Ring A stellt Oxazol, Thiazol, Imidazol, Oxadiazol, Thiadiazol, Benzoxazol, Benzothiazol, Benzimidazol, Pyridin oder Chinolin dar,
der Ring B stellt Pyridin oder Chinolin dar und der Ring B kann weiter mit (C1-C60)Alkyl oder Phenyl oder Naphthyl mit oder ohne (C1-C60)Alkylsubstituent(en) substituiert sein,
R₁₀₁ bis R₁₀₄ stellen unabhängig voneinander Wasserstoff, Halogen, (C1-C60)Alkyl, (C6-C60)Aryl, (C4-C60)Heteroaryl, ein 5-gliedriges oder 6-gliedriges Heterocycloalkyl, enthaltend ein oder mehrere Heteroatome, ausgewählt aus N, O und S, (C3-C60)Cycloalkyl, Tri(C1-C60)alkylsilyl, Di(C1-C60)alkyl(C6-C60)arylsilyl, Tri(C6-C60)arylsilyl, Adamantyl, (C7-C60)Bicycloalkyl, (C2-C60)Alkenyl, (C2-C60)Alkinyl, Cyan, (C1-C60)Alkylamino, (C6-C60)Arylamino, (C6-C60)Ar(C1-C60)alkyl, (C1-C60)Alkoxy, (C1-C60)Akkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro oder Hydroxyl dar, oder jeder von R₁₀₁ bis R₁₀₄ kann durch einen angrenzenden Substituenten über (C3-C60)Alkylen oder (C3-C60)Alkenylen mit oder ohne einen anellierten Ring unter Bildung eines alicyclischen Ringes oder eines monocyclischen oder polycyclischen aromatischen Ringes verknüpft sein, und das Pyridin oder Chinolin kann eine chemische Verbindung mit R₁₀₁ unter Bildung eines anellierten Rings bilden,
das Alkyl, Alkenyl, Alkinyl, Cycloalkyl, Heterocycloalkyl, Aryl, Heteroaryl, Arylsilyl, Alkysilyl, Alkylamino oder Arylamino von Ring A und R₁₀₁ bis R₁₀₄ oder der alicyclische Ring oder der monocyclische Ring oder polycyclische aromatische Ring daraus gebildet können durch Verknüpfung an einen angrenzenden Substituenten über (C3-C60)Alkylen oder (C3-C60)Alkenylen mit oder ohne einen anellierten Ring weiter mit einem oder mehreren Substituent(en) substituiert sein, ausgewählt aus Halogen, (C1-C60)Alkyl, (C6-C60)Aryl, (C4-C60)Heteroaryl, ein 5-gliedriges oder 6-gliedriges Heterocycloalkyl, enthaltend eine oder mehrere Heteroatome, ausgewählt aus N, O und S, (C3-C60)Cycloalkyl, Tri(C1-C60)alkylsilyi, Di(C1-C60)alkyl(C6-C60)arylsilyl, Tri(C6-C60)Arylsilyl, Adamantyl, (C7-C60)Bicycloalkyl, (C2-C60)Alkinyl, (C2-C60)Alkinyl, Cyan, (C1-C60)Alkylamino, (C6-C60)Arylamino, (C6-C60)Ar(C1-C60)Alkyl, (C1-C60)Alkyloxy, (C1-C60)Alkylthio, (C6-C60)Aryloxy, (C6-C60)Arylthio, (C1-C60)Alkoxycarbonyl, (C1-C60)Alkylcarbonyl, (C6-C60)Arylcarbonyl, Carboxyl, Nitro und Hydroxyl.

5. Organische elektrolumineszierende Vorrichtung gemäß Anspruch 4, wobei die organische Schicht ein oder mehrere Verbindungen, ausgewählt aus einer Gruppe, bestehend aus Arylaminverbindungen und Styrolarylaminverbindungen, oder ein oder mehrere Metalle, ausgewählt aus einer Gruppe, bestehend aus organischen Metallen der Gruppe 1, Gruppe 2, Übergangsmetallen der vierten Periode und der fünften Periode, Lanthanoidmetallen und d-Übergangselementen, umfaßt.

6. Organische elektrolumineszierende Vorrichtung gemäß Anspruch 4, welche den Elektrolumineszenzpeak mit Wellenlänge von Blau und Grün gleichzeitig aufweist.

7. Organische elektrolumineszierende Vorrichtung gemäß Anspruch 4, wobei die organische Schicht eine elektrolumineszierende Schicht und eine ladungserzeugende Schicht umfaßt.

8. Organische elektrolumineszierende Vorrichtung gemäß Anspruch 4, wobei ein gemischter Bereich von reduktivem Dotierungsmittel und organischer Substanz oder ein gemischter Bereich von oxidativem Dotierungsmittel und organischer Substanz an der inneren Oberfläche von einer oder beiden Elektroden innerhalb des Elektrodenpaares angeordnet ist.

## Revendications

1. Composé électroluminescent organique représenté par la formule chimique (1) : 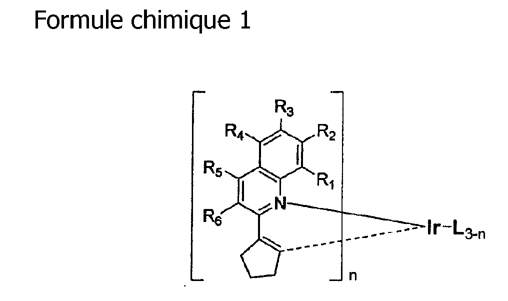 dans laquelle, L est un ligand organique ;
R₁ à R₆ représentent indépendamment l'hydrogène, un groupe alkyle en C1-C60, alcoxy en C1-C60, cycloalkyle en C3-C60, hétérocycloalkyle à 5 ou 6 éléments contenant de l'oxygène, de l'azote ou du soufre, aryle en C6-C60, hétéroaryle en C5-C60, un atome d'halogène, un groupe mono ou di(alkyle en C1-C6)amino, mono ou di(aryle en C6-C60)amino, tri(alkyle en C1-C60)silyle, di(alkyle en C1-C60)(aryle en C6-C60)silyle ou tri(aryle en C6-C60)silyle, ou chacun de R₁ à R₆ peut être lié à un autre groupe adjacent de R₁ à R₆ via un groupe alkylène en C3-C12 ou alcénylène en C3-C12 avec ou sans noyau condensé pour former un noyau alicyclique ou un noyau aromatique monocyclique ou polycyclique ;
le groupe alkyle, alcoxy, cycloalkyle, aryle, hétéroaryle de R₁ à R₆, ou le noyau alicyclique, ou le noyau aromatique monocyclique ou polycyclique formé à partir de ceux-ci par liaison via un groupe alkylène en C3-C12 ou alcénylène en C3-C12 peut encore être substitué par un ou plusieurs substituants choisis parmi un groupe alkyle en C1-C60 avec ou sans substituant(s), un atome d'halogène, un groupe cyano, tri(alkyle en C1-C60)silyle, di(alkyle en C1-C60)(aryle en C6-C60)silyle, tri(aryle en C6-C60)silyle, alcoxy en C1-C60, cycloalkyle en C3-C60, mono ou di(alkyle en C1-C60)amino, mono ou di(aryle en C6-C60)amino, (alkyle en C1-C60)carbonyle, (aryle en C6-C60)carbonyle et aryle en C6-C60 ; et
n est un nombre entier de 1 à 3.

2. Composé électroluminescent organique selon la revendication 1, dans lequel R₁ à R₆ représentent indépendamment l'hydrogène, un groupe méthyle, éthyle, n-propyle, i-propyle, n-butyle, i-butyle, t-butyle, n-pentyle, i-pentyle, n-hexyle, n-heptyle, n-octyle, éthylhexyle, trifluorométhyle, méthoxy, éthoxy, butoxy, cyclopropyle, cyclobutyle, cyclopentyle, cyclohexyle, cycloheptyle, morpholine, fluoro, phényle, naphtyle, anthryle, fluorényle, spirobifluorényle, furyle, pyrrolyle, imidazolyle, pyrazolyle, thiazolyle, pyridyle, quinolyle, thiophényle, diméthylamino, méthyléthylamino, diphénylamino, triméthylsilyle, triéthylsilyle, tripropylsilyle, tri(t-butyl)silyle, t-butyldiméthylsilyle ou triphénylsilyle ; et le groupe phényle, naphtyle, anthryle, fluorényle, furyle, pyrrolyle, imidazolyle, pyrazolyle, thiazolyle, pyridyle, quinolyle et thiophényle de R₁ à R₆ peut encore être substitué par un ou plusieurs substituant(s) choisis parmi le groupe méthyle, éthyle, n-propyle, i-propyle, n-butyle, i-butyle, t-butyle, n-pentyle, i-pentyle, n-hexyle, n-heptyle, n-octyle, 2-éthylhexyle, n-nonyle, trifluorométhyle, fluoro, cyano, triméthylsilyle, tripropylsilyle, tri(t-butyl)-silyle, t-butyldiméthylsilyle, triphénylsilyle, méthoxy, éthoxy, butoxy, cyclopropyle, cyclobutyle, cyclopentyle, cyclohexyle, cycloheptyle, diméthylamino, diphénylamino, méthylcarbonyle, éthylcarbonyle, t-butylcarbonyle, phénylcarbonyle, phényle, naphtyle, anthryle et fluorényle.

3. Composé électroluminescent organique selon la revendication 1, dans lequel le ligand (L) présente une structure représentée par une des formules chimiques suivantes : 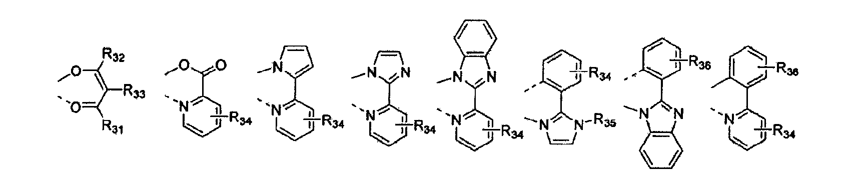 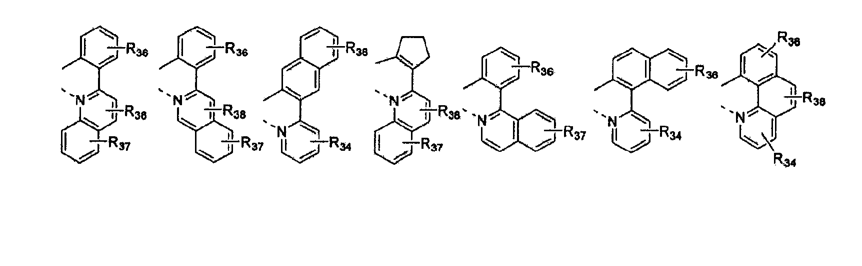 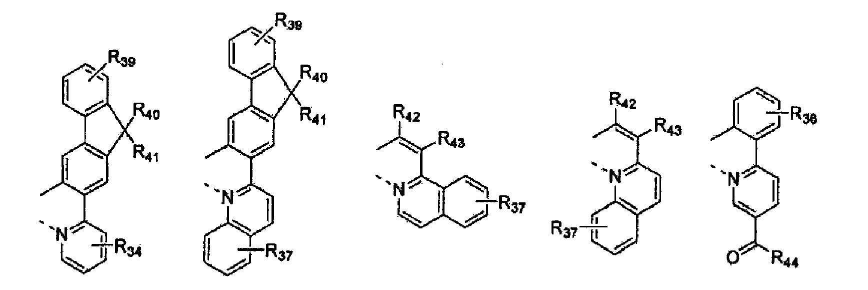 dans lesquelles, R₃₁ et R₃₂ représentent indépendamment l'hydrogène, un groupe alkyle en C1-C60 avec ou sans substituant(s) d'atome d'halogène, un groupe phényle avec ou sans substituant(s) alkyle en C1-C60, ou un atome d'halogène ;
R₃₃ à R₃₉ représentent indépendamment l'hydrogène, un groupe alkyle en C1-C60, phényle avec ou sans substituant(s) alkyle en C1-C60, tri(alkyle en C1-C60)silyle ou un atome d'halogène ;
R₄₀ à R₄₃ représentent indépendamment l'hydrogène, un groupe alkyle en C1-C60, phényle avec ou sans substituant(s) alkyle en C1-C60 ; et
R₄₄ représente un groupe alkyle en C1-C60, phényle avec ou sans substituant(s) alkyle en C1-C60, ou un atome d'halogène.

4. Dispositif électroluminescent organique qui est constitué d'une première électrode ; d'une seconde électrode ; et d'au moins une couche organique intercalée entre la première électrode et la seconde électrode ; dans lequel la couche organique comprend une région électroluminescente comprenant un composé électroluminescent organique représenté par la formule chimique (1) : 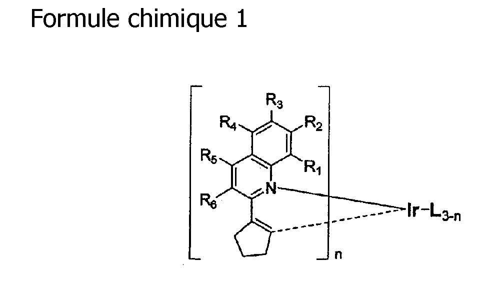 dans laquelle, L est un ligand organique ;
R₁ à R₆ représentent indépendamment l'hydrogène, un groupe alkyle en C1-C60, alcoxy en C1-C60, cycloalkyle en C3-C60, hétérocycloalkyle à 5 ou 6 éléments contenant de l'oxygène, de l'azote ou du soufre, aryle en C6-C60, hétéroaryle en C5-C60, un atome d'halogène, un groupe mono ou di(alkyle en C1-C6)amino, mono ou di(aryle en C6-C60)amino, tri(alkyle en C1-C60)silyle, di(alkyle en C1-C60)(aryle en C6-C60)silyle ou tri(aryle en C6-C60)silyle, ou chacun de R₁ à R₆ peut être lié à un autre groupe adjacent de R₁ à R₆ via un groupe alkylène en C3-C12 ou alcénylène en C3-C12 avec ou sans noyau condensé pour former un noyau alicyclique, ou un noyau aromatique monocyclique ou polycyclique ;
le groupe alkyle, alcoxy, cycloalkyle, aryle, hétéroaryle de R₁ à R₆, ou le noyau alicyclique, ou le noyau aromatique monocyclique ou polycyclique formé à partir de ceux-ci par liaison via un groupe alkylène en C3-C12 ou alcénylène en C3-C12 peut encore être substitué par un ou plusieurs substituants choisis parmi un groupe alkyle en C1-C60 avec ou sans substituant(s) d'atome d'halogène, un atome d'halogène, un groupe cyano, tri(alkyle en C1-C60)silyle, di(alkyle en C1-C60)(aryle en C6-C60)-silyle, tri(aryle en C6-C60)silyle, alcoxy en C1-C60, cycloalkyle en C3-C60, mono ou di(alkyle en C1-C60)amino, mono ou di(aryle en C6-C60)amino, (alkyle en C1-C60)carbonyle, (aryle en C6-C60)carbonyle et aryle en C6-C60 ; et n est un nombre entier de 1 à 3, et un ou plusieurs hôtes choisis parmi le 1,3,5-tricarbazolylbenzène, le polyvinylcarbazole, le m-biscar-bazolylphényle, la 4,4',4"-tri(N-carbazolyl)triphénylamine, le 1,3,5-tri(2-carbazolylphényl)benzène, le 1,3,5-tris(2-carbazolyl-5-méthoxyphényl)-benzène, le bis(4-carbazolylphényl)silane et un ou plusieurs hôtes choisis parmi les composés représentés par l'une des formules chimiques (2) à (5) : 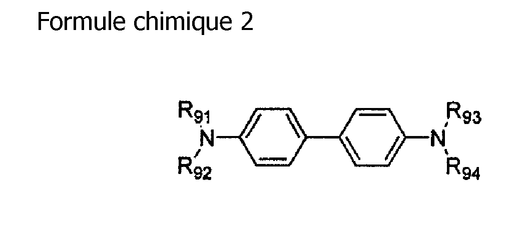 dans la formule chimique (2), R₉₁ à R₉₄ représentent indépendamment l'hydrogène, un atome d'halogène, un groupe alkyle en C1-C60, aryle en C6-C60, hétéroaryle en C4-C60, hétérocycloalkyle à 5 ou 6 éléments contenant un ou plusieurs hétéroatomes choisis parmi N, O et S, cycloalkyle en C3-C60, tri(alkyle en C1-C60)silyle, di(alkyle en C1-C60)(aryle en C6-60)silyle, tri(aryle en C6-C60)silyle, adamantyle, bicycloalkyle en C7-C60, alcényle en C2-C60, alcynyle en C2-C60, cyano, alkylamino en C1-C60, arylamino en C6-C60, (ar en C6-C60)(alkyle en C1-C60), alkyloxy en C1-C60, alkylthio en C1-C60, aryloxy en C6-C60, arylthio en C6-C60, alcoxycarbonyle en C1-C60, alkylcarbonyle en C1-C60, arylcarbonyle en C6-C60, carboxyle, nitro ou hydroxyle, ou chacun de R₉₁ à R₉₄ peut être lié à un substituant adjacent via un groupe alkylène en C3-C60 ou alcénylène en C3-C60 avec ou sans noyau condensé pour former un noyau alicyclique ou un noyau aromatique monocyclique ou polycyclique ;
le groupe alkyle, alcényle, alcynyle, cycloalkyle, hétérocycloalkyle, aryle, hétéroaryle, arylsilyle, alkylsilyle, alkylamino ou arylamino de R₉₁ à R₉₄, ou le noyau alicyclique, ou le noyau aromatique monocyclique ou polycyclique formé à partir de ceux-ci par liaison à un substituant adjacent via un groupe alkylène en C3-C60 ou alcénylène en C3-C60 avec ou sans noyau condensé peut encore être substitué par un ou plusieurs substituant(s) choisis parmi un atome d'halogène, un groupe alkyle en C1-C60, aryle en C6-C60, hétéroaryle en C4-C60, hétérocycloalkyle à 5 ou 6 éléments contenant un ou plusieurs hétéroatomes choisis parmi N, O et S, cycloalkyle en C3-C60, tri(alkyle en C1-C60)silyle, di(alkyle en C1-C60)-(aryle en C6-C60)silyle, tri(aryle en C6-C60)silyle, adamantyle, bicycloalkyle en C7-C60, alcényle en C2-C60, alcynyle en C2-C60, cyano, alkylamino en C1-C60, arylamino en C6-C60, (ar en C6-C60)(alkyle en C1-C60), (alkyle en C1-C60)oxy, (alkyle en C1-C60)thio, (aryle en C6-C60)oxy, (aryle en C6-C60)thio, (alcoxy en C1-C60)carbonyle, (alkyle en C1-C60)carbonyle, (aryle en C6-C60)carbonyle, carboxyle, nitro et hydroxyle. 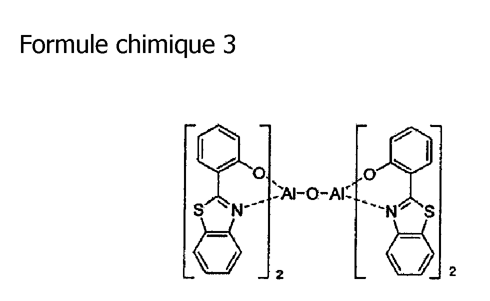 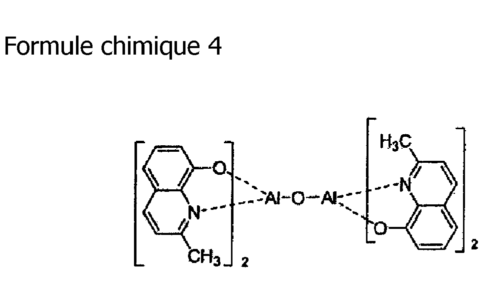
Formule chimique 5 L¹L²M¹(Q)_{y}
Dans la formule chimique (5), les ligands, L¹ et L² sont indépendamment choisis parmi les structures suivantes : 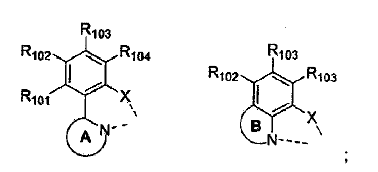 M¹ est un métal bivalent ou trivalent ;
y est égal à 0 lorsque M¹ est un métal bivalent alors que y est égal à 1 lorsque M¹ est un métal trivalent ;
Q représente un groupe (aryle en C6-C60)oxy ou tri(aryle en C6-C60)silyle et le groupe aryloxy et triarylsilyle de Q peut encore être substitué par un groupe alkyle en C1-C60 ou aryle en C6-C60 ;
X représente O, S, ou Se ;
le noyau A représente un groupe oxazole, thiazole, imidazole, oxadiazole, thiadiazole, benzoxazole, benzothiazole, benzimidazole, pyridine ou quinoline ;
le noyau B représente un groupe pyridine ou quinoléine et le noyau B peut encore être substitué par un groupe alkyle en C1-C60 ou phényle ou naphtyle avec ou sans substituant(s) alkyle en C1-C60 ;
R₁₀₁ à R₁₀₄ représentent indépendamment un atome d'hydrogène, d'halogène, un groupe alkyle en C1-C60, aryle en C6-C60, hétéroaryle en C4-C60, hétérocycloalkyle à 5 ou 6 éléments contenant un ou plusieurs hétéroatomes choisis parmi N, O et S, cycloalkyle en C3-C60, tri(alkyle en C1-C60)silyle, di(alkyle en C1-C60)(aryle en C6-C60)silyle, tri(aryle en C6-C60)silyle, adamantyle, bicycloalkyle en C7-C60, alcényle en C2-C60, alcynyle en C2-C60, cyano, (alkyle en C1-C60)amino, (aryle en C6-C60)amino, (ar en C6-C60)(alkyle en C1-C60), (alkyle en C1-C60)oxy, (alkyle en C1-C60)thio, (aryle en C6-C60)oxy, (aryle en C6-C60)thio, (alcoxy en C1-C60)carbonyle, (alkyle en C1-C60)carbonyle, (aryle en C6-C60)carbonyle, carboxyle, nitro ou hydroxyle, ou chacun de R₁₀₁ à R₁₀₄ peut être lié à un substituant adjacent via un groupe alkylène en C3-C60 ou alcénylène en C3-C60 avec ou sans noyau condensé pour former un noyau alicyclique ou un noyau aromatique monocyclique ou polycyclique ; et la pyridine ou la quinoléine peut former une liaison chimique avec R₁₀₁ pour former un noyau condensé ;
le groupe alkyle, alcényle, alcynyle, cycloalkyle, hétérocycloalkyle, aryle, hétéroaryle, arylsilyle, alkylsilyle, alkylamino ou arylamino du noyau A et R₁₀₁ à R₁₀₄, ou le noyau alicyclique, ou le noyau aromatique monocyclique ou polycyclique formé à partir de ceux-ci par liaison à un substituant adjacent via un groupe alkylène en C3-C60 ou alcénylène en C3-C60 avec ou sans noyau condensé peut encore être substitué par un ou plusieurs substituants choisis parmi un atome d'halogène, un groupe alkyle en C1-C60, aryle en C6-C60, hétéroaryle en C4-C60, hétérocycloalkyle à 5 ou 6 éléments contenant un ou plusieurs hétéroatomes choisis parmi N, O et S, cycloalkyle en C3-C60, tri(alkyle en C1-C60)silyle, di(alkyle en C1-C60)(aryle en C6-C60)silyle, tri(aryle en C6-C60)silyle, adamantyle, bicycloalkyle en C7-C60, alcényle en C2-C60, alcynyle en C2-C60, cyano, alkylamino en C1-C60, arylamino en C6-C60, (ar en C6-C60)(alkyle en C1-C60), (alkyle en C1-C60)oxy, (alkyle en C1-C60)thio, (aryle en C6-C60)oxy, (aryle en C6-C60)thio, (alcoxy en C1-C60)carbonyle, (alkyle en C1-C60)carbonyle, (aryle en C6-C60, carboxyle)carbonyle, nitro et hydroxyle.

5. Dispositif électroluminescent organique selon la revendication 4, dans lequel la couche organique comprend un ou plusieurs composés choisis dans un groupe constitué de composés d'arylamine et de composés de styrylarylamine, ou un métal ou plusieurs métaux choisis dans un groupe constitué des métaux organiques du groupe 1, du groupe 2, des métaux de transition de la 4^{ème} période et de la 5^{ème} période, des métaux de lanthanide et des métaux de transition d.

6. Dispositif électroluminescent organique selon la revendication 4 présentant le pic électroluminescent avec une longueur d'onde du bleu et du vert simultanément.

7. Dispositif électroluminescent organique selon la revendication 4, dans lequel la couche organique comprend une couche électroluminescente et une couche générant une charge.

8. Dispositif électroluminescent organique selon la revendication 4, dans lequel une région mixte de dopant réducteur et de substance organique, ou une région mixte de dopant oxydant et de substance organique est placée sur la surface interne d'une ou des deux électrodes parmi la paire d'électrodes.
